(19) Europäisches Patentamt
European Patent Office
Office européen des brevets

(11) **EP 2 955 852 A1**

(12) **EUROPEAN PATENT APPLICATION**
published in accordance with Art. 153(4) EPC

(43) Date of publication:
**16.12.2015 Bulletin 2015/51**

(21) Application number: **14748905.8**

(22) Date of filing: **27.01.2014**

(51) Int Cl.:
***H03M 13/19*** (2006.01)

(86) International application number:
**PCT/JP2014/051620**

(87) International publication number:
**WO 2014/123014 (14.08.2014 Gazette 2014/33)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **08.02.2013 JP 2013023879**

(71) Applicant: **Sony Corporation**
**Tokyo 108-0075 (JP)**

(72) Inventors:
• **SHINOHARA Yuji**
**Tokyo 108-0075 (JP)**
• **YAMAMOTO Makiko**
**Tokyo 108-0075 (JP)**

(74) Representative: **Witte, Weller & Partner**
**Patentanwälte mbB**
**Postfach 10 54 62**
**70047 Stuttgart (DE)**

(54) **DATA PROCESSING DEVICE AND DATA PROCESSING METHOD**

(57) Provided is a data processing device including an encoding unit configured to encode an information bit into an LDPC code with a code length of 64800 bits and an encoding rate of 2/30, based on a parity check matrix of an LDPC (Low Density Parity Check) code. The LDPC code includes an information bit and a parity bit. The parity check matrix includes an information matrix part corresponding to the information bit and a parity matrix part corresponding to the parity bit. The information matrix part is shown by a parity check matrix initial value table. The parity check matrix initial value table is a table showing positions of elements of 1 of the information matrix part every 360 columns.

**FIG. 8**

**Description**

Technical Field

The present disclosure relates to a data processing device and a data processing method, and, for example, especially relates to a data processing device and data processing method that can provide an LDPC code of an excellent error rate.

Background Art

An LDPC (Low Density Parity Check) code has the high error correction capability and has been recently adopted widely to a transmission system including satellite digital broadcasting such as DVB (Digital Video Broadcasting)-S.2 performed in Europe (for example, refer to Non-Patent Literature 1). In addition, adopting of the LDPC code to next-generation terrestrial digital broadcasting such as DVB-T.2 has been examined.

From a recent study, it is known that performance near a Shannon limit is obtained from the LDPC code when a code length increases, similar to a turbo code. Because the LDPC code has a property that a shortest distance is proportional to the code length, the LDPC code has advantages of a block error probability characteristic being superior and a so-called error floor phenomenon observed in a decoding characteristic of the turbo code being rarely generated, as characteristics thereof.

Hereinafter, the LDPC code will be specifically described. The LDPC code is a linear code and it is not necessary for the LDPC code to be a binary code. However, in this case, it is assumed that the LDPC code is the binary code.

A maximum characteristic of the LDPC code is that a parity check matrix defining the LDPC code is sparse. In this case, the sparse matrix is a matrix in which the number of "1" of elements of the matrix is very small (a matrix in which most elements are 0).

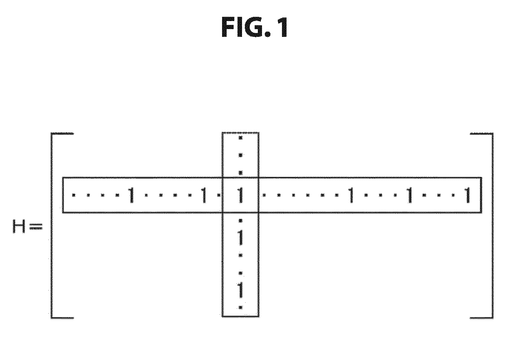

FIG. 1 illustrates an example of a parity check matrix H of the LDPC code.

In the parity check matrix H of FIG. 1, a weight of each column (the column weight) (the number of "1") becomes "3" and a weight of each row (the row weight) becomes "6".

In encoding using the LDPC code (LDPC encoding), for example, a generation matrix G is generated on the basis of the parity check matrix H and the generation matrix G is multiplied by binary information bits, so that a code word (LDPC code) is generated.

Specifically, an encoding device that performs the LDPC encoding first calculates the generation matrix G in which an expression $GH^T = 0$ is realized, between a transposed matrix $H^T$ of the parity check matrix H and the generation matrix G. In this case, when the generation matrix G is a K x N matrix, the encoding device multiplies the generation matrix G with a bit string (vector u) of information bits including K bits and generates a code word c (= uG) including N bits. The code word (LDPC code) that is generated by the encoding device is received at a reception side through a predetermined communication path.

The LDPC code can be decoded by an algorithm called probabilistic decoding suggested by Gallager, that is, a message passing algorithm using belief propagation on a so-called Tanner graph, including a variable node (also referred to as a message node) and a check node. Hereinafter, the variable node and the check node are appropriately referred to as nodes simply.

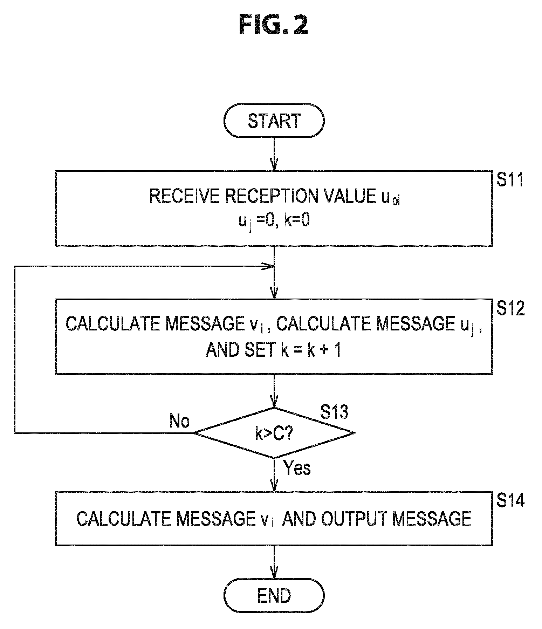

FIG. 2 illustrates a sequence of decoding of the LDPC code.

Hereinafter, a real value (a reception LLR) that is obtained by representing the likelihood of "0" of a value of an i-th code bit of the LDPC code (one code word) received by the reception side by a log likelihood ratio is appropriately referred to as a reception value $u_{0i}$. In addition, a message output from the check node is referred to as $u_j$ and a message output from the variable node is referred to as $v_i$.

First, in decoding of the LDPC code, as illustrated in FIG. 2, in step S11, the LDPC code is received, the message (check node message) $u_j$ is initialized to "0", and a variable k taking an integer as a counter of repetition processing is initialized to "0", and the processing proceeds to step S12. In step S12, the message (variable node message) $v_i$ is calculated by performing an operation (variable node operation) represented by an expression (1), on the basis of the reception value $u_{0i}$ obtained by receiving the LDPC code, and the message $u_j$ is calculated by performing an operation (check node operation) represented by an expression (2), on the basis of the message $v_i$.

[Math. 1]

$$v_i = u_{0i} + \sum_{j=1}^{d_v - 1} u_j$$

$$\cdots (1)$$

[Math. 2]

$$\tanh\left(\frac{u_j}{2}\right) = \prod_{i=1}^{d_c - 1} \tanh\left(\frac{v_i}{2}\right) \qquad \cdots (2)$$

Here, $d_v$ and $d_c$ in an expression (1) and expression (2) are respectively parameters which can be arbitrarily selected and illustrates the number of "1" in the longitudinal direction (column) and transverse direction (row) of the parity check matrix H. For example, in the case of an LDPC code ((3, 6) LDPC code) with respect to the parity check matrix H with a column weight of 3 and a row weight of 6 as illustrated in FIG. 1, $d_v=3$ and $d_c=6$ are established.

In the variable node operation of the expression (1) and the check node operation of the expression (2), because a message input from an edge (line coupling the variable node and the check node) for outputting the message is not an operation target, an operation range becomes 1 to $d_v$ - 1 or 1 to $d_c$ - 1. The check node operation of the expression (2) is performed actually by previously making a table of a function R $(v_1, v_2)$ represented by an expression (3) defined by one output with respect to two inputs $v_1$ and $v_2$ and using the table consecutively (recursively), as represented by an expression (4).

[Math. 3]

$$x = 2\tanh^{-1}\{\tanh(v_1/2)\tanh(v_2/2)\} = R(v_1, v_2) \qquad \cdots (3)$$

[Math. 4]

$$u_j = R(v_1, R(v_2, R(v_3, \cdots R(v_{d_c-2}, v_{d_c-1})))) \qquad \cdots (4)$$

In step S12, the variable k is incremented by "1" and the processing proceeds to step S13. In step S13, it is determined whether the variable k is more than the predetermined repetition decoding number of times C. When it is determined in step S13 that the variable k is not more than C, the processing returns to step S12 and the same processing is repeated hereinafter.

When it is determined in step S 13 that the variable k is more than C, the processing proceeds to step S14, the message $v_i$ that corresponds to a decoding result to be finally output is calculated by performing an operation represented by an expression (5) and is output, and the decoding processing of the LDPC code ends.

[Math. 5]

$$v_i = u_{0i} + \sum_{j=1}^{d_v} u_j \qquad \cdots (5)$$

In this case, the operation of the expression (5) is performed using messages $u_j$ from all edges connected to the variable node, different from the variable node operation of the expression (1).

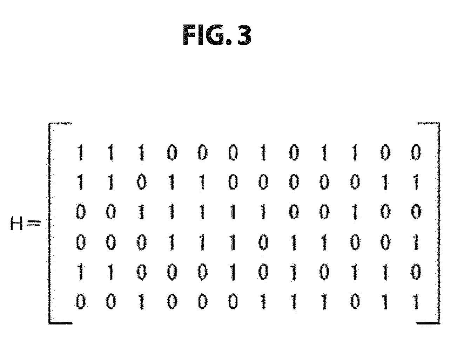

FIG. 3 illustrates an example of the parity check matrix H of the (3, 6) LDPC code (an encoding rate of 1/2 and a code length of 12).

In the parity check matrix H of FIG. 3, a weight of a column is set to 3 and a weight of a row is set to 6, similar to FIG. 1.

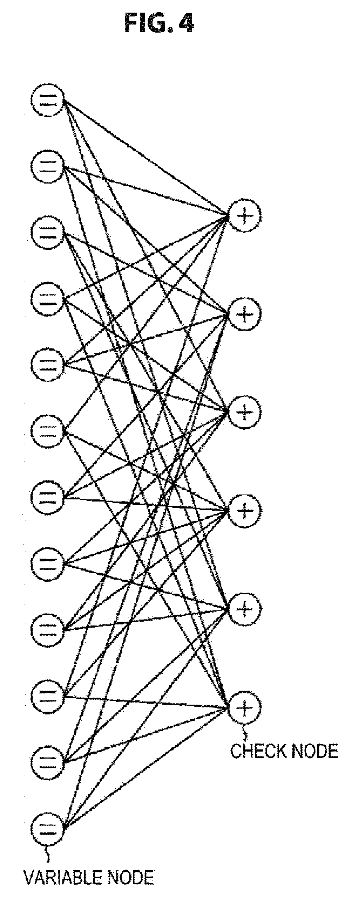

FIG. 4 illustrates a Tanner graph of the parity check matrix H of FIG. 3.

In FIG. 4, the check node is represented by "+"(plus) and the variable node is represented by "="(equal). The check node and the variable node correspond to the row and the column of the parity check matrix H. A line that couples the check node and the variable node is the edge and corresponds to "1" of elements of the parity check matrix.

That is, when an element of a j-th row and an i-th column of the parity check matrix is 1, in FIG. 4, an i-th variable node (node of "=") from the upper side and a j-th check node (node of "+") from the upper side are connected by the edge. The edge shows that a code bit corresponding to the variable node has a restriction condition corresponding to the check node.

In a sum product algorithm that is a decoding method of the LDPC code, the variable node operation and the check node operation are repetitively performed.

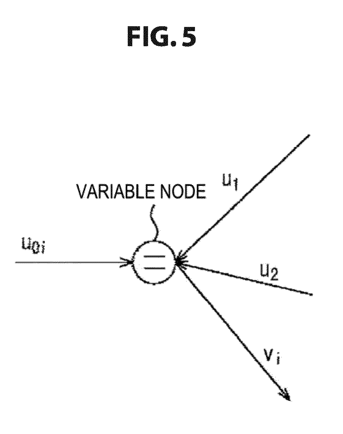

FIG. 5 illustrates the variable node operation that is performed by the variable node.

In the variable node, the message $v_i$ that corresponds to the edge for calculation is calculated by the variable node operation of the expression (1) using messages $u_1$ and $u_2$ from the remaining edges connected to the variable node and the reception value $u_{0i}$. The messages that correspond to the other edges are also calculated by the same method.

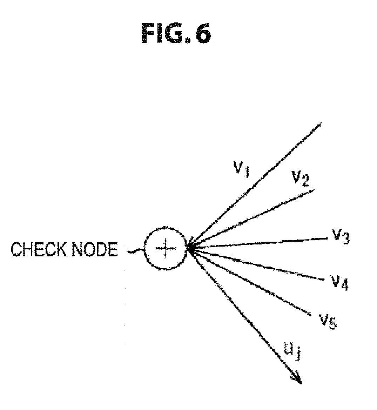

FIG. 6 illustrates the check node operation that is performed by the check node.

In this case, the check node operation of the expression (2) can be rewritten by an expression (6) using a relation of an expression $a \times b = \exp\{\ln(|a|) + \ln(|b|)\} \times \text{sign}(a) \times \text{sign}(b)$. However, $\text{sign}(x)$ is 1 in the case of $x \geq 0$ and is -1 in the case of $x < 0$.

[Math. 6]

$$
\begin{aligned}
u_j &= 2\tanh^{-1}\left(\prod_{i=1}^{d_c-1} \tanh\left(\frac{v_i}{2}\right)\right) \\
&= 2\tanh^{-1}\left[\exp\left\{\sum_{i=1}^{d_c-1} \ln\left(\left|\tanh\left(\frac{v_i}{2}\right)\right|\right)\right\} \times \prod_{i=1}^{d_c-1} \text{sign}\left(\tanh\left(\frac{v_i}{2}\right)\right)\right] \\
&= 2\tanh^{-1}\left[\exp\left\{-\left(\sum_{i=1}^{d_c-1} -\ln\left(\tanh\left(\frac{|v_i|}{2}\right)\right)\right)\right\} \times \prod_{i=1}^{d_c-1} \text{sign}(v_i)\right] \quad \cdots
\end{aligned}
$$

$$(6)$$

In $x \geq 0$, if a function $\phi(x)$ is defined as an expression $\phi(x) = \ln(\tanh(x/2))$, an expression $\phi^{-1}(x) = 2\tanh^{-1}(e^{-x})$ is realized. For this reason, the expression (6) can be changed to an expression (7).

[Math. 7]

$$
u_j = \phi^{-1}\left(\sum_{i=1}^{d_c-1} \phi(|v_i|)\right) \times \prod_{i=1}^{d_c-1} \text{sign}(v_i) \quad \cdots (7)
$$

In the check node, the check node operation of the expression (2) is performed according to the expression (7).

That is, in the check node, as illustrated in FIG. 6, the message $u_j$ that corresponds to the edge for calculation is calculated by the check node operation of the expression (7) using messages $v_1$, $v_2$, $v_3$, $v_4$, and $v_5$ from the remaining edges connected to the check node. The messages that correspond to the other edges are also calculated by the same method.

The function $\phi(x)$ of the expression (7) can be represented as $\phi(x) = \ln((e^x+1)/(e^x-1))$ and $\phi(x) = \phi^{-1}(x)$ is satisfied in $x > 0$. When the functions $\phi(x)$ and $\phi^{-1}(x)$ are mounted to hardware, the functions $\phi(x)$ and $\phi^{-1}(x)$ may be mounted using an LUT (Look Up Table). However, both the functions $\phi(x)$ and $\phi^{-1}(x)$ become the same LUT.

Citation List

Non-Patent Literature

Non-Patent Literature 1: DVB-S.2: ETSI EN 302 307 V1.2.1 (2009-08)

Summary of Invention

Technical Problem

A DVB standard such as the DVB-S.2, DVB-T.2, and DVB-C.2 which adopt the LDPC code makes the LDPC code as a symbol (symbolized) of orthogonal modulation (digital modulation) such as QPSK (Quadrature Phase Shift Keying) and the symbol is mapped to a signal point and is transmitted.

By the way, in recent years, for example, large capacity data such as a so-called 4k image with resolution of width and length of 3840x2160 pixels about four times full hi-vision and a 3D (Dimention) image is requested to be efficiently transmitted.

However, if the efficiency of data transmission is prioritized, the error rate is deteriorated.

On the other hand, there is a case where it is requested to transmit data in an excellent error rate even if the efficiency of data transmission is somewhat sacrificed.

It is assumed that data transmission in various kinds of efficiency is requested in the future, but, according to an LDPC code, for example, by preparing a plurality of LDPC codes of different encoding rates, it is possible to perform data transmission in various kinds of efficiency.

Therefore, for data transmission, it is desirable to adopt LDPC codes of encoding rates, for which a somewhat large number (for example, the number equal to or greater than the number requested for data transmission) of encoding rates are easily set.

Further, even in a case where an LDPC code of any encoding rate is used, it is desirable that resistance against an error is high (strong), that is, an error rate is excellent.

The present disclosure is made considering such a situation, and can provide an LDPC code of an excellent error rate.

Solution to Problem

A first processing device or data processing method according to the present technology includes an encoding unit or encoding step of encoding an information bit into an LDPC code with a code length of 64800 bits and an encoding rate of 2/30, based on a parity check matrix of an LDPC (Low Density Parity Check) code. The LDPC code includes an information bit and a parity bit. The parity check matrix includes an information matrix part corresponding to the information bit and a parity matrix part corresponding to the parity bit. The information matrix part is shown by a parity check matrix initial value table. The parity check matrix initial value table is a table showing positions of elements of 1 of the information matrix part every 360 columns and is expressed as follows
30 251 2458 3467 9897 12052 12191 15073 15949 16328 16972 17704 20672 22200 22276 25349 26106 28258 29737 30518 30951 32440 43031 46622 47113 52077 52609 52750 54295 55384 56954 57155 57853 59942 6985 7975 8681 10628 10866 13223 14882 18449 19570 24418 24538 24556 25926 26162 26947 28181 30049 33678 35497 37980 41276 43443 44124 48684 50382 51223 53635 57661 58040 59128 59300 59614 60200 60329 1896 5169 7347 10895 14434 14583 15125 15279 17169 18374 20805 25203 29509 30267 30925 33774 34653 34827 35707 36868 38136 38926 42690 43464 44624 46562 50291 50321 51544 56470 56532 58199 58398 60423 144 152 1236 8826 11983 12930 13349 19562 20564 30203 31766 35635 40367 40905 41792 41872 42428 43828 44359 47973 48041 49046 50158 50786 55527 55541 57260 57353 57821 58770 59098 59407 60358 60475 2085 28320 37838 50085 6903 21724 38880 59861 17156 20293 21231 44440 16799 38095 41049 44269 11939 30310 39689 47323 10563 17282 45331 60186 19860 23595 59085 60417 10403 19812 27225 48006.

A second data processing device or data processing method according to the present technology includes a decoding unit or decoding step of decoding an LDPC code with a code length of 64800 bits and an encoding rate of 2/30, based on a parity check matrix of an LDPC (Low Density Parity Check) code. The LDPC code includes an information bit and a parity bit. The parity check matrix includes an information matrix part corresponding to the information bit and a parity matrix part corresponding to the parity bit. The information matrix part is shown by a parity check matrix initial value table. The parity check matrix initial value table is a table showing positions of elements of 1 of the information matrix part every 360 columns and is expressed as follows
30 251 2458 3467 9897 12052 12191 15073 15949 16328 16972 17704 20672 22200 22276 25349 26106 28258 29737 30518 30951 32440 43031 46622 47113 52077 52609 52750 54295 55384 56954 57155 57853 59942 6985 7975 8681 10628 10866 13223 14882 18449 19570 24418 24538 24556 25926 26162 26947 28181 30049 33678 35497 37980 41276 43443 44124 48684 50382 51223 53635 57661 58040 59128 59300 59614 60200 60329 1896 5169 7347 10895 14434 14583 15125 15279 17169 18374 20805 25203 29509 30267 30925 33774 34653 34827 35707 36868 38136 38926 42690 43464 44624 46562 50291 50321 51544 56470 56532 58199 58398 60423 144 152 1236 8826 11983 12930 13349 19562 20564 30203 31766 35635 40367 40905 41792 41872 42428 43828 44359 47973 48041 49046 50158 50786 55527 55541 57260 57353 57821 58770 59098 59407 60358 60475 2085 28320 37838 50085 6903 21724 38880 59861 17156 20293 21231 44440 16799 38095 41049 44269 11939 30310 39689 47323 10563 17282 45331 60186 19860 23595 59085 60417 10403 19812 27225 48006.

A third data processing device or data processing method according to the present technology includes an encoding unit or encoding step of encoding an information bit into an LDPC code with a code length of 64800 bits and an encoding rate of 3/30, based on a parity check matrix of an LDPC (Low Density Parity Check) code. The LDPC code includes an information bit and a parity bit. The parity check matrix includes an information matrix part corresponding to the information bit and a parity matrix part corresponding to the parity bit. The information matrix part is shown by a parity check matrix initial value table. The parity check matrix initial value table is a table showing positions of elements of 1 of the information matrix part every 360 columns and is expressed as follows

153 2939 6037 11618 12401 17787 18472 22673 25220 26245 29839 35106 36915 37622 37655 45425 55595 56308 56726 58286 146 160 9060 12867 16536 20818 31754 35546 36480 36698 56314 56509 56837 57342 57373 57895 57947 58163 58202 58262 58 1555 10183 10446 12204 16197 16830 17382 19144 19565 21476 29121 41158 49953 51531 55642 57423 57587 57627 57974 120 9906 12466 21668 26856 27304 28451 29413 30168 31274 33309 33499 37486 38265 43457 50299 55218 56971 57059 58115 80 6649 9541 12490 14153 14346 19926 20677 23672 42397 45629 46288 55935 56115 56555 56865 56993 57921 58049 58190 46 152 3536 7134 9040 10474 10504 11549 17066 19102 27486 29364 39577 39995 48289 56236 57279 57560 57608 57930 19824 21165 34427 58143 22747 50215 50864 58176 2943 31340 39711 57281 1186 20802 27612 33409 1347 20868 29222 48776 19 8548 46255 56946 10762 20467 48519 39 7401 34355 142 10827 17009 1822 29424 39439 5944 11349 28870 4981 14731 15377.

A fourth data processing device or data processing method according to the present technology includes a decoding unit or decoding step of decoding an LDPC code with a code length of 64800 bits and an encoding rate of 3/30, based on a parity check matrix of an LDPC (Low Density Parity Check) code. The LDPC code includes an information bit and a parity bit. The parity check matrix includes an information matrix part corresponding to the information bit and a parity matrix part corresponding to the parity bit. The information matrix part is shown by a parity check matrix initial value table. The parity check matrix initial value table is a table showing positions of elements of 1 of the information matrix part every 360 columns and is expressed as follows

153 2939 6037 11618 12401 17787 18472 22673 25220 26245 29839 35106 36915 37622 37655 45425 55595 56308 56726 58286 146 160 9060 12867 16536 20818 31754 35546 36480 36698 56314 56509 56837 57342 57373 57895 57947 58163 58202 58262 58 1555 10183 10446 12204 16197 16830 17382 19144 19565 21476 29121 41158 49953 51531 55642 57423 57587 57627 57974 120 9906 12466 21668 26856 27304 28451 29413 30168 31274 33309 33499 37486 38265 43457 50299 55218 56971 57059 58115 80 6649 9541 12490 14153 14346 19926 20677 23672 42397 45629 46288 55935 56115 56555 56865 56993 57921 58049 58190 46 152 3536 7134 9040 10474 10504 11549 17066 19102 27486 29364 39577 39995 48289 56236 57279 57560 57608 57930 19824 21165 34427 58143 22747 50215 50864 58176 2943 31340 39711 57281 1186 20802 27612 33409 1347 20868 29222 48776 19 8548 46255 56946 10762 20467 48519 39 7401 34355 142 10827 17009 1822 29424 39439 5944 11349 28870 4981 14731 15377.

A fifth data processing device or data processing method according to the present technology includes an encoding unit or encoding step of encoding an information bit into an LDPC code with a code length of 64800 bits and an encoding rate of 4/30, based on a parity check matrix of an LDPC (Low Density Parity Check) code. The LDPC code includes an information bit and a parity bit. The parity check matrix includes an information matrix part corresponding to the information bit and a parity matrix part corresponding to the parity bit. The information matrix part is shown by a parity check matrix initial value table. The parity check matrix initial value table is a table showing positions of elements of 1 of the information matrix part every 360 columns and is expressed as follows

7248 8578 11266 16015 17433 18038 20159 20848 22164 23848 24516 25093 25888 28382 31701 33259 33540 34615 36428 38595 38683 38814 41592 44323 44522 44859 45857 48657 49686 53354 54260 54853 55069 55426 56127 715 1505 3314 5537 6377 6750 11039 11271 15840 16615 24045 24314 24435 26992 28524 28745 28935 32956 33359 34964 36217 37546 38189 42599 44326 49694 54236 54779 55501 55543 55721 55865 55961 55966 55988 70 116 613 2482 6204 6608 7392 13585 14175 14228 17842 20004 20142 21324 22575 24443 24497 25394 26585 30222 37825 38548 41709 44999 50925 52186 53793 54177 54705 55096 55489 55584 56019 56055 56151 9 2054 3493 3584 3989 5916 11915 14323 15091 16998 17631 18645 18882 20510 27499 28990 30054 32231 36556 37437 39651 41543 41963 42798 42937 44864 48056 48971 53104 54511 54610 55151 55216 55470 55736 30 81 110 294 1636 2152 4312 6098 9415 12105 14021 15226 15618 18614 21368 23154 28913 29260 36969 37792 39386 42362 42949 43758 43765 44572 45877 46424 46948 47683 47903 48245 51804 52166 53264 3 50 987 1771 4255 9714 9907 13728 17807 20438 24206 24326 24458 26039 26898 35691 36875 37877 38103 38398 38671 39288 40642 41533 41753 42069 45374 46377 48016 48165 48805 49392 50660 51907 51968 138 441 4163 6450 7419 10743 11330 14962 14984 15032 24819 28987 29221 33223 35464 37535 38213 39085 39223 39925 41220 41341 41643 44944 46330 46870 47142 48577 49387 50732 52578 53839 54085 55426 56132 3773 41938 55428 55720 8833 47844 49437 50265 7054 31403 48642 53739 2286 22401 42270 53546 14435 24811 29047 36135 21010 23783 55073 55612 20516 27533 51132 52391 884 22844 25100 56123 1150 12133 44416 53752 9761 38585 52021 55545 1476 5057 49721 50744 16334 39503 40494 43840 24 31960 33866 53369 22065 22989 32356 52287 111 155 3706 13753 17878 18240 27828 55776 13582 47019 54558 55557.

A sixth data processing device or data processing method according to the present technology includes a decoding unit or decoding step of decoding an LDPC code with a code length of 64800 bits and an encoding rate of 4/30, based on a parity check matrix of an LDPC (Low Density Parity Check) code. The LDPC code includes an information bit and a parity bit. The parity check matrix includes an information matrix part corresponding to the information bit and a parity matrix part corresponding to the parity bit. The information matrix part is shown by a parity check matrix initial value table. The parity check matrix initial value table is a table showing positions of elements of 1 of the information matrix part every 360 columns and is expressed as follows

7248 8578 11266 16015 17433 18038 20159 20848 22164 23848 24516 25093 25888 28382 31701 33259 33540 34615 36428 38595 38683 38814 41592 44323 44522 44859 45857 48657 49686 53354 54260 54853 55069 55426 56127 715 1505 3314 5537 6377 6750 11039 11271 15840 16615 24045 24314 24435 26992 28524 28745 28935 32956 33359 34964 36217 37546 38189 42599 44326 49694 54236 54779 55501 55543 55721 55865 55961 55966 55988 70 116 613 2482 6204 6608 7392 13585 14175 14228 17842 20004 20142 21324 22575 24443 24497 25394 26585 30222 37825 38548 41709 44999 50925 52186 53793 54177 54705 55096 55489 55584 56019 56055 56151 9 2054 3493 3584 3989 5916 11915 14323 15091 16998 17631 18645 18882 20510 27499 28990 30054 32231 36556 37437 39651 41543 41963 42798 42937 44864 48056 48971 53104 54511 54610 55151 55216 55470 55736 30 81 110 294 1636 2152 4312 6098 9415 12105 14021 15226 15618 18614 21368 23154 28913 29260 36969 37792 39386 42362 42949 43758 43765 44572 45877 46424 46948 47683 47903 48245 51804 52166 53264 3 50 987 1771 4255 9714 9907 13728 17807 20438 24206 24326 24458 26039 26898 35691 36875 37877 38103 38398 38671 39288 40642 41533 41753 42069 45374 46377 48016 48165 48805 49392 50660 51907 51968 138 441 4163 6450 7419 10743 11330 14962 14984 15032 24819 28987 29221 33223 35464 37535 38213 39085 39223 39925 41220 41341 41643 44944 46330 46870 47142 48577 49387 50732 52578 53839 54085 55426 56132 3773 41938 55428 55720 8833 47844 49437 50265 7054 31403 48642 53739 2286 22401 42270 53546 14435 24811 29047 36135 21010 23783 55073 55612 20516 27533 51132 52391 884 22844 25100 56123 1150 12133 44416 53752 9761 38585 52021 55545 1476 5057 49721 50744 16334 39503 40494 43840 24 31960 33866 53369 22065 22989 32356 52287 111 155 3706 13753 17878 18240 27828 55776 13582 47019 54558 55557.

A seventh data processing device or data processing method according to the present technology includes an encoding step of encoding an information bit into an LDPC code with a code length of 64800 bits and an encoding rate of 5/30, based on a parity check matrix of an LDPC (Low Density Parity Check) code. The LDPC code includes an information bit and a parity bit. The parity check matrix includes an information matrix part corresponding to the information bit and a parity matrix part corresponding to the parity bit. The information matrix part is shown by a parity check matrix initial value table. The parity check matrix initial value table is a table showing positions of elements of 1 of the information matrix part every 360 columns and is expressed as follows

2035 5424 6737 8778 10775 15496 17467 21825 23901 27869 28939 29614 34298 34951 35578 37326 39797 44488 45293 45900 49239 53415 53900 2090 4170 12643 12925 13383 17659 23995 24520 25766 26042 26585 29531 31126 34856 43610 49028 49872 50309 50455 51586 52161 52207 53263 819 1629 5521 8339 8501 18663 22208 24768 25082 35272 35560 40387 40618 42891 44288 46834 47264 47458 47561 48563 49141 49583 51837 100 564 4861 9130 15954 22395 23542 26105 27127 31905 33977 35256 37679 40472 40912 42224 43230 44945 45473 52217 52707 52953 53468 73 86 6004 9799 13581 14067 14910 14944 15502 22412 26032 27498 27746 27993 28590 35442 38766 44649 47956 48653 48724 50247 52165 108 1173 5321 6132 7304 15477 18466 19091 20238 23398 26431 34944 36899 40209 42997 48433 48762 49752 49826 50984 51319 53634 53657 4541 7635 11720 12065 16896 28028 28457 30950 35156 38740 39045 43153 43802 44180 45186 45716 45794 46645 48679 49071 49181 53212 53489 6118 8633 11204 11448 15114 19954 24570 26810 28236 39277 43584 46042 47499 48573 48715 49697 50511 51228 51563 51635 53410 53760 53851 1223 4008 8948 9130 16129 17767 22039 23572 24550 28200 29157 32730 33821 38449 39758 48433 49362 52582 53129 53282 53407 53414 53972 176 10948 11719 12340 13870 15842 18928 20987 24540 24852 28366 30017 36547 37426 38667 40361 44725 48275 48825 51211 52901 53737 53868 21792 35759 44481 53371 147 33771 34263 35853 15696 41236 46244 46674 48208 52868 53324 53794 34077 36441 49909 53506 34932 51666 53755 53974 18455 38927 49349 51201 3836 31114 37755 53469 31831 42633 46626 52743 21053 28415 46538 53154 5752 19363 42484 719 48444 52185 25502 53443 53739 11596 53495 53635 43934 52112 53323 42015 52196 52288 72 129 52340 9 17870 43153 24743 41406 53180 23388 48087 52441.

An eighth data processing device or data processing method according to the present technology includes a decoding unit or decoding step of decoding an LDPC code with a code length of 64800 bits and an encoding rate of 5/30, based on a parity check matrix of an LDPC (Low Density Parity Check) code. The LDPC code includes an information bit and a parity bit. The parity check matrix includes an information matrix part corresponding to the information bit and a parity matrix part corresponding to the parity bit. The information matrix part is shown by a parity check matrix initial value table. The parity check matrix initial value table is a table showing positions of elements of 1 of the information matrix part every 360 columns and is expressed as follows

2035 5424 6737 8778 10775 15496 17467 21825 23901 27869 28939 29614 34298 34951 35578 37326 39797 44488 45293 45900 49239 53415 53900 2090 4170 12643 12925 13383 17659 23995 24520 25766 26042 26585 29531 31126 34856 43610 49028 49872 50309 50455 51586 52161 52207 53263 819 1629 5521 8339 8501 18663 22208 24768 25082 35272 35560 40387 40618 42891 44288 46834 47264 47458 47561 48563 49141 49583 51837 100 564 4861 9130 15954 22395 23542 26105 27127 31905 33977 35256 37679 40472 40912 42224 43230 44945 45473 52217 52707 52953 53468 73 86 6004 9799 13581 14067 14910 14944 15502 22412 26032 27498 27746 27993 28590
35442 38766 44649 47956 48653 48724 50247 52165 108 1173 5321 6132 7304 15477 18466 19091 20238 23398
26431 34944 36899 40209 42997 48433 48762 49752 49826 50984 51319 53634 53657 4541 7635 11720 12065
16896 28028 28457 30950 35156 38740 39045 43153 43802 44180 45186 45716 45794 46645 48679 49071 49181
53212 53489 6118 8633 11204 11448 15114 19954 24570 26810 28236 39277 43584 46042 47499 48573 48715
49697 50511 51228 51563 51635 53410 53760 53851 1223 4008 8948 9130 16129 17767 22039 23572 24550 28200
29157 32730 33821 38449 39758 48433 49362 52582 53129 53282 53407 53414 53972 176 10948 11719 12340
13870 15842 18928 20987 24540 24852 28366 30017 36547 37426 38667 40361 44725 48275 48825 51211 52901
53737 53868 21792 35759 44481 53371 147 33771 34263 35853 15696 41236 46244 46674 48208 52868 53324
53794 34077 36441 49909 53506 34932 51666 53755 53974 18455 38927 49349 51201 3836 31114 37755 53469
31831 42633 46626 52743 21053 28415 46538 53154 5752 19363 42484 719 48444 52185 25502 53443 53739 11596
53495 53635 43934 52112 53323 42015 52196 52288 72 129 52340 9 17870 43153 24743 41406 53180 23388 48087
52441.

A ninth data processing device or data processing method according to the present technology includes an encoding unit or encoding step of encoding an information bit into an LDPC code with a code length of 64800 bits and an encoding rate of 6/30, based on a parity check matrix of an LDPC (Low Density Parity Check) code. The LDPC code includes an information bit and a parity bit. The parity check matrix includes an information matrix part corresponding to the information bit and a parity matrix part corresponding to the parity bit. The information matrix part is shown by a parity check matrix initial value table. The parity check matrix initial value table is a table showing positions of elements of 1 of the information matrix part every 360 columns and is expressed as follows

13033 14477 15028 17763 19244 20156 22458 24073 32202 32591 33531 33552 35823 41495 46351 49442 51612
44 66 8422 8760 14694 18768 20943 27806 29012 33594 36262 36820 40434 47704 49355 51729 51758 4233 16270
18958 20915 21313 27009 28249 33438 33855 34475 34541 37093 38835 42139 42169 44757 50122 82 10760 14292
17911 18008 23008 33152 34162 35749 36166 37411 37523 40838 42786 43581 46177 48829 4661 5201 5824 6014
8283 12840 22044 22103 29657 29722 32246 32893 34131 36007 40779 44900 51089 5869 12204 14095 26632
27101 27300 32344 33761 35081 38057 40709 46805 47733 48220 49806 51318 51691 87 5764 16204 20947 23257
31579 38832 40942 43112 43239 44602 49032 49482 49727 49929 50186 50593 880 1883 8876 9204 12370 21536
32858 35875 36247 36319 37151 38601 48914 49533 51239 51399 51824 20 129 2841 5695 8176 15720 26066 26197
34149 35814 36477 37478 45338 48988 50675 51071 51774 7252 14498 19246 20257 20693 22336 26037 29523
29844 34015 35828 38232 40999 41437 43343 44109 49883 4859 8000 9342 16137 21600 24083 36364 37038 38988
44465 45445 46569 48994 50591 51065 51166 51268 7728 9766 11199 11244 13877 14245 23083 27064 28433
28810 34979 39031 42939 44517 45730 48365 51374 67 135 1601 6123 9100 22043 24498 25417 30186 34430 34535
37216 40359 42794 47908 50685 51501 1006 10492 18259 51816 27272 49144 51574 51631 23 5636 38161 39514
9490 41564 46463 51162 33623 41959 50610 11626 22027 50936 28345 39504 45097 46639 50046 50319 74 18582
27985 102 17060 43142 38765 49453 51242 6102 41272 51729 24686 33446 49011 19634 49837 50000 569 22448
25746 33986 50729 51301 9883 14876 29601 9142 29505 50604 22623 40979 51260 23109 33398 51819 163 50643
50984 47021 47381 50970 16215 20964 21588.

A tenth data processing device or data processing method according to the present technology includes a decoding unit or decoding step of decoding an LDPC code with a code length of 64800 bits and an encoding rate of 6/30, based on a parity check matrix of an LDPC (Low Density Parity Check) code. The LDPC code includes an information bit and a parity bit. The parity check matrix includes an information matrix part corresponding to the information bit and a parity matrix part corresponding to the parity bit. The information matrix part is shown by a parity check matrix initial value table. The parity check matrix initial value table is a table showing positions of elements of 1 of the information matrix part every 360 columns and is expressed as follows

13033 14477 15028 17763 19244 20156 22458 24073 32202 32591 33531 33552 35823 41495 46351 49442 51612
44 66 8422 8760 14694 18768 20943 27806 29012 33594 36262 36820 40434 47704 49355 51729 51758 4233 16270
18958 20915 21313 27009 28249 33438 33855 34475 34541 37093 38835 42139 42169 44757 50122 82 10760 14292
17911 18008 23008 33152 34162 35749 36166 37411 37523 40838 42786 43581 46177 48829 4661 5201 5824 6014
8283 12840 22044 22103 29657 29722 32246 32893 34131 36007 40779 44900 51089 5869 12204 14095 26632
27101 27300 32344 33761 35081 38057 40709 46805 47733 48220 49806 51318 51691 87 5764 16204 20947 23257
31579 38832 40942 43112 43239 44602 49032 49482 49727 49929 50186 50593 880 1883 8876 9204 12370 21536
32858 35875 36247 36319 37151 38601 48914 49533 51239 51399 51824 20 129 2841 5695 8176 15720 26066 26197
34149 35814 36477 37478 45338 48988 50675 51071 51774 7252 14498 19246 20257 20693 22336 26037 29523
29844 34015 35828 38232 40999 41437 43343 44109 49883 4859 8000 9342 16137 21600 24083 36364 37038 38988
44465 45445 46569 48994 50591 51065 51166 51268 7728 9766 11199 11244 13877 14245 23083 27064 28433
28810 34979 39031 42939 44517 45730 48365 51374 67 135 1601 6123 9100 22043 24498 25417 30186 34430 34535
37216 40359 42794 47908 50685 51501 1006 10492 18259 51816 27272 49144 51574 51631 23 5636 38161 39514
9490 41564 46463 51162 33623 41959 50610 11626 22027 50936 28345 39504 45097 46639 50046 50319 74 18582 27985 102 17060 43142 38765 49453 51242 6102 41272 51729 24686 33446 49011 19634 49837 50000 569 22448 25746 33986 50729 51301 9883 14876 29601 9142 29505 50604 22623 40979 51260 23109 33398 51819 163 50643 50984 47021 47381 50970 16215 20964 21588.

According to the present technology, an information bit is encoded into an LDPC code with a code length of 64800 bits and an encoding rate of 2/30, 3/30, 4/30, 5/30, or 6/30 based on a parity check matrix of an LDPC (Low Density Parity Check) code.

According to the present technology, an LDPC code with a code length of 64800 bits and an encoding rate of 2/30, 3/30, 4/30, 5/30, or 6/30 is decoded based on a parity check matrix of an LDPC (Low Density Parity Check) code.

The LDPC code includes an information bit and a parity bit. The parity check matrix includes an information matrix part corresponding to the information bit and a parity matrix part corresponding to the parity bit. The information matrix part is shown by a parity check matrix initial value table. The parity check matrix initial value table is a table showing positions of elements of 1 of the information matrix part every 360 columns.

A parity check matrix initial value table with an encoding rate of 2/30 is expressed as follows

30 251 2458 3467 9897 12052 12191 15073 15949 16328 16972 17704 20672 22200 22276 25349 26106 28258 29737 30518 30951 32440 43031 46622 47113 52077 52609 52750 54295 55384 56954 57155 57853 59942 6985 7975 8681 10628 10866 13223 14882 18449 19570 24418 24538 24556 25926 26162 26947 28181 30049 33678 35497 37980 41276 43443 44124 48684 50382 51223 53635 57661 58040 59128 59300 59614 60200 60329 1896 5169 7347 10895 14434 14583 15125 15279 17169 18374 20805 25203 29509 30267 30925 33774 34653 34827 35707 36868 38136 38926 42690 43464 44624 46562 50291 50321 51544 56470 56532 58199 58398 60423 144 152 1236 8826 11983 12930 13349 19562 20564 30203 31766 35635 40367 40905 41792 41872 42428 43828 44359 47973 48041 49046 50158 50786 55527 55541 57260 57353 57821 58770 59098 59407 60358 60475 2085 28320 37838 50085 6903 21724 38880 59861 17156 20293 21231 44440 16799 38095 41049 44269 11939 30310 39689 47323 10563 17282 45331 60186 19860 23595 59085 60417 10403 19812 27225 48006.

A parity check matrix initial value table with an encoding rate of 3/30 is expressed as follows

153 2939 6037 11618 12401 17787 18472 22673 25220 26245 29839 35106 36915 37622 37655 45425 55595 56308 56726 58286 146 160 9060 12867 16536 20818 31754 35546 36480 36698 56314 56509 56837 57342 57373 57895 57947 58163 58202 58262 58 1555 10183 10446 12204 16197 16830 17382 19144 19565 21476 29121 41158 49953 51531 55642 57423 57587 57627 57974 120 9906 12466 21668 26856 27304 28451 29413 30168 31274 33309 33499 37486 38265 43457 50299 55218 56971 57059 58115 80 6649 9541 12490 14153 14346 19926 20677 23672 42397 45629 46288 55935 56115 56555 56865 56993 57921 58049 58190 46 152 3536 7134 9040 10474 10504 11549 17066 19102 27486 29364 39577 39995 48289 56236 57279 57560 57608 57930 19824 21165 34427 58143 22747 50215 50864 58176 2943 31340 39711 57281 1186 20802 27612 33409 1347 20868 29222 48776 19 8548 46255 56946 10762 20467 48519 39 7401 34355 142 10827 17009 1822 29424 39439 5944 11349 28870 4981 14731 15377.

A parity check matrix initial value table with an encoding rate of 4/30 is expressed as follows

7248 8578 11266 16015 17433 18038 20159 20848 22164 23848 24516 25093 25888 28382 31701 33259 33540 34615 36428 38595 38683 38814 41592 44323 44522 44859 45857 48657 49686 53354 54260 54853 55069 55426 56127 715 1505 3314 5537 6377 6750 11039 11271 15840 16615 24045 24314 24435 26992 28524 28745 28935 32956 33359 34964 36217 37546 38189 42599 44326 49694 54236 54779 55501 55543 55721 55865 55961 55966 55988 70 116 613 2482 6204 6608 7392 13585 14175 14228 17842 20004 20142 21324 22575 24443 24497 25394 26585 30222 37825 38548 41709 44999 50925 52186 53793 54177 54705 55096 55489 55584 56019 56055 56151 9 2054 3493 3584 3989 5916 11915 14323 15091 16998 17631 18645 18882 20510 27499 28990 30054 32231 36556 37437 39651 41543 41963 42798 42937 44864 48056 48971 53104 54511 54610 55151 55216 55470 55736 30 81 110 294 1636 2152 4312 6098 9415 12105 14021 15226 15618 18614 21368 23154 28913 29260 36969 37792 39386 42362 42949 43758 43765 44572 45877 46424 46948 47683 47903 48245 51804 52166 53264 3 50 987 1771 4255 9714 9907 13728 17807 20438 24206 24326 24458 26039 26898 35691 36875 37877 38103 38398 38671 39288 40642 41533 41753 42069 45374 46377 48016 48165 48805 49392 50660 51907 51968 138 441 4163 6450 7419 10743 11330 14962 14984 15032 24819 28987 29221 33223 35464 37535 38213 39085 39223 39925 41220 41341 41643 44944 46330 46870 47142 48577 49387 50732 52578 53839 54085 55426 56132 3773 41938 55428 55720 8833 47844 49437 50265 7054 31403 48642 53739 2286 22401 42270 53546 14435 24811 29047 36135 21010 23783 55073 55612 20516 27533 51132 52391 884 22844 25100 56123 1150 12133 44416 53752 9761 38585 52021 55545 1476 5057 49721 50744 16334 39503 40494 43840 24 31960 33866 53369 22065 22989 32356 52287 111 155 3706 13753 17878 18240 27828 55776 13582 47019 54558 55557.

A parity check matrix initial value table with an encoding rate of 5/30 is expressed as follows

2035 5424 6737 8778 10775 15496 17467 21825 23901 27869 28939 29614 34298 34951 35578 37326 39797 44488 45293 45900 49239 53415 53900 2090 4170 12643 12925 13383 17659 23995 24520 25766 26042 26585 29531 31126 34856 43610 49028 49872 50309 50455 51586 52161 52207 53263 819 1629 5521 8339 8501 18663 22208 24768 25082 35272 35560 40387 40618 42891 44288 46834 47264 47458 47561 48563 49141 49583 51837 100 564 4861 9130 15954 22395 23542 26105 27127 31905 33977 35256 37679 40472 40912 42224 43230 44945 45473 52217 52707 52953 53468 73 86 6004 9799 13581 14067 14910 14944 15502 22412 26032 27498 27746 27993 28590 35442 38766 44649 47956 48653 48724 50247 52165 108 1173 5321 6132 7304 15477 18466 19091 20238 23398 26431 34944 36899 40209 42997 48433 48762 49752 49826 50984 51319 53634 53657 4541 7635 11720 12065 16896 28028 28457 30950 35156 38740 39045 43153 43802 44180 45186 45716 45794 46645 48679 49071 49181 53212 53489 6118 8633 11204 11448 15114 19954 24570 26810 28236 39277 43584 46042 47499 48573 48715 49697 50511 51228 51563 51635 53410 53760 53851 1223 4008 8948 9130 16129 17767 22039 23572 24550 28200 29157 32730 33821 38449 39758 48433 49362 52582 53129 53282 53407 53414 53972 176 10948 11719 12340 13870 15842 18928 20987 24540 24852 28366 30017 36547 37426 38667 40361 44725 48275 48825 51211 52901 53737 53868 21792 35759 44481 53371 147 33771 34263 35853 15696 41236 46244 46674 48208 52868 53324 53794 34077 36441 49909 53506 34932 51666 53755 53974 18455 38927 49349 51201 3836 31114 37755 53469 31831 42633 46626 52743 21053 28415 46538 53154 5752 19363 42484 719 48444 52185 25502 53443 53739 11596 53495 53635 43934 52112 53323 42015 52196 52288 72 129 52340 9 17870 43153 24743 41406 53180 23388 48087 52441.

A parity check matrix initial value table with an encoding rate of 6/30 is expressed as follows

13033 14477 15028 17763 19244 20156 22458 24073 32202 32591 33531 33552 35823 41495 46351 49442 51612 44 66 8422 8760 14694 18768 20943 27806 29012 33594 36262 36820 40434 47704 49355 51729 51758 4233 16270 18958 20915 21313 27009 28249 33438 33855 34475 34541 37093 38835 42139 42169 44757 50122 82 10760 14292 17911 18008 23008 33152 34162 35749 36166 37411 37523 40838 42786 43581 46177 48829 4661 5201 5824 6014 8283 12840 22044 22103 29657 29722 32246 32893 34131 36007 40779 44900 51089 5869 12204 14095 26632 27101 27300 32344 33761 35081 38057 40709 46805 47733 48220 49806 51318 51691 87 5764 16204 20947 23257 31579 38832 40942 43112 43239 44602 49032 49482 49727 49929 50186 50593 880 1883 8876 9204 12370 21536 32858 35875 36247 36319 37151 38601 48914 49533 51239 51399 51824 20 129 2841 5695 8176 15720 26066 26197 34149 35814 36477 37478 45338 48988 50675 51071 51774 7252 14498 19246 20257 20693 22336 26037 29523 29844 34015 35828 38232 40999 41437 43343 44109 49883 4859 8000 9342 16137 21600 24083 36364 37038 38988 44465 45445 46569 48994 50591 51065 51166 51268 7728 9766 11199 11244 13877 14245 23083 27064 28433 28810 34979 39031 42939 44517 45730 48365 51374 67 135 1601 6123 9100 22043 24498 25417 30186 34430 34535 37216 40359 42794 47908 50685 51501 1006 10492 18259 51816 27272 49144 51574 51631 23 5636 38161 39514 9490 41564 46463 51162 33623 41959 50610 11626 22027 50936 28345 39504 45097 46639 50046 50319 74 18582 27985 102 17060 43142 38765 49453 51242 6102 41272 51729 24686 33446 49011 19634 49837 50000 569 22448 25746 33986 50729 51301 9883 14876 29601 9142 29505 50604 22623 40979 51260 23109 33398 51819 163 50643 50984 47021 47381 50970 16215 20964 21588.

The data processing device may be an independent device and may be an internal block constituting one device.

Advantageous Effects of Invention

According to the present disclosure, it is possible to provide an LDPC code of an excellent error rate.

Brief Description of Drawings

[FIG. 1] FIG. 1 is an illustration of a parity check matrix H of an LDPC code.
[FIG. 2] FIG. 2 is a flowchart illustrating a decoding sequence of an LDPC code.
[FIG. 3] FIG. 3 is an illustration of an example of a parity check matrix of an LDPC code.
[FIG. 4] FIG. 4 is an illustration of a Tanner graph of a parity check matrix.
[FIG. 5] FIG. 5 is an illustration of a variable node.
[FIG. 6] FIG. 6 is an illustration of a check node.
[FIG. 7] FIG. 7 is an illustration of a configuration example of an embodiment of a transmission system to which the present invention is applied.
[FIG. 8] FIG. 8 is a block diagram illustrating a configuration example of a transmitting device 11.
[FIG. 9] FIG. 9 is a block diagram illustrating a configuration example of a bit interleaver 116.
[FIG. 10] FIG. 10 is an illustration of a parity check matrix.
[FIG. 11] FIG. 11 is an illustration of a parity matrix.
[FIG. 12] FIG. 12 is an illustration of a parity check matrix of an LDPC code defined in a standard of DVB-S.2.
[FIG. 13] FIG. 13 is an illustration of a parity check matrix of an LDPC code defined in a standard of DVB-S.2.
[FIG. 14] FIG. 14 is an illustration of signal point arrangement of 16QAM.
[FIG. 15] FIG. 15 is an illustration of signal point arrangement of 64QAM.
[FIG. 16] FIG. 16 is an illustration of signal point arrangement of 64QAM.

[FIG. 17] FIG. 17 is an illustration of signal point arrangement of 64QAM.

[FIG. 18] FIG. 18 is an illustration of signal point arrangement defined in the standard of DVB-S.2.

[FIG. 19] FIG. 19 is an illustration of signal point arrangement defined in the standard of DVB-S.2.

[FIG. 20] FIG. 20 is an illustration of signal point arrangement defined in the standard of DVB-S.2.

[FIG. 21] FIG. 21 is an illustration of signal point arrangement defined in the standard of DVB-S.2.

[FIG. 22] FIG. 22 is an illustration of processing of a demultiplexer 25.

[FIG. 23] FIG. 23 is an illustration of processing of a demultiplexer 25.

[FIG. 24] FIG. 24 is an illustration of a Tanner graph for decoding of an LDPC code.

[FIG. 25] FIG. 25 is an illustration of a parity matrix $H_T$ becoming a staircase structure and a Tanner graph corresponding to the parity matrix $H_T$.

[FIG. 26] FIG. 26 is an illustration of a parity matrix $H_T$ of a parity check matrix H corresponding to an LDPC code after parity interleave.

[FIG. 27] FIG. 27 is an illustration of a transformed parity check matrix.

[FIG. 28] FIG. 28 is an illustration of processing of a column twist interleaver 24.

[FIG. 29] FIG. 29 is an illustration of a column number of a memory 31 necessary for a column twist interleave and an address of a write start position.

[FIG. 30] FIG. 30 is an illustration of a column number of a memory 31 necessary for a column twist interleave and an address of a write start position.

[FIG. 31] FIG. 31 is a flowchart illustrating processing executed by a bit interleaver 116 and a QAM encoder 117.

[FIG. 32] FIG. 32 is an illustration of a model of a communication path adopted by simulation.

[FIG. 33] FIG. 33 is an illustration of a relation of an error rate obtained by simulation and a Doppler frequency $f_d$ of a flutter.

[FIG. 34] FIG. 34 is an illustration of a relation of an error rate obtained by simulation and a Doppler frequency $f_d$ of a flutter.

[FIG. 35] FIG. 35 is a block diagram illustrating a configuration example of an LDPC encoder 115.

[FIG. 36] FIG. 36 is a flowchart illustrating processing of an LDPC encoder 115.

[FIG. 37] FIG. 37 is an illustration of an example of a parity check matrix initial value table in which an encoding rate is 1/4 and a code length is 16200.

[FIG. 38] FIG. 38 is an illustration of a method of calculating a parity check matrix H from a parity check matrix initial value table.

[FIG. 39] FIG. 39 is an illustration of the characteristic of BER/FER of an LDPC code whose code length defined in the standard of DVB-S.2 is 64800 bits.

[FIG. 40] FIG. 40 is an illustration of an example of a parity check matrix initial value table in which an encoding rate is 2/30 and a code length is 64800.

[FIG. 41] FIG. 41 is an illustration of an example of a parity check matrix initial value table in which an encoding rate is 3/30 and a code length is 64800.

[FIG. 42] FIG. 42 is an illustration of an example of a parity check matrix initial value table in which an encoding rate is 4/30 and a code length is 64800.

[FIG. 43] FIG. 43 is an illustration of an example of a parity check matrix initial value table in which an encoding rate is 5/30 and a code length is 64800.

[FIG. 44] FIG. 44 is an illustration of an example of a parity check matrix initial value table in which an encoding rate is 6/30 and a code length is 64800.

[FIG. 45] FIG. 45 is an illustration of an example of a parity check matrix initial value table in which an encoding rate is 7/30 and a code length is 64800.

[FIG. 46] FIG. 46 is an illustration of an example of a parity check matrix initial value table in which an encoding rate is 8/30 and a code length is 64800.

[FIG. 47] FIG. 47 is an illustration of an example of a parity check matrix initial value table in which an encoding rate is 8/30 and a code length is 64800.

[FIG. 48] FIG. 48 is an illustration of an example of a parity check matrix initial value table in which an encoding rate is 9/30 and a code length is 64800.

[FIG. 49] FIG. 49 is an illustration of an example of a parity check matrix initial value table in which an encoding rate is 9/30 and a code length is 64800.

[FIG. 50] FIG. 50 is an illustration of an example of a parity check matrix initial value table in which an encoding rate is 10/30 and a code length is 64800.

[FIG. 51] FIG. 51 is an illustration of an example of a parity check matrix initial value table in which an encoding rate is 10/30 and a code length is 64800.

[FIG. 52] FIG. 52 is an illustration of an example of a parity check matrix initial value table in which an encoding rate is 11/30 and a code length is 64800.

[FIG. 53] FIG. 53 is an illustration of an example of a parity check matrix initial value table in which an encoding rate is 11/30 and a code length is 64800.

[FIG. 54] FIG. 54 is an illustration of an example of a parity check matrix initial value table in which an encoding rate is 12/30 and a code length is 64800.

[FIG. 55] FIG. 55 is an illustration of an example of a parity check matrix initial value table in which an encoding rate is 12/30 and a code length is 64800.

[FIG. 56] FIG. 56 is an illustration of an example of a parity check matrix initial value table in which an encoding rate is 13/30 and a code length is 64800.

[FIG. 57] FIG. 57 is an illustration of an example of a parity check matrix initial value table in which an encoding rate is 13/30 and a code length is 64800.

[FIG. 58] FIG. 58 is an illustration of an example of a parity check matrix initial value table in which an encoding rate is 14/30 and a code length is 64800.

[FIG. 59] FIG. 59 is an illustration of an example of a parity check matrix initial value table in which an encoding rate is 14/30 and a code length is 64800.

[FIG. 60] FIG. 60 is an illustration of an example of a parity check matrix initial value table in which an encoding rate is 15/30 and a code length is 64800.

[FIG. 61] FIG. 61 is an illustration of an example of a parity check matrix initial value table in which an encoding rate is 15/30 and a code length is 64800.

[FIG. 62] FIG. 62 is an illustration of an example of a parity check matrix initial value table in which an encoding rate is 16/30 and a code length is 64800.

[FIG. 63] FIG. 63 is an illustration of an example of a parity check matrix initial value table in which an encoding rate is 16/30 and a code length is 64800.

[FIG. 64] FIG. 64 is an illustration of an example of a parity check matrix initial value table in which an encoding rate is 16/30 and a code length is 64800.

[FIG. 65] FIG. 65 is an illustration of an example of a parity check matrix initial value table in which an encoding rate is 17/30 and a code length is 64800.

[FIG. 66] FIG. 66 is an illustration of an example of a parity check matrix initial value table in which an encoding rate is 17/30 and a code length is 64800.

[FIG. 67] FIG. 67 is an illustration of an example of a parity check matrix initial value table in which an encoding rate is 17/30 and a code length is 64800.

[FIG. 68] FIG. 68 is an illustration of an example of a parity check matrix initial value table in which an encoding rate is 18/30 and a code length is 64800.

[FIG. 69] FIG. 69 is an illustration of an example of a parity check matrix initial value table in which an encoding rate is 18/30 and a code length is 64800.

[FIG. 70] FIG. 70 is an illustration of an example of a parity check matrix initial value table in which an encoding rate is 18/30 and a code length is 64800.

[FIG. 71] FIG. 71 is an illustration of an example of a parity check matrix initial value table in which an encoding rate is 19/30 and a code length is 64800.

[FIG. 72] FIG. 72 is an illustration of an example of a parity check matrix initial value table in which an encoding rate is 19/30 and a code length is 64800.

[FIG. 73] FIG. 73 is an illustration of an example of a parity check matrix initial value table in which an encoding rate is 19/30 and a code length is 64800.

[FIG. 74] FIG. 74 is an illustration of an example of a parity check matrix initial value table in which an encoding rate is 20/30 and a code length is 64800.

[FIG. 75] FIG. 75 is an illustration of an example of a parity check matrix initial value table in which an encoding rate is 20/30 and a code length is 64800.

[FIG. 76] FIG. 76 is an illustration of an example of a parity check matrix initial value table in which an encoding rate is 20/30 and a code length is 64800.

[FIG. 77] FIG. 77 is an illustration of an example of a parity check matrix initial value table in which an encoding rate is 21/30 and a code length is 64800.

[FIG. 78] FIG. 78 is an illustration of an example of a parity check matrix initial value table in which an encoding rate is 21/30 and a code length is 64800.

[FIG. 79] FIG. 79 is an illustration of an example of a parity check matrix initial value table in which an encoding rate is 21/30 and a code length is 64800.

[FIG. 80] FIG. 80 is an illustration of an example of a parity check matrix initial value table in which an encoding rate is 22/30 and a code length is 64800.

[FIG. 81] FIG. 81 is an illustration of an example of a parity check matrix initial value table in which an encoding rate is 22/30 and a code length is 64800.

[FIG. 82] FIG. 82 is an illustration of an example of a parity check matrix initial value table in which an encoding rate is 22/30 and a code length is 64800.

[FIG. 83] FIG. 83 is an illustration of an example of a parity check matrix initial value table in which an encoding rate is 23/30 and a code length is 64800.

[FIG. 84] FIG. 84 is an illustration of an example of a parity check matrix initial value table in which an encoding rate is 23/30 and a code length is 64800.

[FIG. 85] FIG. 85 is an illustration of an example of a parity check matrix initial value table in which an encoding rate is 23/30 and a code length is 64800.

[FIG. 86] FIG. 86 is an illustration of an example of a parity check matrix initial value table in which an encoding rate is 24/30 and a code length is 64800.

[FIG. 87] FIG. 87 is an illustration of an example of a parity check matrix initial value table in which an encoding rate is 24/30 and a code length is 64800.

[FIG. 88] FIG. 88 is an illustration of an example of a parity check matrix initial value table in which an encoding rate is 24/30 and a code length is 64800.

[FIG. 89] FIG. 89 is an illustration of an example of a parity check matrix initial value table in which an encoding rate is 25/30 and a code length is 64800.

[FIG. 90] FIG. 90 is an illustration of an example of a parity check matrix initial value table in which an encoding rate is 25/30 and a code length is 64800.

[FIG. 91] FIG. 91 is an illustration of an example of a parity check matrix initial value table in which an encoding rate is 25/30 and a code length is 64800.

[FIG. 92] FIG. 92 is an illustration of an example of a parity check matrix initial value table in which an encoding rate is 26/30 and a code length is 64800.

[FIG. 93] FIG. 93 is an illustration of an example of a parity check matrix initial value table in which an encoding rate is 26/30 and a code length is 64800.

[FIG. 94] FIG. 94 is an illustration of an example of a parity check matrix initial value table in which an encoding rate is 26/30 and a code length is 64800.

[FIG. 95] FIG. 95 is an illustration of an example of a parity check matrix initial value table in which an encoding rate is 27/30 and a code length is 64800.

[FIG. 96] FIG. 96 is an illustration of an example of a parity check matrix initial value table in which an encoding rate is 27/30 and a code length is 64800.

[FIG. 97] FIG. 97 is an illustration of an example of a parity check matrix initial value table in which an encoding rate is 27/30 and a code length is 64800.

[FIG. 98] FIG. 98 is an illustration of an example of a parity check matrix initial value table in which an encoding rate is 27/30 and a code length is 64800.

[FIG. 99] FIG. 99 is an illustration of an example of a parity check matrix initial value table in which an encoding rate is 28/30 and a code length is 64800.

[FIG. 100] FIG. 100 is an illustration of an example of a parity check matrix initial value table in which an encoding rate is 28/30 and a code length is 64800.

[FIG. 101] FIG. 101 is an illustration of an example of a parity check matrix initial value table in which an encoding rate is 28/30 and a code length is 64800.

[FIG. 102] FIG. 102 is an illustration of an example of a parity check matrix initial value table in which an encoding rate is 28/30 and a code length is 64800.

[FIG. 103] FIG. 103 is an illustration of an example of a parity check matrix initial value table in which an encoding rate is 29/30 and a code length is 64800.

[FIG. 104] FIG. 104 is an illustration of an example of a parity check matrix initial value table in which an encoding rate is 29/30 and a code length is 64800.

[FIG. 105] FIG. 105 is an illustration of an example of a parity check matrix initial value table in which an encoding rate is 29/30 and a code length is 64800.

[FIG. 106] FIG. 106 is an illustration of an example of a parity check matrix initial value table in which an encoding rate is 29/30 and a code length is 64800.

[FIG. 107] FIG. 107 is an illustration of a Tanner graph of an ensemble of a degree sequence in which the column weight is 3 and the row weight is 6.

[FIG. 108] FIG. 108 is an illustration of an example of a Tanner graph of an ensemble of a multi-edge type.

[FIG. 109] FIG. 109 is an illustration of the minimum cycle length and performance threshold of a parity check matrix of an LDPC code with a code length of 64800.

[FIG. 110] FIG. 110 is an illustration of a parity check matrix of an LDPC code with a code length of 64800.

[FIG. 111] FIG. 111 is an illustration of a parity check matrix of an LDPC code with a code length of 64800.

[FIG. 112] FIG. 112 is an illustration of a simulation result of BER/FER of an LDPC code with a code length of 64800.

[FIG. 113] FIG. 113 is an illustration of a simulation result of BER/FER of an LDPC code with a code length of 64800.

[FIG. 114] FIG. 114 is an illustration of a simulation result of BER/FER of an LDPC code with a code length of 64800.

[FIG. 115] FIG. 115 is an illustration of a BCH code used for simulation of BER/FER of an LDPC code with a code length of 64800.

[FIG. 116] FIG. 116 is a block diagram illustrating a configuration example of a receiving device 12.

[FIG. 117] FIG. 117 is a block diagram illustrating a configuration example of a bit deinterleaver 165.

[FIG. 118] FIG. 118 is a flowchart illustrating processing executed by a QAM decoder 164, a bit deinterleaver 165, and an LDPC decoder 166.

[FIG. 119] FIG. 119 is an illustration of an example of a parity check matrix of an LDPC code.

[FIG. 120] FIG. 120 is an illustration of a matrix (transformed parity check matrix) obtained by executing row replacement and column replacement with respect to a parity check matrix.

[FIG. 121] FIG. 121 is an illustration of a transformed parity check matrix divided in a $5 \times 5$ unit.

[FIG. 122] FIG. 122 is a block diagram illustrating a configuration example of a decoding device that collectively performs P node operations.

[FIG. 123] FIG. 123 is a block diagram illustrating a configuration example of an LDPC decoder 166.

[FIG. 124] FIG. 124 is an illustration of processing of a multiplexer 54 constituting a bit deinterleaver 165.

[FIG. 125] FIG. 125 is an illustration of processing of a column twist deinterleaver 55.

[FIG. 126] FIG. 126 is a block diagram illustrating another configuration example of a bit deinterleaver 165.

[FIG. 127] FIG. 127 is a block diagram illustrating a first configuration example of a reception system that can be applied to a receiving device 12.

[FIG. 128] FIG. 128 is a block diagram illustrating a second configuration example of a reception system that can be applied to a receiving device 12.

[FIG. 129] FIG. 129 is a block diagram illustrating a third configuration example of a reception system that can be applied to a receiving device 12.

[FIG. 130] FIG. 130 is a block diagram illustrating a configuration example of an embodiment of a computer to which the present technology is applied.

Description of Embodiments

[Configuration example of transmission system to which present disclosure is applied]

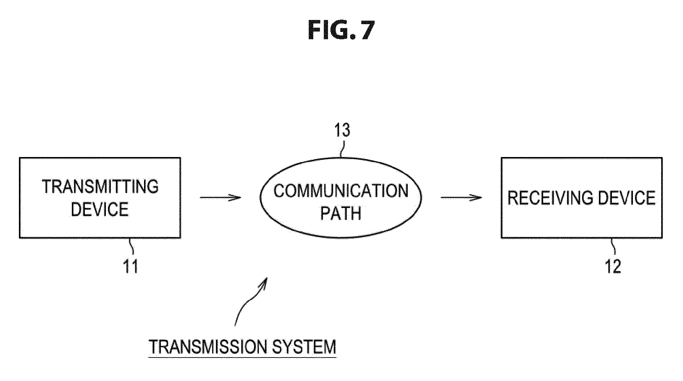

FIG. 7 illustrates a configuration example of an embodiment of a transmission system (a system means a logical gathering of a plurality of devices and a device of each configuration may be arranged or may not be arranged in the same casing) to which the present invention is applied.

In FIG. 7, the transmission system includes a transmitting device 11 and a receiving device 12.

For example, the transmitting device 11 transmits (broadcasts) (transfers) a program of television broadcasting, and so on. That is, for example, the transmitting device 11 encodes target data that is a transmission target such as image data and audio data as a program into LDPC codes, and, for example, transmits them through a communication path 13 such as a satellite circuit, a ground wave and a cable (wire circuit).

The receiving device 12 receives the LDPC code transmitted from the transmitting device 11 through the communication path 13, decodes the LDPC code to obtain the target data, and outputs the target data.

In this case, it is known that the LDPC code used by the transmission system of FIG. 7 shows the very high capability in an AWGN (Additive White Gaussian Noise) communication path.

Meanwhile, in the communication path 13, burst error or erasure may be generated. Especially in the case where the communication path 13 is the ground wave, for example, in an OFDM (Orthogonal Frequency Division Multiplexing) system, power of a specific symbol may become 0 (erasure) according to delay of an echo (paths other than a main path), under a multi-path environment in which D/U (Desired to Undesired Ratio) is 0 dB (power of Undesired = echo is equal to power of Desired = main path).

In the flutter (communication path in which delay is 0 and an echo having a Doppler frequency is added), when D/U is 0 dB, entire power of an OFDM symbol at a specific time may become 0 (erasure) by the Doppler frequency.

In addition, the burst error may be generated due to a situation of a wiring line from a receiving unit (not illustrated in the drawings) of the side of the receiving device 12 such as an antenna receiving a signal from the transmitting device 11 to the receiving device 12 or instability of a power supply of the receiving device 12.

Meanwhile, in decoding of the LDPC code, in the variable node corresponding to the column of the parity check matrix H and the code bit of the LDPC code, as illustrated in FIG. 5 described above, the variable node operation of the expression (1) with the addition of (the reception value $u_{0i}$ of) the code bit of the LDPC code is performed. For this reason, if error is generated in the code bits used for the variable node operation, precision of the calculated message is deteriorated.

In the decoding of the LDPC code, in the check node, the check node operation of the expression (7) is performed using the message calculated by the variable node connected to the check node. For this reason, if the number of check nodes in which error (including erasure) is generated simultaneously in (the code bits of the LDPC codes corresponding to) the plurality of connected variable nodes increases, decoding performance is deteriorated.

That is, if the two or more variable nodes of the variable nodes connected to the check node become simultaneously erasure, the check node returns a message in which the probability of a value being 0 and the probability of a value being 1 are equal to each other, to all the variable nodes. In this case, the check node that returns the message of the equal probabilities does not contribute to one decoding processing (one set of the variable node operation and the check node operation). As a result, it is necessary to increase the repetition number of times of the decoding processing, the decoding performance is deteriorated, and consumption power of the receiving device 12 that performs decoding of the LDPC code increases.

Therefore, in the transmission system of FIG. 7, tolerance against the burst error or the erasure can be improved while performance in the AWGN communication path is maintained.

[Configuration example of transmitting device 11]

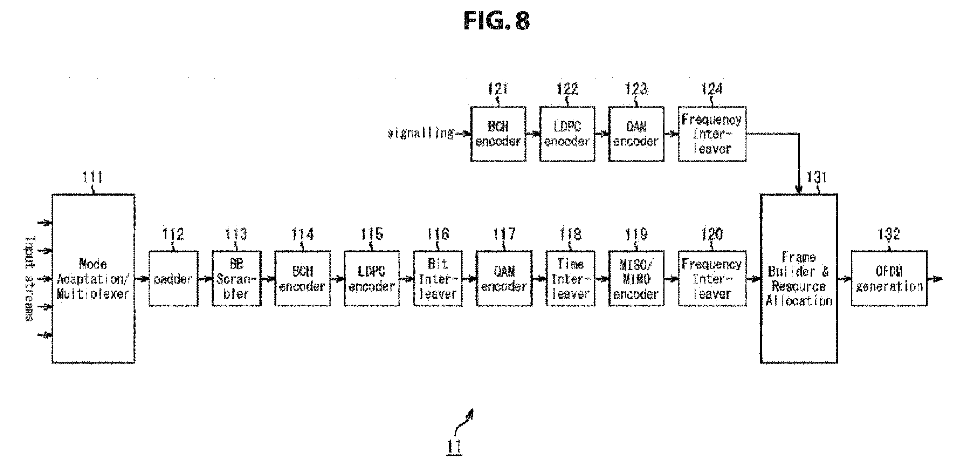

FIG. 8 is a block diagram illustrating a configuration example of the transmitting device 11 of FIG. 7.

In the transmitting device 11, one or more input streams corresponding to target data are supplied to a mode adaptation/multiplexer 111.

The mode adaptation/multiplexer 111 performs mode selection and processes such as multiplexing of one or more input streams supplied thereto, as needed, and supplies data obtained as a result to a padder 112.

The padder 112 performs necessary zero padding (insertion of Null) with respect to the data supplied from the mode adaptation/multiplexer 111 and supplies data obtained as a result to a BB scrambler 113.

The BB scrambler 113 performs base-band scrambling (BB scrambling) with respect to the data supplied from the padder 112 and supplies data obtained as a result to a BCH encoder 114.

The BCH encoder 114 performs BCH encoding with respect to the data supplied from the BB scrambler 113 and supplies data obtained as a result as LDPC target data to be an LDPC encoding target to an LDPC encoder 115.

The LDPC encoder 115 performs LDPC encoding according to a parity check matrix in which a parity matrix to be a portion corresponding to a parity bit of an LDPC code becomes a staircase structure with respect to the LDPC target data supplied from the BCH encoder 114, and outputs an LDPC code in which the LDPC target data is information bits.

That is, the LDPC encoder 115 performs the LDPC encoding to encode the LDPC target data with an LDPC such as the LDPC code (corresponding to the parity check matrix) defined in the predetermined standard of the DVB-S.2, the DVB-T.2, the DVB-C.2 or the like and outputs the predetermined LDPC code (corresponding to the parity check matrix) or the like obtained as a result.

The LDPC code defined in the standard of the DVB-S.2, the DVB-T.2, and the DVB-C.2 is an IRA (Irregular Repeat Accumulate) code and a parity matrix of the parity check matrix of the LDPC code becomes a staircase structure. The parity matrix and the staircase structure will be described later. The IRA code is described in "Irregular Repeat-Accumulate Codes", H. Jin, A. Khandekar, and R. J. McEliece, in Proceedings of 2nd International Symposium on Turbo codes and Related Topics, pp. 1-8, Sept. 2000, for example.

The LDPC code that is output by the LDPC encoder 115 is supplied to the bit interleaver 116.

The bit interleaver 116 performs bit interleave to be described later with respect to the LDPC code supplied from the LDPC encoder 115 and supplies the LDPC code after the bit interleave to a QAM encoder 117.

The QAM encoder 117 maps the LDPC code supplied from the bit interleaver 116 to a signal point representing one symbol of orthogonal modulation in a unit (symbol unit) of code bits of one or more bits of the LDPC code and performs the orthogonal modulation (multilevel modulation).

That is, the QAM encoder 117 performs maps the LDPC code supplied from the bit interleaver 116 to a signal point determined by a modulation method performing the orthogonal modulation of the LDPC code, on an IQ plane (IQ constellation) defined by an I axis representing an I component of the same phase as a carrier and a Q axis representing a Q component orthogonal to the carrier, and performs the orthogonal modulation.

In this case, as the modulation method of the orthogonal modulation performed by the QAM encoder 117, there are modulation methods including the modulation method defined in the standard of the DVB-S.2, the DVB-T.2, the DVB-C.2 or the like, and other modulation method, that is, BPSK (Binary Phase Shift Keying), QPSK (Quadrature Phase Shift Keying), 16APSK (Amplitude Phase-Shift Keying), 32APSK, 16QAM (Quadrature Amplitude Modulation), 64QAM, 256QAM, 1024QAM, 4096QAM, 4PAM (Pulse Amplitude Modulation), or the like. In the QAM encoder 117, to perform the orthogonal modulation based on which modulation method is previously set according to an operation of an operator of the transmitting device 11.

Data (symbol mapped to the signal point) that is obtained by processing in the QAM encoder 117 is supplied to the time interleaver 118.

The time interleaver 118 performs time interleave (interleave in a time direction) in a unit of symbol with respect to the data (symbol) supplied from the QAM encoder 117 and supplies data obtained as a result to an MISO/MIMO encoder (MISO/MIMO encoder) 119.

The MISO/MIMO encoder 119 performs spatiotemporal encoding with respect to the data (symbol) supplied from the time interleaver 118 and supplies the data to the frequency interleaver 120.

The frequency interleaver 120 performs frequency interleave (interleave in a frequency direction) in a unit of symbol with respect to the data (symbol) supplied from the MISO/MIMO encoder 119 and supplies the data to a frame builder/resource allocation unit 131.

On the other hand, for example, control data (signalling) for transfer control such as BB signaling (Base Band Signalling) (BB Header) is supplied to the BCH encoder 121.

The BCH encoder 121 performs the BCH encoding with respect to the signaling supplied thereto and supplies data obtained as a result to an LDPC encoder 122, similar to the BCH encoder 114.

The LDPC encoder 122 sets the data supplied from the BCH encoder 121 as LDPC target data, performs the LDPC encoding with respect to the data, and supplies an LDPC code obtained as a result to a QAM encoder 123, similar to the LDPC encoder 115.

The QAM encoder 123 maps the LDPC code supplied from the LDPC encoder 122 to a signal point representing one symbol of orthogonal modulation in a unit (symbol unit) of code bits of one or more bits of the LDPC code, performs the orthogonal modulation, and supplies data (symbol) obtained as a result to the frequency interleaver 124, similar to the QAM encoder 117.

The frequency interleaver 124 performs the frequency interleave in a unit of symbol with respect to the data (symbol) supplied from the QAM encoder 123 and supplies the data to the frame builder/resource allocation unit 131, similar to the frequency interleaver 120.

The frame builder/resource allocation unit 131 inserts symbols of pilots into necessary positions of the data (symbols) supplied from the frequency interleavers 120 and 124, configures a frame (for example, a physical layer (PL) frame, a T2 frame, a C2 frame, and so on) including symbols of a predetermined number from data (symbols) obtained as a result, and supplies the frame to an OFDM generating unit 132.

The OFDM generating unit 132 generates an OFDM signal corresponding to the frame from the frame supplied from the frame builder/resource allocation unit 131 and transmits the OFDM signal through the communication path 13 (FIG. 7).

Here, for example, the transmitting device 11 can be configured without including part of the blocks illustrated in FIG. 8 such as the time interleaver 118, the MISO/MIMO encoder 119, the frequency interleaver 120 and the frequency interleaver 124.

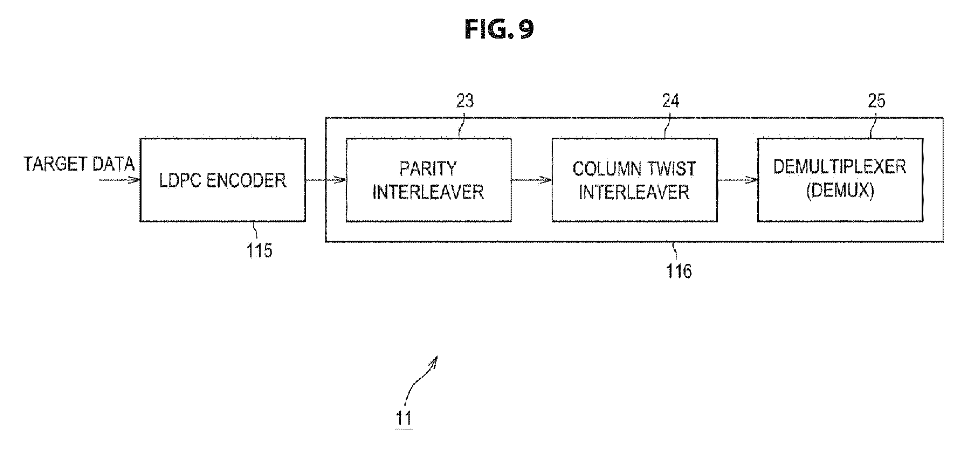

FIG. 9 illustrates a configuration example of the bit interleaver 116 of FIG. 8.

The bit interleaver 116 is a data processing device that interleaves data and includes the parity interleaver 23, the column twist interleaver 24, and a demultiplexer (DEMUX) 25. Here, the bit interleaver 116 can be configured without including one or both of the parity interleaver 23 and the column twist interleaver 24.

The parity interleaver 23 performs parity interleave for interleaving the parity bits of the LDPC code supplied from the LDPC encoder 115 into positions of other parity bits and supplies the LDPC code after the parity interleave to the column twist interleaver 24.

The column twist interleaver 24 performs the column twist interleave with respect to the LDPC code supplied from the parity interleaver 23 and supplies the LDPC code after the column twist interleave to the demultiplexer 25.

That is, in the QAM encoder 117 of FIG. 8, the code bits of one or more bits of the LDPC code are mapped to the signal point representing one symbol of the orthogonal modulation and are transmitted.

In the column twist interleaver 24, the column twist interleave to be described later is performed as rearrangement processing for rearranging the code bits of the LDPC code supplied from the parity interleaver 23, such that a plurality of code bits of the LDPC code corresponding to 1 in any one row of the parity check matrix used by the LDPC encoder 115 are not included in one symbol.

The demultiplexer 25 executes interchange processing for interchanging positions of two or more code bits of the LDPC code becoming the symbol, with respect to the LDPC code supplied from the column twist interleaver 24, and obtains an LDPC code in which tolerance against the AWGN is reinforced. In addition, the demultiplexer 25 supplies two or more code bits of the LDPC code obtained by the interchange processing as the symbol to the QAM encoder 117 (FIG. 8).

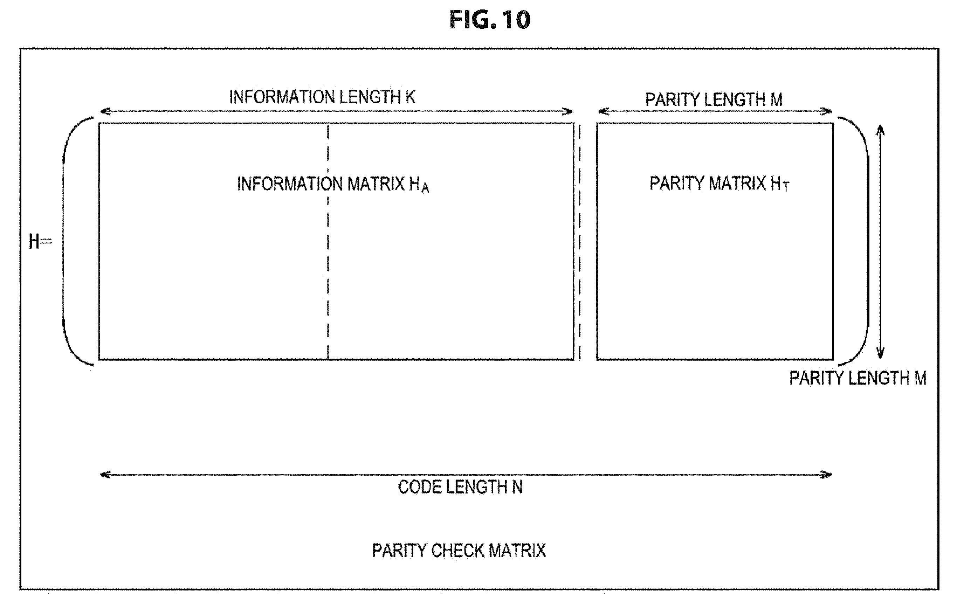

Next, FIG. 10 illustrates the parity check matrix H that is used for LDPC encoding by the LDPC encoder 115 of FIG. 8.

The parity check matrix H becomes an LDGM (Low-Density Generation Matrix) structure and can be represented by an expression $H = [H_A | H_T]$ (a matrix in which elements of the information matrix $H_A$ are set to left elements and elements of the parity matrix $H_T$ are set to right elements), using an information matrix $H_A$ of a portion corresponding to information bits among the code bits of the LDPC code and a parity matrix $H_T$ corresponding to the parity bits.

In this case, a bit number of the information bits among the code bits of one LDPC code (one code word) and a bit number of the parity bits are referred to as an information length K and a parity length M, respectively, and a bit number of the code bits of one LDPC code is referred to as a code length N (= K + M).

The information length K and the parity length M of the LDPC code having the certain code length N are determined by an encoding rate. The parity check matrix H becomes a matrix in which row × column is M × N. The information matrix $H_A$ becomes a matrix of M × K and the parity matrix $H_T$ becomes a matrix of M × M.

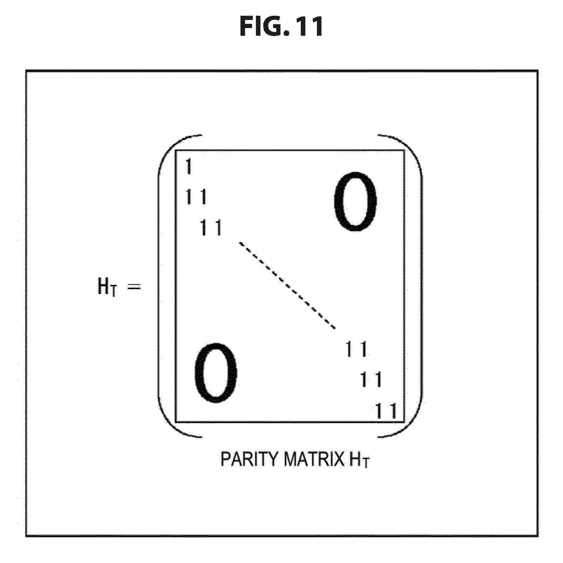

FIG. 11 illustrates the parity matrix $H_T$ of the parity check matrix H of the LDPC code that is defined in the standard of the DVB-S.2, the DVB-T.2, and the DVB-C.2.

The parity matrix $H_T$ of the parity check matrix H of the LDPC code that is defined in the standard of the DVB-T.2 or the like becomes a staircase structure matrix (lower bidagonal matrix) in which elements of 1 are arranged in a staircase shape, as illustrated in FIG. 11. The row weight of the parity matrix $H_T$ becomes 1 with respect to the first row and becomes 2 with respect to the remaining rows. The column weight becomes 1 with respect to the final column and becomes 2 with respect to the remaining columns.

As described above, the LDPC code of the parity check matrix H in which the parity matrix $H_T$ becomes the staircase structure can be easily generated using the parity check matrix H.

That is, the LDPC code (one code word) is represented by a row vector c and a column vector obtained by transposing the row vector is represented by $C^T$. In addition, a portion of information bits of the row vector c to be the LDPC code is represented by a row vector A and a portion of the parity bits is represented by a row vector T.

The row vector c can be represented by an expression c = [A|T] (a row vector in which elements of the row vector A are set to left elements and elements of the row vector T are set to right elements), using the row vector A corresponding to the information bits and the row vector T corresponding to the parity bits.

In the parity check matrix H and the row vector c = [A|T] corresponding to the LDPC code, it is necessary to satisfy an expression $Hc^T = 0$. The row vector T that corresponds to the parity bits constituting the row vector c = [A|T] satisfying the expression $Hc^T = 0$ can be sequentially calculated by setting elements of each row to 0, sequentially (in order) from elements of a first row of the column vector $Hc^T$ in the expression $Hc^T = 0$, when the parity matrix $H_T$ of the parity check matrix H = [$H_A$ |$H_T$] becomes the staircase structure illustrated in FIG. 11.

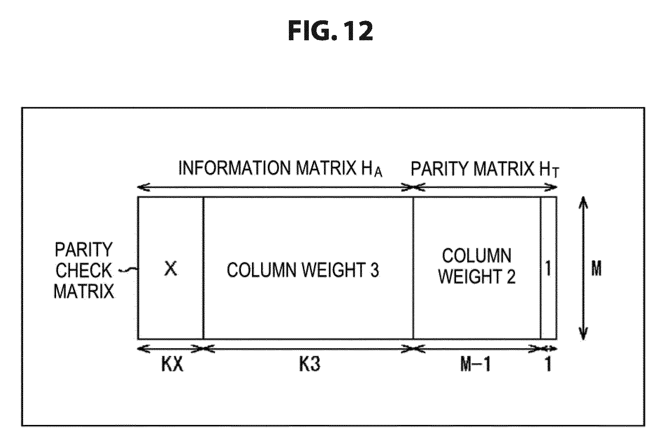

FIG. 12 is an illustration of the parity check matrix H of the LDPC code that is defined in the standard of the DVB-T.2 or the like.

The column weight becomes X with respect KX columns from a first column of the parity check matrix H of the LDPC code defined in the standard of the DVB-T.2 or the like, becomes 3 with respect to the following K3 columns, becomes 2 with respect to the following (M-1) columns, and becomes 1 with respect to a final column.

In this case, KX + K3 + M - 1 + 1 is equal to the code length N.

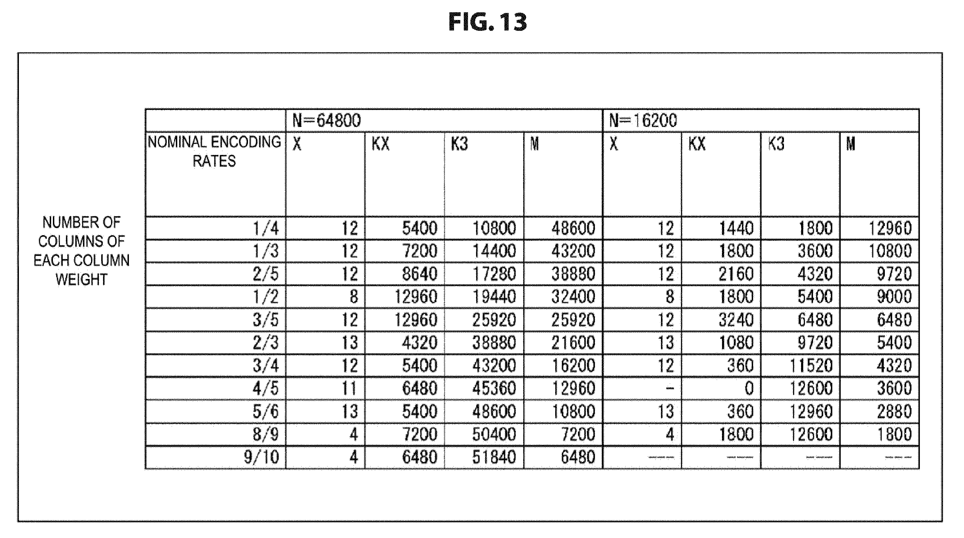

FIG. 13 is an illustration of column numbers KX, K3, and M and a column weight X, with respect to each encoding rate r of the LDPC code defined in the standard of the DVB-T.2 or the like.

In the standard of the DVB-T.2 or the like, LDPC codes that have code lengths N of 64800 bits and 16200 bits are defined.

With respect to the LDPC code having the code length N of 64800 bits, 11 encoding rates (nominal rates) of 1/4, 1/3, 2/5, 1/2, 3/5, 2/3, 3/4, 4/5, 5/6, 8/9, and 9/10 are defined. With respect to the LDPC code having the code length N of 16200 bits, 10 encoding rates of 1/4, 1/3, 2/5, 1/2, 3/5, 2/3, 3/4, 4/5, 5/6, and 8/9 are defined.

Hereinafter, the code length N of the 64800 bits is referred to as 64 kbits and the code length N of the 16200 is referred to as 16 kbits.

With respect to the LDPC code, it is known that an error rate is low in a code bit corresponding to a column of which a column weight of the parity check matrix H is large.

In the parity check matrix H that is illustrated in FIGS. 12 and 13 and is defined in the standard of the DVB-T.2 or the like, a column weight of a column of a head side (left side) tends to be large. Therefore, with respect to the LDPC code corresponding to the parity check matrix H, a code bit of a head side tends to be strong for error (there is tolerance against the error) and a code bit of an ending side tends to be weak for the error.

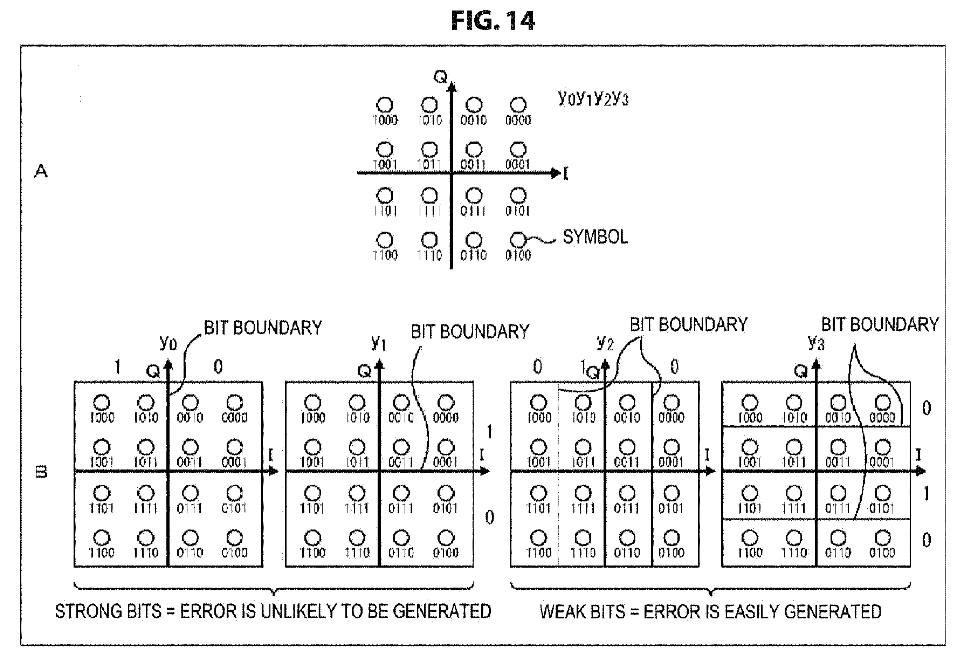

Next, FIG. 14 illustrates an arrangement example of (signal points corresponding to) 16 symbols on an IQ plane, when 16QAM is performed by the QAM encoder 117 of FIG. 8.

That is, A of FIG. 14 illustrates symbols of the 16QAM of the DVB-T.2.

In the 16QAM, one symbol is represented by 4 bits and 16 symbols (= $2^4$) exist. The 16 symbols are arranged such that an I direction × a Q direction becomes a 4 x 4 square shape, on the basis of an original point of the IQ plane.

If an (i + 1)-th bit from a most significant bit of a bit string represented by one symbol is represented as a bit $y_i$, the 4 bits represented by one symbol of the 16QAM are can be represented as bits $y_0$, $y_1$, $y_2$, and $y_3$, respectively, sequentially from the most significant bit. When a modulation method is the 16QAM, 4 bits of code bits of the LDPC code become a symbol (symbol value) of 4 bits $y_0$ to $y_3$ (symbolized).

B of FIG. 14 illustrates a bit boundary with respect to each of the 4 bits (hereinafter, referred to as symbol bits)

$y_0$ to $y_3$ represented by the symbol of the 16QAM.

In this case, a bit boundary with respect to the symbol bit $y_i$ (in FIG. 14, i = 0, 1,2, and 3) means a boundary of a symbol of which a symbol bit $y_i$ becomes 0 and a symbol of which a symbol bit $y_i$ becomes 1.

As illustrated by B of FIG. 14, only one place of the Q axis of the IQ plane becomes a bit boundary with respect to the most significant symbol bit $y_0$ of the 4 symbol bits $y_0$ to $y_3$ represented by the symbol of the 16QAM and only one place of the I axis of the IQ plane becomes a bit boundary with respect to the second (second from the most significant bit) symbol bit $y_i$.

With respect to the third symbol bit $y_2$, two places of a place between first and second columns from the left side and a place between third and four columns, among the 4 × 4 symbols, become bit boundaries.

With respect to the fourth symbol bit $y_3$, two places of a place between first and second rows from the upper side and a place between third and four rows, among the 4 × 4 symbols, become bit boundaries.

In the symbol bits $y_i$ that are represented by the symbols, when the number of symbols apart from the bit boundaries is large, the error is difficult to be generated (the error probability is low) and when the number of symbols close to the bit boundaries is large, the error is easily generated (the error probability is high).

If the bits (strong for the error) in which the error is difficult to be generated are referred to as "strong bits" and the bits (weak for the error) in which the error is easily generated are referred to as "weak bits", with respect to the 4 symbol bits $y_0$ to $y_3$ of the symbol of the 16QAM, the most significant symbol bit $y_0$ and the second symbol bit $y_1$ become the strong bits and the third symbol bit $y_2$ and the fourth symbol bit $y_3$ become the weak bits.

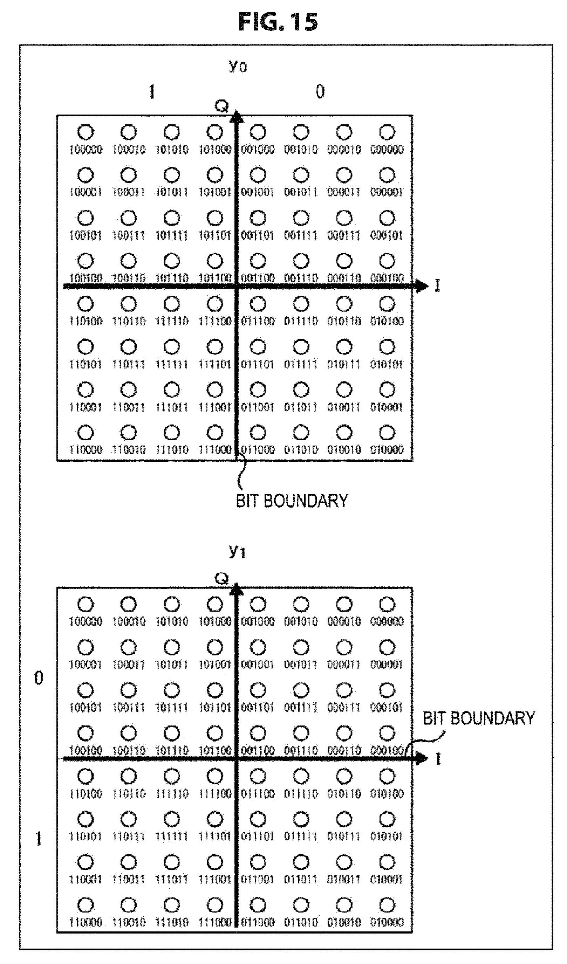

FIGS. 15 to 17 illustrate an arrangement example of (signal points corresponding to) 64 symbols on an IQ plane, that is, symbols of the 16QAM of the DVB-T.2, when the 64QAM is performed by the QAM encoder 117 of FIG. 8.

In the 64QAM, one symbol represents 6 bits and 64 symbols (= $2^6$) exist. The 64 symbols are arranged such that an I direction × a Q direction becomes an 8 × 8 square shape, on the basis of an original point of the IQ plane.

The symbol bits of one symbol of the 64QAM can be represented as $y_0$, $y_1$, $y_2$, $y_3$, $y_4$, and $y_5$, sequentially from the most significant bit. When the modulation method is the 64QAM, 6 bits of code bits of the LDPC code become a symbol of symbol bits $y_0$ to $y_5$ of 6 bits.

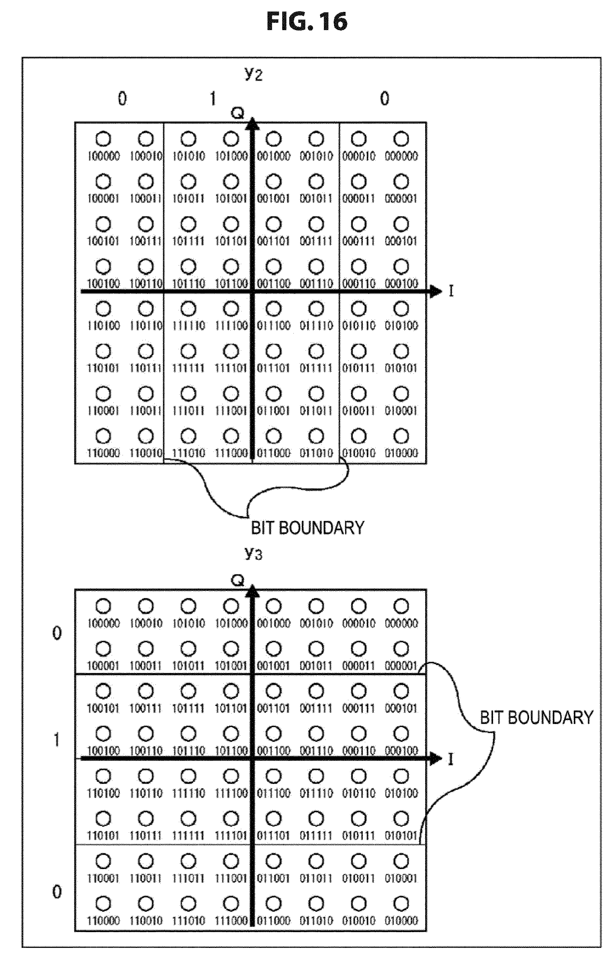

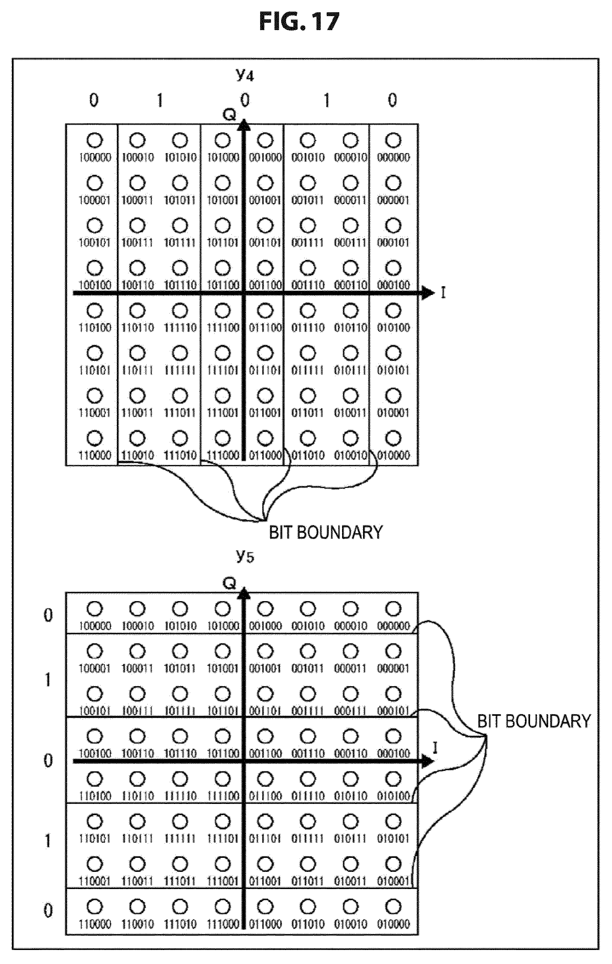

In this case, FIG. 15 illustrates a bit boundary with respect to each of the most significant symbol bit $y_0$ and the second symbol bit $y_1$ among the symbol bits $y_0$ to $y_5$ of the symbol of the 64QAM, FIG. 16 illustrates a bit boundary with respect to each of the third symbol bit $y_2$ and the fourth symbol bit $y_3$, and FIG. 17 illustrates a bit boundary with respect to each of the fifth symbol bit $y_4$ and the sixth symbol bit $y_5$.

As illustrated in FIG. 15, the bit boundary with respect to each of the most significant symbol bit $y_0$ and the second symbol bit $y_1$ becomes one place. As illustrated in FIG. 16, the bit boundaries with respect to each of the third symbol bit $y_2$ and the fourth symbol bit $y_3$ become two places. As illustrated in FIG. 17, the bit boundaries with respect to each of the fifth symbol bit $y_4$ and the sixth symbol bit $y_5$ become four places.

Therefore, with respect to the symbol bits $y_0$ to $y_5$ of the symbol of the 64QAM, the most significant symbol bit $y_0$ and the second symbol bit $y_1$ become strong bits and the third symbol bit $y_2$ and the fourth symbol bit $y_3$ become next strong bits. In addition, the fifth symbol bit $y_4$ and the sixth symbol bit $y_5$ become weak bits.

From FIGS. 14 and 15 to 17, it can be known that, with respect to the symbol bits of the symbol of the orthogonal modulation, the upper bits tend to become the strong bits and the lower bits tend to become the weak bits.

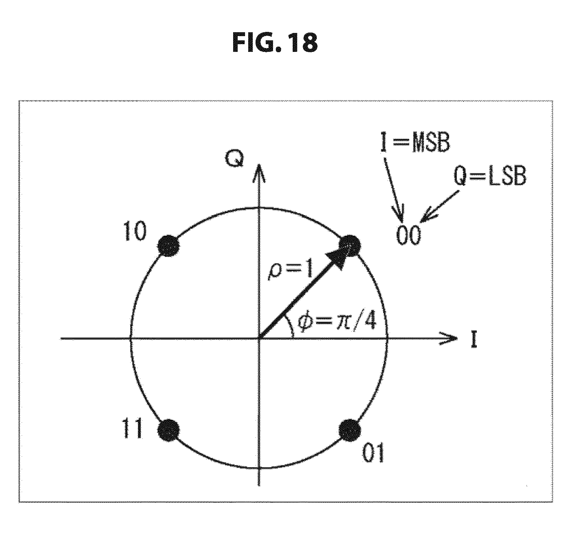

FIG. 18 is an illustration of an example of arrangement on the IQ plane of (signal points corresponding to) 4 symbols in a case where a satellite circuit is adopted as the communication path 13 (FIG. 7) and QPSK is performed in the QAM encoder 117 of FIG. 8, that is, for example, an illustration of symbols of QPSK of DVB-S.2.

In QPSK of DVB-S.2, a symbol is mapped on any of 4 signal points on the circumference of a circle whose radius centering on the origin of the IQ plane is p.

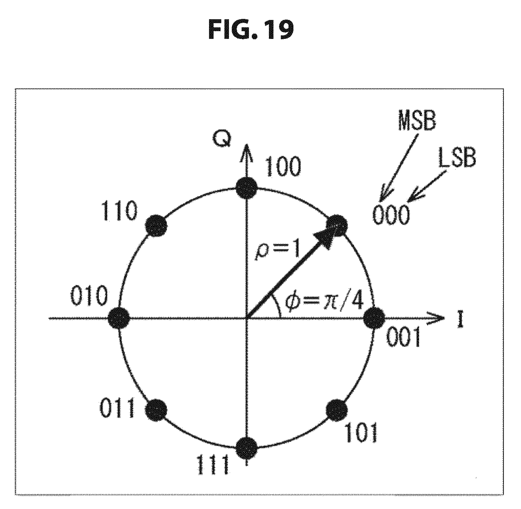

FIG. 19 is an illustration of an example of arrangement on the IQ plane of 8 symbols in a case where a satellite circuit is adopted as the communication path 13 (FIG. 7) and 8PSK is performed in the QAM encoder 117 of FIG. 8, that is, for example, an illustration of symbols of 8PSK of DVB-S.2.

In 8PSK of DVB-S.2, a symbol is mapped on any of 8 signal points on the circumference of a circle whose radius centering on the origin of the IQ plane is p.

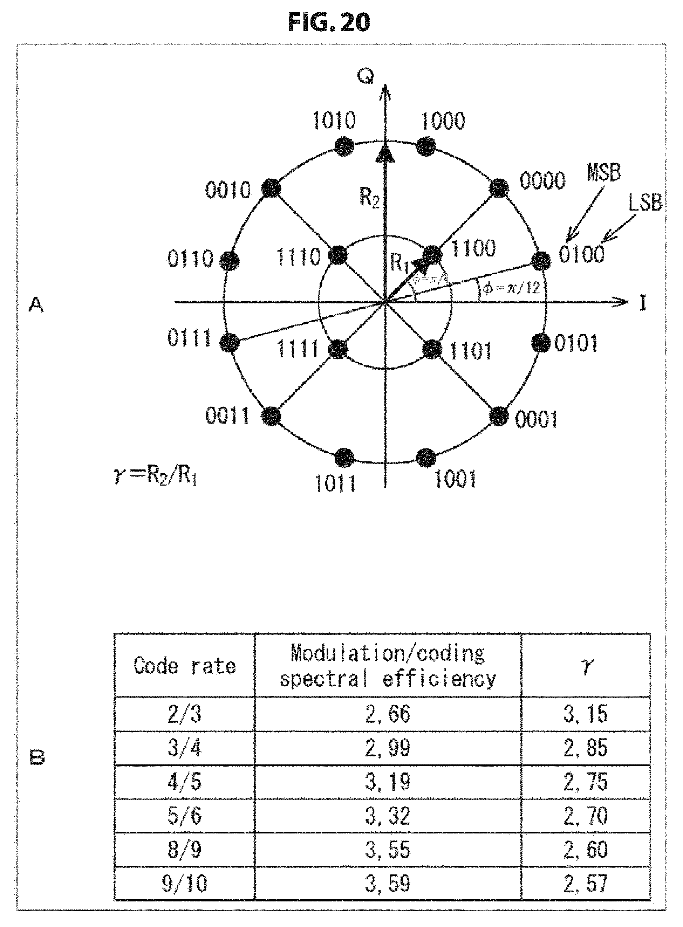

FIG. 20 is an example of arrangement on the IQ plane of 16 symbols in a case where a satellite circuit is adopted as the communication path 13 (FIG. 7) and 16APSK is performed in the QAM encoder 117 of FIG. 8, that is, for example, an illustration of symbols of 16APSK of DVB-S.2.

A of FIG. 20 illustrates the arrangement of signal points of 16APSK of DVB-S.2.

In 16APSK of DVB-S.2, a symbol is mapped on any of totally 16 signal points of 4 signal points on the circumference of a circle whose radius centering on the origin of the IQ plane is $R_1$ and 12 signal points on the circumference of a circle whose radius is $R_2(>R_1)$.

B of FIG. 20 illustrates $\gamma=R_2/R_1$ which is the ratio of radiuses $R_2$ and $R_1$ in the arrangement of signal points of 16APSK of DVB-S.2.

In the arrangement of signal points of 16APSK of DVB-S.2, ratio $\gamma$ of radiuses $R_2$ and $R_1$ varies depending on

each encoding rate.

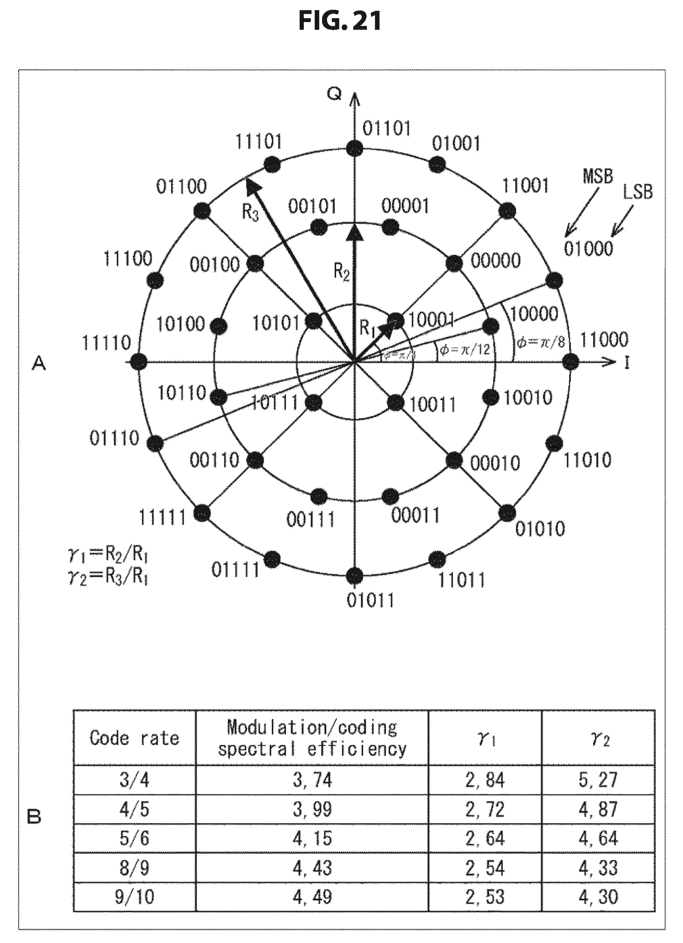

FIG. 21 is an example of arrangement on the IQ plane of 32 symbols in a case where a satellite circuit is adopted as the communication path 13 (FIG. 7) and 32APSK is performed in the QAM encoder 117 of FIG. 8, that is, for example, an illustration of symbols of 32APSK of DVB-S.2.

A of FIG. 21 illustrates the arrangement of signal points of 32APSK of DVB-S.2.

In 32APSK of DVB-S.2, a symbol is mapped on any of totally 32 signal points of 4 signal points on the circumference of a circle whose radius centering on the origin of the IQ plane is $R_1$, 12 signal points on the circumference of a circle whose radius is $R_2$ ($>R_1$) and 16 signal points on the circumference of a circle whose radius is $R_3$ ($>R_2$).

B of FIG. 21 illustrates $\gamma_1=R_2/R_1$ which is the ratio of radiuses $R_2$ and $R_1$ in the arrangement of signal points of 32APSK of DVB-S.2 and $\gamma_2=R_3/R_1$ which is the ratio of radiuses $R_3$ and $R_1$.

In the arrangement of signal points of 32APSK of DVB-S.2, ratio $\gamma_1$ of radiuses $R_2$ and $R_1$ and ratio $\gamma_2$ of radiuses $R_3$ and $R_1$ vary depending on each encoding rate.

Even for symbol bits of the symbols of each quadrature modulation (QPSK, 8PSK, 16APSK and 32APSK) of DVB-S.2 illustrating the arrangement of signal points in FIG. 18 to FIG. 21, similar to the cases of FIG. 14 to FIG. 17, there are strong bits and weak bits.

As described in FIGS. 12 and 13, with respect to the LDPC code output by the LDPC encoder 115 (FIG. 8), code bits strong for the error and code bits weak for the error exist.

As described in FIGS. 14 to 21, with respect to the symbol bits of the symbol of the orthogonal modulation performed by the QAM encoder 117, the strong bits and the weak bits exist.

Therefore, if the code bits of the LDPC code strong for the error are allocated to the weak symbol bits of the symbol of the orthogonal modulation, tolerance against the error is lowered as a whole.

Therefore, an interleaver that interleaves the code bits of the LDPC code in such a manner that the code bits of the LDPC code weak for the error are allocated to the strong bits (symbol bits) of the symbol of the orthogonal modulation is suggested.

The demultiplexer 25 of FIG. 9 can execute processing of the interleaver.

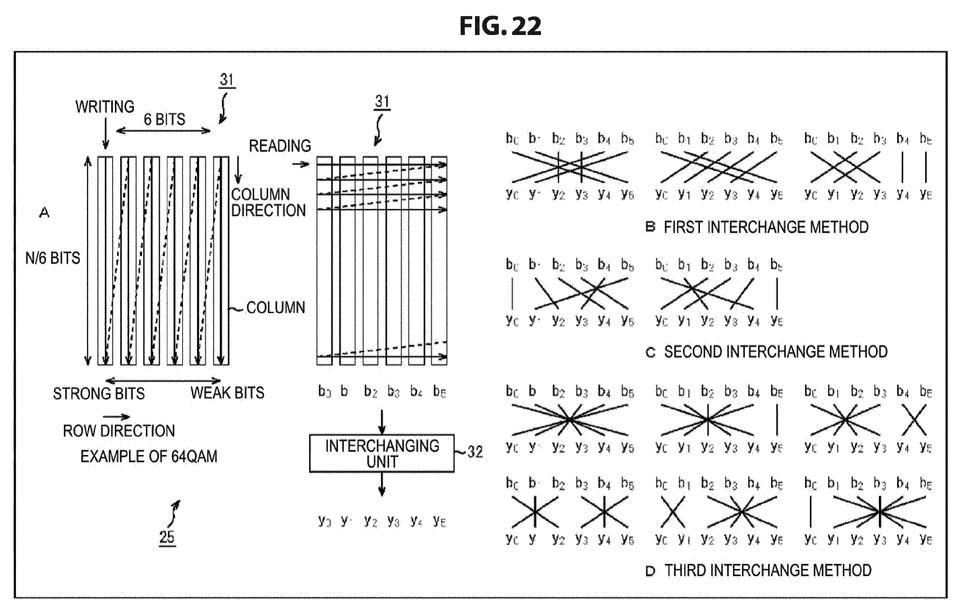

FIG. 22 is an illustration of processing of the demultiplexer 25 of FIG. 9.

That is, A of FIG. 18 illustrates a functional configuration example of the demultiplexer 25.

The demultiplexer 25 includes a memory 31 and an interchanging unit 32.

An LDPC code is supplied from the LDPC encoder 115 to the memory 31.

The memory 31 has a storage capacity to store mb bits in a row (transverse) direction and store N/(mb) bits in a column (longitudinal) direction. The memory 31 writes code bits of the LDPC code supplied thereto in the column direction, reads the code bits in the row direction, and supplies the code bits to the interchanging unit 32.

In this case, N (= information length K + parity length M) represents a code length of the LDPC code, as described above.

In addition, m represents a bit number of the code bits of the LDPC code that becomes one symbol and b represents a multiple that is a predetermined positive integer and is used to perform integral multiplication of m. As described above, the demultiplexer 25 symbolizes the code bits of the LDPC code. However, the multiple b represents the number of symbols obtained by one-time symbolization of the demultiplexer 25.

A of FIG. 22 illustrates a configuration example of the demultiplexer 25 in a case where a modulation method is 64QAM or the like in which mapping is performed on any of 64 signal points, and therefore bit number m of the code bits of the LDPC code becoming one symbol is 6 bits.

In A of FIG. 22, the multiple b becomes 1. Therefore, the memory 31 has a storage capacity in which a column direction $\times$ a row direction is $N/(6 \times 1) \times (6 \times 1)$ bits.

In this case, a storage region of the memory 31 in which the row direction is 1 bit and which extends in the column direction is appropriately referred to as a column hereinafter. In A of FIG. 22, the memory 31 includes 6 (=6 $\times$ 1) columns.

In the demultiplexer 25, writing of the code bits of the LDPC code in a downward direction (column direction) from the upper side of the columns constituting the memory 31 is performed toward the columns of a rightward direction from the left side.

If writing of the code bits ends to the bottom of the rightmost column, the code bits are read in a unit of 6 bits (mb bits) in the row direction from a first row of all the columns constituting the memory 31 and are supplied to the interchanging unit 32.

The interchanging unit 32 executes interchange processing for interchanging positions of the code bits of the 6 bits from the memory 31 and outputs 6 bits obtained as a result as 6 symbol bits $y_0$, $y_1$, $y_2$, $y_3$, $y_4$, and $y_5$ representing one symbol of the 64QAM.

That is, the code bits of the mb bits (in this case, 6 bits) are read from the memory 31 in the row direction. However, if the i-th (i = 0, 1, $\cdots$, and mb - 1) bit from the most significant bit, of the code bits of the mb bits read from the memory 31, is represented as a bit $b_i$, the code bits of the 6 bits that are read from the memory 31 in the row direction can be represented as bits $b_0$, $b_1$, $b_2$, $b_3$, $b_4$, and $b_5$, sequentially from the most significant bit.

With the relation of the column weights described in FIGS. 12 and 13, the code bit in a direction of the bit $b_0$ becomes a code bit strong for the error and the code bit in a direction of the bit $b_5$ becomes a code bit weak for the error.

In the interchanging unit 32, interchange processing for interchanging the positions of the code bits $b_0$ to $b_5$ of the 6 bits from the memory 31, such that the code bits weak for the error among the code bits $b_0$ to $b_5$ of the 6 bits from the memory 31 are allocated to the strong bits among the symbol bits $y_0$ to $y_5$ of one symbol of the 64QAM, can be executed.

In this case, as interchange methods for interchanging the code bits $b_0$ to $b_5$ of the 6 bits from the memory 31 and allocating the code bits $b_0$ to $b_5$ of the 6 bits to the 6 symbol bits $y_0$ to $y_5$ representing one symbol of the 64QAM, various methods are suggested from individual companies.

B of FIG. 22 illustrates a first interchange method, C of FIG. 22 illustrates a second interchange method, and D of FIG. 22 illustrates a third interchange method.

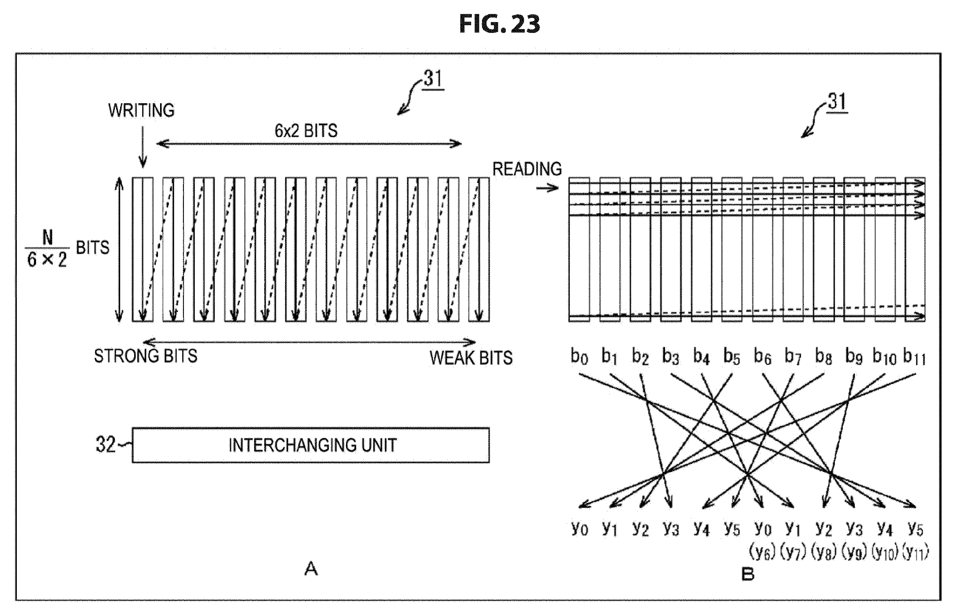

In B of FIG. 22 to D of FIG. 22 (and FIG. 23 to be described later), a line segment coupling the bits $b_i$ and $y_j$ means that the code bit $b_i$ is allocated to the symbol bit $y_j$ of the symbol (interchanged with a position of the symbol bit $y_j$).

As the first interchange method of B of FIG. 22, to adopt any one of three kinds of interchange methods is suggested. As the second interchange method of C of FIG. 22, to adopt any one of two kinds of interchange methods is suggested.

As the third interchange method of D of FIG. 22, to sequentially select six kinds of interchange methods and use the interchange method is suggested.

FIG. 23 illustrates a configuration example of the demultiplexer 25 in a case where a modulation method is 64QAM or the like in which mapping is performed on any of 64 signal points (therefore, bit number m of the code bits of the LDPC code mapped on one symbol is 6 bits as well as FIG. 22) and multiple b is 2, and the fourth interchange method.

When the multiple b is 2, the memory 31 has a storage capacity in which a column direction $\times$ a row direction is $N/(6 \times 2) \times (6 \times 2)$ bits and includes 12 (= $6 \times 2$) columns.

A of FIG. 23 illustrates a sequence of writing the LDPC code to the memory 31.

In the demultiplexer 25, as described in FIG. 22, writing of the code bits of the LDPC code in a downward direction (column direction) from the upper side of the columns constituting the memory 31 is performed toward the columns of a rightward direction from the left side.

If writing of the code bits ends to the bottom of the rightmost column, the code bits are read in a unit of 12 bits (mb bits) in the row direction from a first row of all the columns constituting the memory 31 and are supplied to the interchanging unit 32.

The interchanging unit 32 executes interchange processing for interchanging positions of the code bits of the 12 bits from the memory 31 using the fourth interchange method and outputs 12 bits obtained as a result as 12 bits representing two symbols (b symbols) of the 64QAM, that is, six symbol bits y0, $y_1$, $y_2$, $y_3$, $y_4$, and $y_5$ representing one symbol of the 64QAM and six symbol bits $y_0$, $y_1$, $y_2$, $y_3$, $y_4$, and $y_5$ representing a next one symbol.

In this case, B of FIG. 23 illustrates the fourth interchange method of the interchange processing by the interchanging unit 32 of A of FIG. 23.

When the multiple b is 2 (or 3 or more), in the interchange processing, the code bits of the mb bits are allocated to the symbol bits of the mb bits of the b consecutive symbols. In the following explanation including the explanation of FIG. 23, the (i + 1)-th bit from the most significant bit of the symbol bits of the mb bits of the b consecutive symbols is represented as a bit (symbol bit) $y_i$, for the convenience of explanation.

What kind of code bits are appropriate to be interchanged, that is, the improvement of the error rate in the AWGN communication path is different according to the encoding rate or the code length of the LDPC code and the modulation method.

[Parity interleave]

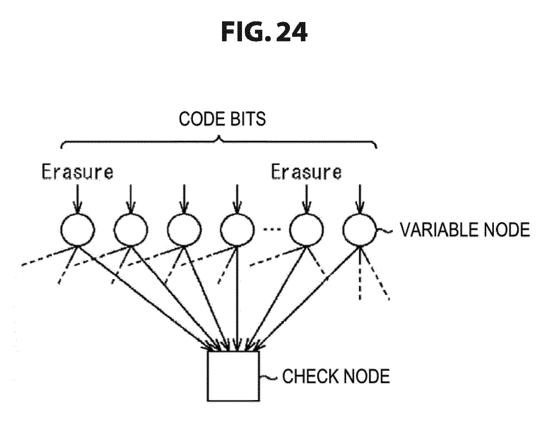

Next, the parity interleave by the parity interleaver 23 of FIG. 9 will be described with reference to FIGS. 24 to 26.

FIG. 24 illustrates (a part of) a Tanner graph of the parity check matrix of the LDPC code.

As illustrated in FIG. 24, if a plurality of, for example, two variable nodes among (the code bits corresponding to) the variable nodes connected to the check node simultaneously become the error such as the erasure, the check node returns a message in which the probability of a value being 0 and the probability of a value being 1 are equal to each other, to all the variable nodes connected to the check node. For this reason, if the plurality of variable nodes connected to the same check node simultaneously become the erasure, decoding performance is deteriorated.

Meanwhile, the LDPC code that is output by the LDPC encoder 115 of FIG. 8 and is defined in the standard of the DVB-S.2 or the like is an IRA code and the parity matrix $H_T$ of the parity check matrix H becomes a staircase structure, as illustrated in FIG. 11.

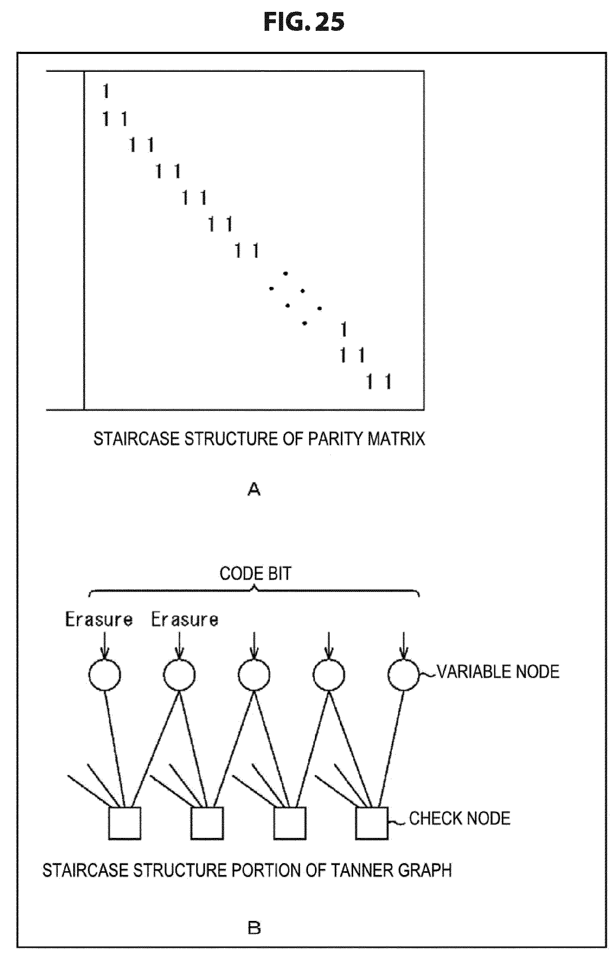

FIG. 25 illustrates the parity matrix $H_T$ becoming the staircase structure and a Tanner graph corresponding to the parity matrix $H_T$.

That is, A of FIG. 25 illustrates the parity matrix HT becoming the staircase structure and B of FIG. 25 illustrates the Tanner graph corresponding to the parity matrix HT of A of FIG. 25.

In the parity matrix $H_T$ with a staircase structure, elements of 1 are adjacent in each row (excluding the first row). Therefore, in the Tanner graph of the parity matrix $H_T$, two adjacent variable nodes corresponding to a column of two adjacent elements in which the value of the parity matrix $H_T$ is 1 are connected with the same check node.

Therefore, when parity bits corresponding to two above-mentioned adjacent variable nodes become errors at the same time by burst error and erasure, and so on, the check node connected with two variable nodes (variable nodes to find a message by the use of parity bits) corresponding to those two parity bits that became errors returns message that the probability with a value of 0 and the probability with a value of 1 are equal probability, to the variable nodes connected with the check node, and therefore the performance of decoding is deteriorated. Further, when the burst length (bit number of parity bits that continuously become errors) becomes large, the number of check nodes that return the message of equal probability increases and the performance of decoding is further deteriorated.

Therefore, the parity interleaver 23 (FIG. 9) performs the parity interleave for interleaving the parity bits of the LDPC code from the LDPC encoder 115 into positions of other parity bits, to prevent the decoding performance from being deteriorated.

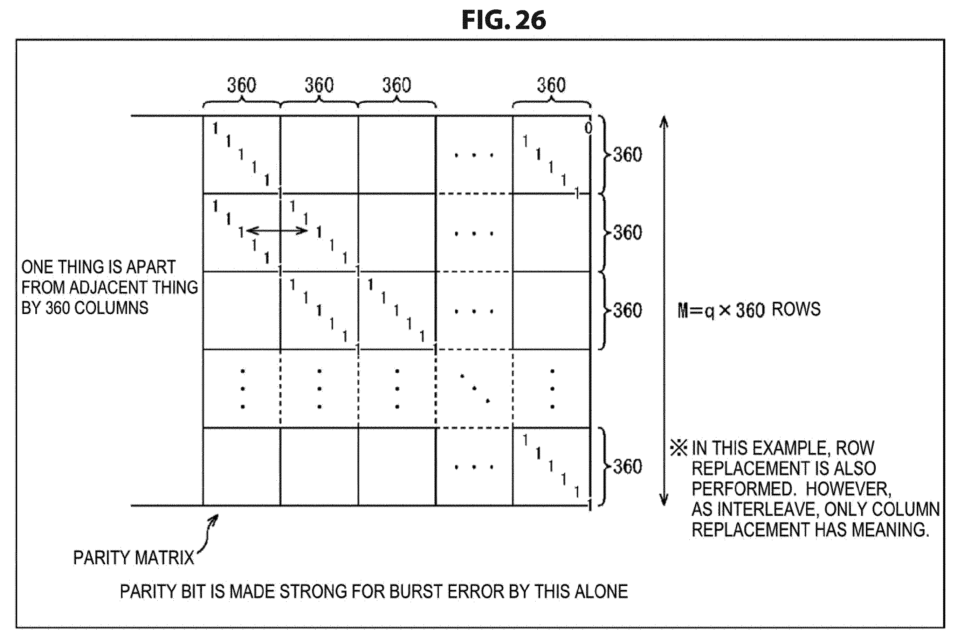

FIG. 26 illustrates the parity matrix $H_T$ of the parity check matrix H corresponding to the LDPC code after the parity interleave performed by the parity interleaver 23 of FIG. 9.

In this case, the information matrix $H_A$ of the parity check matrix H corresponding to the LDPC code that is output by the LDPC encoder 115 and is defined in the standard of the DVB-S.2 or the like becomes a cyclic structure.

The cyclic structure means a structure in which a certain column is matched with a column obtained by cyclically shifting another column. For example, the cyclic structure includes a structure in which a position of 1 of each row of P columns becomes a position obtained by cyclically shifting a first column of the P columns in a column direction by a value proportional to a value q obtained by dividing a parity length M, for every P columns. Hereinafter, the P columns in the cyclic structure are appropriately referred to as a column number of a unit of the cyclic structure.

As an LDPC code defined in a standard such as DVB-S.2, as described in FIG. 12 and FIG. 13, there are two kinds of LDPC codes whose code length N is 64800 bits and 16200 bits, and, for both of those two kinds of LDPC codes, the column number P which is a unit of a cyclic structure is defined as 360 which is one of divisors excluding 1 and M among the divisors of the parity length M.

The parity length M becomes a value other than primes represented by an expression $M = q \times P = q \times 360$, using a value q different according to the encoding rate. Therefore, similar to the column number P of the unit of the cyclic structure, the value q is one other than 1 and M among the divisors of the parity length M and is obtained by dividing the parity length M by the column number P of the unit of the cyclic structure (the product of P and q to be the divisors of the parity length M becomes the parity length M).

As described above, when information length is assumed to be K, an integer equal to or greater than 0 and less than P is assumed to be x and an integer equal to or greater than 0 and less than q is assumed to be y, the parity interleaver 23 interleaves the K+qx+y+1-th code bit among code bits of an LDPC code of N bits to the position of the K+Py+x+1-th code bit as parity interleave.

Since both of the K+qx+y+1-th code bit and the K+Py+x+1-th code bit are code bits after the K+1-th one, they are parity bits, and therefore the positions of the parity bits of the LDPC code are moved according to the parity interleave.

According to the parity interleave, (the parity bits corresponding to) the variable nodes connected to the same check node are separated by the column number P of the unit of the cyclic structure, that is, 360 bits in this case. For this reason, when the burst length is less than 360 bits, the plurality of variable nodes connected to the same check node can be prevented from simultaneously becoming the error. As a result, tolerance against the burst error can be improved.

The LDPC code after the interleave for interleaving the (K + qx + y + 1)-th code bit into the position of the (K + Py + x + 1)-th code bit is matched with an LDPC code of a parity check matrix (hereinafter, referred to as a transformed parity check matrix) obtained by performing column replacement for replacing the (K + qx + y+ 1)-th column of the original parity check matrix H with the (K + Py + x + 1)-th column.

In the parity matrix of the transformed parity check matrix, as illustrated in FIG. 26, a pseudo cyclic structure that uses the P columns (in FIG. 26, 360 columns) as a unit appears.

In this case, the pseudo cyclic structure means a structure in which a cyclic structure is formed except for a part thereof. The transformed parity check matrix that is obtained by performing the column replacement corresponding to the parity interleave with respect to the parity check matrix of the LDPC code defined in the standard of the DVB-S.2 or the like becomes the pseudo cyclic structure, not the (perfect) cyclic structure, because the number of elements of 1 is less than 1 (elements of 0 exist) in a portion (shifted matrix to be described later) of 360 rows $\times$ 360 columns of a right corner portion thereof.

The transformed parity check matrix of FIG. 26 becomes a matrix that is obtained by performing the column replacement corresponding to the parity interleave and replacement (row replacement) of a row to configure the transformed parity check matrix with a constitutive matrix to be described later, with respect to the original parity check matrix H.

[Column twist interleave]

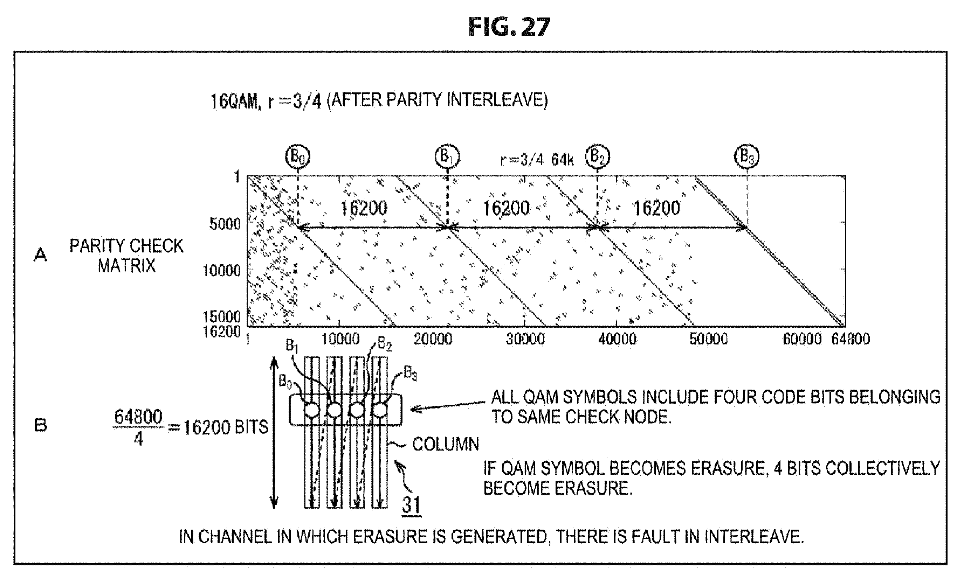

Next, column twist interleave corresponding to rearrangement processing by the column twist interleaver 24 of FIG. 9 will be described with reference to FIGS. 27 to 30.

In the transmitting device 11 of FIG. 8, one or more bits of the code bits of the LDPC code are transmitted as one symbol. That is, when two bits of the code bits are set as one symbol, the QPSK is used as the modulation method and when four bits of the code bits are set as one symbol, the APSK or the 16QAM is used as the modulation method.

As such, when the two or more bits of the code bits are transmitted as one symbol, if the erasure is generated in a certain symbol, all of the code bits of the symbol become the error (erasure).

Therefore, it is necessary to prevent the variable nodes corresponding to the code bits of one symbol from being connected to the same check node, in order to decrease the probability of (the code bits corresponding to) the plurality of variable nodes connected to the same check node simultaneously becoming the erasure to improve the decoding performance.

Meanwhile, as described above, in the parity check matrix H of the LDPC code that is output by the LDPC encoder 115 and is defined in the standard of the DVB-S.2 or the like, the information matrix $H_A$ has the cyclic structure and the parity matrix $H_T$ has the staircase structure. As described in FIG. 26, in the transformed parity check matrix to be the parity check matrix of the LDPC code after the parity interleave, the cyclic structure (in fact, the pseudo cyclic structure as described above) appears in the parity matrix.

FIG. 27 illustrates a transformed parity check matrix.

That is, A of FIG. 27 illustrates a transformed parity check matrix of a parity check matrix H of an LDPC code in which a code length N is 64800 bits and an encoding rate (r) is 3/4.

In A of FIG. 27, in the transformed parity check matrix, a position of an element of which a value becomes 1 is shown by a point (·).

B of FIG. 27 illustrates processing executed by the demultiplexer 25 (FIG. 9), with respect to the LDPC code of the transformed parity check matrix of A of FIG. 27, that is, the LDPC code after the parity interleave.

In B of FIG. 27, with an assumption that a modulation method is a method in which a symbol is mapped on any of 16 signal points such as 16APSK and 16QAM, the code bits of the LDPC code after the parity interleave are written in four columns forming the memory 31 of the demultiplexer 25 in the column direction.

The code bits that are written in the column direction in the four columns constituting the memory 31 are read in a unit of four bits in the row direction and become one symbol.

In this case, code bits $B_0$, $B_1$, $B_2$, and $B_3$ of the four bits that become one symbol may become code bits corresponding to 1 in any one row of the transformed parity check matrix of A of FIG. 27. In this case, the variable nodes that correspond to the code bits $B_0$, $B_1$, $B_2$, and $B_3$ are connected to the same check node.

Therefore, when the code bits $B_0$, $B_1$, $B_2$, and $B_3$ of the four bits of one symbol become the code bits corresponding to 1 in any one row of the transformed parity check matrix, if the erasure is generated in the symbol, an appropriate message may not be calculated in the same check node to which the variable nodes corresponding to the code bits $B_0$, $B_1$, $B_2$, and $B_3$ are connected. As a result, the decoding performance is deteriorated.

With respect to the encoding rates other than 3/4, the plurality of code bits corresponding to the plurality of variable nodes connected to the same check node may become one symbol of the APSK or the 16QAM, similar to the above case.

Therefore, the column twist interleaver 24 performs the column twist interleave for interleaving the code bits of the LDPC code after the parity interleave from the parity interleaver 23, such that the plurality of code bits corresponding to 1 in any one row of the transformed parity check matrix are not included in one symbol.

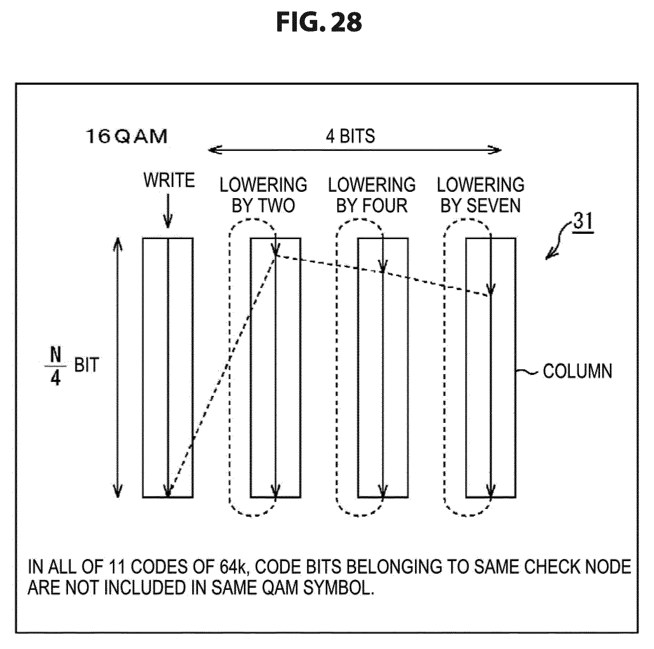

FIG. 28 is an illustration of the column twist interleave.

That is, FIG. 28 illustrates the memory 31 (FIGS. 22 and 23) of the demultiplexer 25.

As described in FIG. 22, the memory 31 has a storage capacity to store mb bits in the column (longitudinal) direction and store N/(mb) bits in the row (transverse) direction and includes mb columns. The column twist interleaver 24 writes the code bits of the LDPC code in the column direction with respect to the memory 31, controls a write start position when the code bits are read in the row direction, and performs the column twist interleave.

That is, in the column twist interleaver 24, the write start position to start writing of the code bits is appropriately changed with respect to each of the plurality of columns, such that the plurality of code bits read in the row direction and becoming one symbol do not become the code bits corresponding to 1 in any one row of the transformed parity check matrix (the code bits of the LDPC code are rearranged such that the plurality of code bits corresponding to 1 in any one row of the parity check matrix are not included in the same symbol).

In this case, FIG. 28 illustrates a configuration example of the memory 31 when the modulation method is the 16 APSK or the 16QAM and the multiple b described in FIG. 22 is 1. Therefore, the bit number m of the code bits of the LDPC code becoming one symbol is 4 bits and the memory 31 includes 4 (= mb) columns.

The column twist interleaver 24 performs writing of the code bits of the LDPC code (instead of the demultiplexer 25 of FIG. 22) in the downward direction (column direction) from the upper side of the four columns constituting the memory 31, toward the columns of the rightward direction from the left side.

If writing of the code bits ends to the rightmost column, the column twist interleaver 24 reads the code bits in a unit of four bits (mb bits) in the row direction from the first row of all the columns constituting the memory 31 and outputs the code bits as the LDPC code after the column twist interleave to the interchanging unit 32 (FIGS. 22 and 23) of the demultiplexer 25.

However, in the column twist interleaver 24, if an address of a position of a head (top) of each column is set to 0 and an address of each position of the column direction is represented by an ascending integer, a write start position is set to a position of which an address is 0, with respect to a leftmost column. A write start position is set to a position of which an address is 2, with respect to a second (from the left side) column. A write start position is set to a position of which an address is 4, with respect to a third column. A write start position is set to a position of which an address is 7, with respect to a fourth column.

With respect to the columns in which the write start positions are the positions other than the position of which the address is 0, after the code bits are written to a lowermost position, the position returns to the head (the position of which the address is 0) and writing is performed to the position immediately before the write start position. Then, writing with respect to a next (right) column is performed.

By performing the column twist interleave described above, with respect to the LDPC codes that are defined in the standard of the DVB-T.2 or the like, the plurality of code bits corresponding to the plurality of variable nodes connected to the same check node can be prevented from becoming one symbol of the APSK or the 16QAM (being included in the same symbol). As a result, decoding performance in a communication path in which the erasure exists can be improved.

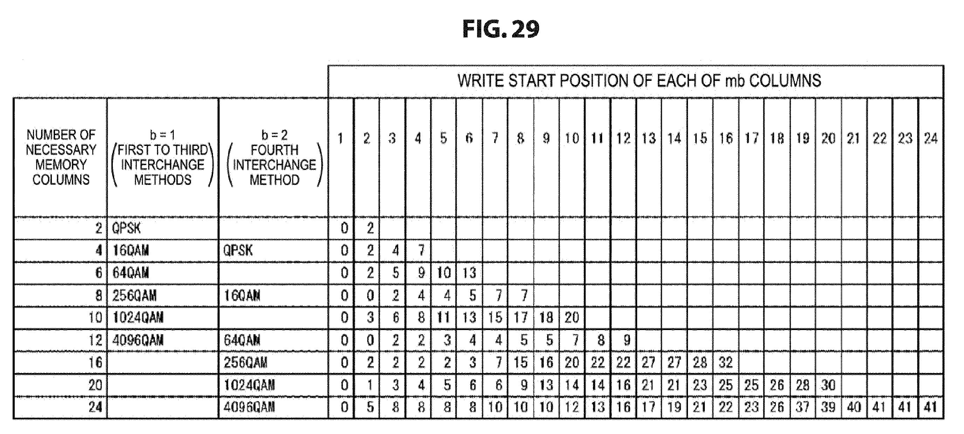

FIG. 29 illustrates a column number of the memory 31 necessary for the column twist interleave and an address of a write start position for each modulation method, with respect to LDPC codes of 11 encoding rates defined in the standard of the DVB-T.2 and having a code length N of 64800.

When the multiple b is 1, the QPSK is adopted as the modulation method, and a bit number m of one symbol is 2 bits, according to FIG. 29, the memory 31 has two columns to store $2 \times 1$ (= mb) bits in the row direction and stores $64800/(2 \times 1)$ bits in the column direction.

A write start position of a first column of the two columns of the memory 31 becomes a position of which an address is 0 and a write start position of a second column becomes a position of which an address is 2.

For example, when any one of the first to third interchange methods of FIG. 22 is adopted as the interchange method of the interchange processing of the demultiplexer 25 (FIG. 9), the multiple b becomes 1.

When the multiple b is 2, the QPSK is adopted as the modulation method, and a bit number m of one symbol is 2 bits, according to FIG. 29, the memory 31 has four columns to store $2 \times 2$ bits in the row direction and stores $64800/(2 \times 2)$ bits in the column direction.

A write start position of a first column of the four columns of the memory 31 becomes a position of which an address is 0, a write start position of a second column becomes a position of which an address is 2, a write start position of a third column becomes a position of which an address is 4, and a write start position of a fourth column becomes a position of which an address is 7.

For example, when the fourth interchange method of FIG. 23 is adopted as the interchange method of the interchange processing of the demultiplexer 25 (FIG. 9), the multiple b becomes 2.

When the multiple b is 1, the 16QAM is adopted as the modulation method, and a bit number m of one symbol is 4 bits, according to FIG. 29, the memory 31 has four columns to store $4 \times 1$ bits in the row direction and stores $64800/(4 \times 1)$ bits in the column direction.

A write start position of a first column of the four columns of the memory 31 becomes a position of which an address is 0, a write start position of a second column becomes a position of which an address is 2, a write start position of a third column becomes a position of which an address is 4, and a write start position of a fourth column becomes a position of which an address is 7.

When the multiple b is 2, the 16QAM is adopted as the modulation method, and a bit number m of one symbol is 4 bits, according to FIG. 29, the memory 31 has eight columns to store $4 \times 2$ bits in the row direction and stores $64800/(4 \times 2)$ bits in the column direction.

A write start position of a first column of the eight columns of the memory 31 becomes a position of which an address is 0, a write start position of a second column becomes a position of which an address is 0, a write start position of a third column becomes a position of which an address is 2, a write start position of a fourth column becomes a position of which an address is 4, a write start position of a fifth column becomes a position of which an address is 4, a write start position of a sixth column becomes a position of which an address is 5, a write start position of a seventh column becomes a position of which an address is 7, and a write start position of a eighth column becomes a position of which an address is 7.

When the multiple b is 1, the 64QAM is adopted as the modulation method, and a bit number m of one symbol is 6 bits, according to FIG. 29, the memory 31 has six columns to store 6 × 1 bits in the row direction and stores 64800/(6 × 1) bits in the column direction.

A write start position of a first column of the six columns of the memory 31 becomes a position of which an address is 0, a write start position of a second column becomes a position of which an address is 2, a write start position of a third column becomes a position of which an address is 5, a write start position of a fourth column becomes a position of which an address is 9, a write start position of a fifth column becomes a position of which an address is 10, and a write start position of a sixth column becomes a position of which an address is 13.

When the multiple b is 2, the 64QAM is adopted as the modulation method, and a bit number m of one symbol is 6 bits, according to FIG. 29, the memory 31 has twelve columns to store 6 × 2 bits in the row direction and stores 64800/(6 × 2) bits in the column direction.

A write start position of a first column of the twelve columns of the memory 31 becomes a position of which an address is 0, a write start position of a second column becomes a position of which an address is 0, a write start position of a third column becomes a position of which an address is 2, a write start position of a fourth column becomes a position of which an address is 2, a write start position of a fifth column becomes a position of which an address is 3, a write start position of a sixth column becomes a position of which an address is 4, a write start position of a seventh column becomes a position of which an address is 4, a write start position of a eighth column becomes a position of which an address is 5, a write start position of a ninth column becomes a position of which an address is 5 a write start position of a tenth column becomes a position of which an address is 7, a write start position of a eleventh column becomes a position of which an address is 8, and a write start position of a twelfth column becomes a position of which an address is 9.

When the multiple b is 1, the 256QAM is adopted as the modulation method, and a bit number m of one symbol is 8 bits, according to FIG. 29, the memory 31 has eight columns to store 8 × 1 bits in the row direction and stores 64800/(8 × 2) bits in the column direction.

A write start position of a first column of the eight columns of the memory 31 becomes a position of which an address is 0, a write start position of a second column becomes a position of which an address is 0, a write start position of a third column becomes a position of which an address is 2, a write start position of a fourth column becomes a position of which an address is 4, a write start position of a fifth column becomes a position of which an address is 4, a write start position of a sixth column becomes a position of which an address is 5, a write start position of a seventh column becomes a position of which an address is 7, and a write start position of a eighth column becomes a position of which an address is 7.

When the multiple b is 2, the 256QAM is adopted as the modulation method, and a bit number m of one symbol is 8 bits, according to FIG. 29, the memory 31 has sixteen columns to store 8 × 2 bits in the row direction and stores 64800/(8 × 2) bits in the column direction.

A write start position of a first column of the sixteen columns of the memory 31 becomes a position of which an address is 0, a write start position of a second column becomes a position of which an address is 2, a write start position of a third column becomes a position of which an address is 2, a write start position of a fourth column becomes a position of which an address is 2, a write start position of a fifth column becomes a position of which an address is 2, a write start position of a sixth column becomes a position of which an address is 3, a write start position of a seventh column becomes a position of which an address is 7, a write start position of a eighth column becomes a position of which an address is 15, a write start position of a ninth column becomes a position of which an address is 16 a write start position of a tenth column becomes a position of which an address is 20, a write start position of a eleventh column becomes a position of which an address is 22, a write start position of a twelfth column becomes a position of which an address is 22, a write start position of a thirteenth column becomes a position of which an address is 27, a write start position of a fourteenth column becomes a position of which an address is 27, a write start position of a fifteenth column becomes a position of which an address is 28, and a write start position of a sixteenth column becomes a position of which an address is 32.

When the multiple b is 1, the 1024QAM is adopted as the modulation method, and a bit number m of one symbol is 10 bits, according to FIG. 29, the memory 31 has ten columns to store 10 × 1 bits in the row direction and stores 64800/(10 × 1) bits in the column direction.

A write start position of a first column of the ten columns of the memory 31 becomes a position of which an address is 0, a write start position of a second column becomes a position of which an address is 3, a write start position of a third column becomes a position of which an address is 6, a write start position of a fourth column becomes a position of which an address is 8, a write start position of a fifth column becomes a position of which an address is 11, a write start position of a sixth column becomes a position of which an address is 13, a write start position of a seventh column becomes a position of which an address is 15, a write start position of a eighth column becomes a position of which an address is 17, a write start position of a ninth column becomes a position of which an address is 18 and a write start position of a tenth column becomes a position of which an address is 20.

When the multiple b is 2, the 1024QAM is adopted as the modulation method, and a bit number m of one symbol is 10 bits, according to FIG. 29, the memory 31 has twemty columns to store $10 \times 2$ bits in the row direction and stores $64800/(10 \times 2)$ bits in the column direction.

A write start position of a first column of the twenty columns of the memory 31 becomes a position of which an address is 0, a write start position of a second column becomes a position of which an address is 1, a write start position of a third column becomes a position of which an address is 3, a write start position of a fourth column becomes a position of which an address is 4, a write start position of a fifth column becomes a position of which an address is 5, a write start position of a sixth column becomes a position of which an address is 6, a write start position of a seventh column becomes a position of which an address is 6, a write start position of a eighth column becomes a position of which an address is 9, a write start position of a ninth column becomes a position of which an address is 13 a write start position of a tenth column becomes a position of which an address is 14, a write start position of a eleventh column becomes a position of which an address is 14, a write start position of a twelfth column becomes a position of which an address is 16, a write start position of a thirteenth column becomes a position of which an address is 21, a write start position of a fourteenth column becomes a position of which an address is 21, a write start position of a fifteenth column becomes a position of which an address is 23, a write start position of a sixteenth column becomes a position of which an address is 25, a write start position of a seventeenth column becomes a position of which an address is 25, a write start position of a eighteenth column becomes a position of which an address is 26, a write start position of a nineteenth column becomes a position of which an address is 28, and a write start position of a twentieth column becomes a position of which an address is 30.

When the multiple b is 1, the 4096QAM is adopted as the modulation method, and a bit number m of one symbol is 12 bits, according to FIG. 29, the memory 31 has twelve columns to store $12 \times 1$ bits in the row direction and stores $64800/(12 \times 1)$ bits in the column direction.

A write start position of a first column of the twelve columns of the memory 31 becomes a position of which an address is 0, a write start position of a second column becomes a position of which an address is 0, a write start position of a third column becomes a position of which an address is 2, a write start position of a fourth column becomes a position of which an address is 2, a write start position of a fifth column becomes a position of which an address is 3, a write start position of a sixth column becomes a position of which an address is 4, a write start position of a seventh column becomes a position of which an address is 4, a write start position of a eighth column becomes a position of which an address is 5, a write start position of a ninth column becomes a position of which an address is 5 a write start position of a tenth column becomes a position of which an address is 7, a write start position of a eleventh column becomes a position of which an address is 8, and a write start position of a twelfth column becomes a position of which an address is 9.

When the multiple b is 2, the 4096QAM is adopted as the modulation method, and a bit number m of one symbol is 12 bits, according to FIG. 29, the memory 31 has twenty four columns to store $12 \times 2$ bits in the row direction and stores $64800/(12 \times 2)$ bits in the column direction.

A write start position of a first column of the twenty four columns of the memory 31 becomes a position of which an address is 0, a write start position of a second column becomes a position of which an address is 5, a write start position of a third column becomes a position of which an address is 8, a write start position of a fourth column becomes a position of which an address is 8, a write start position of a fifth column becomes a position of which an address is 8, a write start position of a sixth column becomes a position of which an address is 8, a write start position of a seventh column becomes a position of which an address is 10, a write start position of a eighth column becomes a position of which an address is 10, a write start position of a ninth column becomes a position of which an address is 10 a write start position of a tenth column becomes a position of which an address is 12, a write start position of a eleventh column becomes a position of which an address is 13, a write start position of a twelfth column becomes a position of which an address is 16, a write start position of a thirteenth column becomes a position of which an address is 17, a write start position of a fourteenth column becomes a position of which an address is 19, a write start position of a fifteenth column becomes a position of which an address is 21, a write start position of a sixteenth column becomes a position of which an address is 22, a write start position of a seventeenth column becomes a position of which an address is 23, a write start position of a eighteenth column becomes a position of which an address is 26, a write start position of a nineteenth column becomes a position of which an address is 37, a write start position of a twentieth column becomes a position of which an address is 39, a write start position of a twenty first column becomes a position of which an address is 40, a write start position of a twenty second column becomes a position of which an address is 41, a write start position of a twenty third column becomes a position of which an address is 41, and a write start position of a twenty fourth column becomes a position of which an address is 41.

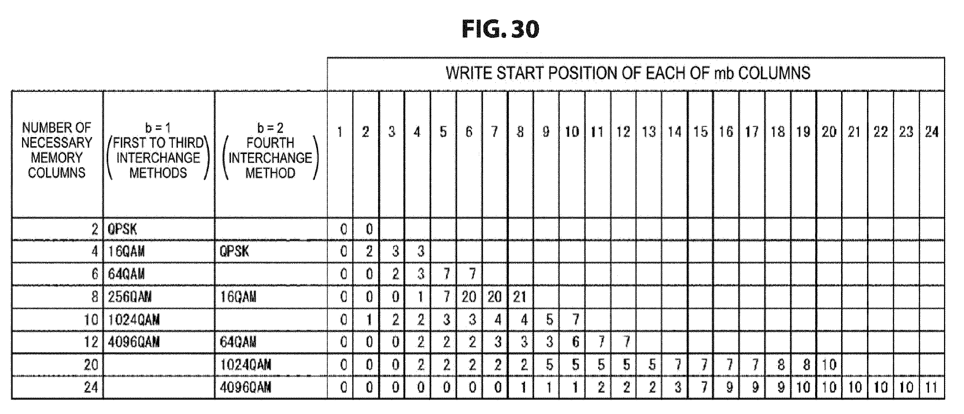

FIG. 30 illustrates a column number of the memory 31 necessary for the column twist interleave and an address of a write start position for each modulation method, with respect to LDPC codes of 10 encoding rates defined in the standard of the DVB-T.2 and having a code length N of 16200.

When the multiple b is 1, the QPSK is adopted as the modulation method, and a bit number m of one symbol is 2 bits, according to FIG. 30, the memory 31 has two columns to store $2 \times 1$ bits in the row direction and stores $16200/(2 \times 1)$ bits in the column direction.

A write start position of a first column of the two columns of the memory 31 becomes a position of which an address is 0 and a write start position of a second column becomes a position of which an address is 0.

When the multiple b is 2, the QPSK is adopted as the modulation method, and a bit number m of one symbol is 2 bits, according to FIG. 30, the memory 31 has four columns to store $2 \times 2$ (= mb) bits in the row direction and stores $16200/(2 \times 2)$ bits in the column direction.

A write start position of a first column of the four columns of the memory 31 becomes a position of which an address is 0, a write start position of a second column becomes a position of which an address is 2, a write start position of a third column becomes a position of which an address is 3, and a write start position of a fourth column becomes a position of which an address is 3.

When the multiple b is 1, the 16QAM is adopted as the modulation method, and a bit number m of one symbol is 4 bits, according to FIG. 30, the memory 31 has four columns to store $4 \times 1$ bits in the row direction and stores $16200/(4 \times 1)$ bits in the column direction.

A write start position of a first column of the four columns of the memory 31 becomes a position of which an address is 0, a write start position of a second column becomes a position of which an address is 2, a write start position of a third column becomes a position of which an address is 3, and a write start position of a fourth column becomes a position of which an address is 3.

When the multiple b is 2, the 16QAM is adopted as the modulation method, and a bit number m of one symbol is 4 bits, according to FIG. 30, the memory 31 has eight columns to store $4 \times 2$ bits in the row direction and stores $16200/(4 \times 2)$ bits in the column direction.

A write start position of a first column of the eight columns of the memory 31 becomes a position of which an address is 0, a write start position of a second column becomes a position of which an address is 0, a write start position of a third column becomes a position of which an address is 0, a write start position of a fourth column becomes a position of which an address is 1, a write start position of a fifth column becomes a position of which an address is 7, a write start position of a sixth column becomes a position of which an address is 20, a write start position of a seventh column becomes a position of which an address is 20, and a write start position of a eighth column becomes a position of which an address is 21.

When the multiple b is 1, the 64QAM is adopted as the modulation method, and a bit number m of one symbol is 6 bits, according to FIG. 30, the memory 31 has six columns to store $6 \times 1$ bits in the row direction and stores $16200/(6 \times 1)$ bits in the column direction.

A write start position of a first column of the six columns of the memory 31 becomes a position of which an address is 0, a write start position of a second column becomes a position of which an address is 0, a write start position of a third column becomes a position of which an address is 2, a write start position of a fourth column becomes a position of which an address is 3, a write start position of a fifth column becomes a position of which an address is 7, and a write start position of a sixth column becomes a position of which an address is 7.

When the multiple b is 2, the 64QAM is adopted as the modulation method, and a bit number m of one symbol is 6 bits, according to FIG. 30, the memory 31 has twelve columns to store $6 \times 2$ bits in the row direction and stores $16200/(6 \times 2)$ bits in the column direction.

A write start position of a first column of the twelve columns of the memory 31 becomes a position of which an address is 0, a write start position of a second column becomes a position of which an address is 0, a write start position of a third column becomes a position of which an address is 0, a write start position of a fourth column becomes a position of which an address is 2, a write start position of a fifth column becomes a position of which an address is 2, a write start position of a sixth column becomes a position of which an address is 2, a write start position of a seventh column becomes a position of which an address is 3, a write start position of a eighth column becomes a position of which an address is 3, a write start position of a ninth column becomes a position of which an address is 3 a write start position of a tenth column becomes a position of which an address is 6, a write start position of a eleventh column becomes a position of which an address is 7, and a write start position of a twelfth column becomes a position of which an address is 7.

When the multiple b is 1, the 256QAM is adopted as the modulation method, and a bit number m of one symbol is 8 bits, according to FIG. 30, the memory 31 has eight columns to store $8 \times 1$ bits in the row direction and stores $16200/(8 \times 1)$ bits in the column direction.

A write start position of a first column of the eight columns of the memory 31 becomes a position of which an address is 0, a write start position of a second column becomes a position of which an address is 0, a write start position of a third column becomes a position of which an address is 0, a write start position of a fourth column becomes a position of which an address is 1, a write start position of a fifth column becomes a position of which an address is 7, a write start position of a sixth column becomes a position of which an address is 20, a write start position of a seventh column becomes a position of which an address is 20, and a write start position of a eighth column becomes a position of which an address is 21.

When the multiple b is 1, the 1024QAM is adopted as the modulation method, and a bit number m of one symbol is 10 bits, according to FIG. 30, the memory 31 has ten columns to store 10× 1 bits in the row direction and stores 16200/(10 × 1) bits in the column direction.

A write start position of a first column of the ten columns of the memory 31 becomes a position of which an address is 0, a write start position of a second column becomes a position of which an address is 1, a write start position of a third column becomes a position of which an address is 2, a write start position of a fourth column becomes a position of which an address is 2, a write start position of a fifth column becomes a position of which an address is 3, a write start position of a sixth column becomes a position of which an address is 3, a write start position of a seventh column becomes a position of which an address is 4, a write start position of a eighth column becomes a position of which an address is 4, a write start position of a ninth column becomes a position of which an address is 5, and a write start position of a tenth column becomes a position of which an address is 7.

When the multiple b is 2, the 1024QAM is adopted as the modulation method, and a bit number m of one symbol is 10 bits, according to FIG. 30, the memory 31 has twenty columns to store 10 × 2 bits in the row direction and stores 16200/(10 × 2) bits in the column direction.

A write start position of a first column of the twenty columns of the memory 31 becomes a position of which an address is 0, a write start position of a second column becomes a position of which an address is 0, a write start position of a third column becomes a position of which an address is 0, a write start position of a fourth column becomes a position of which an address is 2, a write start position of a fifth column becomes a position of which an address is 2, a write start position of a sixth column becomes a position of which an address is 2, a write start position of a seventh column becomes a position of which an address is 2, a write start position of a eighth column becomes a position of which an address is 2, a write start position of a ninth column becomes a position of which an address is 5 a write start position of a tenth column becomes a position of which an address is 5, a write start position of a eleventh column becomes a position of which an address is 5, a write start position of a twelfth column becomes a position of which an address is 5, a write start position of a thirteenth column becomes a position of which an address is 5, a write start position of a fourteenth column becomes a position of which an address is 7, a write start position of a fifteenth column becomes a position of which an address is 7, a write start position of a sixteenth column becomes a position of which an address is 7, a write start position of a seventeenth column becomes a position of which an address is 7, a write start position of a eighteenth column becomes a position of which an address is 8, a write start position of a nineteenth column becomes a position of which an address is 8, and a write start position of a twentieth column becomes a position of which an address is 10.

When the multiple b is 1, the 4096QAM is adopted as the modulation method, and a bit number m of one symbol is 12 bits, according to FIG. 30, the memory 31 has twelve columns to store 12 × 1 bits in the row direction and stores 16200/(12 × 1) bits in the column direction.

A write start position of a first column of the twelve columns of the memory 31 becomes a position of which an address is 0, a write start position of a second column becomes a position of which an address is 0, a write start position of a third column becomes a position of which an address is 0, a write start position of a fourth column becomes a position of which an address is 2, a write start position of a fifth column becomes a position of which an address is 2, a write start position of a sixth column becomes a position of which an address is 2, a write start position of a seventh column becomes a position of which an address is 3, a write start position of a eighth column becomes a position of which an address is 3, a write start position of a ninth column becomes a position of which an address is 3 a write start position of a tenth column becomes a position of which an address is 6, a write start position of a eleventh column becomes a position of which an address is 7, and a write start position of a twelfth column becomes a position of which an address is 7.

When the multiple b is 2, the 4096QAM is adopted as the modulation method, and a bit number m of one symbol is 12 bits, according to FIG. 30, the memory 31 has twenty four columns to store 12 × 2 bits in the row direction and stores 16200/(12 × 2) bits in the column direction.

A write start position of a first column of the twenty four columns of the memory 31 becomes a position of which an address is 0, a write start position of a second column becomes a position of which an address is 0, a write start position of a third column becomes a position of which an address is 0, a write start position of a fourth column becomes a position of which an address is 0, a write start position of a fifth column becomes a position of which an address is 0, a write start position of a sixth column becomes a position of which an address is 0, a write start position of a seventh column becomes a position of which an address is 0, a write start position of a eighth column becomes a position of which an address is 1, a write start position of a ninth column becomes a position of which an address is 1 a write start position of a tenth column becomes a position of which an address is 1, a write start position of a eleventh column becomes a position of which an address is 2, a write start position of a twelfth column becomes a position of which an address is 2, a write start position of a thirteenth column becomes a position of which an address is 2, a write start position of a fourteenth column becomes a position of which an address is 3, a write start position of a fifteenth column becomes a position of which an address is 7, a write start position of a sixteenth column becomes a position of which an address is 9, a write start position of a seventeenth column becomes a position of which an address is 9, a write start position of a eighteenth column becomes a position of which an address is 9, a write start position of a nineteenth column becomes a position of which an address is 10, a write start position of a twentieth column becomes a position of which an address is 10, a write start position of a twenty first column becomes a position of which an address is 10, a write start position of a twenty second column becomes a position of which an address is 10, a write start position of a twenty third column becomes a position of which an address is 10, and a write start position of a twenty fourth column becomes a position of which an address is 11.

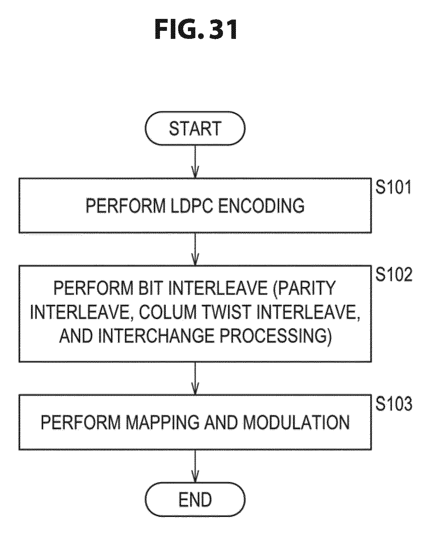

FIG. 31 is a flowchart illustrating processing executed by the LDPC encoder 115, the bit interleaver 116, and the QAM encoder 117 of FIG. 8.

The LDPC encoder 115 awaits supply of the LDPC target data from the BCH encoder 114. In step S101, the LDPC encoder 115 encodes the LDPC target data with the LDPC code and supplies the LDPC code to the bit interleaver 116. The processing proceeds to step S102.

In step S102, the bit interleaver 116 performs bit interleave with respect to the LDPC code supplied from the LDPC encoder 115 and supplies a symbol obtained by symbolizing the LDPC code after the bit interleave to the QAM encoder 117. The processing proceeds to step S103.

That is, in step S102, in the bit interleaver 116 (FIG. 9), the parity interleaver 23 performs parity interleave with respect to the LDPC code supplied from the LDPC encoder 115 and supplies the LDPC code after the parity interleave to the column twist interleaver 24.

The column twist interleaver 24 performs column twist interleave with respect to the LDPC code supplied from the parity interleaver 23 and supplies the LDPC code to the demultiplexer 25.

The demultiplexer 25 executes interchange processing for interchanging the code bits of the LDPC code after the column twist interleave by the column twist interleaver 24 and making the code bits after the interchange become symbol bits (bits representing a symbol) of the symbol.

Here, the interchange processing by the demultiplexer 25 can be performed according to the first or fourth interchange methods illustrated in FIG. 22 and FIG. 23, and, moreover, can be performed according to a predetermined allocation rule defined beforehand to allocate a symbol bit showing a symbol to a code bit of the LDPC code.

The symbol that is obtained by the interchange processing by the demultiplexer 25 is supplied from the demultiplexer 25 to the QAM encoder 117.

In step S103, the QAM encoder 117 maps the symbol supplied from the demultiplexer 25 to a signal point determined by the modulation method of the orthogonal modulation performed by the QAM encoder 117, performs the orthogonal modulation, and supplies data obtained as a result to the time interleaver 118.

As described above, the parity interleave or the column twist interleave is performed, so that tolerance against the erasure or the burst error when the plurality of code bits of the LDPC code are transmitted as one symbol can be improved.

In FIG. 9, the parity interleaver 23 to be a block to perform the parity interleave and the column twist interleaver 24 to be a block to perform the column twist interleave are individually configured for the convenience of explanation. However, the parity interleaver 23 and the column twist interleaver 24 can be integrally configured.

That is, both the parity interleave and the column twist interleave can be performed by writing and reading of the code bits with respect to the memory and can be represented by a matrix to convert an address (write address) to perform writing of the code bits into an address (read address) to perform reading of the code bits.

Therefore, if a matrix obtained by multiplying a matrix representing the parity interleave and a matrix representing the column twist interleave is calculated, the code bits are converted by the matrix, the parity interleave is performed, and a column twist interleave result of the LDPC code after the parity interleave can be obtained.

In addition to the parity interleaver 23 and the column twist interleaver 24, the demultiplexer 25 can be integrally configured.

That is, the interchange processing executed by the demultiplexer 25 can be represented by the matrix to convert the write address of the memory 31 storing the LDPC code into the read address.

Therefore, if a matrix obtained by multiplying the matrix representing the parity interleave, the matrix representing the column twist interleave, and the matrix representing the interchange processing is calculated, the parity interleave, the column twist interleave, and the interchange processing can be collectively executed by the matrix.

Only one of the parity interleave and the column twist interleave may be performed or both the parity interleave and the column twist interleave may not be performed. For example, like DVB-S.2, in a case where the communication path 13 (FIG. 7) is a satellite circuit or the like which is different from AWGN and for which burst error and flutter, and so on, do not have to be considered so much, it is possible to cause the parity interleave and the column twist interleave not to be performed.

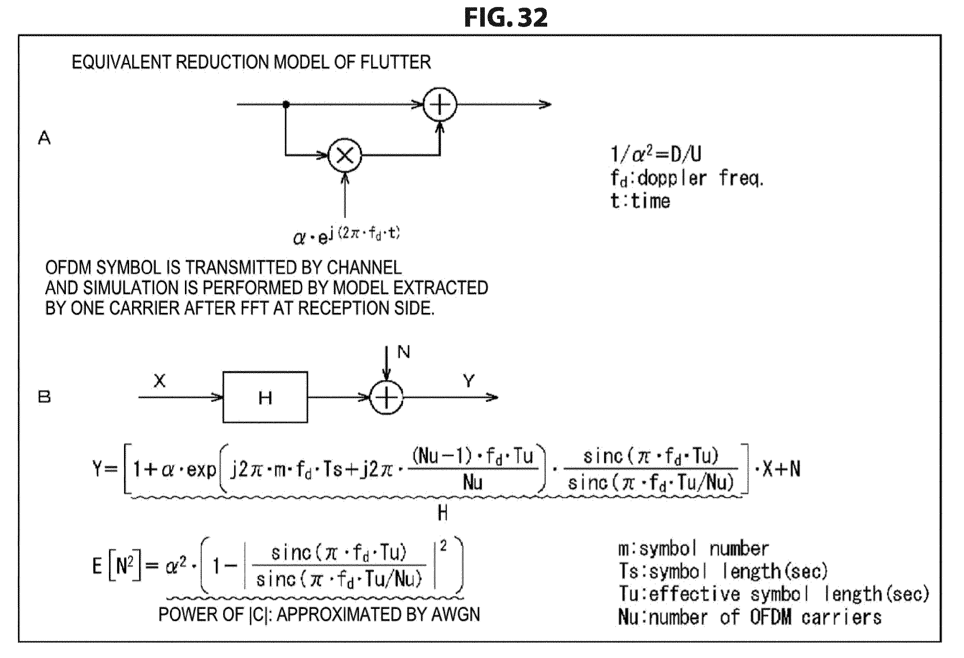

Next, simulation to measure an error rate (bit error rate) that is performed with respect to the transmitting device 11 of FIG. 8 will be described with reference to FIGS. 32 to 34.

The simulation is performed by adopting a communication path in which a flutter having D/U of 0 dB exists.

FIG. 32 illustrates a model of a communication path that is adopted by the simulation.

That is, A of FIG. 32 illustrates a model of a flutter that is adopted by the simulation.

In addition, B of FIG. 32 illustrates a model of a communication path in which the flutter represented by the model of A of FIG. 32 exists.

In B of FIG. 32, H represents the model of the flutter of A of FIG. 32. In B of FIG. 32, N represents ICI (Inter Carrier Interference). In the simulation, an expectation value $E[N^2]$ of power is approximated by the AWGN.

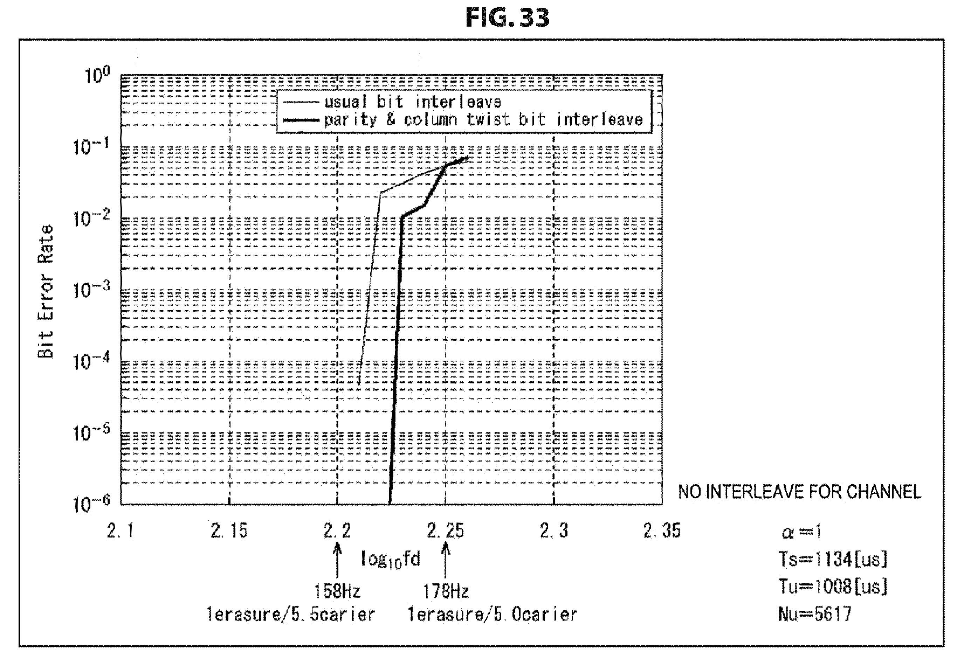

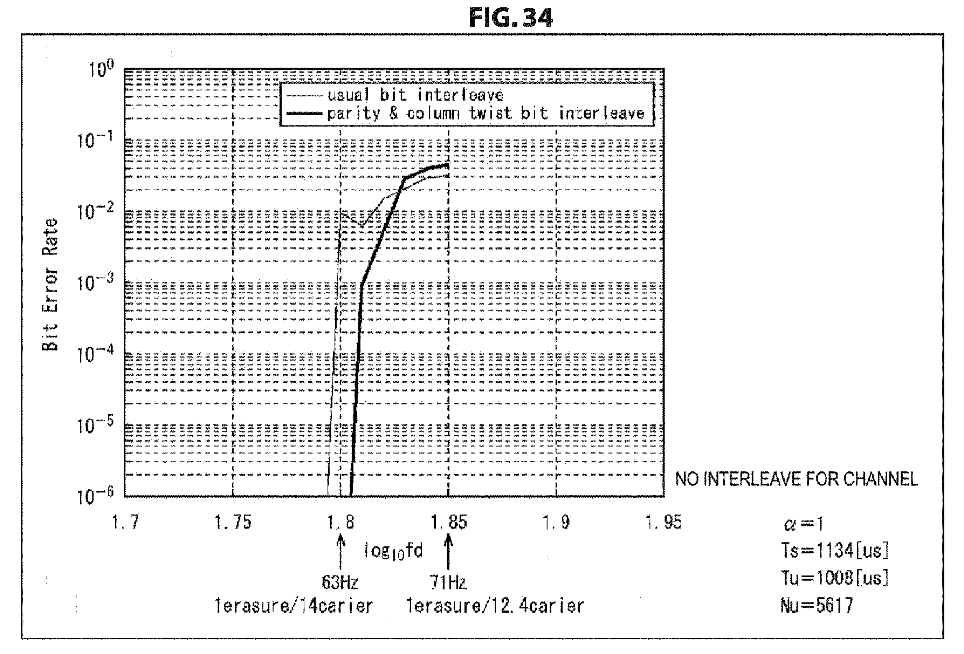

FIGS. 33 and 34 illustrate a relation of an error rate obtained by the simulation and a Doppler frequency $f_d$ of the flutter.

FIG. 33 illustrates a relation of the error rate and the Doppler frequency $f_d$ when a modulation method is the 16QAM, an encoding rate (r) is (3/4), and an interchange method is the first interchange method. FIG. 34 illustrates a relation of the error rate and the Doppler frequency $f_d$ when the modulation method is the 64QAM, the encoding rate (r) is (5/6), and the interchange method is the first interchange method.

In FIGS. 33 and 34, a thick line shows a relation of the error rate and the Doppler frequency $f_d$ when all of the parity interleave, the column twist interleave, and the interchange processing are performed and a thin line shows a relation of the error rate and the Doppler frequency $f_d$ when only the interchange processing among the parity interleave, the column twist interleave, and the interchange processing is performed.

In both FIGS. 33 and 34, it can be known that the error rate is further improved (decreased) when all of the parity interleave, the column twist interleave, and the interchange processing are performed, as compared with when only the interchange processing is executed.

[Configuration example of LDPC encoder 115]

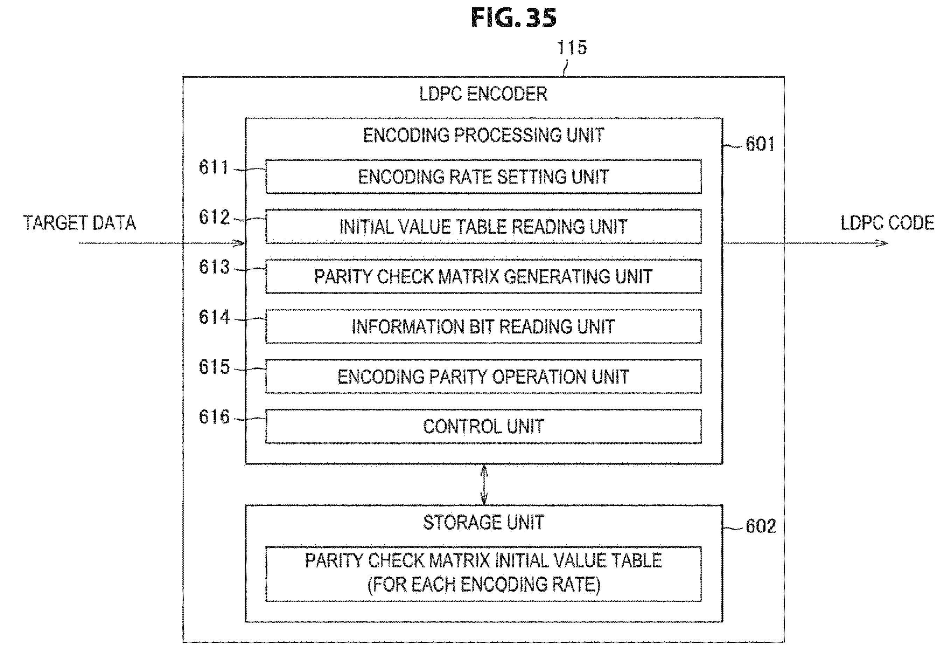

FIG. 35 is a block diagram illustrating a configuration example of the LDPC encoder 115 of FIG. 8.

The LDPC encoder 122 of FIG. 8 is also configured in the same manner.

As described in FIGS. 12 and 13, in the standard of the DVB-S.2 or the like, the LDPC codes that have the two code lengths N of 64800 bits and 16200 bits are defined.

With respect to the LDPC code having the code length N of 64800 bits, 11 encoding rates of 1/4, 1/3, 2/5, 1/2, 3/5, 2/3, 3/4, 4/5, 5/6, 8/9, and 9/10 are defined. With respect to the LDPC code having the code length N of 16200 bits, 10 encoding rates of 1/4, 1/3, 2/5, 1/2, 3/5, 2/3, 3/4, 4/5, 5/6, and 8/9 are defined (FIGS. 12 and 13).

For example, the LDPC encoder 115 can perform encoding (error correction encoding) using the LDPC code of each encoding rate having the code length N of 64800 bits or 16200 bits, according to the parity check matrix H prepared for each code length N and each encoding rate.

The LDPC encoder 115 includes an encoding processing unit 601 and a storage unit 602.

The encoding processing unit 601 includes an encoding rate setting unit 611, an initial value table reading unit 612, a parity check matrix generating unit 613, an information bit reading unit 614, an encoding parity operation unit 615, an a control unit 616. The encoding processing unit 601 performs the LDPC encoding of LDPC target data supplied to the LDPC encoder 115 and supplies an LDPC code obtained as a result to the bit interleaver 116 (FIG. 8).

That is, the encoding rate setting unit 611 sets the code length N and the encoding rate of the LDPC code, according to an operation of an operator.

The initial value table reading unit 612 reads a parity check matrix initial value table to be described later, which corresponds to the code length N and the encoding rate set by the encoding rate setting unit 611, from the storage unit 602.

The parity check matrix generating unit 613 generates a parity check matrix H by arranging elements of 1 of an information matrix $H_A$ corresponding to an information length K (= information length N - parity length M) according to the code length N and the encoding rate set by the encoding rate setting unit 611 in the column direction with a period of 360 columns (column number P of a unit of the cyclic structure), on the basis of the parity check matrix initial value table read by the initial value table reading unit 612, and stores the parity check matrix H in the storage unit 602.

The information bit reading unit 614 reads (extracts) information bits corresponding to the information length K, from the LDPC target data supplied to the LDPC encoder 115.

The encoding parity operation unit 615 reads the parity check matrix H generated by the parity check matrix generating unit 613 from the storage unit 602, and generates a code word (LDPC code) by calculating parity bits for the information bits read by the information bit reading unit 614 on the basis of a predetermined expression using the parity check matrix H.

The control unit 616 controls each block constituting the encoding processing unit 601.

In the storage unit 602, a plurality of parity check matrix initial value tables that correspond to the plurality of encoding rates illustrated in FIGS. 12 and 13, with respect to the code lengths N such as the 64800 bits and 16200 bits, are stored. In addition, the storage unit 602 temporarily stores data that is necessary for processing of the encoding processing unit 601.

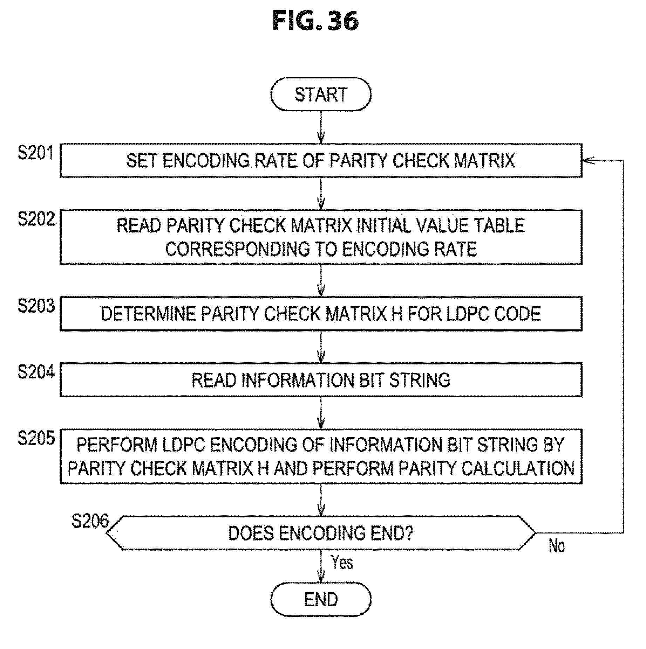

FIG. 36 is a flowchart illustrating processing of the LDPC encoder 115 of FIG. 35.

In step S201, the encoding rate setting unit 611 determines (sets) the code length N and the encoding rate r to perform the LDPC encoding.

In step S202, the initial value table reading unit 612 reads the previously determined parity check matrix initial value table corresponding to the code length N and the encoding rate r determined by the encoding rate setting unit 611, from the storage unit 602.

In step S203, the parity check matrix generating unit 613 calculates (generates) the parity check matrix H of the LDPC code of the code length N and the encoding rate r determined by the encoding rate setting unit 611, using the parity check matrix initial value table read from the storage unit 602 by the initial value table reading unit 612, supplies the parity check matrix to the storage unit 602, and stores the parity check matrix in the storage unit.

In step S204, the information bit reading unit 614 reads the information bits of the information length K (= N $\times$ r) corresponding to the code length N and the encoding rate r determined by the encoding rate setting unit 611, from the LDPC target data supplied to the LDPC encoder 115, reads the parity check matrix H calculated by the parity check matrix generating unit 613 from the storage unit 602, and supplies the information bits and the parity check matrix to the encoding parity operation unit 615.

In step S205, the encoding parity operation unit 615 sequentially operates parity bits of a code word c that satisfies an expression (8) using the information bits and the parity check matrix H that have been read from the information bit reading unit 614.

$$\mathrm{Hc}^{\mathrm{T}} = 0 \qquad\qquad \cdots (8)$$

In the expression (8), c represents a row vector as the code word (LDPC code) and $c^T$ represents transposition of the row vector c.

As described above, when a portion of the information bits of the row vector c as the LDPC code (one code word) is represented by a row vector A and a portion of the parity bits is represented by a row vector T, the row vector c can be represented by an expression c = [A/T], using the row vector A as the information bits and the row vector T as the parity bits.

In the parity check matrix H and the row vector c = [A|T] corresponding to the LDPC code, it is necessary to satisfy an expression $Hc^T = 0$. The row vector T that corresponds to the parity bits constituting the row vector c = [A|T] satisfying the expression $Hc^T = 0$ can be sequentially calculated by setting elements of each row to 0, sequentially from elements of a first row of the column vector $Hc^T$ in the expression $Hc^T = 0$, when the parity matrix $H_T$ of the parity check matrix H = [$H_A$ |$H_T$] becomes the staircase structure illustrated in FIG. 11.

If the encoding parity operation unit 615 calculates the parity bits T with respect to the information bits A from the information bit reading unit 614, the encoding parity operation unit 615 outputs the code word c = [A/T] represented by the information bits A and the parity bits T as an LDPC encoding result of the information bits A.

Then, in step S206, the control unit 616 determines whether the LDPC encoding ends. When it is determined in step S206 that the LDPC encoding does not end, that is, when there is LDPC target data to perform the LDPC encoding, the processing returns to step S201 (or step S204). Hereinafter, the processing of steps S201 (or step S204) to S206 is repeated.

When it is determined in step S206 that the LDPC encoding ends, that is, there is no LDPC target data to perform the LDPC encoding, the LDPC encoder 115 ends the processing.

As described above, the parity check matrix initial value table corresponding to each code length N and each encoding rate r is prepared and the LDPC encoder 115 performs the LDPC encoding of the predetermined code length N and the predetermined encoding rate r, using the parity check matrix H generated from the parity check matrix initial value table corresponding to the predetermined code length N and the predetermined encoding rate r.

[Example of the parity check matrix initial value table]

The parity check matrix initial value table is a table that represents positions of elements of 1 of the information matrix $H_A$ (FIG. 10) of the parity check matrix H corresponding to the information length K according to the code length N and the encoding rate r of the LDPC code (LDPC code defined by the parity check matrix H) for every 360 columns (column number P of a unit of the cyclic structure) and is previously made for each parity check matrix H of each code length N and each encoding rate r.

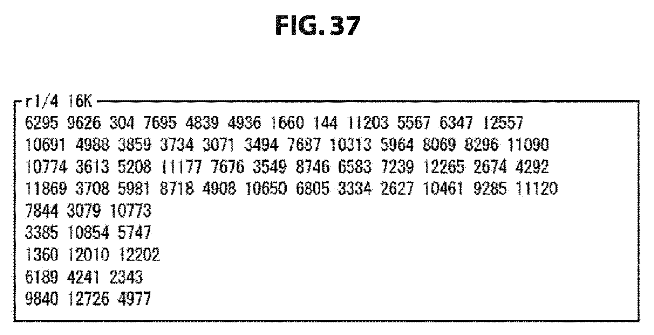

FIG. 37 is an illustration of an example of the parity check matrix initial value table.

That is, FIG. 37 illustrates a parity check matrix initial value table with respect to the parity check matrix H that is defined in the standard of the DVB-T.2 and has the code length N of 16200 bits and the encoding rate (an encoding rate of notation of the DVB-T.2) r of 1/4.

The parity check matrix generating unit 613 (FIG. 35) calculates the parity check matrix H using the parity check matrix initial value table, as follows.

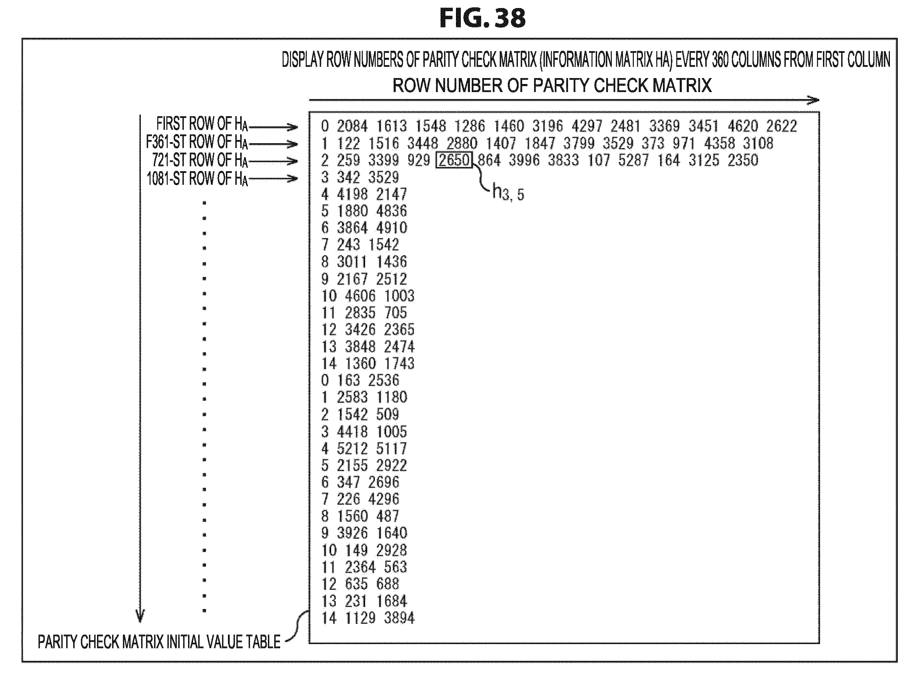

That is, FIG. 38 illustrates a method of calculating the parity check matrix H from the parity check matrix initial value table.

The parity check matrix initial value table in FIG. 38 illustrates a parity check matrix initial value table with respect to the parity check matrix H that is defined in the standard of the DVB-T.2 and has the code length N of 16200 bits and the encoding rate r of 2/3.

As described above, the parity check matrix initial value table is the table that represents the positions of the elements of 1 of the information matrix $H_A$ (FIG. 10) corresponding to the information length K according to the code length N and the encoding rate r of the LDPC code for every 360 columns (column number P of a unit of the cyclic structure). In the i-th row thereof, row numbers (row numbers when a row number of a first row of the parity check matrix H is set to 0) of elements of 1 of a $(1 + 360 \times (i - 1)$-th column of the parity check matrix H are arranged by a number of column weights of the $(1 + 360 \times (i - 1)$-th column.

In this case, because the parity matrix $H_T$ (FIG. 10) of the parity check matrix H corresponding to the parity length M is determined as illustrated in FIG. 25, according to the parity check matrix initial value table, the information matrix $H_A$ (FIG. 10) of the parity check matrix H corresponding to the information length K is calculated.

A row number k + 1 of the parity check matrix initial value table is different according to the information length K.

A relation of an expression (9) is realized between the information length K and the row number k + 1 of the parity check matrix initial value table.

$$K = (k + 1) \times 360 \qquad \cdots (9)$$

In this case, 360 of the expression (9) is the column umber P of the unit of the cyclic structure described in FIG. 26.

In the parity check matrix initial value table of FIG. 38, 13 numerical values are arranged from the first row to the third row and 3 numerical values are arranged from the fourth row to the (k + 1)-th row (in FIG. 38, the 30th row).

Therefore, the column weights of the parity check matrix H that are calculated from the parity check matrix initial value table of FIG. 38 are 13 from the first column to the $(1+ 360 \times (3 - 1) - 1)$-th column and are 3 from the $(1+ 360 \times (3-1))$-th column to the K-th column.

The first row of the parity check matrix initial value table of FIG. 38 becomes 0, 2084, 1613, 1548, 1286, 1460, 3196, 4297, 2481, 3369, 3451, 4620, and 2622, which shows that elements of rows having row numbers of 0, 2084, 1613, 1548, 1286, 1460, 3196, 4297, 2481, 3369, 3451, 4620, and 2622 are 1 (and the other elements are 0), in the first column of the parity check matrix H.

The second row of the parity check matrix initial value table of FIG. 38 becomes 1, 122, 1516, 3448, 2880, 1407, 1847, 3799, 3529, 373, 971, 4358, and 3108, which shows that elements of rows having row numbers of 1, 122, 1516, 3448, 2880, 1407, 1847, 3799, 3529, 373, 971, 4358, and 3108 are 1, in the 361 $(= 1 + 360 \times (2 - 1))$-th column of the parity check matrix H.

As described above, the parity check matrix initial value table represents positions of elements of 1 of the information matrix $H_A$ of the parity check matrix H for every 360 columns.

The columns other than the $(1 + 360 \times (i - 1))$-th column of the parity check matrix H, that is, the individual columns from the $(2 + 360 \times (i - 1))$-th column to the $(360 \times i)$-th column are arranged by cyclically shifting elements of 1 of the $(1 + 360 \times (i - 1))$-th column determined by the parity check matrix initial value table periodically in a downward direction (downward direction of the columns) according to the parity length M.

That is, the $(2 + 360 \times (i - 1))$-th column is obtained by cyclically shifting $(1 + 360 \times (i - 1))$-th column in the downward direction by M/360 (= q) and the next $(3 + 360 \times (i - 1))$-th column is obtained by cyclically shifting $(1 + 360 \times (i - 1))$-th column in the downward direction by $2 \times$ M/360 $(= 2 \times q)$ (obtained by cyclically shifting $(2 + 360 \times (i - 1))$-th column in the downward direction by M/360 (= q)).

If a numerical value of a j-th column (j-th column from the left side) of an i-th row (i-th row from the upper side) of the parity check matrix initial value table is represented as $h_{i,j}$ and a row number of the j-th element of 1 of the w-th column of the parity check matrix H is represented as $H_{w-j}$, the row number $H_{w-j}$ of the element of 1 of the w-th column to be a column other than the $(1 + 360 \times (i - 1))$-th column of the parity check matrix H can be calculated by an expression (10).

$$H_{w - j} = \mathrm{mod}\{h_{i,j} + \mathrm{mod}((w-1),P) \times q, M\} \qquad \cdots (10)$$

In this case, mod(x, y) means a remainder that is obtained by dividing x by y.

In addition, P is a column number of a unit of the cyclic structure described above. For example, in the standard of the DVB-S.2, the DVB-T.2, and the DVB-C.2, P is 360 as described above. In addition, q is a value M/360 that is obtained by dividing the parity length M by the column number P (= 360) of the unit of the cyclic structure.

The parity check matrix generating unit 613 (FIG. 35) specifies the row numbers of the elements of 1 of the (1 + 360 $\times$ (i - 1))-th column of the parity check matrix H by the parity check matrix initial value table.

The parity check matrix generating unit 613 (FIG. 35) calculates the row number $H_{w-j}$ of the element of 1 of the w-th column to be the column other than the (1 + 360 $\times$ (i - 1))-th column of the parity check matrix H, according to the expression (10), and generates the parity check matrix H in which the element of the obtained row number is set to 1.

[New LDPC code]

By the way, the suggestion of a standard that improves DVB-S.2 (which may be called DVB-Sx below) is requested.

In CfT (Call for Technology) submitted to a standardization conference of DVB-Sx, a predetermined number of ModCod (combination of a modulation method (Modulation) and an LDPC code (Code)) is requested for each range (range) of C/N (Carrier to Noise ratio) (SNR (Signal to Noise Ratio)) according to the use case.

That is, in CfT, as the first request, it is requested that 20 pieces of ModCod are prepared in a range of 7 dB in which C/N is from 5 dB to 12 dB, for the usage of DTH (Direct To Home).

In addition, in CfT, as the second request, it is requested that 22 pieces of ModCod are prepared in a range of 12 dB in which C/N is from 12 dB to 24 dB, as the third request, it is requested that 12 pieces of ModCod are prepared in a range of 8 dB in which C/N is from -3 dB to 5 dB, and, as the fourth request, it is requested that 5 pieces of ModCod are prepared in a range of 7 dB in which C/N is from -10 dB to -3 dB.

Moreover, in CfT, it is requested that FER(Frame Error Rate) of ModCod in the first or fourth requests becomes about $10^{-5}$ (or less).

Here, in CfT, the priority of the first request is "1" which is the highest, and the priority of any of the second to fourth requests is "2" which is lower than the first request.

Therefore, in the present disclosure, at least in CfT, (a parity check matrix of) an LDPC code that can satisfy the first request of the highest priority is provided as a new LDPC code.

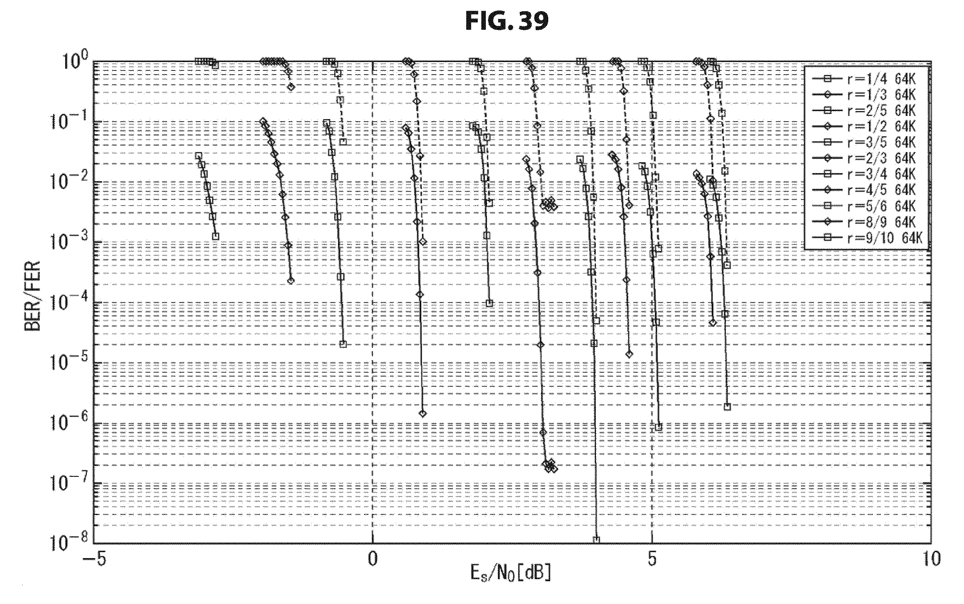

FIG. 39 illustrates a BER/FER curve in a case where QPSK is adopted as a modulation method, for LDPC codes of 11 encoding rates with a code length N of 64k.

In FIG. 39, the horizontal axis shows $E_s/N_0$ (signal-to-noise power ratio per symbol) corresponding to C/N, and the vertical axis shows FER/BER. Here, in FIG. 39, the solid line shows FER and the dotted line shows BER (Bit Error Rate).

In FIG. 39, there is a FER (BER) curve in a case where QPSK is adopted as a code method, for LSPC codes of 11 encoding rates with a code length N of 64k defined in DVB-S.2, in a range in which $E_s/N_0$ is 10dB.

That is, in FIG. 39, there are 11 FER curves of ModCod in which a modulation method is fixed to QPSK, in a range of about 10 dB of $E_s/N_0$ from about -3 dB to about 7 dB.

Therefore, as for LSPC codes of 11 encoding rates with a code length N of 64k defined in DVB-S.2, the average interval of FER curves of ModCod (which may be called an average interval below) is about 1 dB ($\approx$ 10 dB /(10-1))

Meanwhile, since it is requested to prepare 20 pieces of ModCod in a range in which $E_s/N_0$ (C/N) is 7 dB in the first request of CfT, the average interval of FER curves of ModCod is about 0.3 dB ($\approx$ 7 dB /(20-1)).

In a case where a modulation method is fixed to one kind such as QPSK to take margin, as compared with the case of DVB-S.2 in which ModCod with an average interval of about 1 dB can be obtained by LDPC codes of 11 encoding rates, LDPC codes of the number about three times of 11 encoding rates ($\approx$ 1 dB /0.3 dB), that is, LDPC codes of about 30 encoding rates only have to be provided to acquire ModCod with an average interval of 0.3 dB to satisfy the first request of CfT.

Therefore, the present disclosure prepares an LDPC code with an encoding rate of i/30 (where i denotes a positive integer less than 30) and a code length of 64k as an LDPC code of an encoding rate for which about 30 encoding rates are easily set, and provides it as a new LDPC code that satisfies at least the first request with the highest priority in CfT.

Here, as for the new LDPC code, from the viewpoint that the affinity (compatibility) with DVB-S.2 is maintained as much as possible, similar to an LDPC code defined in DVB-S.2, parity matrix $H_T$ of the parity check matrix H is assumed to have a staircase structure (FIG. 11).

In addition, as for the new LDPC code, similar to the LDPC code defined in DVB-S.2, the information matrix $H_A$ of the parity check matrix H is assumed to be a cyclic structure and column number P which is the unit of the cyclic structure is assumed to be 360.

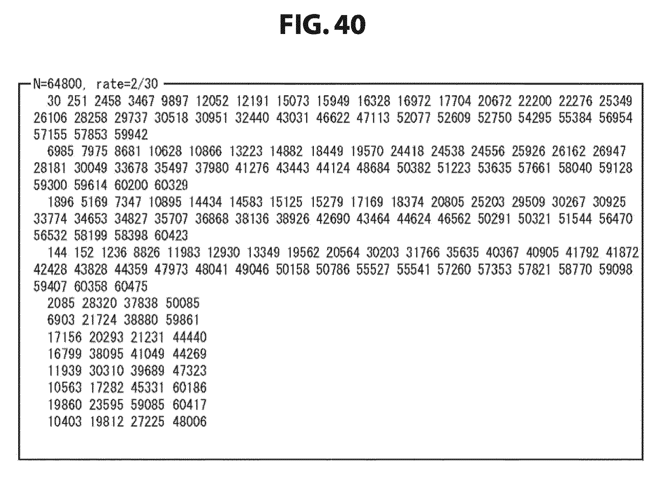

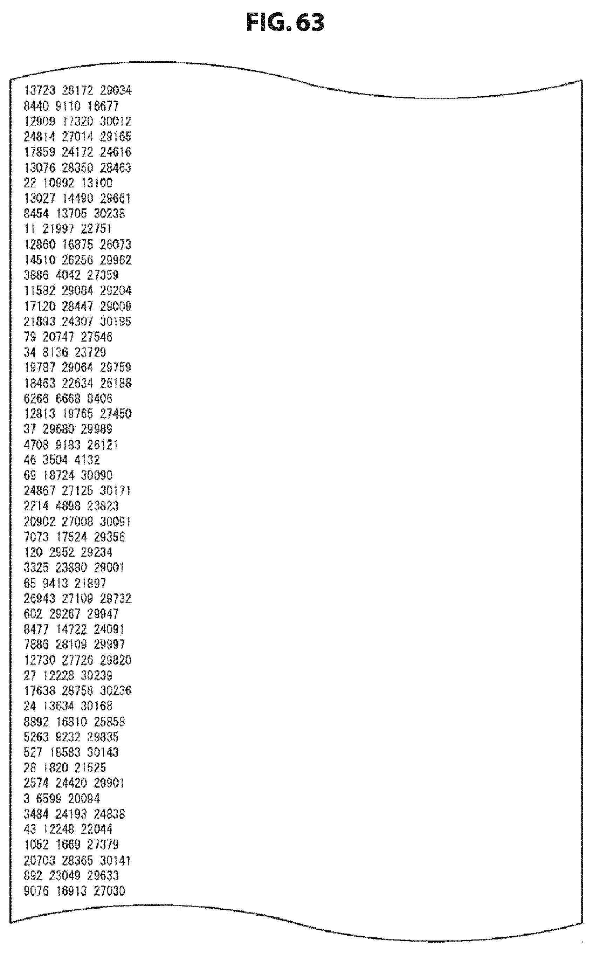

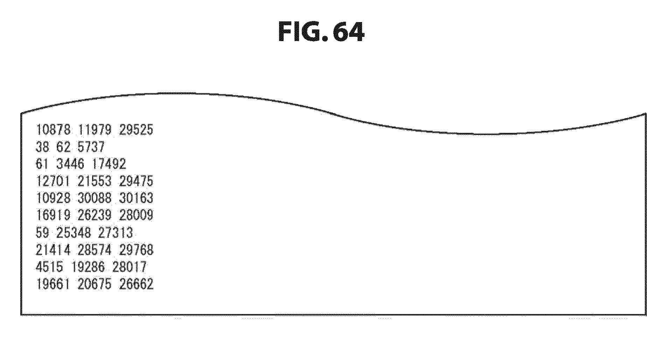

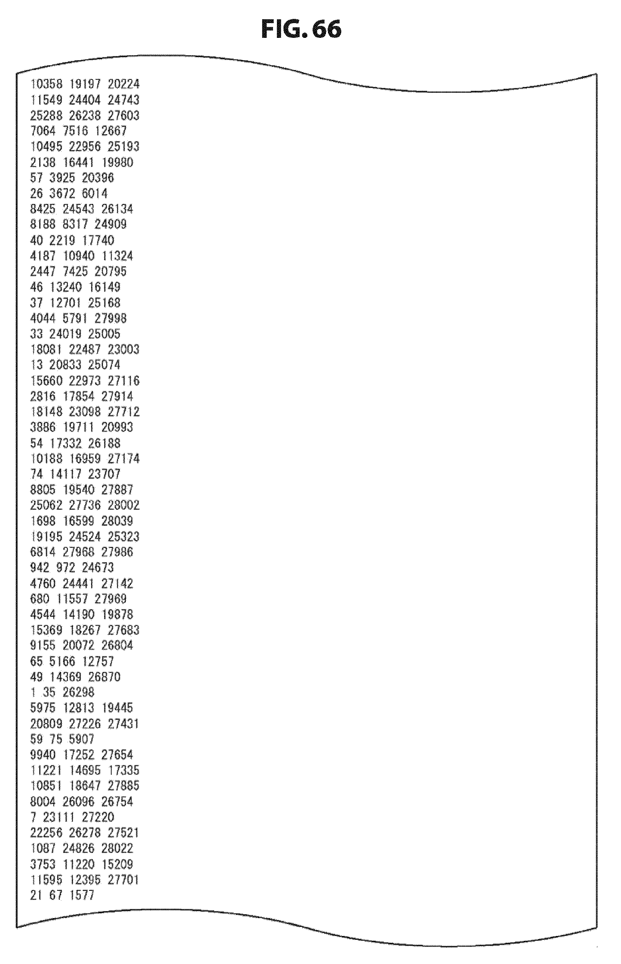

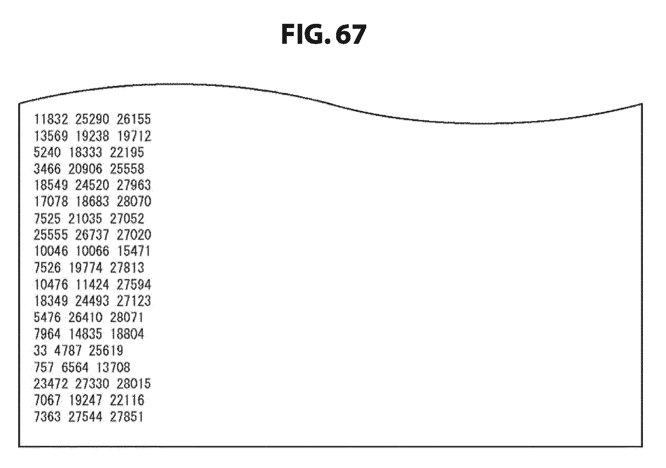

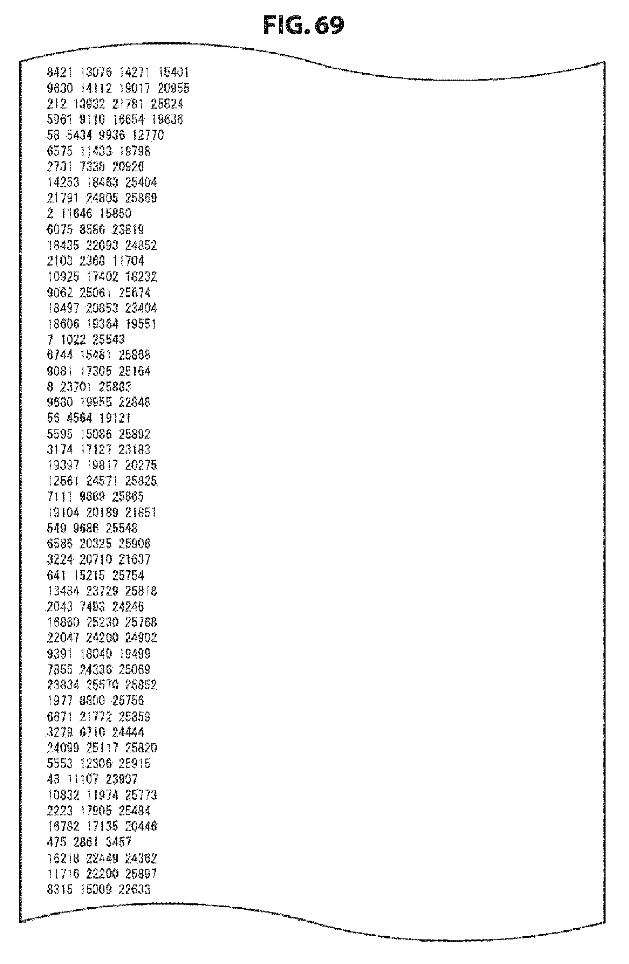

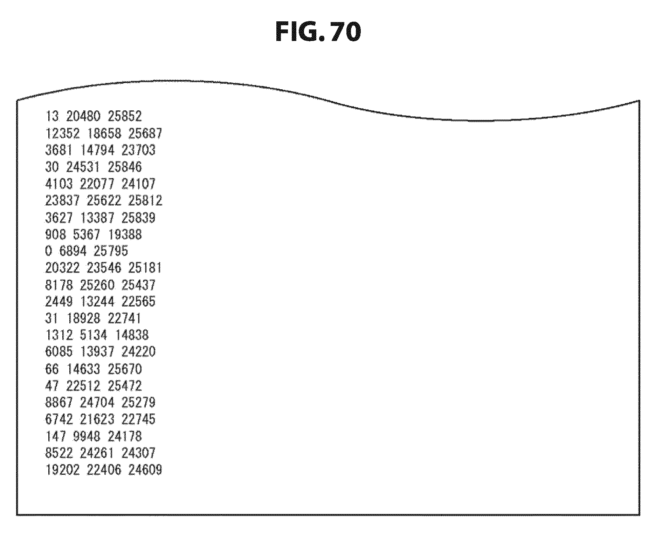

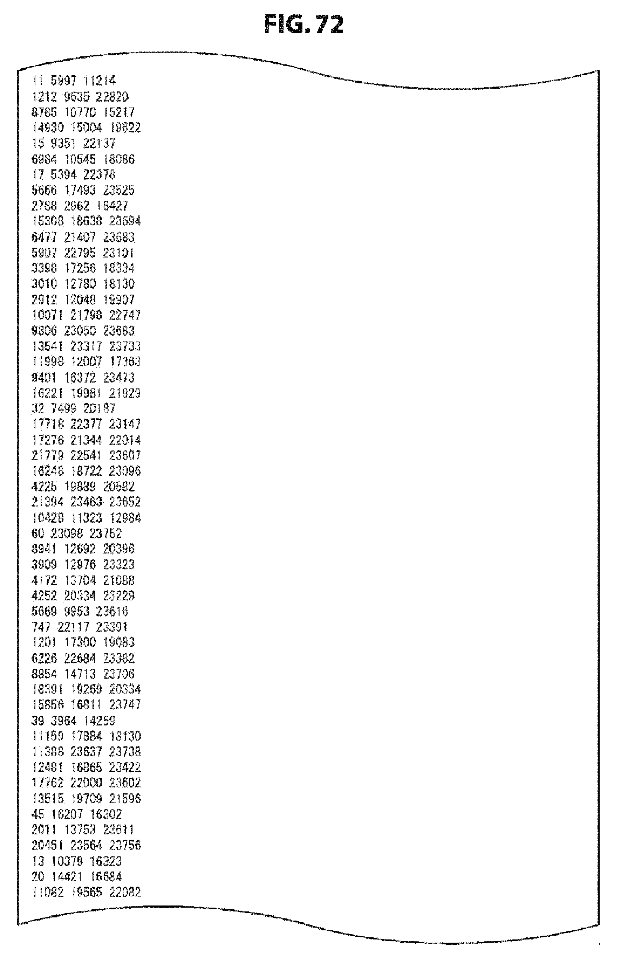

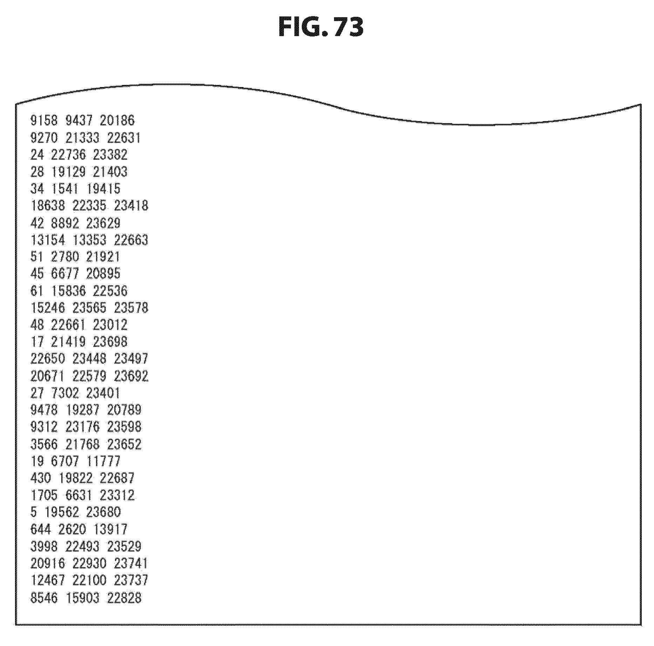

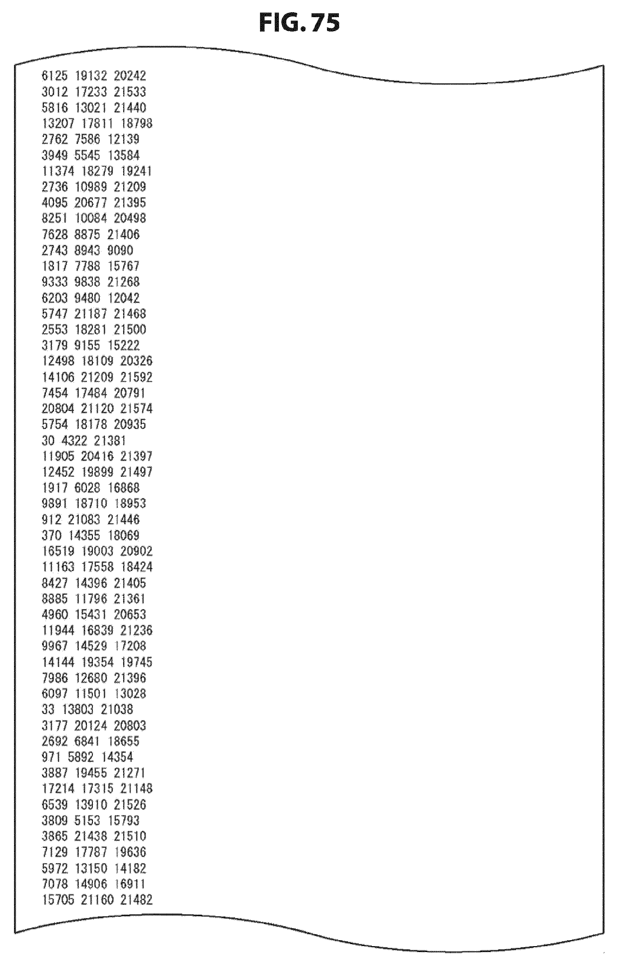

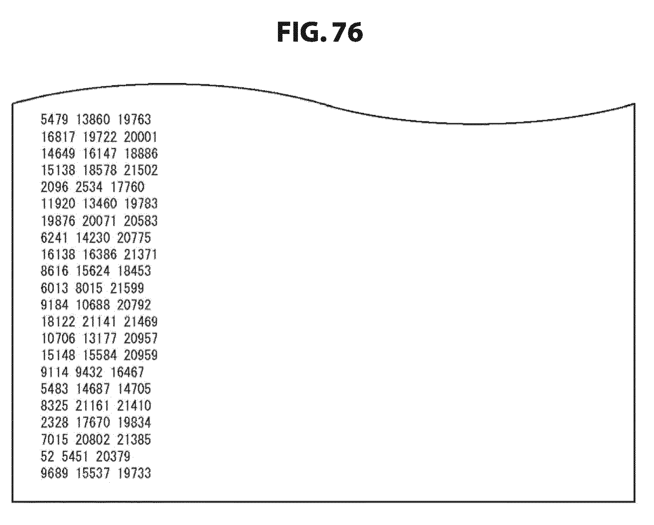

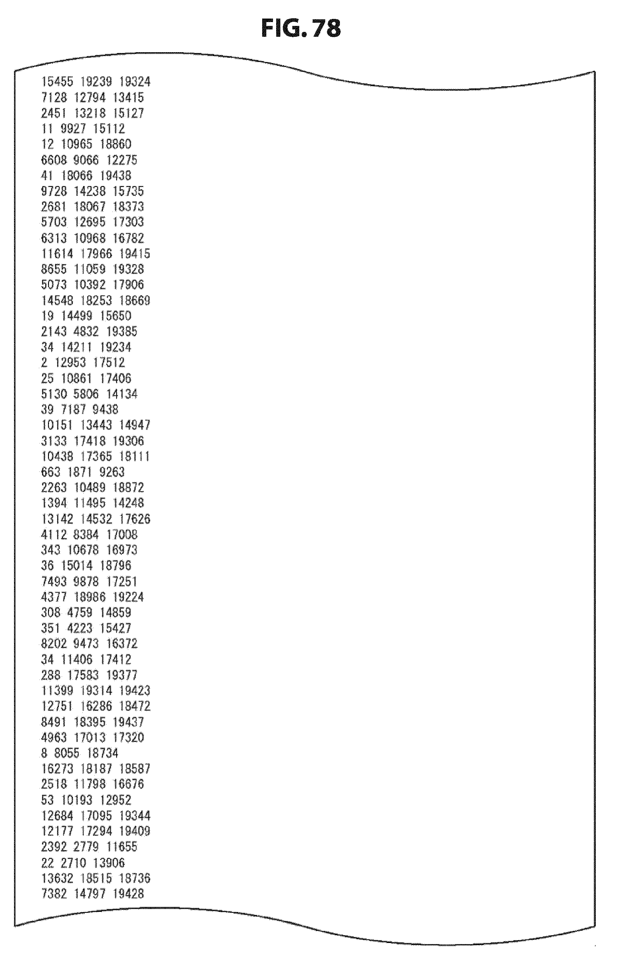

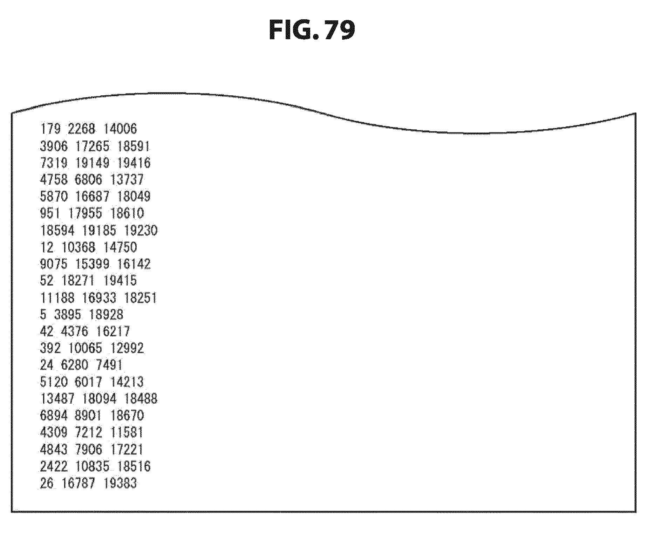

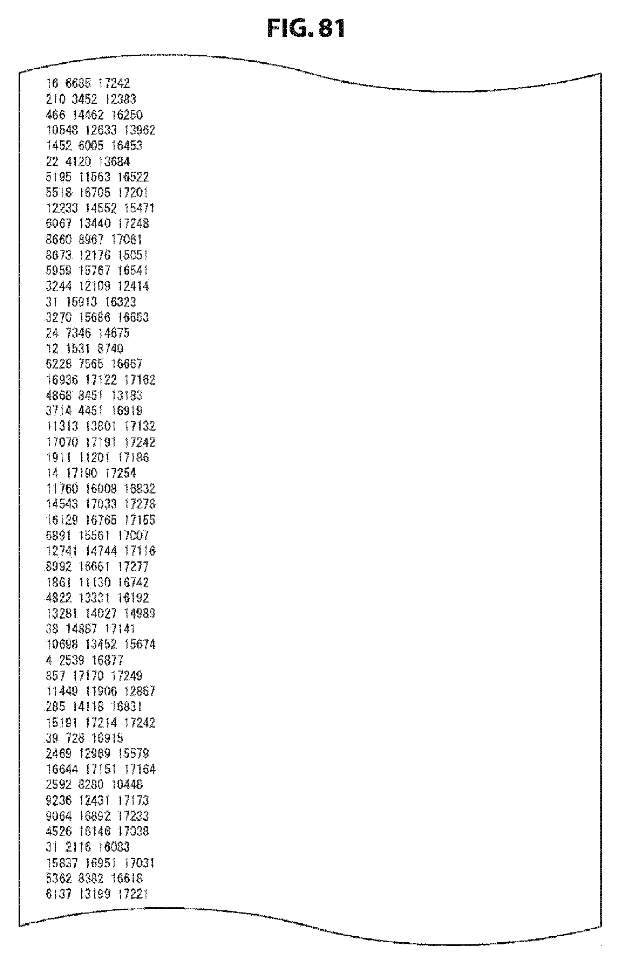

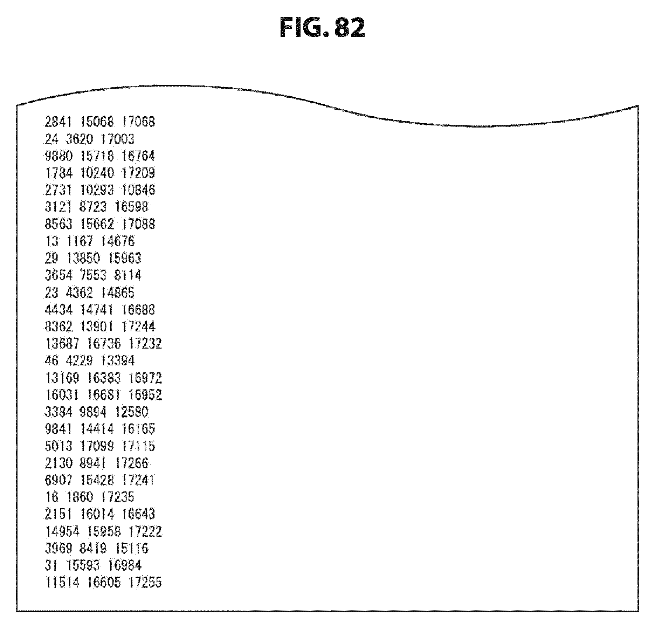

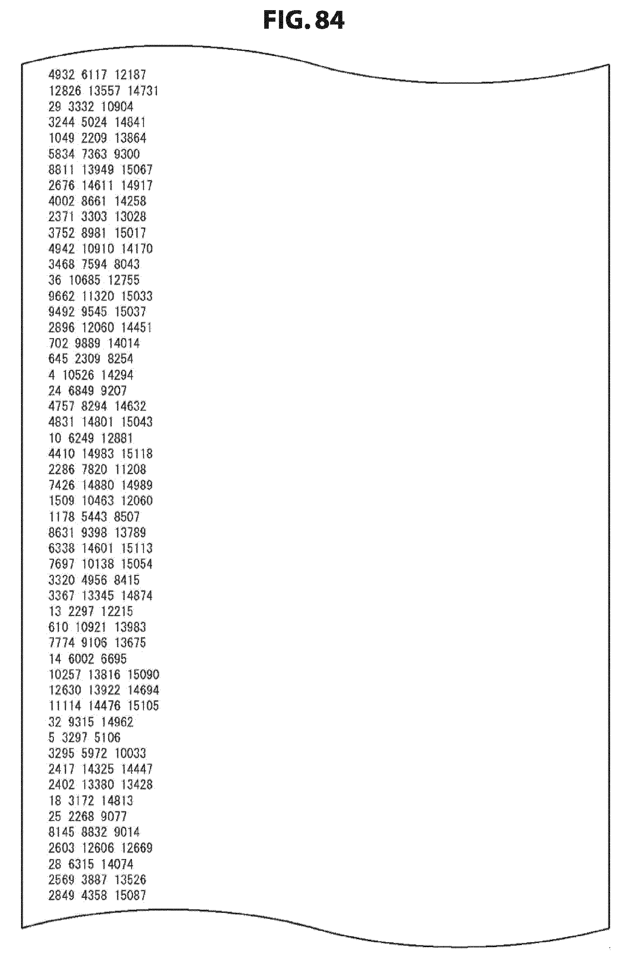

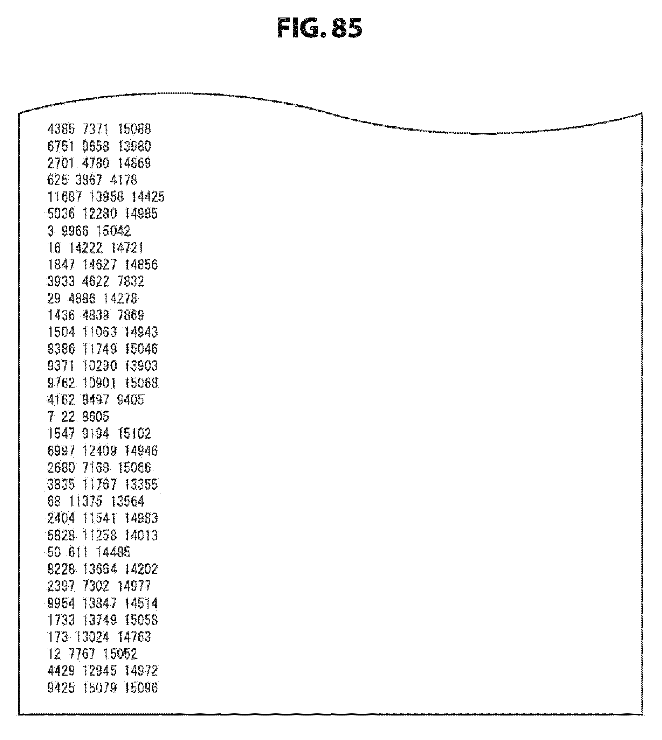

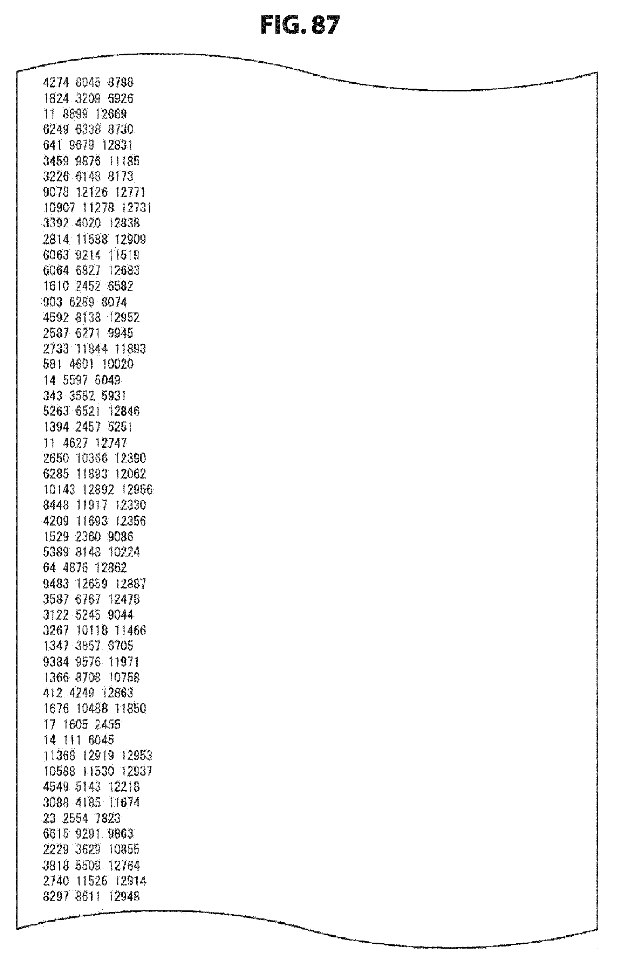

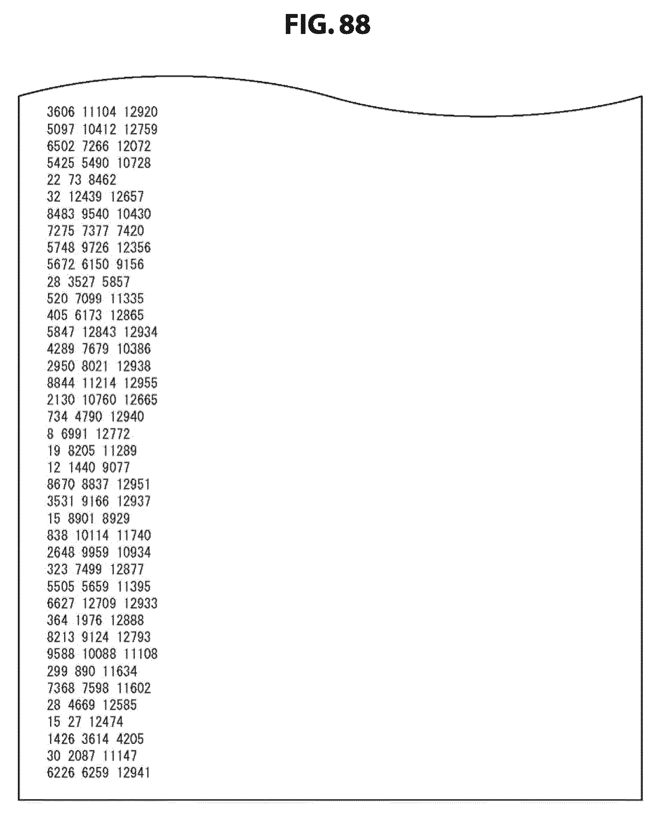

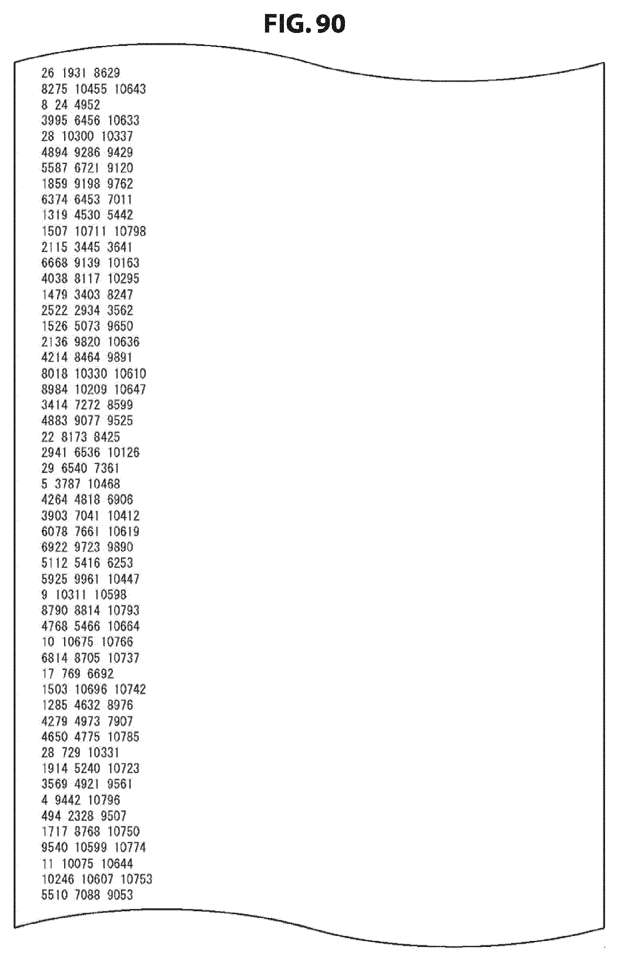

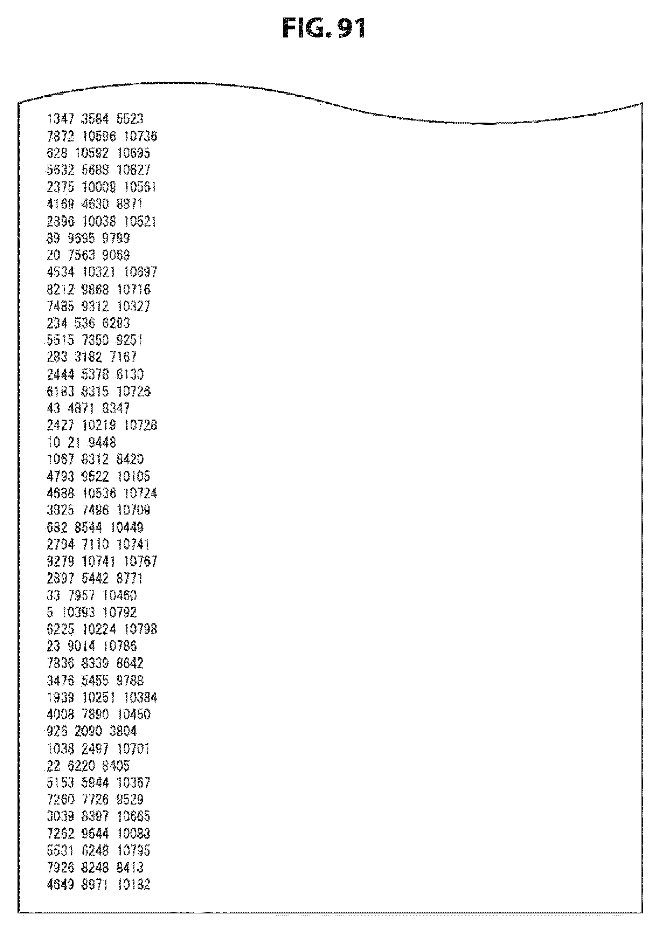

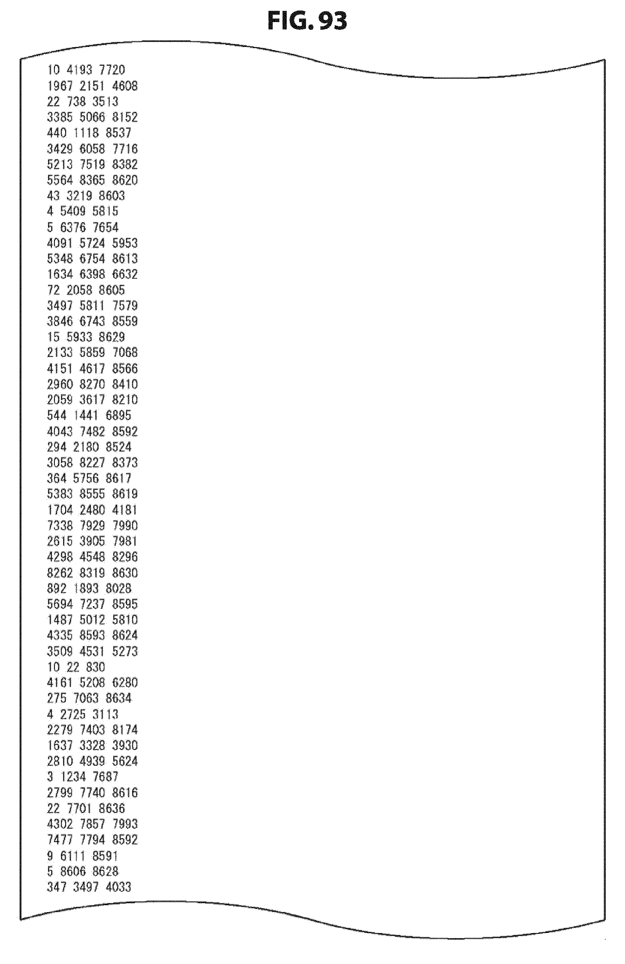

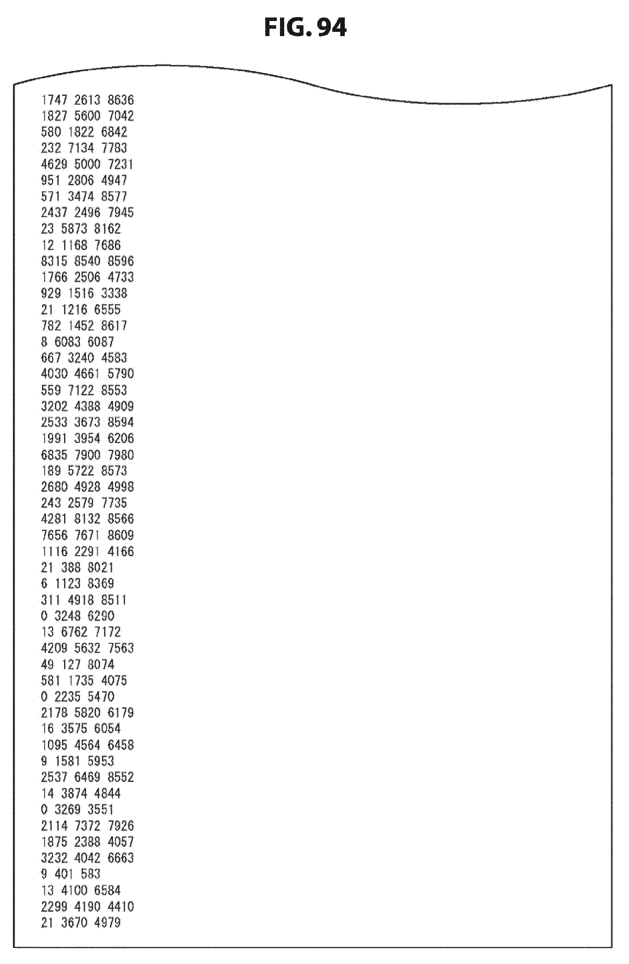

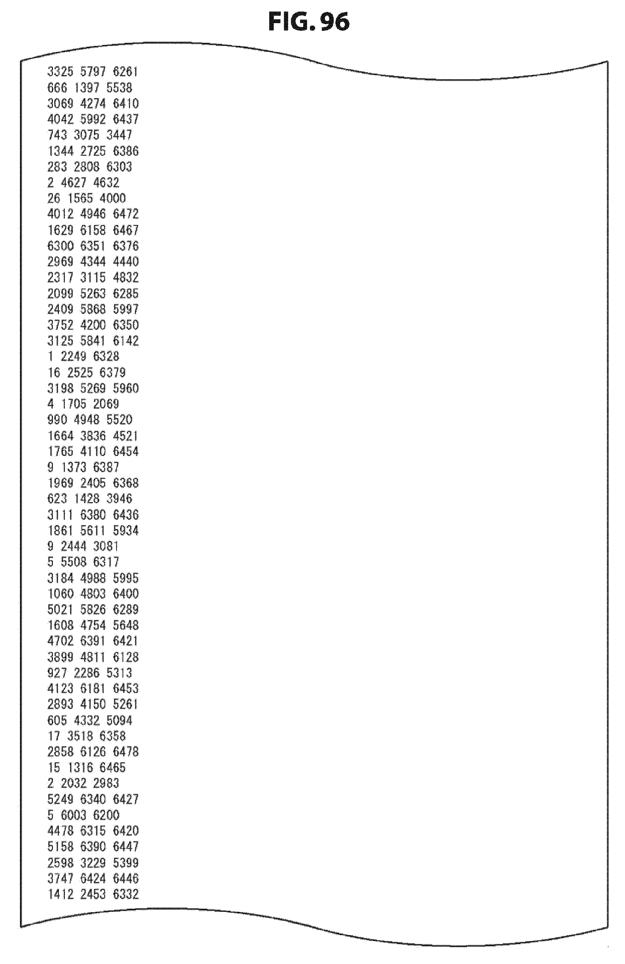

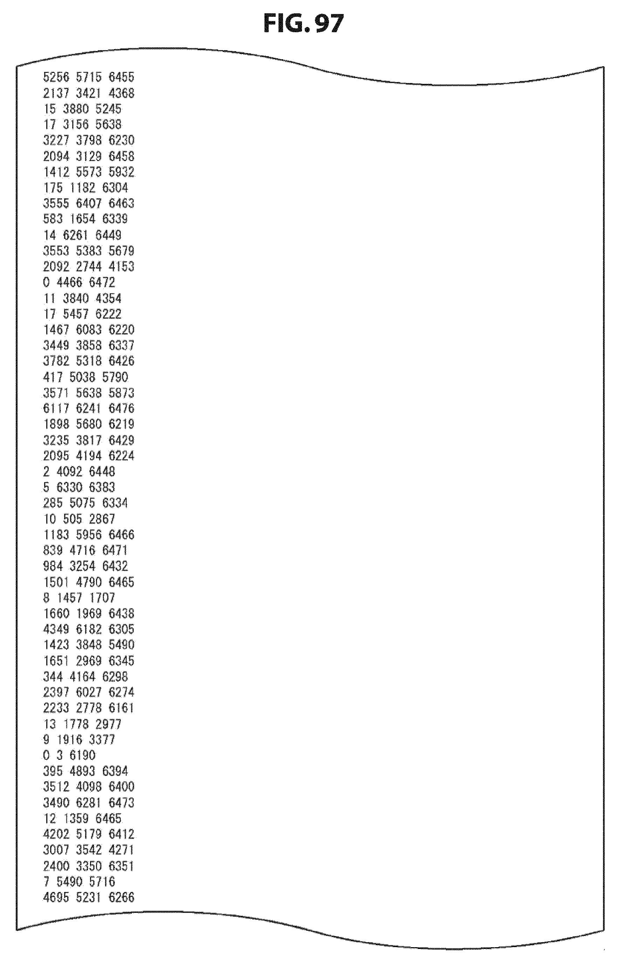

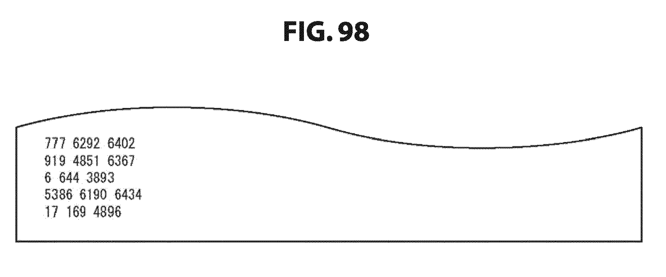

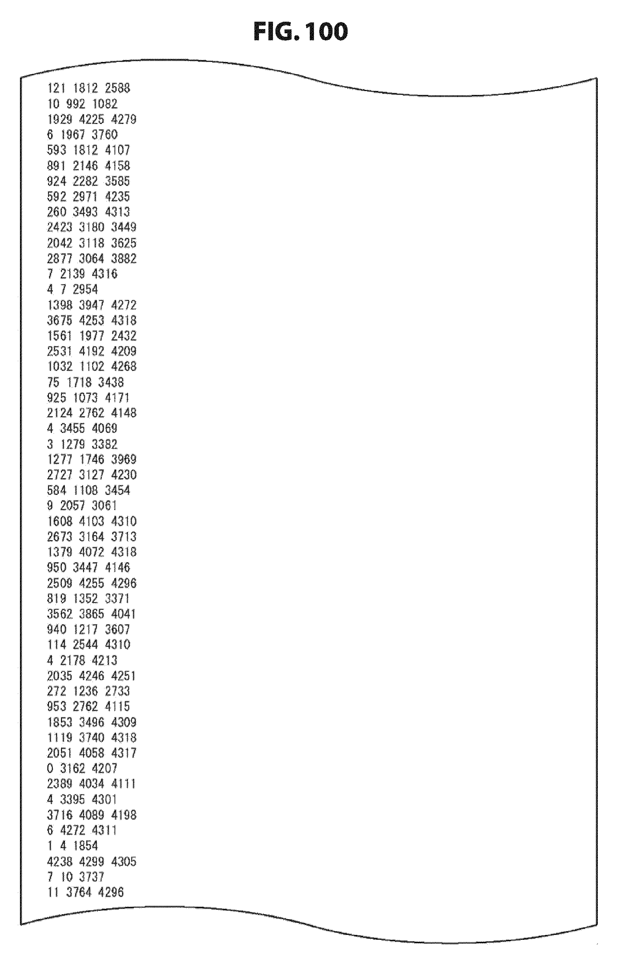

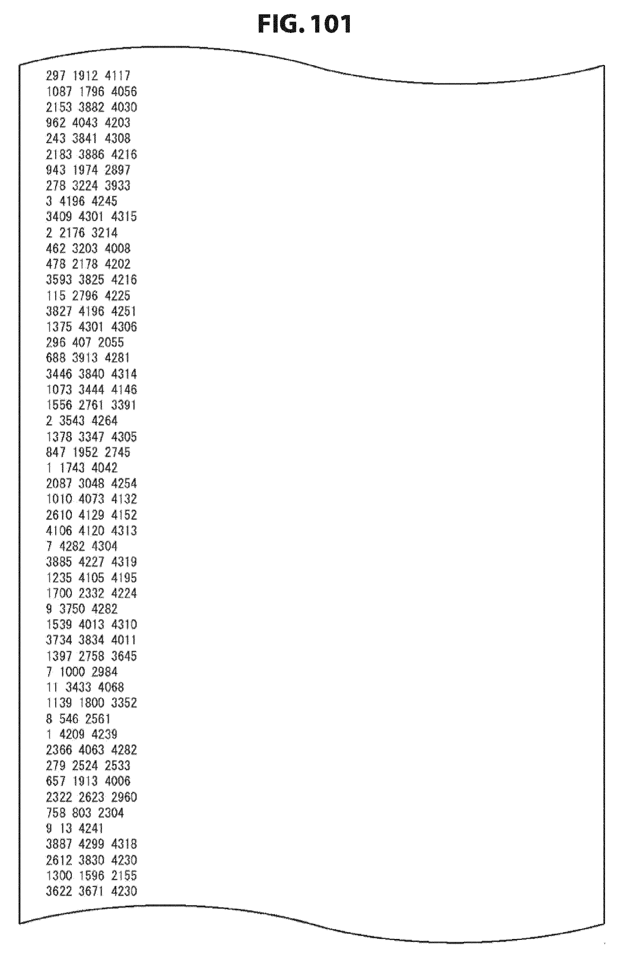

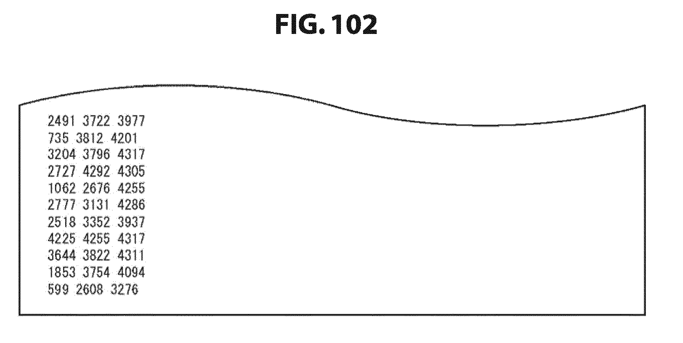

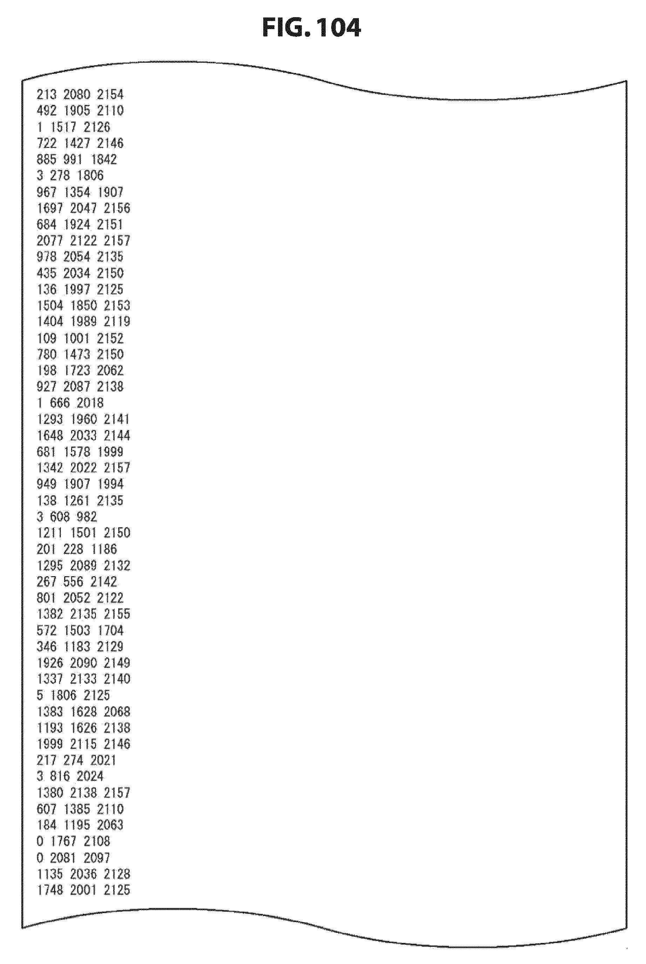

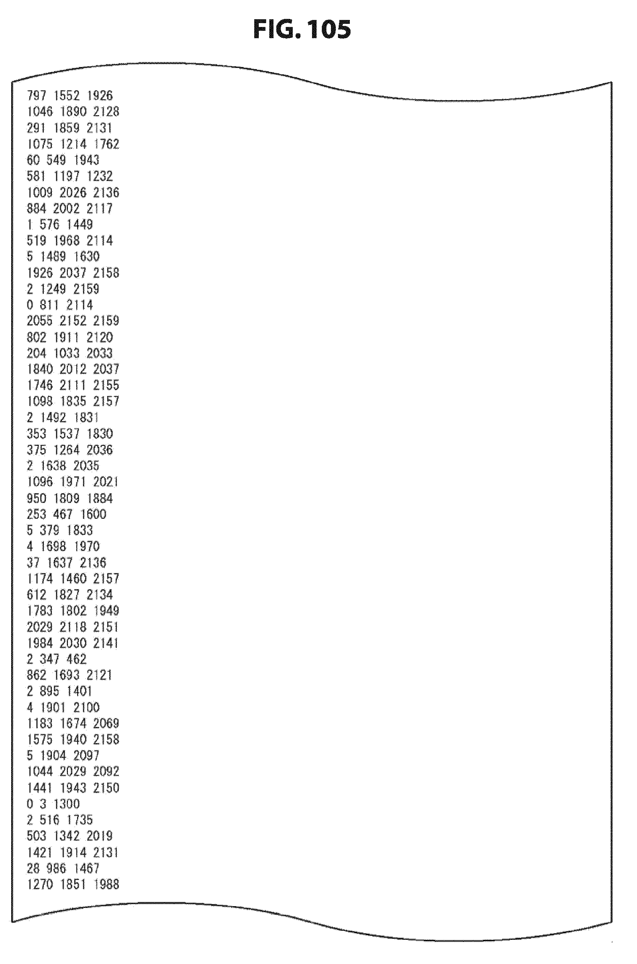

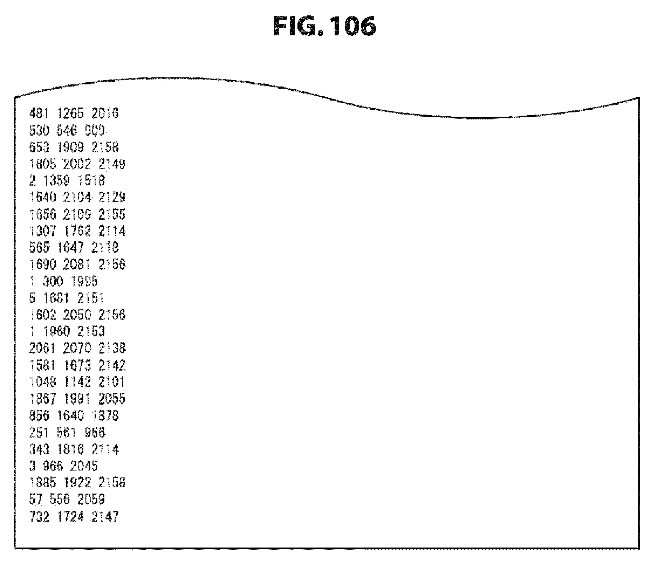

FIG. 40 to FIG. 106 are diagrams illustrating examples of a parity check matrix initial value table of a new LDPC code with a code length N of 64k bits and an encoding rate of i/30 as described above.

Here, since the new LDPC code is an LDPC code in which the encoding rate is expressed by i/30, there are LDPC codes with 29 encoding rates of 1/30, 2/30, 3/30 ... 28/30 and 29/30 at maximum.

However, as for an LDPC code with an encoding rate of 1/30, there is a possibility that the use is restricted in respect of efficiency. Moreover, as for an LDPC code with an encoding rate of 29/30, the use may be restricted in respect of the error rate (BER/FER).

Therefore, one or both of the LDPC code with an encoding rate of 1/30 and the LDPC code with an encoding rate of 29/30 among the LDPC codes with 29 encoding rates of encoding rates 1/30 to 29/30 can be assumed not to be treated as a new LDPC code.

Here, for example, LDPC codes with 28 encoding rates of encoding rates 2/30 to 29/30 among encoding rates 1/30 to 29/30 are assumed as new LDPC codes, and a parity check matrix initial value table with respect to the parity check matrix H of the new LDPC codes are shown below.

FIG. 40 illustrates a parity check matrix initial value table with respect to the parity check matrix H of the LDPC code with a code length N of 64k bits and an encoding rate of 2/30.

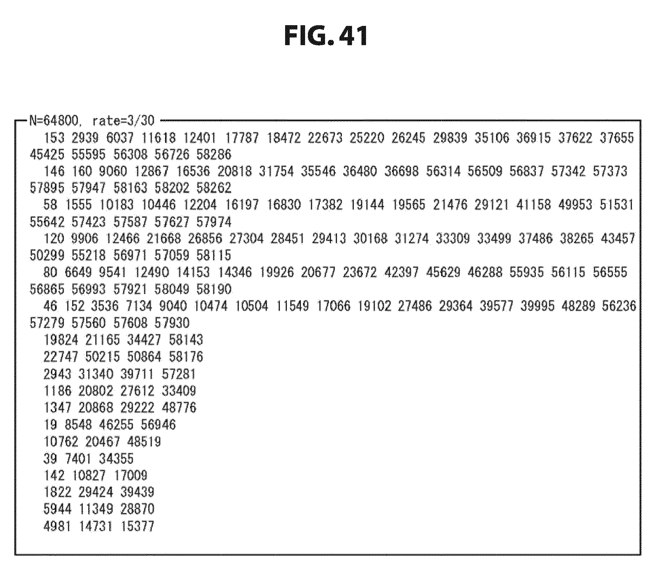

FIG. 41 illustrates a parity check matrix initial value table with respect to the parity check matrix H of the LDPC code with a code length N of 64k bits and an encoding rate of 3/30.

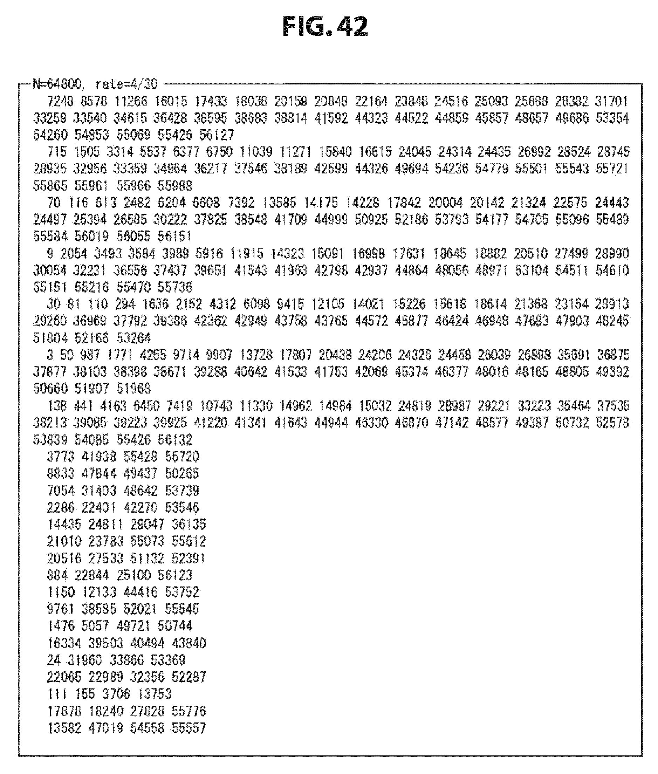

FIG. 42 illustrates a parity check matrix initial value table with respect to the parity check matrix H of the LDPC code with a code length N of 64k bits and an encoding rate of 4/30.

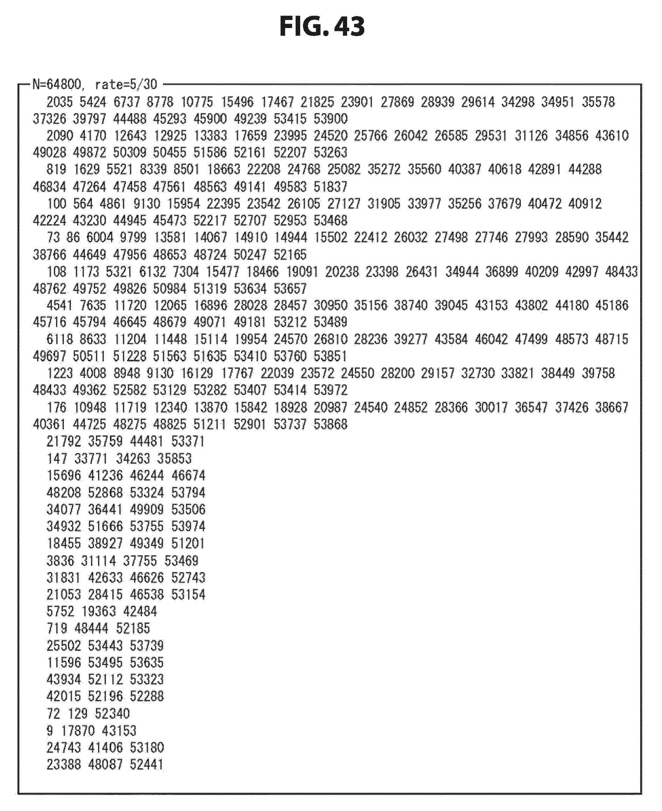

FIG. 43 illustrates a parity check matrix initial value table with respect to the parity check matrix H of the LDPC code with a code length N of 64k bits and an encoding rate of 5/30.

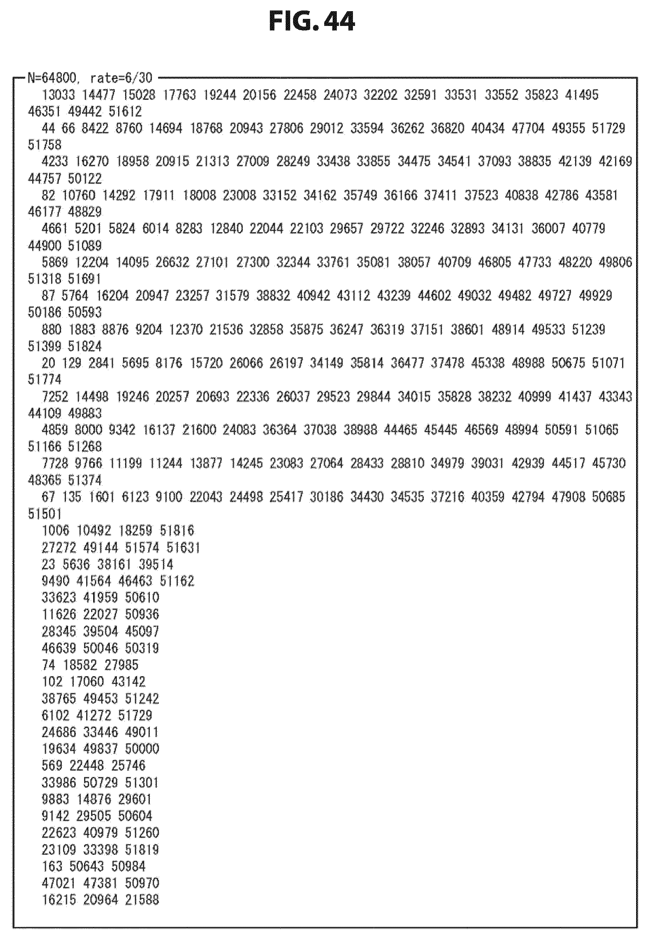

FIG. 44 illustrates a parity check matrix initial value table with respect to the parity check matrix H of the LDPC code with a code length N of 64k bits and an encoding rate of 6/30.

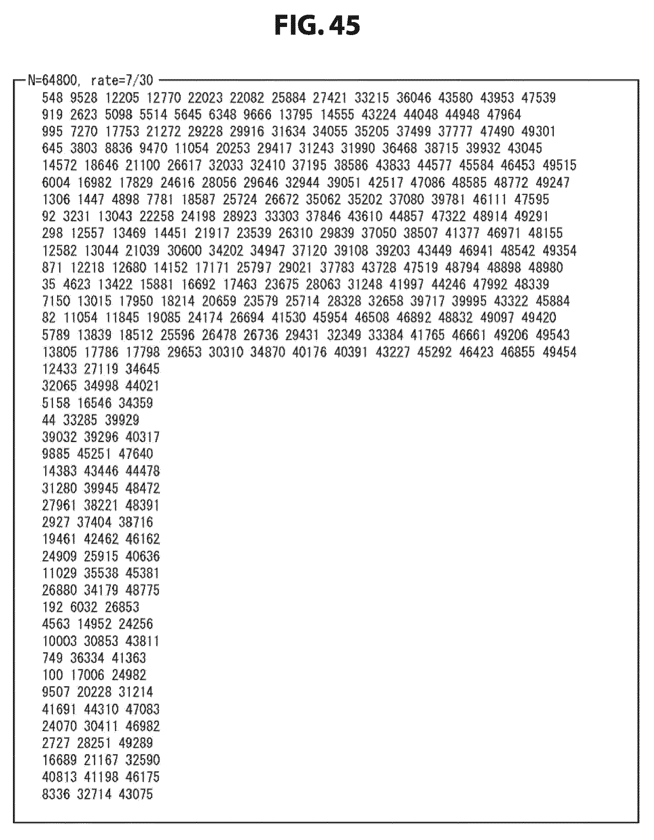

FIG. 45 illustrates a parity check matrix initial value table with respect to the parity check matrix H of the LDPC code with a code length N of 64k bits and an encoding rate of 7/30.

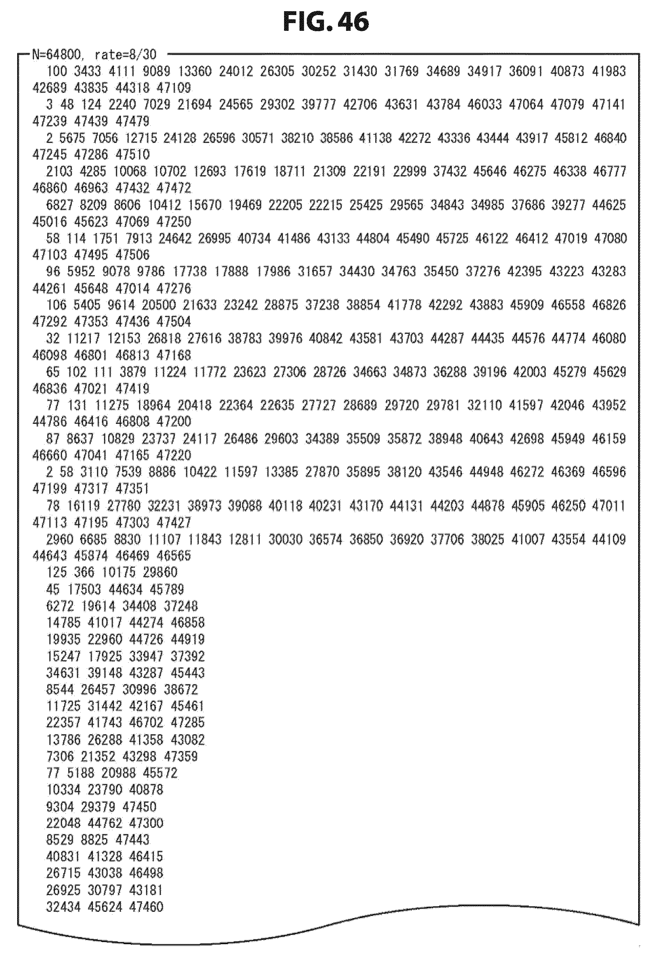

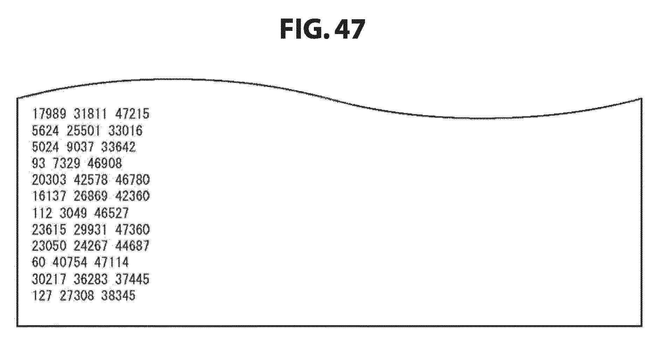

FIGS. 46 and 47 illustrate a parity check matrix initial value table with respect to the parity check matrix H of the LDPC code with a code length N of 64k bits and an encoding rate of 8/30.

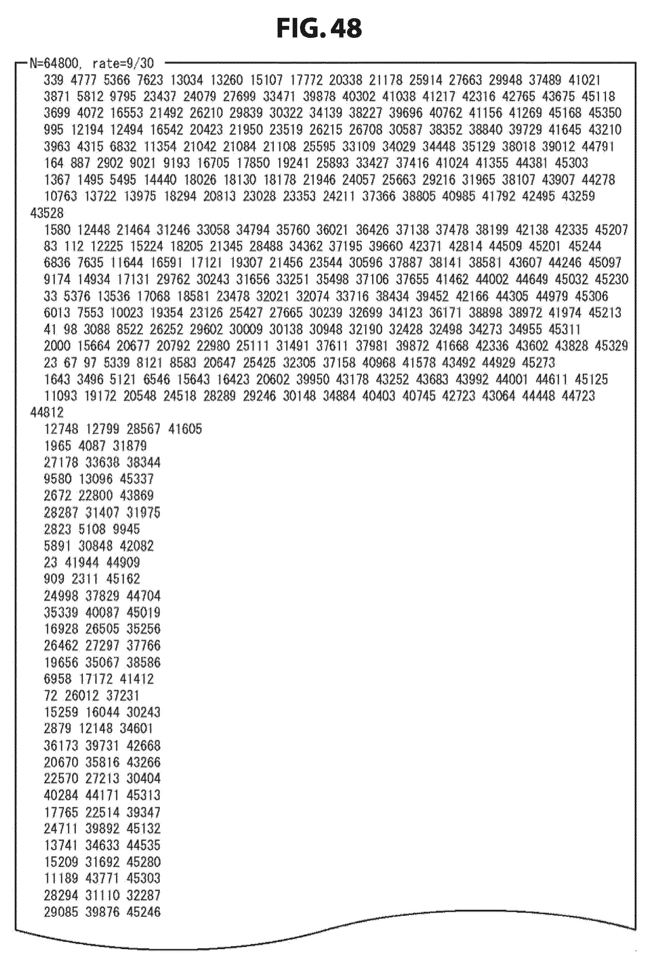

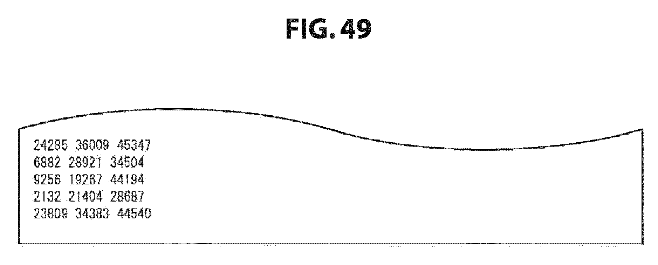

FIGS. 48 and 49 illustrate a parity check matrix initial value table with respect to the parity check matrix H of the LDPC code with a code length N of 64k bits and an encoding rate of 9/30.

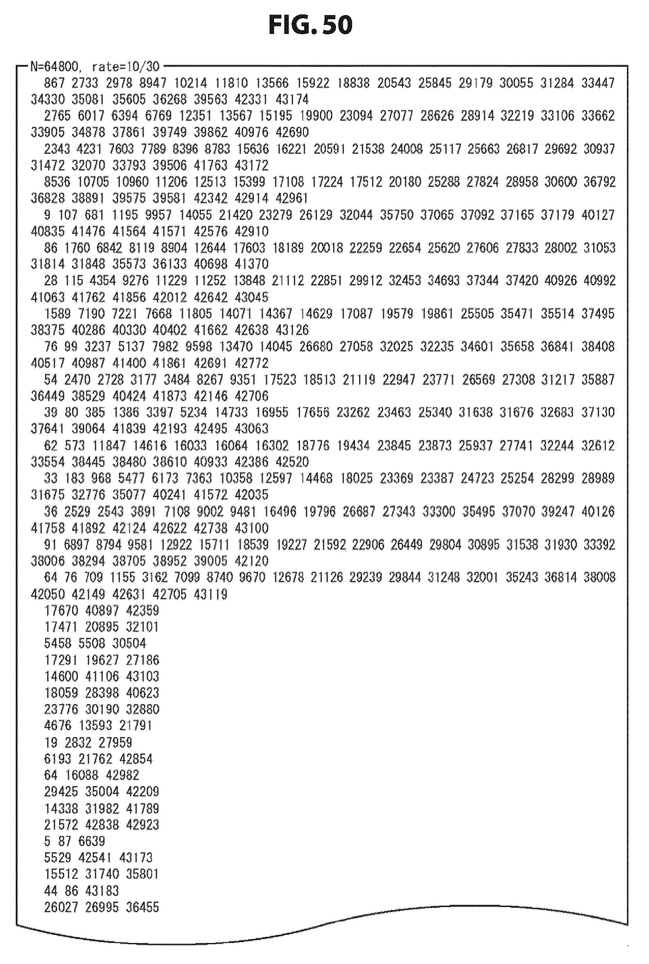

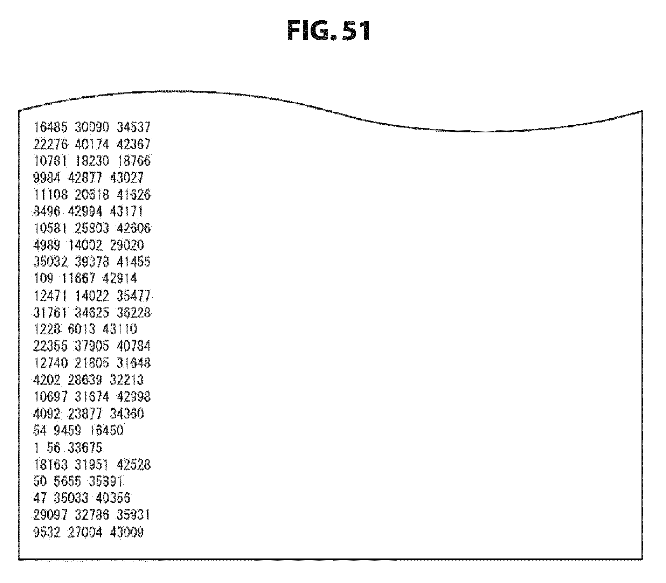

FIGS. 50 and 51 illustrate a parity check matrix initial value table with respect to the parity check matrix H of the LDPC code with a code length N of 64k bits and an encoding rate of 10/30.

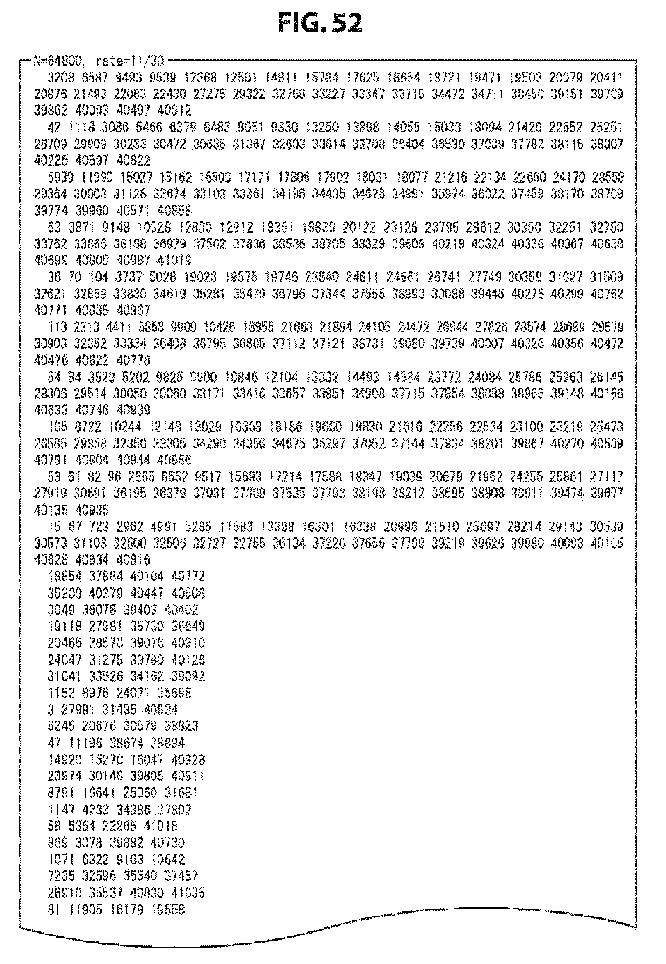

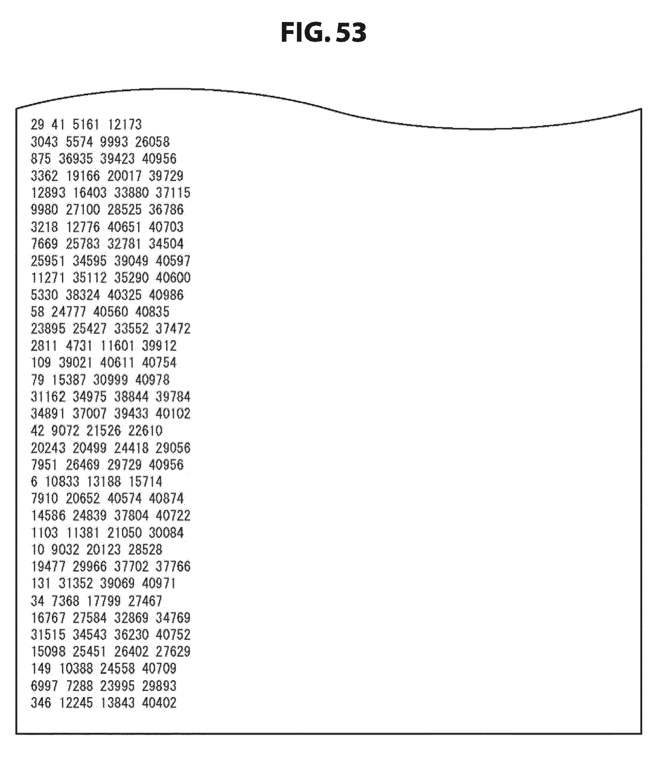

FIGS. 52 and 53 illustrate a parity check matrix initial value table with respect to the parity check matrix H of the LDPC code with a code length N of 64k bits and an encoding rate of 11/30.

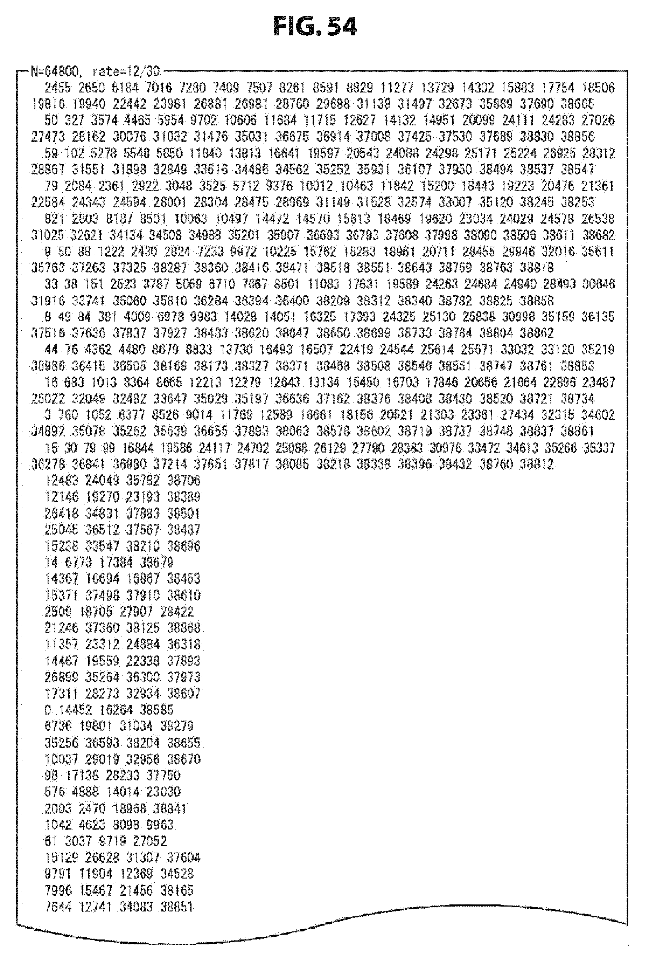

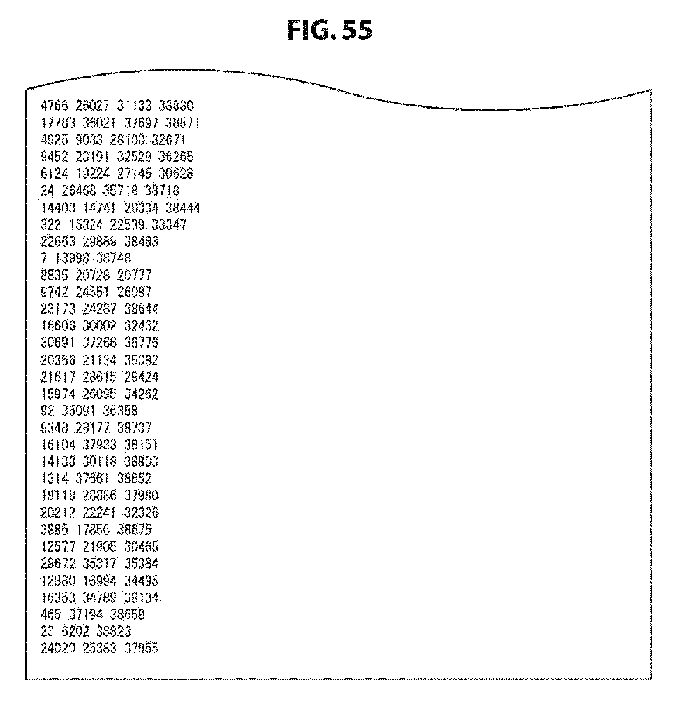

FIGS. 54 and 55 illustrate a parity check matrix initial value table with respect to the parity check matrix H of the LDPC code with a code length N of 64k bits and an encoding rate of 12/30.

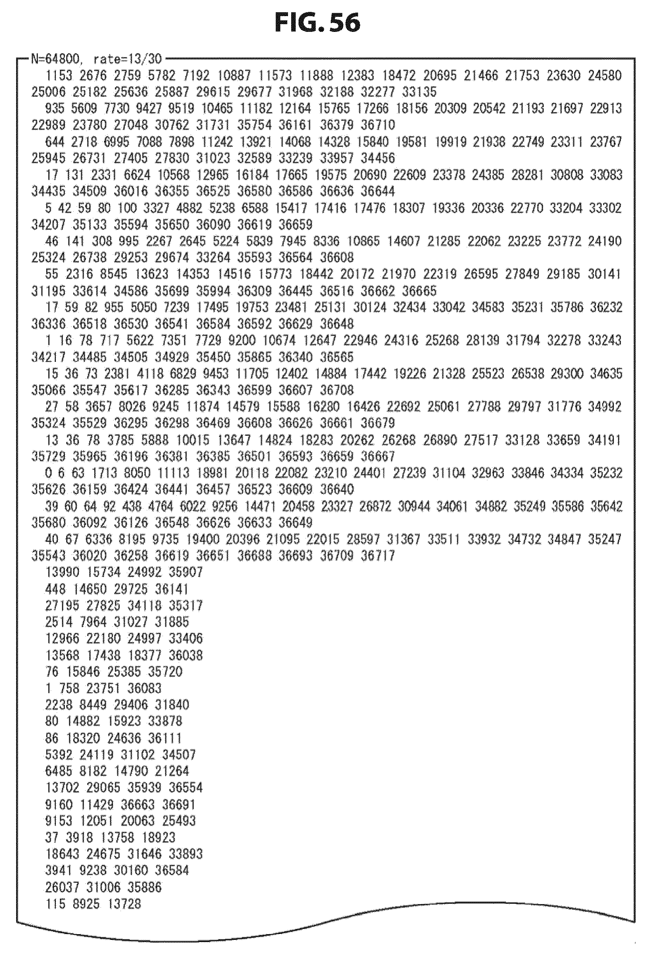

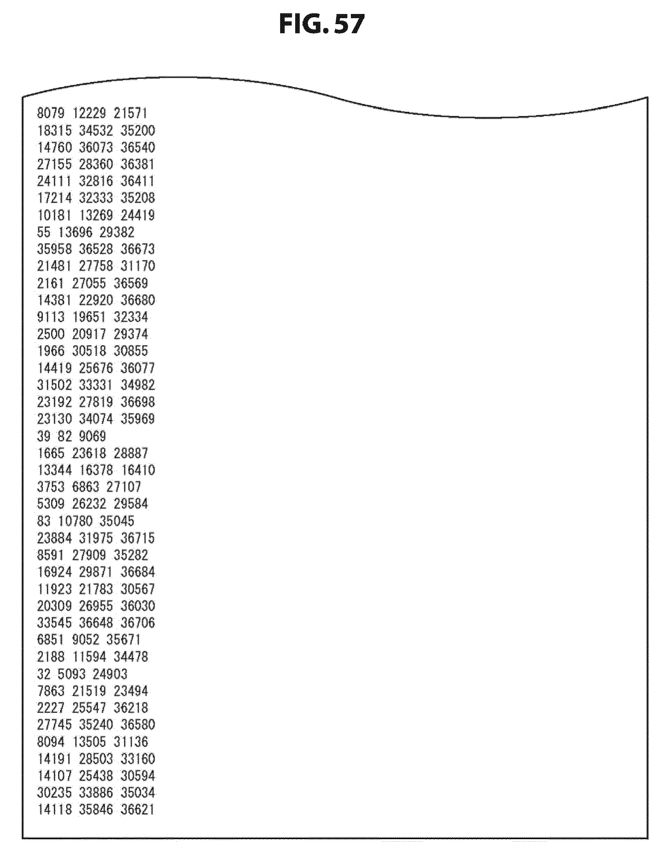

FIGS. 56 and 57 illustrate a parity check matrix initial value table with respect to the parity check matrix H of the LDPC code with a code length N of 64k bits and an encoding rate of 13/30.

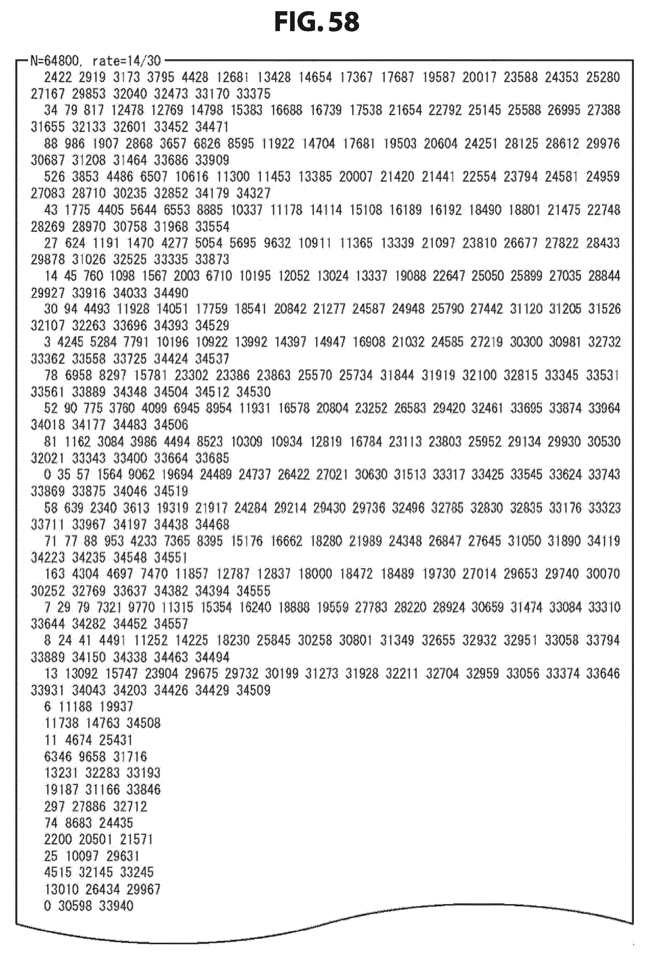

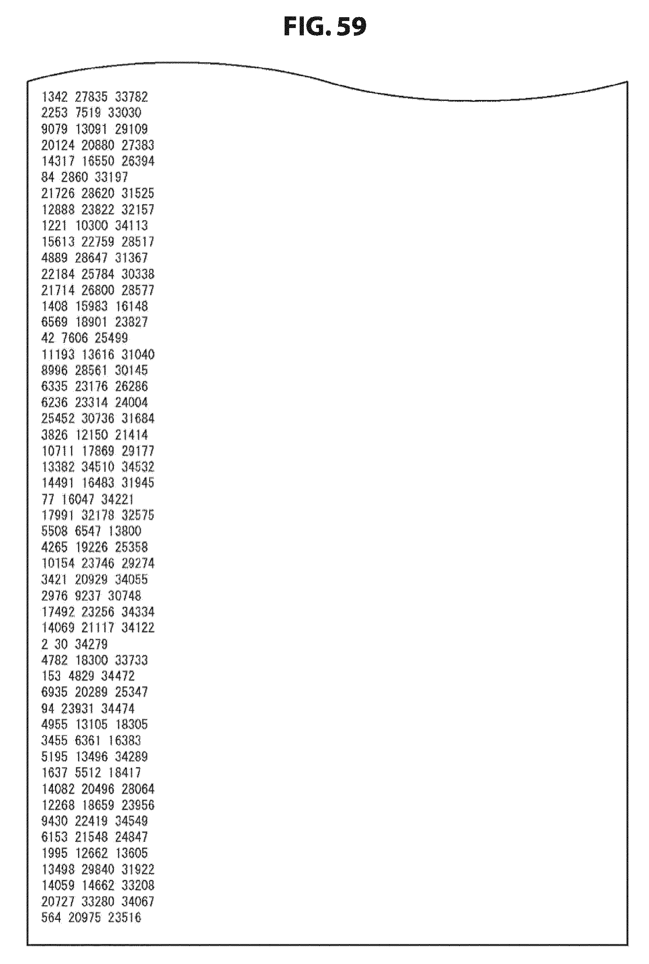

FIGS. 58 and 59 illustrate a parity check matrix initial value table with respect to the parity check matrix H of the LDPC code with a code length N of 64k bits and an encoding rate of 14/30.

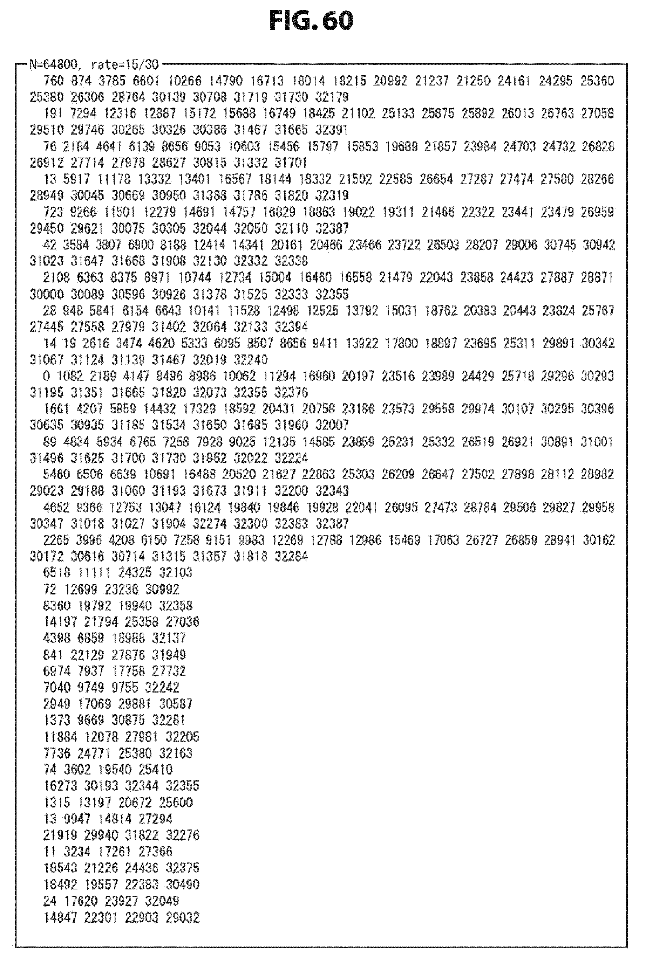

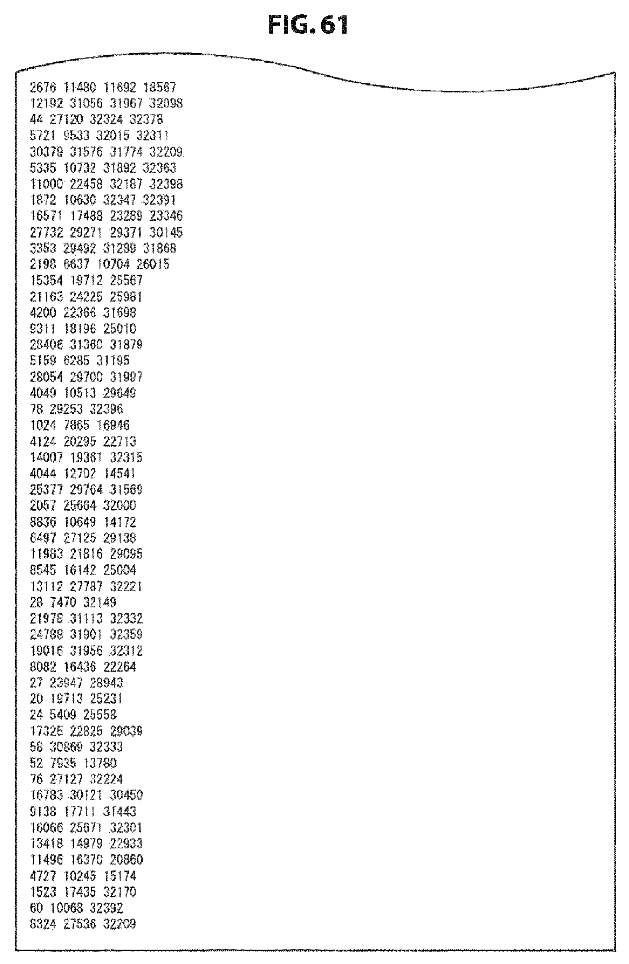

FIGS. 60 and 61 illustrate a parity check matrix initial value table with respect to the parity check matrix H of the LDPC code with a code length N of 64k bits and an encoding rate of 15/30.

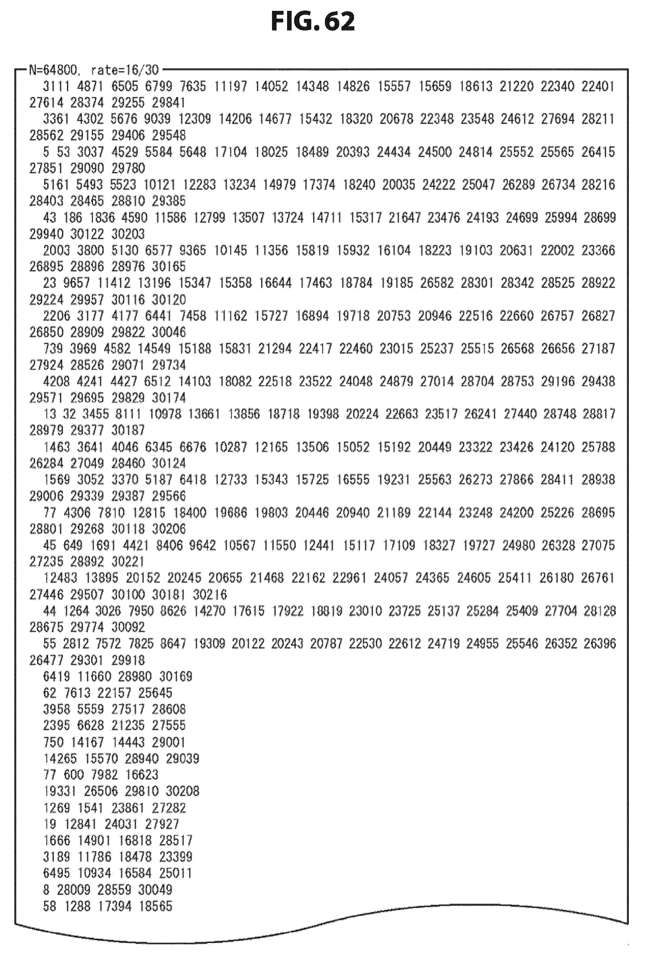

FIGS. 62, 63, and 64 illustrate a parity check matrix initial value table with respect to the parity check matrix H of the LDPC code with a code length N of 64k bits and an encoding rate of 16/30.

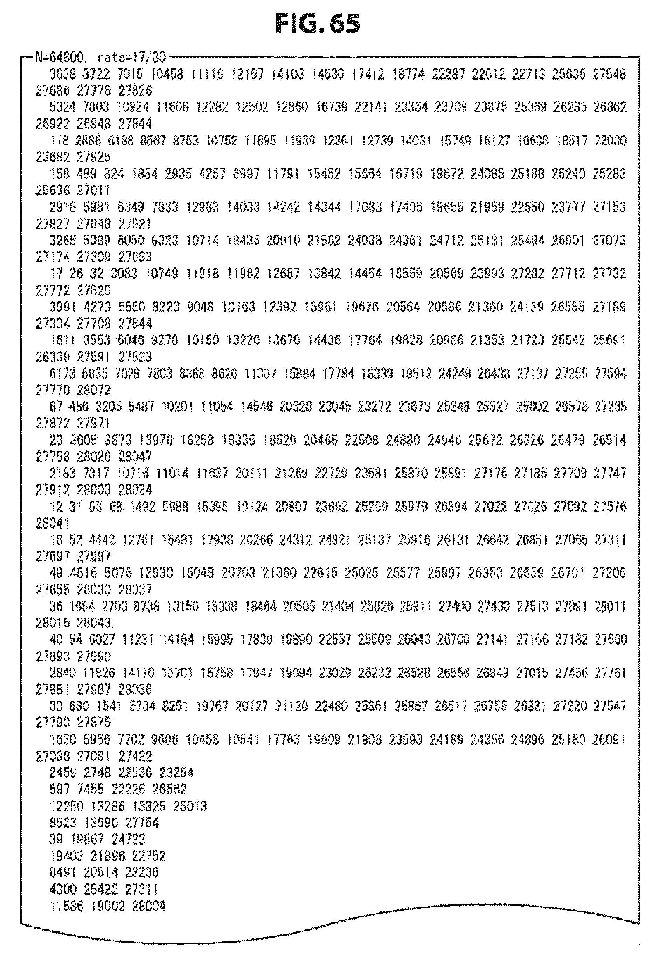

FIGS. 65, 66, and 67 illustrate a parity check matrix initial value table with respect to the parity check matrix H of the LDPC code with a code length N of 64k bits and an encoding rate of 17/30.

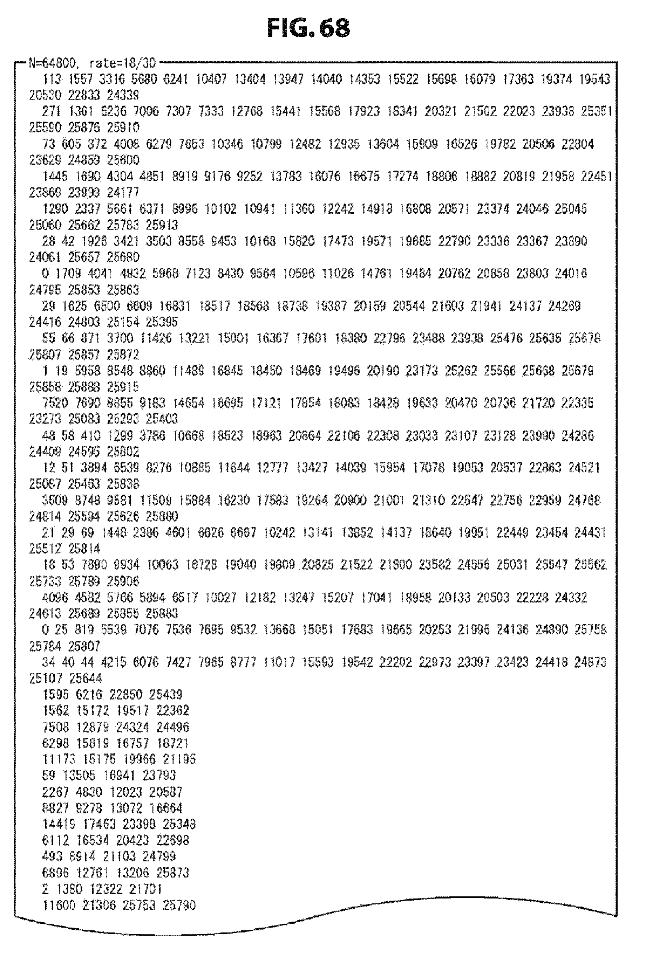

FIGS. 68, 69, and 70 illustrate a parity check matrix initial value table with respect to the parity check matrix H of the LDPC code with a code length N of 64k bits and an encoding rate of 18/30.

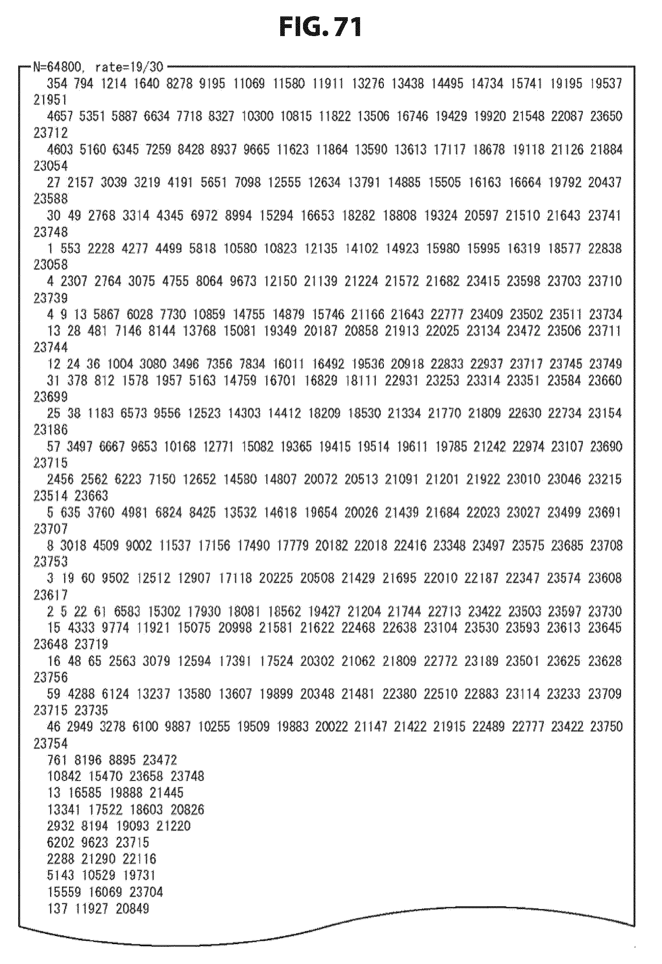

FIGS. 71, 72, and 73 illustrate a parity check matrix initial value table with respect to the parity check matrix H of the LDPC code with a code length N of 64k bits and an encoding rate of 19/30.

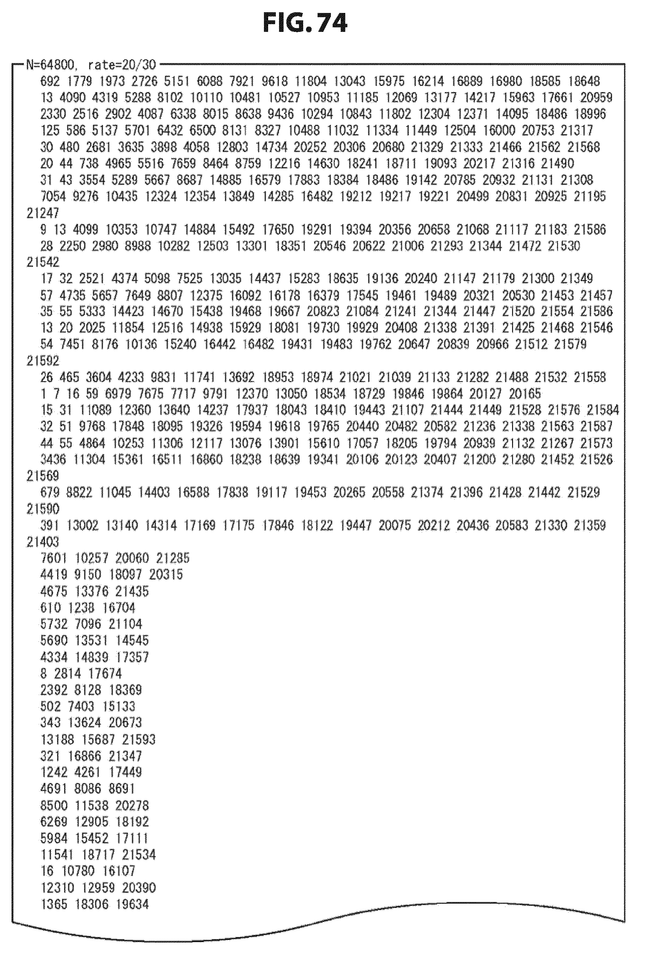

FIGS. 74, 75, and 76 illustrate a parity check matrix initial value table with respect to the parity check matrix H of the LDPC code with a code length N of 64k bits and an encoding rate of 20/30.

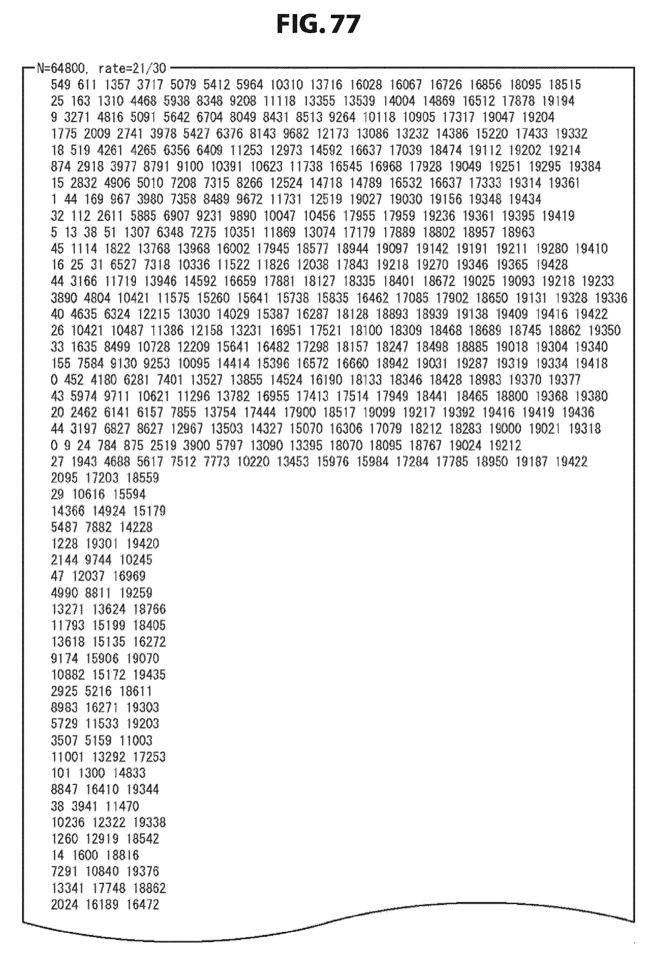

FIGS. 77, 78, and 79 illustrate a parity check matrix initial value table with respect to the parity check matrix H of the LDPC code with a code length N of 64k bits and an encoding rate of 21/30.

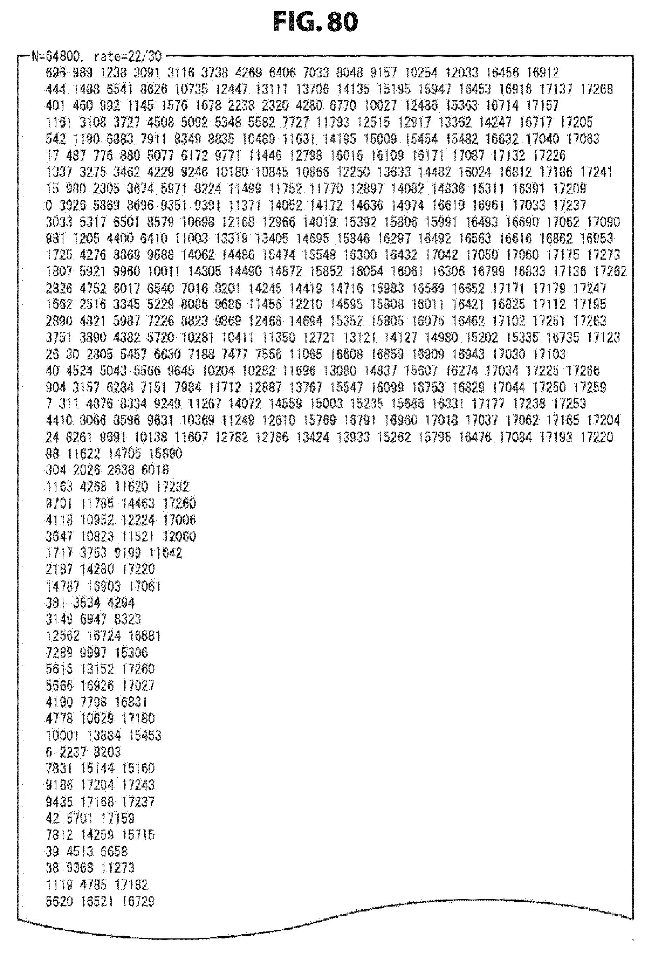

FIGS. 80, 81, and 82 illustrate a parity check matrix initial value table with respect to the parity check matrix H of the LDPC code with a code length N of 64k bits and an encoding rate of 22/30.

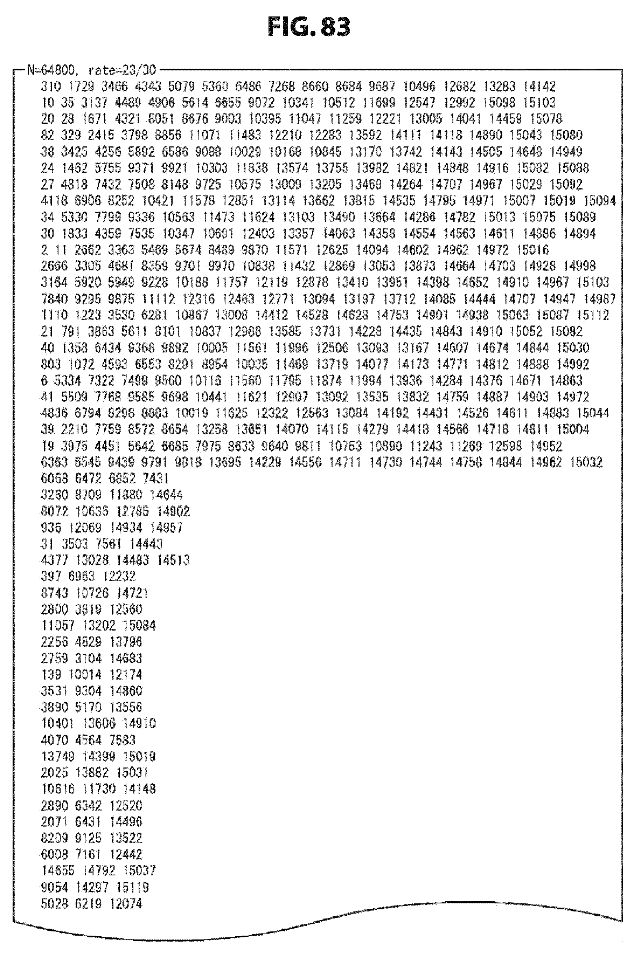

FIGS. 83, 84, and 85 illustrate a parity check matrix initial value table with respect to the parity check matrix H of the LDPC code with a code length N of 64k bits and an encoding rate of 23/30.

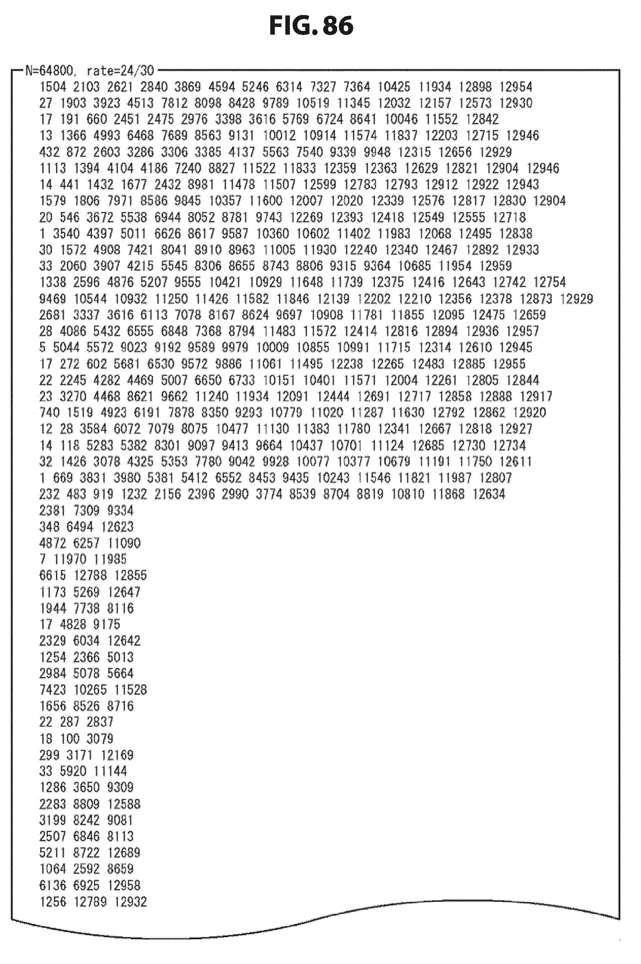

FIGS. 86, 87, and 88 illustrate a parity check matrix initial value table with respect to the parity check matrix H of the LDPC code with a code length N of 64k bits and an encoding rate of 24/30.

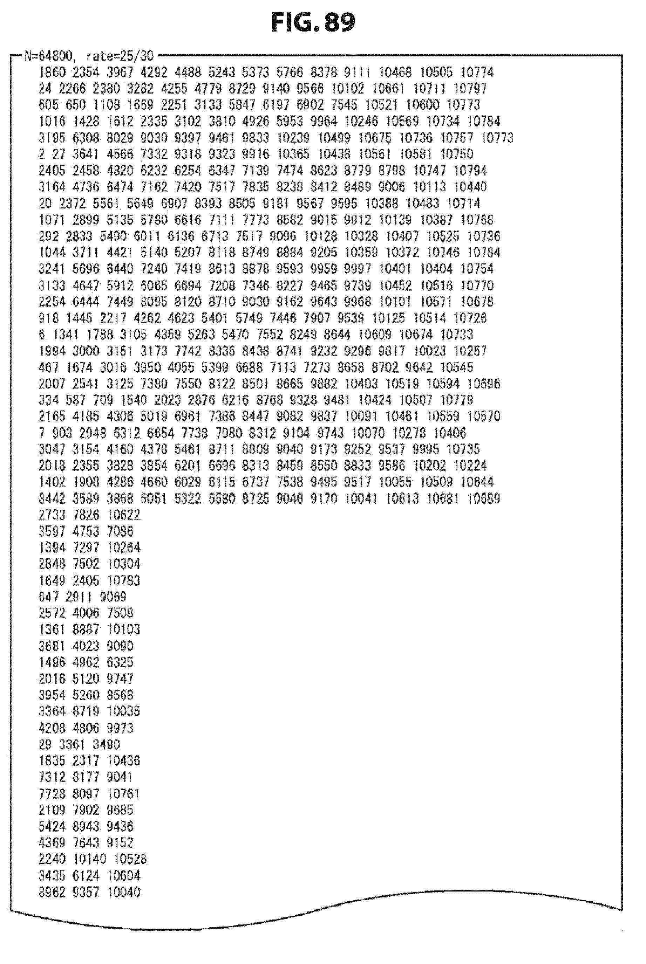

FIGS. 89, 90, and 91 illustrate a parity check matrix initial value table with respect to the parity check matrix H of the LDPC code with a code length N of 64k bits and an encoding rate of 25/30.

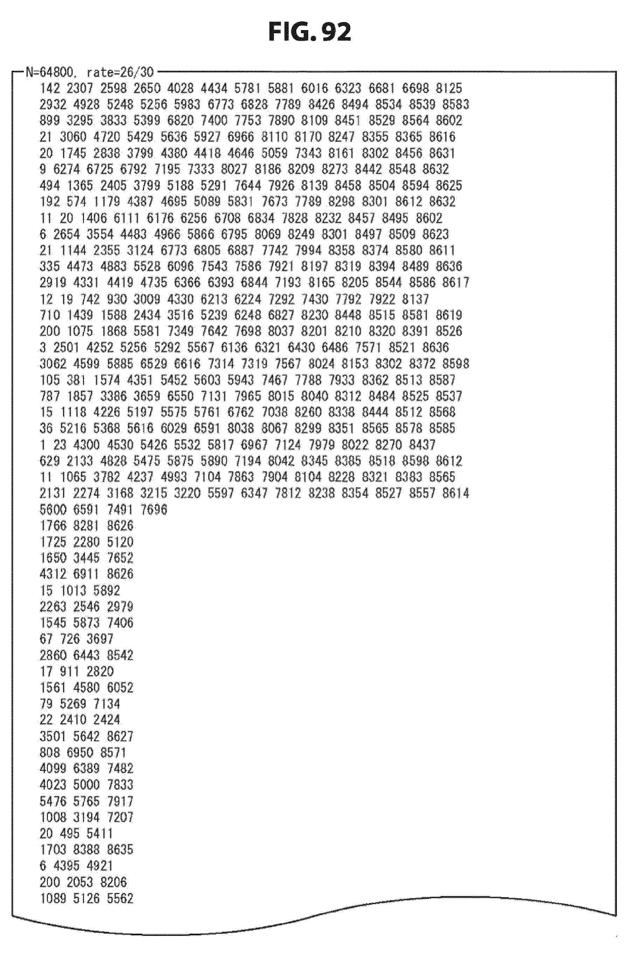

FIGS. 92, 93, and 94 illustrate a parity check matrix initial value table with respect to the parity check matrix H of the LDPC code with a code length N of 64k bits and an encoding rate of 26/30.

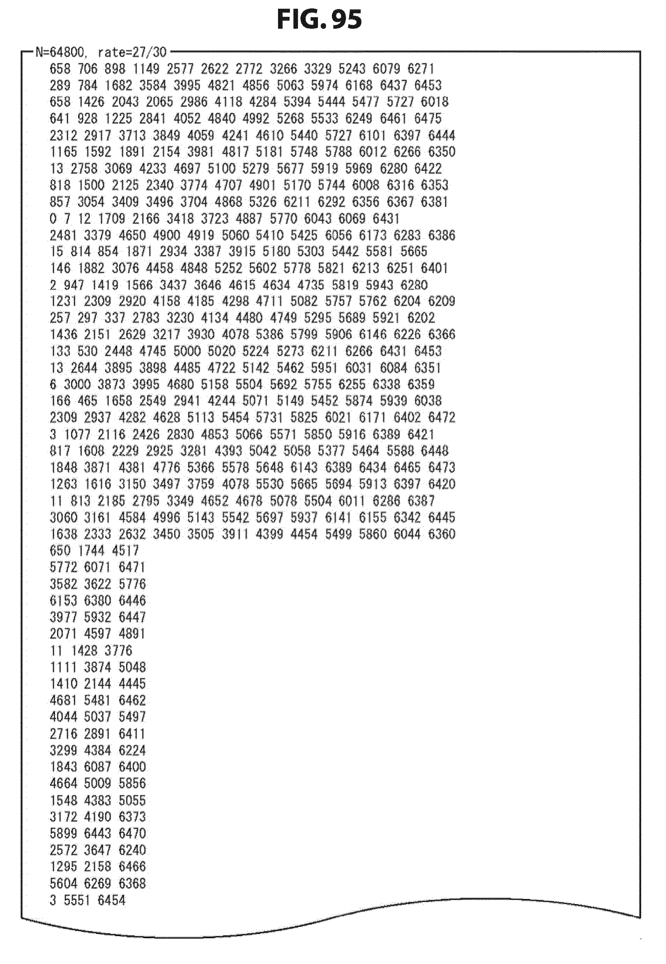

FIGS. 95, 96, and 97 illustrate a parity check matrix initial value table with respect to the parity check matrix H of the LDPC code with a code length N of 64k bits and an encoding rate of 27/30.

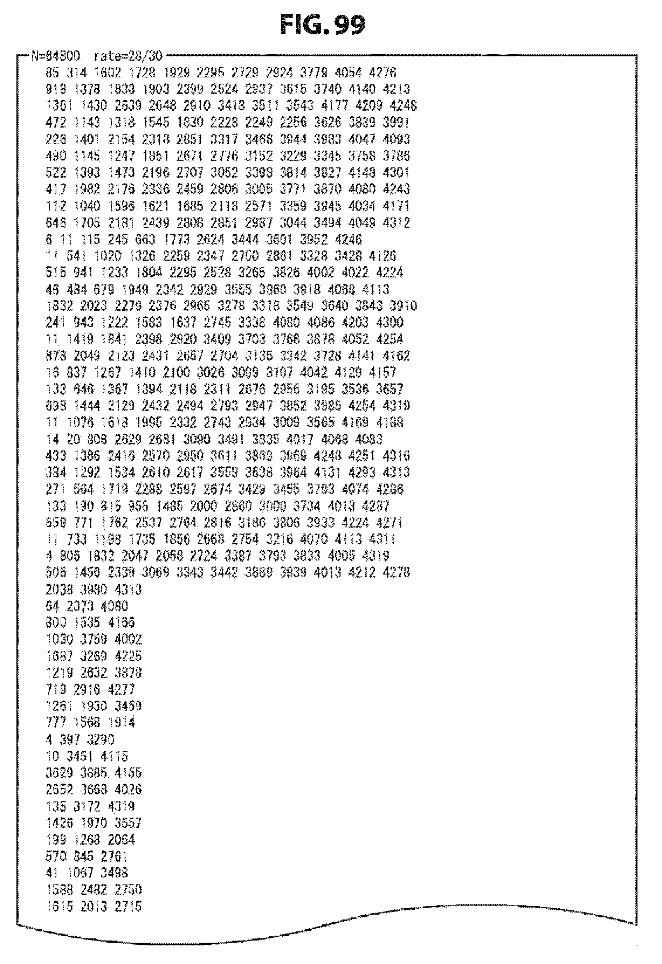

FIGS. 99, 100, 101, and 102 illustrate a parity check matrix initial value table with respect to the parity check matrix H of the LDPC code with a code length N of 64k bits and an encoding rate of 28/30.

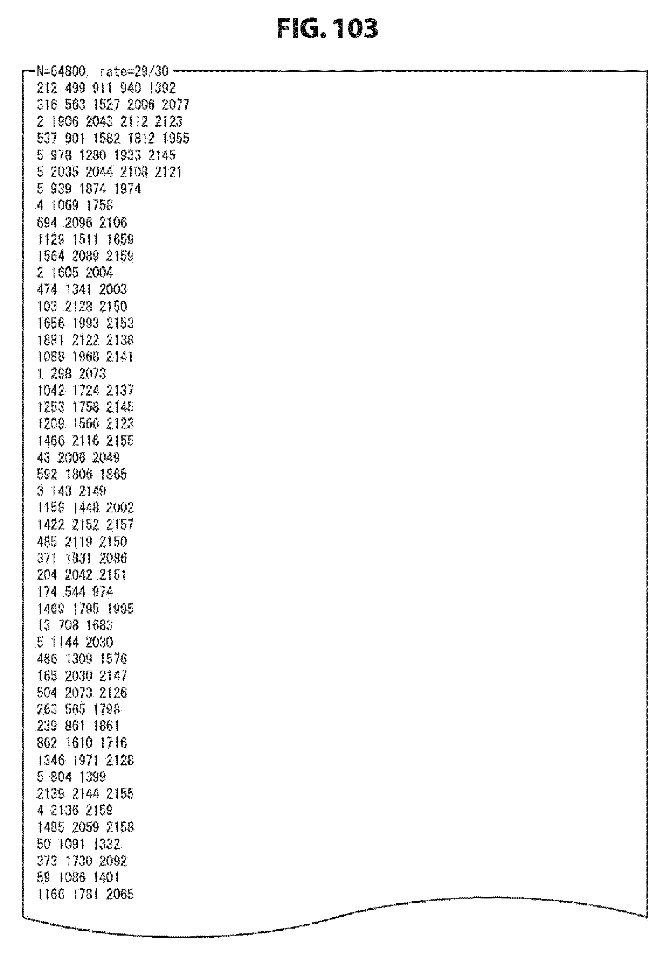

FIGS. 103, 104, 105, and 106 illustrate a parity check matrix initial value table with respect to the parity check matrix H of the LDPC code with a code length N of 64k bits and an encoding rate of 29/30.

The LDPC encoder 115 (FIG. 8 and FIG. 35) can perform encoding into any (new) LDPC code with a code length N of 64k among 28 kinds of encoding rates r of 2/30 to 29/30, by the use of the parity check matrix H found from the parity check matrix initial value tables illustrated in FIG. 40 to FIG. 106.

In this case, the parity check matrix initial value tables illustrated in FIG. 40 to FIG. 106 are stored in the storage unit 602 of the LDPC encoder 115 (FIG. 8).

Here, all of LDPC codes with 28 kinds of encoding rates r of 2/30 to 29/30 (found from the parity check matrix initial value tables) in FIG. 40 to FIG. 106 do not have to be necessarily adopted as a new LDPC. That is, as for the LDPC codes with 28 kinds of encoding rates r of 2/30 to 29/30 in FIG. 40 to FIG. 106, LDPC codes of one or more arbitrary encoding rates among them can be adopted as a new LDPC code.

An LDPC code obtained by the use of the parity check matrix H found from the parity check matrix initial value tables in FIG. 40 to FIG. 106 is an LDPC code of good performance.

Here, the LDPC code of good performance is an LDPC code obtained from an appropriate parity check matrix H.

Moreover, the appropriate parity check matrix H is a parity check matrix that satisfies a predetermined condition to make BER (and FER) smaller when an LDPC code obtained from the parity check matrix H is transmitted at low $E_s/N_0$ or $E_b/N_o$ (signal-to-noise power ratio per bit).

For example, the appropriate parity check matrix H can be found by performing simulation to measure BER when LDPC codes obtained from various parity check matrices that satisfy a predetermined condition are transmitted at low $E_s/N_o$.

As a predetermined condition to be satisfied by the appropriate parity check matrix H, for example, an analysis result obtained by a code performance analysis method called density evolution (Density Evolution) is excellent, and a loop of elements of 1 does not exist, which is called cycle 4, and so on.

Here, in the information matrix $H_A$, it is known that the decoding performance of LDPC code is deteriorated when elements of 1 are dense like cycle 4, and therefore it is requested that cycle 4 does not exist, as a predetermined condition to be satisfied by the appropriate parity check matrix H.

Here, the predetermined condition to be satisfied by the appropriate parity check matrix H can be arbitrarily determined from the viewpoint of the improvement in the decoding performance of LDPC code and the facilitation (simplification) of decoding processing of LDPC code, and so on.

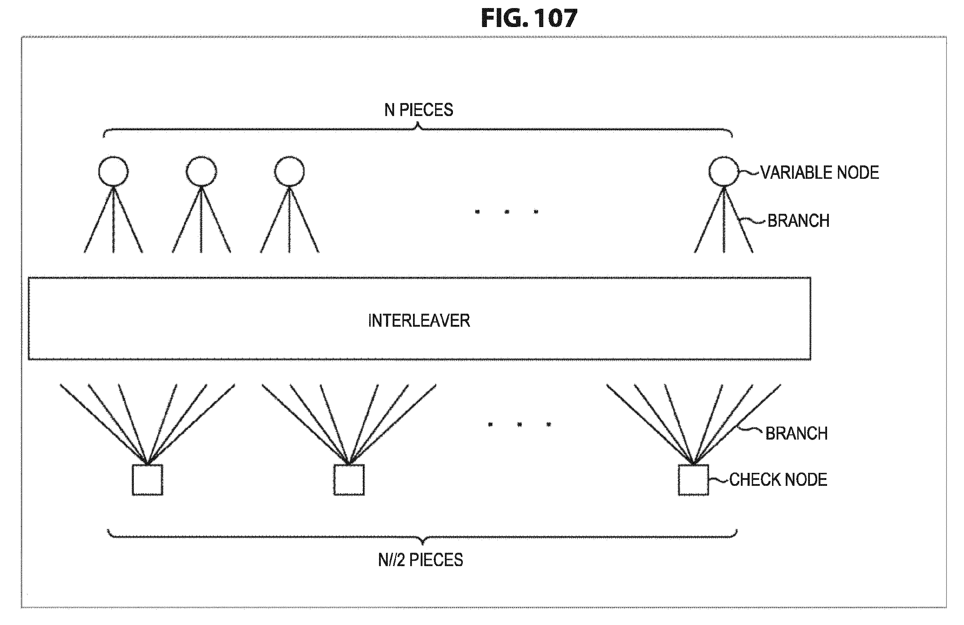

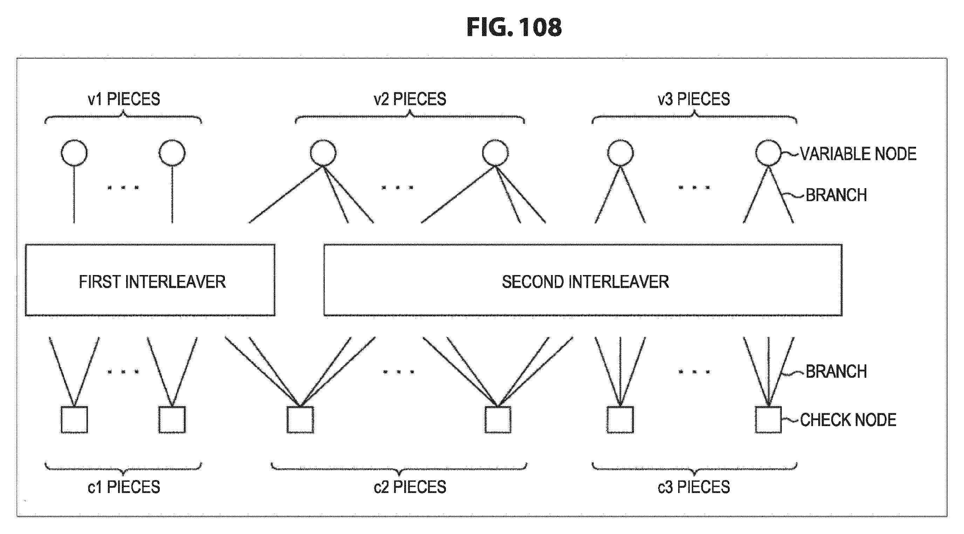

FIG. 107 and FIG. 108 are diagrams to describe the density evolution that can obtain an analytical result as a predetermined condition to be satisfied by the appropriate parity check matrix H.

The density evolution is a code analysis method that calculates the expectation value of the error probability of the entire LDPC code (ensemble) with a code length N of $\infty$ characterized by a degree sequence described later.

For example, when the dispersion value of noise is gradually increased from 0 on the AWGN channel, the expectation value of the error probability of a certain ensemble is 0 first, but, when the dispersion value of noise becomes equal to or greater than a certain threshold, it is not 0.

According to the density evolution, by comparison of the threshold of the dispersion value of noise (which may also be called a performance threshold) in which the expectation value of the error probability is not 0, it is possible to decide the quality of ensemble performance (appropriateness of the parity check matrix).

Here, as for a specific LDPC code, when an ensemble to which the LDPC code belongs is decided and density evolution is performed for the ensemble, rough performance of the LDPC code can be expected.

Therefore, if an ensemble of good performance is found, an LDPC code of good performance can be found from LDPC codes belonging to the ensemble.

Here, the above-mentioned degree sequence shows at what percentage a variable node or check node having the weight of each value exists with respect to the code length N of an LDPC code.

For example, a regular (3,6) LDPC code with an encoding rate of 1/2 belongs to an ensemble characterized by a degree sequence in which the weight (column weight) of all variable nodes is 3 and the weight (row weight) of all check nodes is 6.

FIG. 107 illustrates a Tanner graph of such an ensemble.

In the Tanner graph of FIG. 107, there are variable nodes shown by circles (sign O) in the diagram only by N pieces equal to the code length N, and there are check nodes shown by quadrangles (sign □) only by N/2 pieces equal to a multiplication value multiplying encoding rate 1/2 by the code length N.

Three branches (edge) equal to the column weight are connected with each variable node, and therefore there are totally 3N branches connected with N variable nodes.

Moreover, six branches (edge) equal to the row weight are connected with each check node, and therefore there are totally 3N branches connected with N/2 check nodes.

In addition, there is one interleaver in the Tanner graph in FIG. 107.

The interleaver randomly rearranges 3N branches connected with N variable nodes and connects each rearranged branch with any of 3N branches connected with N/2 check nodes.

There are (3N)! (= (3N)×(3N-1)×...×1) rearrangement patterns to rearrange 3N branches connected with N variable nodes in the interleaver. Therefore, an ensemble characterized by the degree sequence in which the weight of all variable nodes is 3 and the weight of all check nodes is 6, becomes aggregation of (3N)! LDPC codes.

In simulation to find an LDPC code of good performance (appropriate parity check matrix), an ensemble of a multi-edge type is used in the density evolution.

In the multi edge type, an interleaver through which the branches connected with the variable nodes and the branches connected with the check nodes pass, is divided into plural (multi edge), and, by this means, the ensemble is characterized more strictly.

FIG. 108 illustrates an example of a Tanner graph of an ensemble of the multi-edge type.

In the Tanner graph of FIG. 108, there are two interleavers of the first interleaver and the second interleaver.

Moreover, in the Tanner graph chart of FIG. 108, v1 variable nodes with one branch connected with the first interleaver and no branch connected with the second interleaver exist, v2 variable nodes with one branch connected with the first interleaver and two branches connected with the second interleaver exist, and v3 variable nodes with no branch connected with the first interleaver and two branches connected with the second interleaver exist, respectively.

Furthermore, in the Tanner graph chart of FIG. 108, c1 check nodes with two branches connected with the first interleaver and no branch connected with the second interleaver exist, c2 check nodes with two branches connected with the first interleaver and two branches connected with the second interleaver exist, and c3 check nodes with no branch connected with the first interleaver and three branches connected with the second interleaver exist, respectively.

Here, for example, the density evolution and the mounting thereof are described in "On the Design of Low-Density Parity-Check Codes within 0.0045 dB of the Shannon Limit", S.Y.Chung, G.D.Forney, T.J.Richardson, R.Urbanke, IEEE Communications Leggers, VOL.5, NO.2, Feb 2001.

In simulation to find (a parity check matrix initial value table of) a new LDPC code, by the density evaluation of the multi-edge type, an ensemble in which a performance threshold that is $E_b/N_0$ (signal-to-noise power ratio per bit) with deteriorating (decreasing) BER is equal to or less than a predetermined value is found, and an LDPC code that decreases BER in a plurality of modulation methods used in DVB-S.2 or the like such as QPSK is selected from LDPC codes belonging to the ensemble as an LDPC code of good performance.

The above-mentioned parity check matrix initial value table of the new LDPC code is a parity check matrix initial value table of an LDPC code with a code length N of 64k bits found from the above-mentioned simulation.

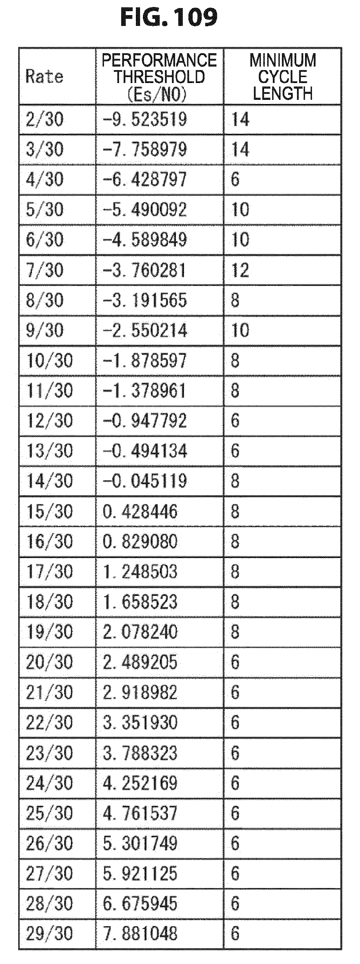

FIG. 109 is a diagram illustrating the minimum cycle length and performance threshold of the parity check matrix H found from the parity check matrix initial value tables of new LDPC codes with 28 kinds of encoding rates of 2/30 to 29/30 and a code length N of 64k bits in FIG. 40 to FIG. 106.

Here, the minimum cycle length (girth) means the minimum value of the length of a loop (loop length) formed with elements of 1 in the parity check matrix H.

In the parity check matrix H found from the parity check matrix initial value table of the new LDPC code, cycle 4 (a loop of elements of 1 with a loop length of 4) does not exist.

Moreover, since the redundancy of an LDPC code becomes larger as the encoding rate r becomes smaller, the performance threshold tends to improve (decrease) as the encoding rate r decreases.

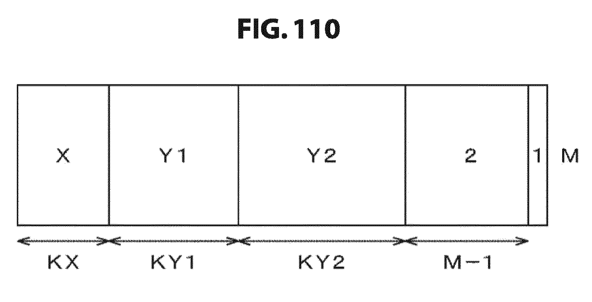

FIG. 110 is a diagram illustrating the parity check matrix H (which may be called a new LDPC code parity check matrix H) of FIG. 40 to FIG. 106 (which is found from a parity check matrix initial value table).

The column weight is X for the KX column from the first column of the new LDPC code parity check matrix H, the column weight is Y1 for the subsequent KY1 column, the column weight is Y2 for the subsequent KY2 column, the column weight is 2 for the subsequent M-1 column, and the column weight is 1 for the last column.

Here, KX+KY1+KY2+M-1+1 is equal to a code length of N=64800 bits.

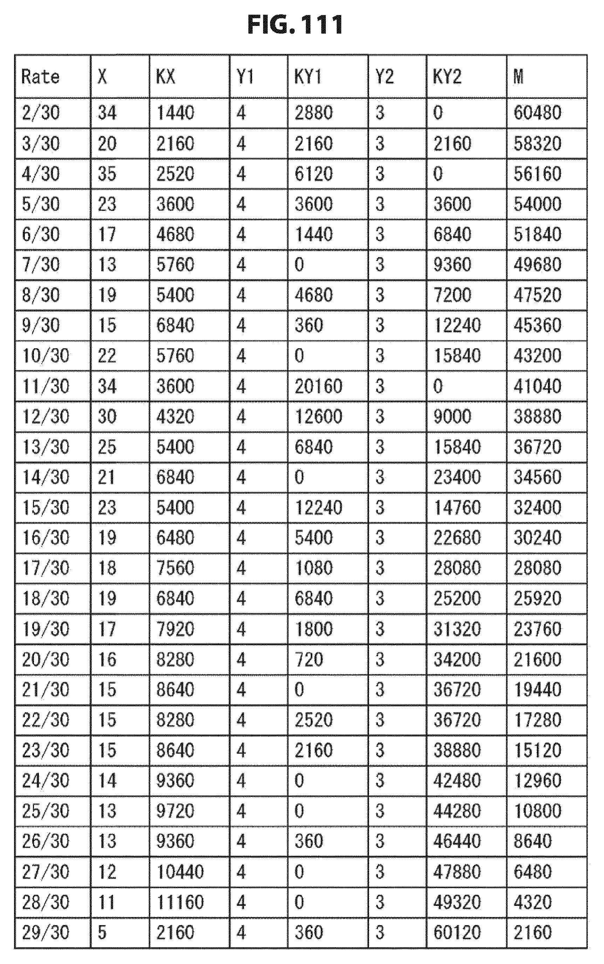

FIG. 111 is a diagram illustrating column numbers KX, KY1, KY2 and M and column weights X, Y1 and Y2 in FIG. 110, for each encoding rate r of a new LDPC code.

As for the new LDPC code parity check matrix H with a code length N of 64k, similar to the parity check matrix described in FIG. 12 and FIG. 13, the column weight tends to be larger in a column closer to the head side (left side), and therefore a code bit closer to the head of the new LDPC code tends to be more tolerant to errors (have resistance to errors).

Here, shift amount q of cyclic shift, which is performed when a parity check matrix is found from the parity check matrix initial value table of a new LDPC code with a code length N of 64k as described in FIG. 38, is expressed by an expression q=M/P=M/360.

Therefore, the shift amounts of new LDPC codes with encoding rates of 2/30, 3/30, 4/30, 5/30, 6/30, 7/30, 8/30, 9/30, 10/30, 11/30, 12/30, 13/30, 14/30, 15/30, 16/30, 17/30, 18/30, 19/30, 20/30, 21/30, 22/30, 23/30, 24/30, 25/30, 26/30, 27/30, 28/30 and 29/30 are 168,162,156,150,144,138,132,126,120,114,108,102, 96, 90, 84, 78, 72, 66, 60, 54, 48, 42, 36, 30, 24, 18, 12 and 6, respectively.

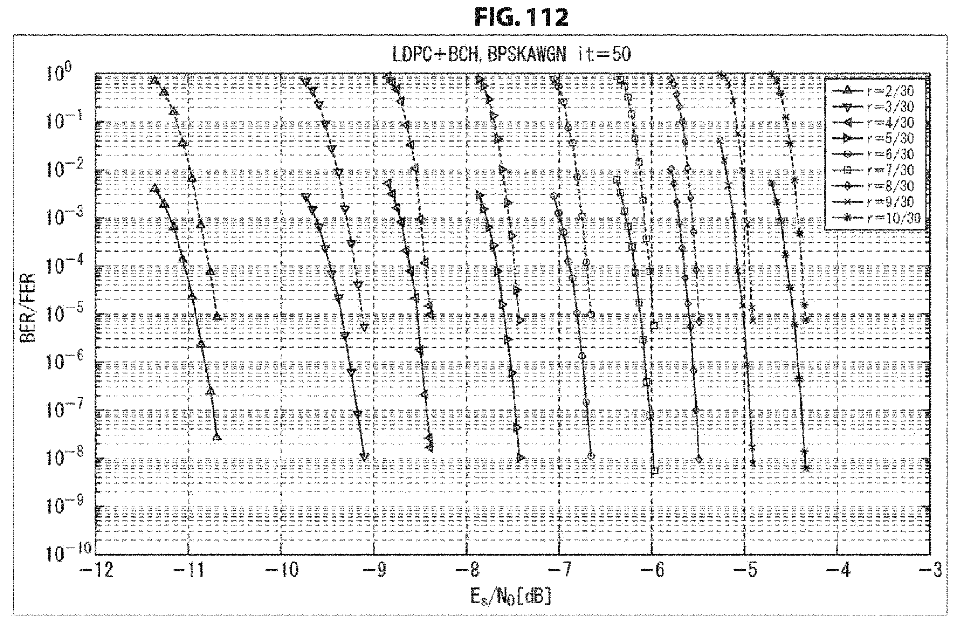

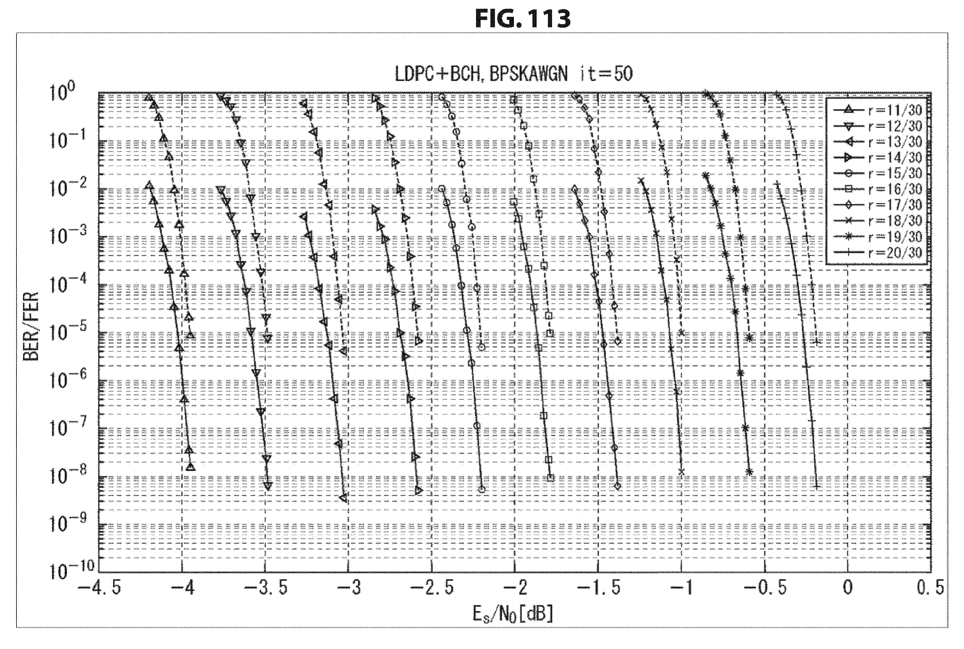

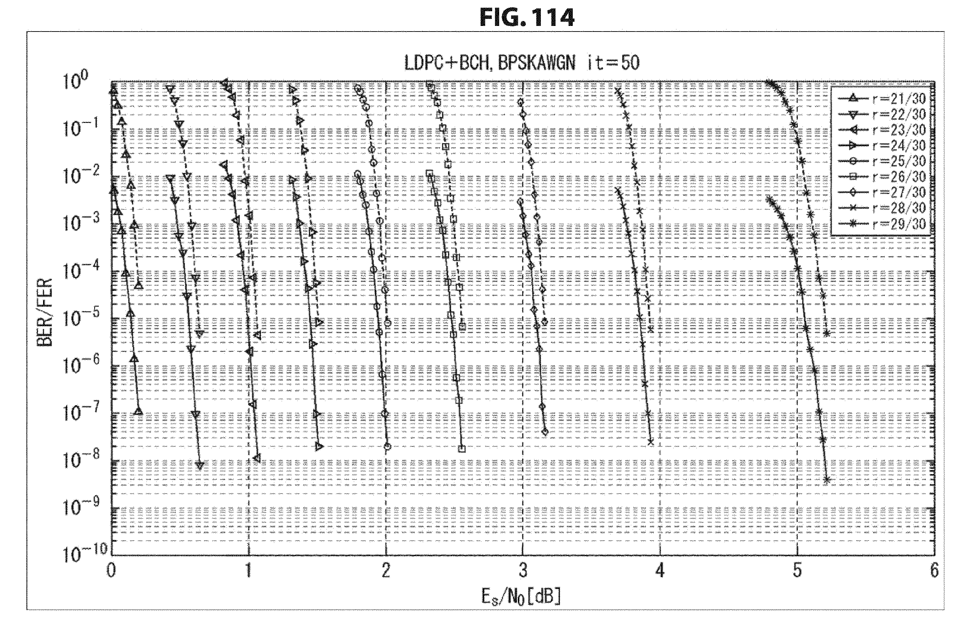

FIG. 112, FIG. 113 and FIG. 114 are diagrams illustrating a simulation result of BER/FER of new LDPC codes of FIG. 40 to FIG. 106.

In the simulation, a communication path (channel) of AWGN is assumed, BPSK is adopted as a modulation method and 50 times are adopted as an iterative decoding number C(it).

In FIG. 112, FIG. 113 and FIG. 114, the horizontal axis shows $E_s/N_0$ and the vertical axis shows BER/FER. Here, the solid line shows BER and the dotted line shows FER.

As for the FER (BER) curves of respective new LDPC codes with 28 kinds of encoding rates of 2/30 to 29/30 in FIG. 112 to FIG. 114, FER is equal to or less than $10^{-5}$ in a range of (about) 15 dB of $E_s/N_0$ from (almost) -10 dB to 5 dB.

According to the simulation, since it is possible to set 28 pieces of ModCod in which FER is equal to or less than $10^{-5}$ in a range of 15 dB in which $E_s/N_0$ is from -10 dB to 5dB, by considering various modulation methods such as QPSK, 8PSK, 16APSK, 32APSK, 16QAM, 32QAM and 64QAM other than BPSK used in the simulation, it is sufficiently expected that it is possible to set 20 or more pieces of ModCod in which FER is equal to or less than $10^{-5}$ in a range of 7 dB from 5 dB to 12 dB.

Therefore, it is possible to provide an LDPC code of a good error rate, which satisfies the first request of CfT.

Moreover, according to FIG. 112 to FIG. 114, almost all of FER (BER) curves are arranged at relatively equal intervals for each of groups with encoding rates of Low, Medium and High at intervals less than 1 dB. Therefore, for broadcasters who broadcast a program by the transmitting device 11, there is an advantage that a new LDPC code easily selects an encoding rate used for broadcast according to the situation of a channel (communication path 13), and so on.

Here, in the simulation to find the BER/FER curves in FIG. 112 to FIG. 114, information is subjected to BCH encoding and a BCH code obtained as a result is subjected to LDPC encoding.

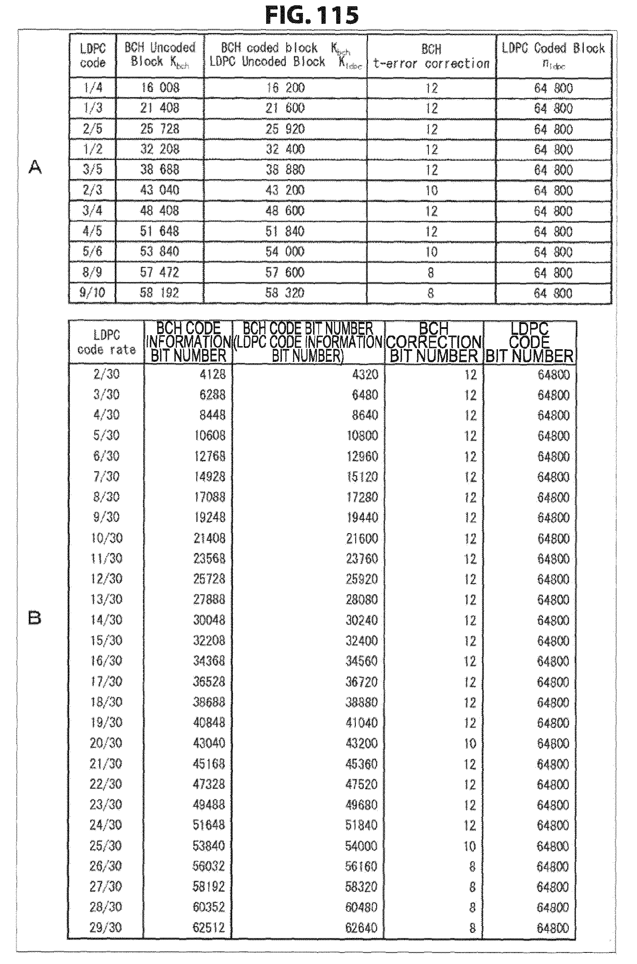

FIG. 115 is a diagram illustrating the BCH encoding used for the simulation.

That is, A of FIG. 115 is a diagram illustrating parameters of the BCH encoding performed before the LDPC encoding for an LDPC code of 64k defined in DVB-S.2.

In DVB-S.2, by attaching redundancy bits of 192 bits, 160 bits or 128 bits according to the encoding rate of an LDPC code, BCH encoding that enables error correction of 12 bits, 10 bits or 8 bits is performed.

B of FIG. 115 is a diagram illustrating parameters of the BCH encoding used for the simulation.

In the simulation, similar to the case of DVB-S.2, by attaching redundancy bits of 192 bits, 160 bits or 128 bits according to the encoding rate of an LDPC code, the BCH encoding that enables error correction of 12 bits, 10 bits or 8 bits is performed.

[Configuration example of receiving device 12]

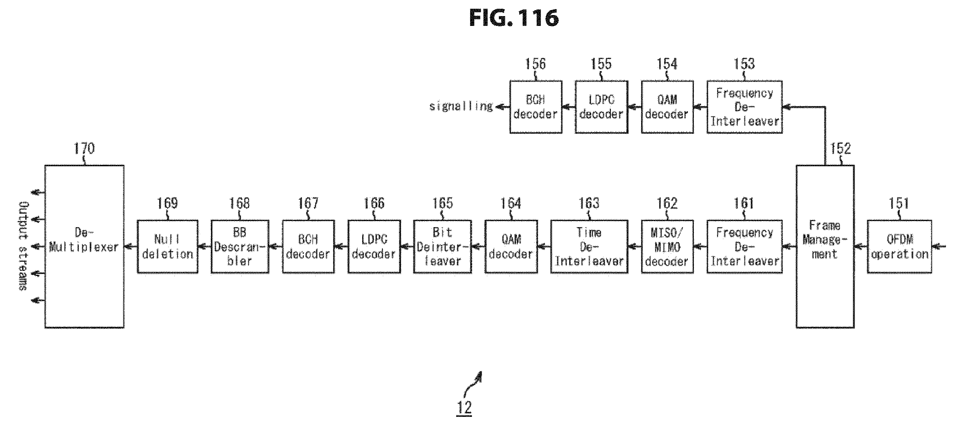

FIG. 116 is a block diagram illustrating a configuration example of the receiving device 12 of FIG. 7.

An OFDM operating unit 151 receives an OFDM signal from the transmitting device 11 (FIG. 7) and executes signal processing of the OFDM signal. Data (symbol) that is obtained by executing the signal processing by the OFDM operating unit 151 is supplied to a frame managing unit 152.

The frame managing unit 152 executes processing (frame interpretation) of a frame configured by the symbol supplied from the OFDM operating unit 151 and supplies a symbol of target data obtained as a result and a symbol of signaling to frequency deinterleavers 161 and 153.

The frequency deinterleaver 153 performs frequency deinterleave in a unit of symbol, with respect to the symbol supplied from the frame managing unit 152, and supplies the symbol to a QAM decoder 154.

The QAM decoder 154 demaps (signal point arrangement decoding) the symbol (symbol arranged on a signal point) supplied from the frequency deinterleaver 153, performs orthogonal demodulation, and supplies data (LDPC code) obtained as a result to a LDPC decoder 155.

The LDPC decoder 155 performs LDPC decoding of the LDPC code supplied from the QAM decoder 154 and supplies LDPC target data (in this case, a BCH code) obtained as a result to a BCH decoder 156.

The BCH decoder 156 performs BCH decoding of the LDPC target data supplied from the LDPC decoder 155 and outputs control data (signaling) obtained as a result.

Meanwhile, the frequency deinterleaver 161 performs frequency deinterleave in a unit of symbol, with respect to the symbol supplied from the frame managing unit 152, and supplies the symbol to a MISO/MIMO decoder 162.

The MISO/MIMO decoder 162 performs spatiotemporal decoding of the data (symbol) supplied from the frequency deinterleaver 161 and supplies the data to a time deinterleaver 163.

The time deinterleaver 163 performs time deinterleave in a unit of symbol, with respect to the data (symbol) supplied from the MISO/MIMO decoder 162, and supplies the data to a QAM decoder 164.

The QAM decoder 164 demaps (signal point arrangement decoding) the symbol (symbol arranged on a signal point) supplied from the time deinterleaver 163, performs orthogonal demodulation, and supplies data (symbol) obtained as a result to a bit deinterleaver 165.

The bit deinterleaver 165 performs bit deinterleave of the data (symbol) supplied from the QAM decoder 164 and supplies an LDPC code obtained as a result to an LDPC decoder 166.

The LDPC decoder 166 performs LDPC decoding of the LDPC code supplied from the bit deinterleaver 165 and supplies LDPC target data (in this case, a BCH code) obtained as a result to a BCH decoder 167.

The BCH decoder 167 performs BCH decoding of the LDPC target data supplied from the LDPC decoder 155 and supplies data obtained as a result to a BB descrambler 168.

The BB descrambler 168 executes BB descramble with respect to the data supplied from the BCH decoder 167 and supplies data obtained as a result to a null deletion unit 169.

The null deletion unit 169 deletes null inserted by the padder 112 of FIG. 8, from the data supplied from the BB descrambler 168, and supplies the data to a demultiplexer 170.

The demultiplexer 170 individually separates one or more streams (target data) multiplexed with the data supplied from the null deletion unit 169, performs necessary processing to output the streams as output streams.

Here, the receiving device 12 can be configured without including part of the blocks illustrated in FIG. 116. That is, for example, in a case where the transmitting device 11 (FIG. 8) is configured without including the time interleaver 118, the MISO/MIMO encoder 119, the frequency interleaver 120 and the frequency interleaver 124, the receiving device 12 can be configured without including the time deinterleaver 163, the MISO/MIMO decoder 162, the frequency deinterleaver 161 and the frequency deinterleaver 153 which are blocks respectively corresponding to the time interleaver 118, the MISO/MIMO encoder 119, the frequency interleaver 120 and the frequency interleaver 124 of the transmitting device 11.

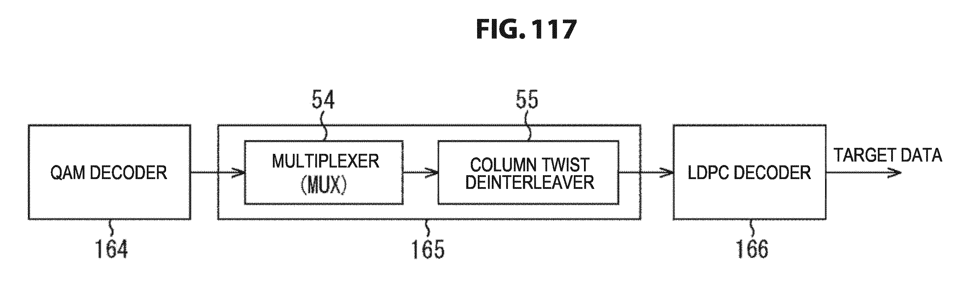

FIG. 117 is a block diagram illustrating a configuration example of the bit deinterleaver 165 of FIG. 116.

The bit deinterleaver 165 includes a multiplexer (MUX) 54 and a column twist deinterleaver 55 and performs (bit) deinterleave of symbol bits of the symbol supplied from the QAM decoder 164 (FIG. 116).

That is, the multiplexer 54 executes reverse interchange processing (reverse processing of the interchange processing) corresponding to the interchange processing executed by the demultiplexer 25 of FIG. 9, that is, reverse interchange processing for returning positions of the code bits (symbol bits) of the LDPC codes interchanged by the interchange processing to original positions, with respect to the symbol bits of the symbol supplied from the QAM decoder 164, and supplies an LDPC code obtained as a result to the column twist deinterleaver 55.

The column twist deinterleaver 55 performs the column twist deinterleave (reverse processing of the column twist interleave) corresponding to the column twist interleave as the rearrangement processing executed by the column twist interleaver 24 of FIG. 9, that is, the column twist deinterleave as the reverse rearrangement processing for returning the code bits of the LDPC codes of which an arrangement is changed by the column twist interleave as the rearrangement processing to the original arrangement, with respect to the LDPC code supplied from the multiplexer 54.

Specifically, the column twist deinterleaver 55 writes the code bits of the LDPC code to a memory for deinterleave having the same configuration as the memory 31 illustrated in FIG. 28, reads the code bits, and performs the column twist deinterleave.

However, in the column twist deinterleaver 55, writing of the code bits is performed in a row direction of the memory for the deinterleave, using read addresses when the code bits are read from the memory 31 as write addresses. In addition, reading of the code bits is performed in a column direction of the memory for the deinterleave, using write addresses when the code bits are written to the memory 31 as read addresses.

The LDPC code that is obtained as a result of the column twist deinterleave is supplied from the column twist deinterleaver 55 to the LDPC decoder 166.

Here, in a case where the parity interleave, the column twist interleave and the interchange processing are performed on an LDPC code supplied from the QAM decoder 164 to the bit deinterleaver 165, all of parity deinterleave (processing opposite to the parity interleave, that is, parity deinterleave that returns the code bits of an LDPC code in which the arrangement is changed by the parity interleave to the original arrangement) corresponding to the parity interleave, reverse interchange processing corresponding to the interchange processing and column twist deinterleave corresponding to the column twist interleave can be performed in the bit deinterleaver 165.

However, the bit deinterleaver 165 in FIG. 117 includes the multiplexer 54 that performs the reverse interchange processing corresponding to the interchange processing and the column twist deinterleaver 55 that performs the column twist deinterleave corresponding to the column twist interleave, but does not include a block that performs the parity deinterleave corresponding to the parity interleave, and the parity deinterleave is not performed.

Therefore, the LDPC code in which the reverse interchange processing and the column twist deinterleave are performed and the parity deinterleave is not performed is supplied from (the column twist deinterleaver 55 of) the bit deinterleaver 165 to the LDPC decoder 166.

The LDPC decoder 166 performs the LDPC decoding of the LDPC code supplied from the bit deinterleaver 165, using a transformed parity check matrix obtained by performing at least column replacement corresponding to the parity interleave with respect to the parity check matrix H used by the LDPC encoder 115 of FIG. 8 to perform the LDPC encoding, and outputs data obtained as a result to a decoding result of LDPC target data.

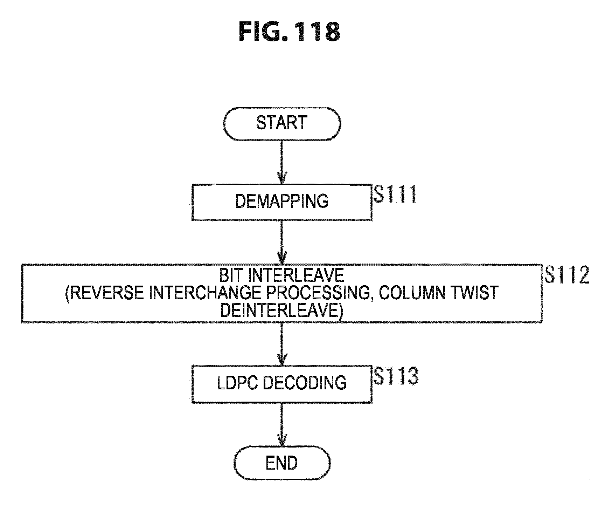

FIG. 118 is a flowchart illustrating processing that is executed by the QAM decoder 164, the bit deinterleaver 165, and the LDPC decoder 166 of FIG. 117.

In step S111, the QAM decoder 164 demaps the symbol (symbol mapped to a signal point) supplied from the time deinterleaver 163, performs orthogonal modulation, and supplies the symbol to the bit deinterleaver 165, and the processing proceeds to step S 112.

In step S112, the bit deinterleaver 165 performs deinterleave (bit deinterleave) of the symbol bits of the symbol supplied from the QAM decoder 164 and the processing proceeds to step S113.

That is, in step S112, in the bit deinterleaver 165, the multiplexer 54 executes reverse interchange processing with respect to the symbol bits of the symbol supplied from the QAM decoder 164 and supplies code bits of an LDPC code obtained as a result to the column twist deinterleaver 55.

The column twist deinterleaver 55 performs the column twist deinterleave with respect to the LDPC code supplied from the multiplexer 54 and supplies an LDPC code obtained as a result to the LDPC decoder 166.

In step S113, the LDPC decoder 166 performs the LDPC decoding of the LDPC code supplied from the column twist deinterleaver 55, using a transformed parity check matrix obtained by performing at least column replacement corresponding to the parity interleave with respect to the parity check matrix H used by the LDPC encoder 115 of FIG. 8 to perform the LDPC encoding, and outputs data obtained as a result, as a decoding result of LDPC target data, to the BCH decoder 167.

In FIG. 117, for the convenience of explanation, the multiplexer 54 that executes the reverse interchange processing and the column twist deinterleaver 55 that performs the column twist deinterleave are individually configured, similar to the case of FIG. 9. However, the multiplexer 54 and the column twist deinterleaver 55 can be integrally configured.

In the bit interleaver 116 of FIG. 9, when the column twist interleave is not performed, it is not necessary to provide the column twist deinterleaver 55 in the bit deinterleaver 165 of FIG. 117.

Next, the LDPC decoding that is performed by the LDPC decoder 166 of FIG. 116 will be further described.

In the LDPC decoder 166 of FIG. 116, as described above, the LDPC decoding of the LDPC code from the column twist deinterleaver 55, in which the reverse interchange processing and the column twist deinterleave are performed and the parity deinterleave is not performed, is performed using a transformed parity check matrix obtained by performing at least column replacement corresponding to the parity interleave with respect to the parity check matrix H used by the LDPC encoder 115 of FIG. 8 to perform the LDPC encoding.

In this case, LDPC decoding that can suppress an operation frequency at a sufficiently realizable range while suppressing a circuit scale, by performing the LDPC decoding using the transformed parity check matrix, is previously suggested (for example, refer to JP 4224777B).

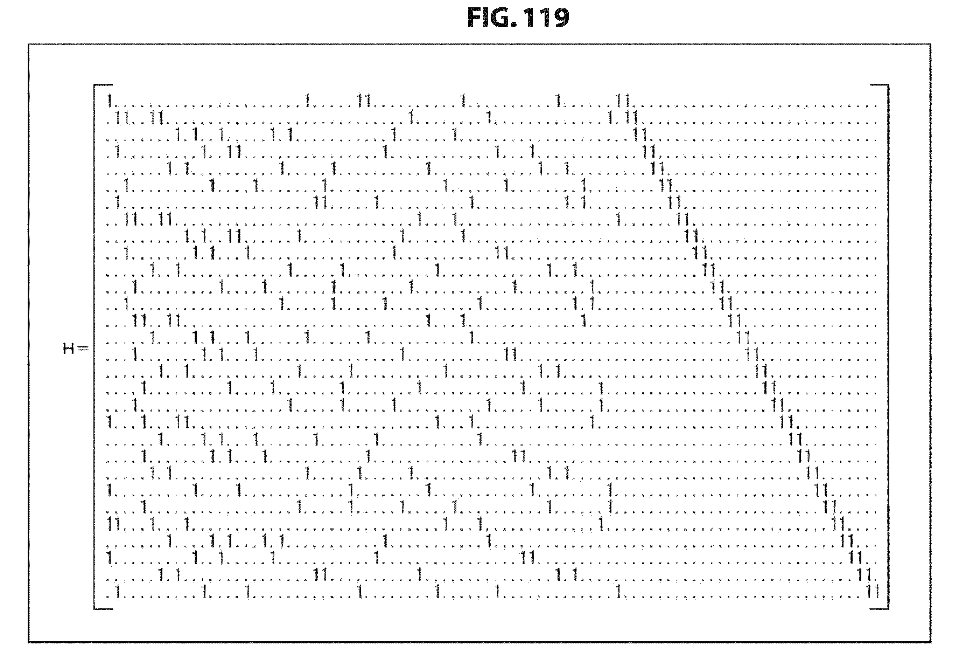

Therefore, first, the previously suggested LDPC decoding using the transformed parity check matrix will be described with reference to FIGS. 119 to 122.

FIG. 119 illustrates an example of a parity check matrix H of an LDPC code in which a code length N is 90 and an encoding rate is 2/3.

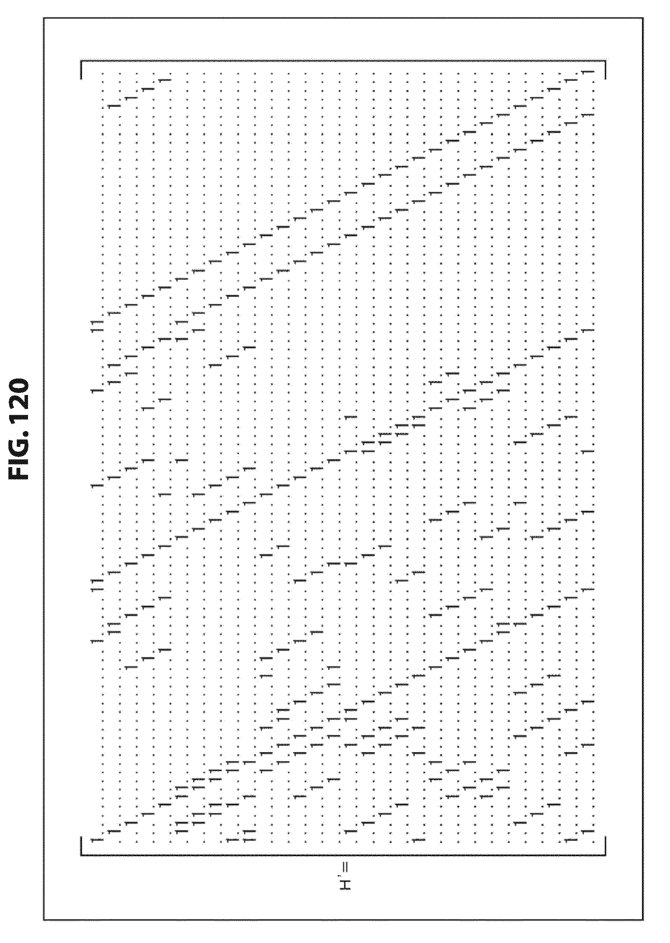

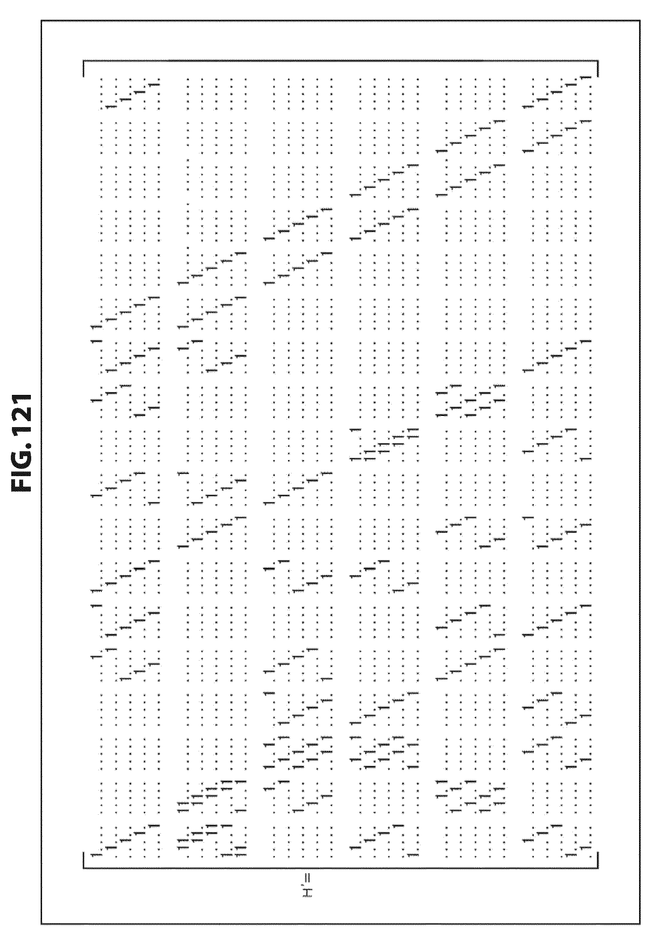

In FIG. 119 (and FIGS. 120 and 121 to be described later), 0 is represented by a period (.).

In the parity check matrix H of FIG. 119, the parity matrix becomes a staircase structure.

FIG. 120 illustrates a parity check matrix H' that is obtained by executing row replacement of an expression (11) and column replacement of an expression (12) with respect to the parity check matrix H of FIG. 119.

$$\text{Row Replacement: } (6s + t + 1)\text{-th row} \rightarrow (5t + s + 1)\text{-th row} \qquad \cdots (11)$$

$$\text{Column Replacement: } (6x + y + 61)\text{-th column} \rightarrow (5y + x + 61)\text{-th column}$$

$$\cdots (12)$$

In the expressions (11) and (12), s, t, x, and y are integers in ranges of $0 \leq s < 5$, $0 \leq t < 6$, $0 \leq x < 5$, and $0 \leq t < 6$, respectively.

According to the row replacement of the expression (11), replacement is performed such that the 1st, 7th, 13rd, 19th, and 25th rows having remainders of 1 when being divided by 6 are replaced with the 1st, 2nd, 3rd, 4th, and 5th rows, and the 2nd, 8th, 14th, 20th, and 26th rows having remainders of 2 when being divided by 6 are replaced with the 6th, 7th, 8th, 9th, and 10th rows, respectively.

According to the column replacement of the expression (12), replacement is performed such that the 61st, 67th, 73rd, 79th, and 85th columns having remainders of 1 when being divided by 6 are replaced with the 61st, 62nd, 63rd, 64th, and 65th columns, respectively, and the 62nd, 68th, 74th, 80th, and 86th columns having remainders of 2 when being divided by 6 are replaced with the 66th, 67th, 68th, 69th, and 70th columns, respectively, with respect to the 61st and following columns (parity matrix).

In this way, a matrix that is obtained by performing the replacements of the rows and the columns with respect to the parity check matrix H of FIG. 119 is a parity check matrix H' of FIG. 120.

In this case, even when the row replacement of the parity check matrix H is performed, the arrangement of the code bits of the LDPC code is not influenced.

The column replacement of the expression (12) corresponds to parity interleave to interleave the (K + qx+ y+ 1)-th code bit into the position of the (K + Py + x + 1)-th code bit, when the information length K is 60, the column number P of the unit of the cyclic structure is 5, and the divisor q (= M/P) of the parity length M (in this case, 30) is 6.

Therefore, the parity check matrix H' in FIG. 120 is a transformed parity check matrix obtained by performing at least column replacement that replaces the K+qx+y+1-th column of the parity check matrix H in FIG. 119 (which may be arbitrarily called an original parity check matrix below) with the K+Py+x+1-th column.

If the parity check matrix H' of FIG. 120 is multiplied with a result obtained by performing the same replacement as the expression (12) with respect to the LDPC code of the parity check matrix H of FIG. 119, a zero vector is output. That is, if a row vector obtained by performing the column replacement of the expression (12) with respect to a row vector c as the LDPC code (one code word) of the original parity check matrix H is represented as c', HcT becomes the zero vector from the property of the parity check matrix. Therefore, H'c'T naturally becomes the zero vector.

Thereby, the transformed parity check matrix H' of FIG. 120 becomes a parity check matrix of an LDPC code c' that is obtained by performing the column replacement of the expression (12) with respect to the LDPC code c of the original parity check matrix H.

Therefore, the column replacement of the expression (12) is performed with respect to the LDPC code of the original parity check matrix H, the LDPC code c' after the column replacement is decoded (LDPC decoding) using the transformed parity check matrix H' of FIG. 120, reverse replacement of the column replacement of the expression (12) is performed with respect to a decoding result, and the same decoding result as the case in which the LDPC code of the original parity check matrix H is decoded using the parity check matrix H can be obtained.

FIG. 121 illustrates the transformed parity check matrix H' of FIG. 120 with being spaced in units of $5 \times 5$ matrixes.

In FIG. 121, the transformed parity check matrix H' is represented by a combination of a $5 \times 5$ (= $p \times p$) unit matrix, a matrix (hereinafter, appropriately referred to as a quasi unit matrix) obtained by setting one or more 1 of the unit matrix to zero, a matrix (hereinafter, appropriately referred to as a shifted matrix) obtained by cyclically shifting the unit matrix or the quasi unit matrix, a sum (hereinafter, appropriately referred to as a sum matrix) of two or more matrixes of the unit matrix, the quasi unit matrix, and the shifted matrix, and a $5 \times 5$ zero matrix.

The transformed parity check matrix H' of FIG. 121 can be configured using the $5 \times 5$ unit matrix, the quasi unit matrix, the shifted matrix, the sum matrix, and the zero matrix. Therefore, the $5 \times 5$ matrixes (the unit matrix, the quasi unit matrix, the shifted matrix, the sum matrix, and the zero matrix) that constitute the transformed parity check matrix H' are appropriately referred to as constitutive matrixes hereinafter.

When the LDPC code represented by the parity check matrix represented by the $P \times P$ constitutive matrixes is decoded, an architecture in which P check node operations and variable node operations are simultaneously performed can be used.

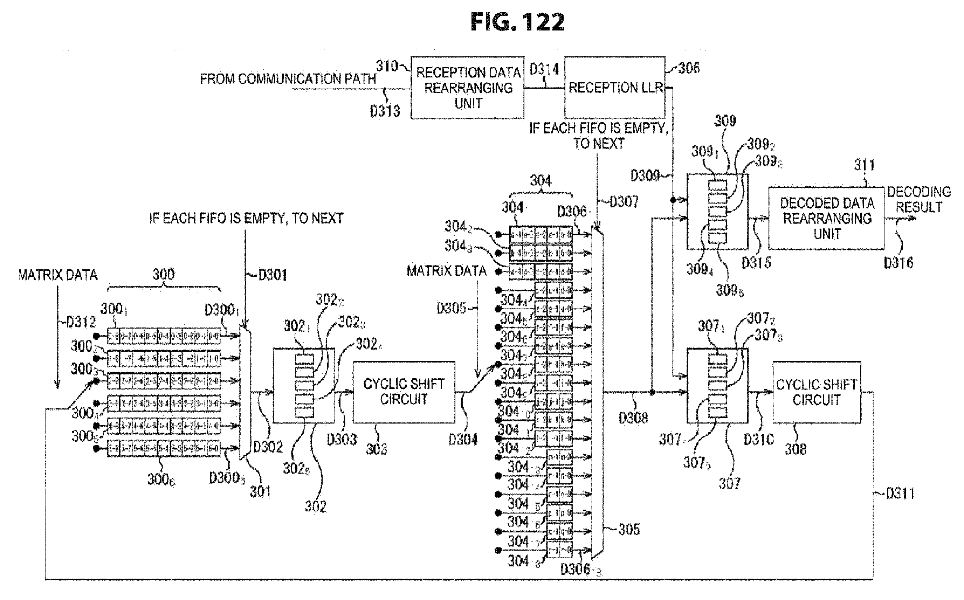

FIG. 122 is a block diagram illustrating a configuration example of a decoding device that performs the decoding.

That is, FIG. 122 illustrates the configuration example of the decoding device that performs decoding of the LDPC code, using the transformed parity check matrix H' of FIG. 119 obtained by performing at least the column replacement of the expression (12) with respect to the original parity check matrix H of FIG. 121.

The decoding device of FIG. 122 includes a branch data storing memory 300 that includes 6 FIFOs $300_1$ to $300_6$, a selector 301 that selects the FIFOs $300_1$ to $300_6$, a check node calculating unit 302, two cyclic shift circuits 303 and 308, a branch data storing memory 304 that includes 18 FIFOs $304_1$ to $304_{18}$, a selector 305 that selects the FIFOs $304_1$ to $304_{18}$, a reception data memory 306 that stores reception data, a variable node calculating unit 307, a decoding word calculating unit 309, a reception data rearranging unit 310, and a decoded data rearranging unit 311.

First, a method of storing data in the branch data storing memories 300 and 304 will be described.

The branch data storing memory 300 includes the 6 FIFOs $300_1$ to $300_6$ that correspond to a number obtained by dividing a row number 30 of the transformed parity check matrix H' of FIG. 121 by a row number 5 of the constitutive matrix (the column number P of the unit of the cyclic structure). The FIFO $300_y$ (y = 1, 2, ..., and 6) includes a plurality of steps of storage regions. In the storage region of each step, messages corresponding to five branches to be a row number and a column number of the constitutive matrix (the column number P of the unit of the cyclic structure) can be simultaneously read or written. The number of steps of the storage regions of the FIFO $300_y$ becomes 9 to be a maximum number of the number (Hamming weight) of 1 of a row direction of the transformed parity check matrix of FIG. 121.

In the FIFO $300_1$, data (messages $v_i$ from variable nodes) corresponding to positions of 1 in the first to fifth rows of the transformed parity check matrix H' of FIG. 121 is stored in a form filling each row in a transverse direction (a form in which 0 is ignored). That is, if a j-th row and an i-th column are represented as (j, i), data corresponding to positions of 1 of a 5 × 5 unit matrix of (1, 1) to (5, 5) of the transformed parity check matrix H' is stored in the storage region of the first step of the FIFO $300_1$. In the storage region of the second step, data corresponding to positions of 1 of a shifted matrix (shifted matrix obtained by cyclically shifting the 5 × 5 unit matrix to the right side by 3) of (1, 21) to (5, 25) of the transformed parity check matrix H' is stored. Similar to the above case, in the storage regions of the third to eighth steps, data is stored in association with the transformed parity check matrix H'. In the storage region of the ninth step, data corresponding to positions of 1 of a shifted matrix (shifted matrix obtained by replacing 1 of the first row of the 5 × 5 unit matrix with 0 and cyclically shifting the unit matrix to the left side by 1) of (1, 86) to (5, 90) of the transformed parity check matrix H' is stored.

In the FIFO $300_2$, data corresponding to positions of 1 in the sixth to tenth rows of the transformed parity check matrix H' of FIG. 121 is stored. That is, in the storage region of the first step of the FIFO $300_2$, data corresponding to positions of 1 of the first shifted matrix constituting a sum matrix (sum matrix to be a sum of the first shifted matrix obtained by cyclically shifting the 5 × 5 unit matrix to the right side by 1 and the second shifted matrix obtained by cyclically shifting the 5 × 5 unit matrix to the right side by 2) of (6, 1) to (10, 5) of the transformed parity check matrix H' is stored. In addition, in the storage region of the second step, data corresponding to positions of 1 of the second shifted matrix constituting the sum matrix of (6, 1) to (10, 5) of the transformed parity check matrix H' is stored.

That is, with respect to a constitutive matrix of which the weight is two or more, when the constitutive matrix is represented by a sum of multiple parts of a P × P unit matrix of which the weight is 1, a quasi unit matrix in which one or more elements of 1 in the unit matrix become 0, or a shifted matrix obtained by cyclically shifting the unit matrix or the quasi unit matrix, data (messages corresponding to branches belonging to the unit matrix, the quasi unit matrix, or the shifted matrix) corresponding to the positions of 1 in the unit matrix of the weight of 1, the quasi unit matrix, or the shifted matrix is stored at the same address (the same FIFO among the FIFOs $300_1$ to $300_6$).

Subsequently, in the storage regions of the third to ninth steps, data is stored in association with the transformed parity check matrix H', similar to the above case.

In the FIFOs $300_3$ to $300_6$, data is stored in association with the transformed parity check matrix H', similar to the above case.

The branch data storing memory 304 includes 18 FIFOs $304_1$ to $304_{18}$ that correspond to a number obtained by dividing a column number 90 of the transformed parity check matrix H' by 5 to be a column number of a constitutive matrix (the column number P of the unit of the cyclic structure). The FIFO $304_x$ (x = 1, 2, ..., and 18) includes a plurality of steps of storage regions. In the storage region of each step, messages corresponding to five branches corresponding to a row number and a column number of the constitutive matrix (the column number P of the unit of the cyclic structure) can be simultaneously read or written.

In the FIFO $304_1$, data (messages $u_j$ from check nodes) corresponding to positions of 1 in the first to fifth columns of the transformed parity check matrix H' of FIG. 121 is stored in a form filling each column in a longitudinal direction (a form in which 0 is ignored). That is, if a j-th row and an i-th column are represented as (j, i), data corresponding to positions of 1 of a 5 × 5 unit matrix of (1, 1) to (5, 5) of the transformed parity check matrix H' is stored in the storage region of the first step of the FIFO $304_1$. In the storage region of the second step, data corresponding to positions of 1 of the first shifted matrix constituting a sum matrix (sum matrix to be a sum of the first shifted matrix obtained by cyclically shifting the 5 × 5 unit matrix to the right side by 1 and the second shifted matrix obtained by cyclically shifting the 5 × 5 unit matrix to the right side by 2) of (6, 1) to (10, 5) of the transformed parity check matrix H' is stored. In addition, in the storage region of the third step, data corresponding to positions of 1 of the second shifted matrix constituting the sum matrix of (6, 1) to (10, 5) of the transformed parity check matrix H' is stored.

That is, with respect to a constitutive matrix of which the weight is two or more, when the constitutive matrix is represented by a sum of multiple parts of a P × P unit matrix of which the weight is 1, a quasi unit matrix in which one or more elements of 1 in the unit matrix become 0, or a shifted matrix obtained by cyclically shifting the unit matrix or the quasi unit matrix, data (messages corresponding to branches belonging to the unit matrix, the quasi unit matrix, or the shifted matrix) corresponding to the positions of 1 in the unit matrix of the weight of 1, the quasi unit matrix, or the shifted matrix is stored at the same address (the same FIFO among the FIFOs $304_1$ to $304_{18}$).

Subsequently, in the storage regions of the fourth and fifth steps, data is stored in association with the transformed parity check matrix H', similar to the above case. The number of steps of the storage regions of the FIFO $304_1$ becomes 5 to be a maximum number of the number (Hamming weight) of 1 of a row direction in the first to fifth columns of the transformed parity check matrix H'.

In the FIFOs $304_2$ and $304_3$, data is stored in association with the transformed parity check matrix H', similar to the above case, and each length (the number of steps) is 5. In the FIFOs $304_4$ to $304_{12}$, data is stored in association with the transformed parity check matrix H', similar to the above case, and each length is 3. In the FIFOs $304_{13}$ to $304_{18}$, data is stored in association with the transformed parity check matrix H', similar to the above case, and each length is 2.

Next, an operation of the decoding device of FIG. 122 will be described.

The branch data storing memory 300 includes the 6 FIFOs $300_1$ to $300_6$. According to information (matrix data) D312 on which row of the transformed parity check matrix H' in FIG. 121 five messages D311 supplied from a cyclic shift circuit 308 of a previous step belongs to, the FIFO storing data is selected from the FIFOs $300_1$ to $300_6$ and the five messages D311 are collectively stored sequentially in the selected FIFO. When the data is read, the branch data storing memory 300 sequentially reads the five messages $D300_1$ from the FIFO $300_1$ and supplies the messages to the selector 301 of a next step. After reading of the messages from the FIFO $300_1$ ends, the branch data storing memory 300 reads the messages sequentially from the FIFOs $300_2$ to $300_6$ and supplies the messages to the selector 301.

The selector 301 selects the five messages from the FIFO from which data is currently read, among the FIFOs $300_1$ to $300_6$, according to a select signal D301, and supplies the selected messages as messages D302 to the check node calculating unit 302.

The check node calculating unit 302 includes five check node calculators $302_1$ to $302_5$. The check node calculating unit 302 performs a check node operation according to the expression (7), using the messages D302 ($D302_1$ to $D302_5$) (messages $v_i$ of the expression 7) supplied through the selector 301, and supplies five messages D303 ($D303_1$ to $D303_5$) (messages $u_j$ of the expression (7)) obtained as a result of the check node operation to a cyclic shift circuit 303.

The cyclic shift circuit 303 cyclically shifts the five messages $D303_1$ to $D303_5$ calculated by the check node calculating unit 302, on the basis of information (matrix data) D305 on how many the unit matrixes (or the quasi unit matrix) becoming the origin in the transformed parity check matrix H' are cyclically shifted to obtain the corresponding branches, and supplies a result as messages D304 to the branch data storing memory 304.

The branch data storing memory 304 includes the eighteen FIFOs $304_1$ to $304_{18}$. According to information D305 on which row of the transformed parity check matrix H' five messages D304 supplied from a cyclic shift circuit 303 of a previous step belongs to, the FIFO storing data is selected from the FIFOs $304_1$ to $304_{18}$ and the five messages D304 are collectively stored sequentially in the selected FIFO. When the data is read, the branch data storing memory 304 sequentially reads the five messages $D304_1$ from the FIFO $304_1$ and supplies the messages to the selector 305 of a next step. After reading of the messages from the FIFO $304_1$ ends, the branch data storing memory 304 reads the messages sequentially from the FIFOs $304_2$ to $304_{18}$ and supplies the messages to the selector 305.

The selector 305 selects the five messages from the FIFO from which data is currently read, among the FIFOs $304_1$ to $304_{18}$, according to a select signal D307, and supplies the selected messages as messages D308 to the variable node calculating unit 307 and the decoding word calculating unit 309.

Meanwhile, the reception data rearranging unit 310 rearranges the LDPC code D313, that is corresponding to the parity check matrix H in FIG. 119, received through the communication path 13 by performing the column replacement of the expression (12) and supplies the LDPC code as reception data D314 to the reception data memory 306. The reception data memory 306 calculates a reception LLR (Log Likelihood Ratio) from the reception data D314 supplied from the reception data rearranging unit 310, stores the reception LLR, collects five reception LLRs, and supplies the reception LLRs as reception values D309 to the variable node calculating unit 307 and the decoding word calculating unit 309.

The variable node calculating unit 307 includes five variable node calculators $307_1$ to $307_5$. The variable node calculating unit 307 performs the variable node operation according to the expression (1), using the messages D308 ($D308_1$ to $D308_5$) (messages $u_j$ of the expression (1)) supplied through the selector 305 and the five reception values D309 (reception values $u_{0i}$ of the expression (1)) supplied from the reception data memory 306, and supplies messages D310 ($D310_1$ to $D310_5$) (message $v_i$ of the expression (1)) obtained as an operation result to the cyclic shift circuit 308.

The cyclic shift circuit 308 cyclically shifts the messages $D310_1$ to $D310_5$ calculated by the variable node calculating unit 307, on the basis of information on how many the unit matrixes (or the quasi unit matrix) becoming the origin in the transformed parity check matrix H' are cyclically shifted to obtain the corresponding branches, and supplies a result as messages D311 to the branch data storing memory 300.

By circulating the above operation in one cycle, decoding (variable node operation and check node operation) of the LDPC code can be performed once. After decoding the LDPC code by the predetermined number of times, the decoding device of FIG. 122 calculates a final decoding result and outputs the final decoding result, in the decoding word calculating unit 309 and the decoded data rearranging unit 311.

That is, the decoding word calculating unit 309 includes five decoding word calculators $309_1$ to $309_5$. The decoding word calculating unit 309 calculates a decoding result (decoding word) on the basis of the expression (5), as a final step of multiple decoding, using the five messages D308 ($D308_1$ to $D308_5$) (messages $u_j$ of the expression) output by the selector 305 and the five reception values D309 (reception values $u_{0i}$ of the expression (5)) supplied from the reception data memory 306, and supplies decoded data D315 obtained as a result to the decoded data rearranging unit 311.

The decoded data rearranging unit 311 performs the reverse replacement of the column replacement of the expression (12) with respect to the decoded data D315 supplied from the decoding word calculating unit 309, rearranges the order thereof, and outputs the decoded data as a final decoding result D316.

As mentioned above, by performing one or both of row replacement and column replacement on the parity check matrix (original parity check matrix) and converting it into a parity check matrix (transformed parity check matrix) that can be shown by the combination of a pxp unit matrix, a quasi unit matrix in which one or more elements of 1 thereof become 0, a shifted matrix that cyclically shifts the unit matrix or the quasi unit matrix, a sum matrix that is the sum of two or more of the unit matrix, the quasi unit matrix and the shifted matrix, and a pxp 0 matrix, that is, the combination of constitutive matrixes, as for LDPC code decoding, it becomes possible to adopt architecture that simultaneously performs check node calculation and variable node calculation by P which is the number less than the row number and column number of the parity check matrix. In the case of adopting the architecture that simultaneously performs node calculation (check node calculation and variable node calculation) by P which is the number less than the row number and column number of the parity check matrix, as compared with a case where the node calculation is simultaneously performed by the number equal to the row number and column number of the parity check matrix, it is possible to suppress the operation frequency within a feasible range and perform many items of iterative decoding.

The LDPC decoder 166 that constitutes the receiving device 12 of FIG. 116 performs the LDPC decoding by simultaneously performing P check node operations and variable node operations, similar to the decoding device of FIG. 122.

That is, for the simplification of explanation, if the parity check matrix of the LDPC code output by the LDPC encoder 115 constituting the transmitting device 11 of FIG. 8 is regarded as the parity check matrix H illustrated in FIG. 119 in which the parity matrix becomes a staircase structure, in the parity interleaver 23 of the transmitting device 11, the parity interleave to interleave the (K + qx + y + 1)-th code bit into the position of the (K + Py + x + 1)-th code bit is performed in a state in which the information K is set to 60, the column number P of the unit of the cyclic structure is set to 5, and the divisor q (= M/P) of the parity length M is set to 6.

Because the parity interleave corresponds to the column replacement of the expression (12) as described above, it is not necessary to perform the column replacement of the expression (12) in the LDPC decoder 166.

For this reason, in the receiving device 12 of FIG. 116, as described above, the LDPC code in which the parity deinterleave is not performed, that is, the LDPC code in a state in which the column replacement of the expression (12) is performed is supplied from the column twist deinterleaver 55 to the LDPC decoder 166. In the LDPC decoder 166, the same processing as the decoding device of FIG. 122, except that the column replacement of the expression (12) is not performed, is executed.

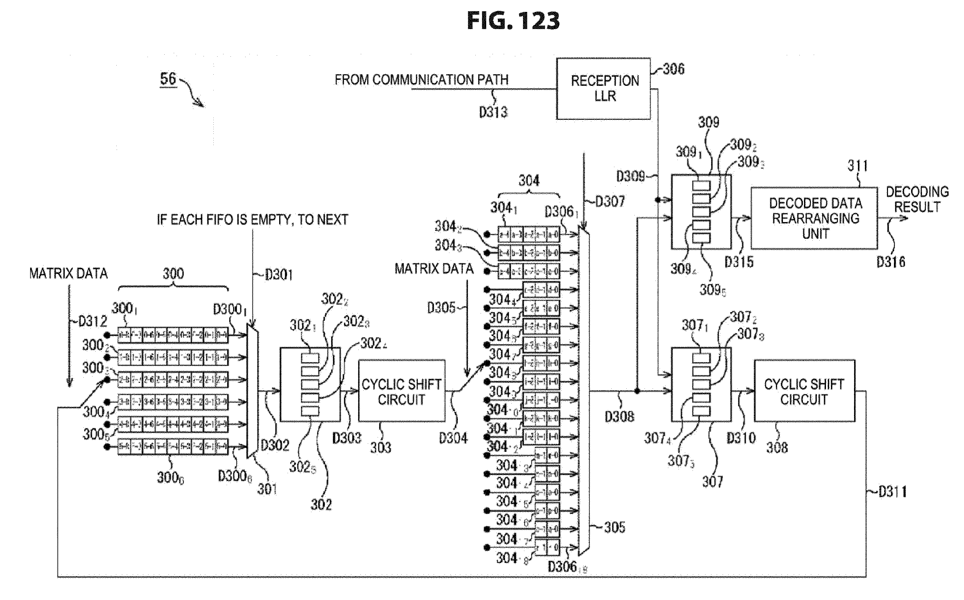

That is, FIG. 123 illustrates a configuration example of the LDPC decoder 166 of FIG. 116.

In FIG. 123, the LDPC decoder 166 has the same configuration as the decoding device of FIG. 122, except that the reception data rearranging unit 310 of FIG. 122 is not provided, and executes the same processing as the decoding device of FIG. 122, except that the column replacement of the expression (12) is not performed. Therefore, explanation of the LDPC decoder is omitted.

As described above, because the LDPC decoder 166 can be configured without providing the reception data rearranging unit 310, a scale can be decreased as compared with the decoding device of FIG. 122.

In FIGS. 119 to 123, for the simplification of explanation, the code length N of the LDPC code is set to 90, the information length K is set to 60, the column number (the row number and the column number of the constitutive matrix) P of the unit of the cyclic structure is set to 5, and the divisor q (= M/P) of the parity length M is set to 6. However, the code length N, the information length K, the column number P of the unit of the cyclic structure, and the divisor q (= M/P) are not limited to the above values.

That is, in the transmitting device 11 of FIG. 8, the LDPC encoder 115 outputs the LDPC code in which the code length N is set to 64800 or 16200, the information length K is set to N - Pq (= N - M), the column number P of the unit of the cyclic structure is set to 360, and the divisor q is set to M/P. However, the LDPC decoder 166 of FIG. 123 can be applied to the case in which P check node operation and variable node operations are simultaneously performed with respect to the LDPC code and the LDPC decoding is performed.

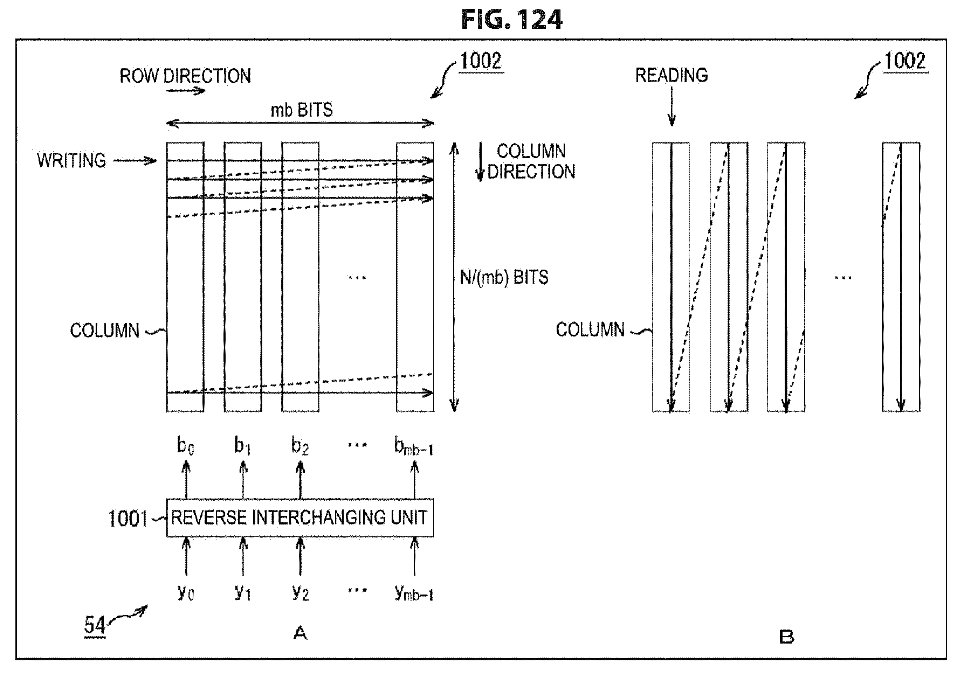

FIG. 124 is an illustration of processing of the multiplexer 54 constituting the bit deinterleaver 165 of FIG. 117.

That is, A of FIG. 124 illustrates a functional configuration example of the multiplexer 54.

The multiplexer 54 includes a reverse interchanging unit 1001 and a memory 1002.

The multiplexer 54 executes reverse interchange processing (reverse processing of the interchange processing) corresponding to the interchange processing executed by the demultiplexer 25 of the transmitting device 11, that is, reverse interchange processing for returning positions of the code bits (symbol bits) of the LDPC codes interchanged by the interchange processing to original positions, with respect to the symbol bits of the symbol supplied from the QAM decoder 164 of the previous step, and supplies an LDPC code obtained as a result to the column twist deinterleaver 55 of the following step.

That is, in the multiplexer 54, symbol bits $y_0$, $y_1$, $\cdots$, and $y_{mb-1}$ of mb bits of b symbols are supplied to the reverse interchanging unit 1001 in a unit of the b (consecutive) symbols.

The reverse interchanging unit 1001 performs reverse interchanging for returning the symbol bits $y_0$, $y_1$, $\cdots$, and $y_{mb-1}$ of the mb bits to an arrangement of code bits $b_0$, $b_1$, $\cdots$, and $b_{mb-1}$ of original mb bits (arrangement of the code bits $b_0$ to $b_{mb-1}$ before interchanging is performed in the interchanging unit 32 constituting the demultiplexer 25 of the side of the transmitting device 11) and outputs the code bits $b_0$ to $b_{mb-1}$ of the mb bits obtained as a result.

The memory 1002 has a storage capacity to store the mb bits in a row (transverse) direction and store N/(mb) bits in a column (longitudinal) direction, similar to the memory 31 constituting the demultiplexer 25 of the side of the transmitting device 11. That is, the memory 1002 includes mb columns that store N/(mb) bits.

However, in the memory 1002, writing of the code bits of the LDPC code output by the reverse interchanging unit 1001 is performed in a direction in which reading of the code bits from the memory 31 of the demultiplexer 25 of the transmitting device 11 is performed and reading of the code bits written to the memory 1002 is performed in a direction in which writing of the code bits to the memory 31 is performed.

That is, in the multiplexer 54 of the receiving device 12, as illustrated by A of FIG. 124, writing of the code bits of the LDPC code output by the reverse interchanging unit 1001 in the row direction in a unit of the mb bits is sequentially performed toward the lower rows from the first row of the memory 1002.

If writing of the code bits corresponding to one code length ends, the multiplexer 54 reads the code bits from the memory 1002 in the column direction and supplies the code bits to the column twist deinterleaver 55 of a following step.

In this case, B of FIG. 124 is an illustration of reading of the code bits from the memory 1002.

In the multiplexer 54, reading of the code bits of the LDPC code in the downward direction (column direction) from the upper side of the columns constituting the memory 1002 is performed toward the columns of the rightward direction from the left side.

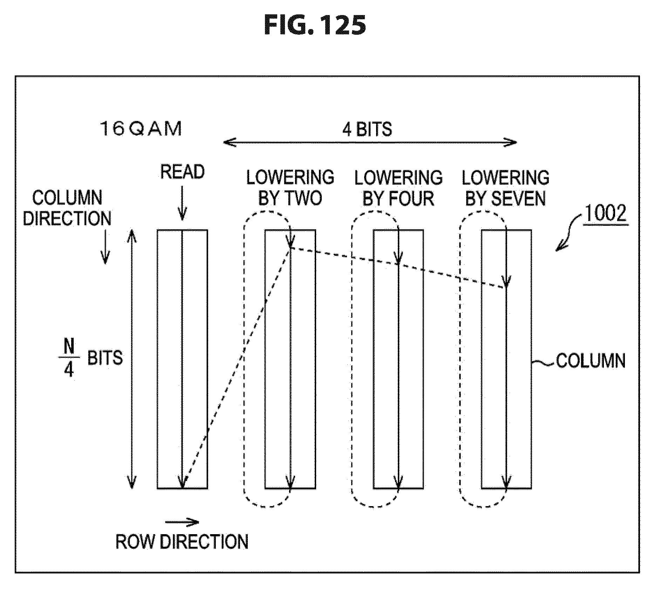

FIG. 125 is an illustration of processing of the column twist deinterleaver 55 constituting the bit deinterleaver 165 of FIG. 117.

That is, FIG. 125 illustrates a configuration example of the memory 1002 of the multiplexer 54.

The memory 1002 has a storage capacity to store the mb bits in the column (longitudinal) direction and store the N/(mb) bits in the row (transverse) direction and includes mb columns.

The column twist deinterleaver 55 writes the code bits of the LDPC code to the memory 1002 in the row direction, controls a read start position when the code bits are read in the column direction, and performs the column twist deinterleave.

That is, in the column twist deinterleaver 55, a read start position to start reading of the code bits is appropriately changed with respect to each of the plurality of columns and the reverse rearrangement processing for returning the arrangement of the code bits rearranged by the column twist interleave to the original arrangement is executed.

In this case, FIG. 125 illustrates a configuration example of the memory 1002 when the modulation method is the 16APSK, the 16QAM or the like and the multiple b is 1, described in FIG. 28. In this case, a bit number m of one symbol is 4 bits and the memory 1002 includes four (= mb) columns.

The column twist deinterleaver 55, (instead of the multiplexer 54), sequentially performs writing of the code bits of the LDPC code output by the reverse interchanging unit 1001 in the row direction, toward the lower rows from the first row of the memory 1002.

If writing of the code bits corresponding to one code length ends, the column twist deinterleaver 55 performs reading of the code bits in the downward direction (column direction) from the upper side of the memory 1002, toward the columns of the rightward direction from the left side.

However, the column twist deinterleaver 55 performs reading of the code bits from the memory 1002, using the write start position to write the code bits by the column twist interleaver 24 of the side of the transmitting device 11 as the read start position of the code bits.

That is, if an address of a position of a head (top) of each column is set to 0 and an address of each position of the column direction is represented by an integer of ascending order, when the modulation method is the 16APSK or the 16QAM and the multiple b is 1, in the column twist deinterleaver 55, a read start position is set as a position of which an address is 0, with respect the leftmost column. With respect the second column (from the left side), a read start position is set as a position of which an address is 2. With respect the third column, a read start position is set as a position of which an address is 4. With respect the fourth column, a read start position is set as a position of which an address is 7.

With respect to the columns in which the read start positions are the positions other than the position of which the address is 0, after reading of the code bits is performed to the lowermost position, the position returns to the head (position of which the address is 0), and reading to the position immediately before the read start position is performed. Then, reading from a next (right) column is performed.

By performing the column twist deinterleave described above, the arrangement of the code bits that are rearranged by the column twist interleave returns to the original arrangement.

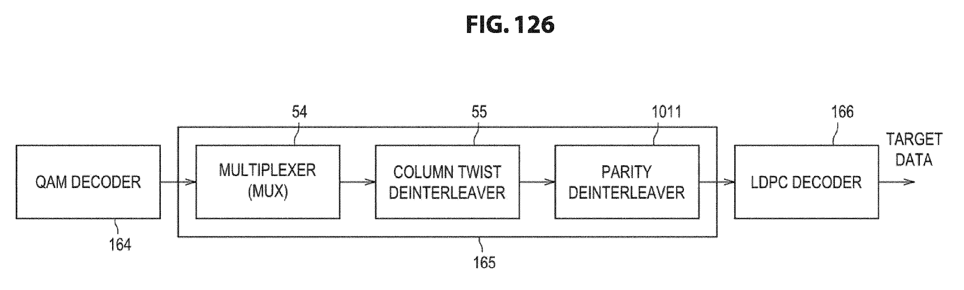

FIG. 126 is a block diagram illustrating another configuration example of the bit deinterleaver 165 of FIG. 116.

In the drawings, portions that correspond to the case of FIG. 117 are denoted with the same reference numerals and explanation thereof is appropriately omitted hereinafter.

That is, the bit deinterleaver 165 of FIG. 126 has the same configuration as the case of FIG. 117, except that a parity deinterleaver 1011 is newly provided.

In FIG. 126, the bit deinterleaver 165 includes a multiplexer (MUX) 54, a column twist deinterleaver 55, and a parity deinterleaver 1011 and performs bit deinterleave of code bits of the LDPC code supplied from the QAM decoder 164.

That is, the multiplexer 54 executes the reverse interchange processing (reverse processing of the interchange processing) corresponding to the interchange processing executed by the demultiplexer 25 of the transmitting device 11, that is, the reverse interchange processing for returning the positions of the code bits interchanged by the interchange processing to the original positions, with respect to the LDPC code supplied from the QAM decoder 164, and supplies an LDPC code obtained as a result to the column twist deinterleaver 55.

The column twist deinterleaver 55 performs the column twist deinterleave corresponding to the column twist interleave as the rearranging processing executed by the column twist interleaver 24 of the transmitting device 11, with respect to the LDPC code supplied from the multiplexer 54.

The LDPC code that is obtained as a result of the column twist deinterleave is supplied from the column twist deinterleaver 55 to the parity deinterleaver 1011.

The parity deinterleaver 1011 performs the parity deinterleave (reverse processing of the parity interleave) corresponding to the parity interleave performed by the parity interleaver 23 of the transmitting device 11, that is, the parity deinterleave to return the arrangement of the code bits of the LDPC code of which an arrangement is changed by the parity interleave to the original arrangement, with respect to the code bits after the column twist deinterleave in the column twist deinterleaver 55.

The LDPC code that is obtained as a result of the parity deinterleave is supplied from the parity deinterleaver 1011 to the LDPC decoder 166.

Therefore, in the bit deinterleaver 165 of FIG. 126, the LDPC code in which the reverse interchange processing, the column twist deinterleave, and the parity deinterleave are performed, that is, the LDPC code that is obtained by the LDPC encoding according to the parity check matrix H is supplied to the LDPC decoder 166.

The LDPC decoder 166 performs LDPC decoding of an LDPC code from the bit deinterleaver 165 by the use of the parity check matrix H used for LDPC encoding by the LDPC encoder 115 of the transmitting device 11. That is, the LDPC decoder 166 performs LDPC decoding of the LDPC code from the bit deinterleaver 165 by the use of the parity check matrix H itself used for LDPC encoding by the LDPC encoder 115 of the transmitting device 11 or by the use of a transformed parity check matrix obtained by performing at least column replacement corresponding to parity interleave with respect to the parity check matrix H.

In FIG. 126, the LDPC code that is obtained by the LDPC encoding according to the parity check matrix H is supplied from (the parity deinterleaver 1011 of) the bit deinterleaver 165 to the LDPC decoder 166. For this reason, when the LDPC decoding of the LDPC code is performed using the parity check matrix H used by the LDPC encoder 115 of the transmitting device 11 to perform the LDPC encoding, the LDPC decoder 166 can be configured by a decoding device performing the LDPC decoding according to a full serial decoding method to sequentially perform operations of messages (a check node message and a variable node message) for each node or a decoding device performing the LDPC decoding according to a full parallel decoding method to simultaneously (in parallel) perform operations of messages for all nodes.

In the LDPC decoder 166, when the LDPC decoding of the LDPC code is performed using the transformed parity check matrix obtained by performing at least the column replacement corresponding to the parity interleave with respect to the parity check matrix H used by the LDPC encoder 115 of the transmitting device 11 to perform the LDPC encoding, the LDPC decoder 166 can be configured by a decoding device (FIG. 122) that is a decoding device of an architecture simultaneously performing P (or divisor of P other than 1) check node operations and variable node operations and has the reception data rearranging unit 310 to perform the same column replacement as the column replacement to obtain the transformed parity check matrix with respect to the LDPC code and rearrange the code bits of the LDPC code.

In FIG. 126, for the convenience of explanation, the multiplexer 54 executing the reverse interchange processing, the column twist deinterleaver 55 performing the column twist deinterleave, and the parity deinterleaver 1011 performing the parity deinterleave are individually configured. However, two or more elements of the multiplexer 54, the column twist deinterleaver 55, and the parity deinterleaver 1011 can be integrally configured, similar to the parity interleaver 23, the column twist interleaver 24, and the demultiplexer 25 of the transmitting device 11.

Moreover, in a case where the bit interleaver 116 (FIG. 8) of the transmitting device 11 is configured without including the parity interleaver 23 and the column twist interleaver 24, in FIG. 126, the bit deinterleaver 165 can be configured without including the column twist deinterleaver 55 and the parity deinterleaver 1011.

Even in this case, the LDPC decoder 166 can be configured with a decoding device of a full serial decoding method to perform LDPC decoding by the use of the parity check matrix H itself, a decoding device of a full parallel decoding method to perform LDPC decoding by the use of the parity check matrix H itself, and a decoding device (FIG. 122) having the reception data rearranging unit 310 that performs LDPC decoding by P simultaneous check node calculations and variable node calculations by the use of the transformed parity check matrix H'.

[Configuration Example of Reception System]

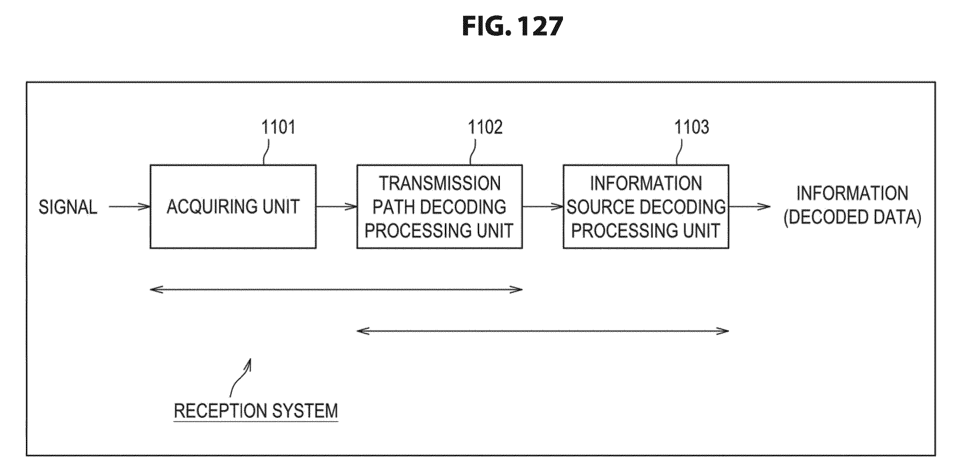

FIG. 127 is a block diagram illustrating a first configuration example of a reception system that can be applied to the receiving device 12.

In FIG. 127, the reception system includes an acquiring unit 1101, a transmission path decoding processing unit 1102, and an information source decoding processing unit 1103.

The acquiring unit 1101 acquires a signal including an LDPC code obtained by performing at least LDPC encoding with respect to LDPC target data such as image data or sound data of a program, through a transmission path (communication path) not illustrated in the drawings, such as terrestrial digital broadcasting, satellite digital broadcasting, a CATV network, the Internet, or other networks, and supplies the signal to the transmission path decoding processing unit 1102.

In this case, when the signal acquired by the acquiring unit 1101 is broadcast from a broadcasting station through a ground wave, a satellite wave, or a CATV (Cable Television) network, the acquiring unit 1101 is configured using a tuner and an STB (Set Top Box). When the signal acquired by the acquiring unit 1101 is transmitted from a web server by multicasting like an IPTV (Internet Protocol Television), the acquiring unit 1101 is configured using a network I/F (Interface) such as an NIC (Network Interface Card).

The transmission path decoding processing unit 1102 corresponds to the receiving device 12. The transmission path decoding processing unit 1102 executes transmission path decoding processing including at least processing for correcting error generated in a transmission path, with respect to the signal acquired by the acquiring unit 1101 through the transmission path, and supplies a signal obtained as a result to the information source decoding processing unit 1103.

That is, the signal that is acquired by the acquiring unit 1101 through the transmission path is a signal that is obtained by performing at least error correction encoding to correct the error generated in the transmission path. The transmission path decoding processing unit 1102 executes transmission path decoding processing such as error correction processing, with respect to the signal.

As the error correction encoding, for example, LDPC encoding or BCH encoding exists. In this case, as the error correction encoding, at least the LDPC encoding is performed.

The transmission path decoding processing includes demodulation of a modulation signal.

The information source decoding processing unit 1103 executes information source decoding processing including at least processing for extending compressed information to original information, with respect to the signal on which the transmission path decoding processing is executed.

That is, compression encoding that compresses information may be performed with respect to the signal acquired by the acquiring unit 1101 through the transmission path to decrease a data amount of an image or a sound corresponding to information. In this case, the information source decoding processing unit 1103 executes the information source decoding processing such as the processing (extension processing) for extending the compressed information to the original information, with respect to the signal on which the transmission path decoding processing is executed.

When the compression encoding is not performed with respect to the signal acquired by the acquiring unit 1101 through the transmission path, the processing for extending the compressed information to the original information is not executed in the information source decoding processing unit 1103.

In this case, as the extension processing, for example, MPEG decoding exists. In the transmission path decoding processing, in addition to the extension processing, descramble may be included.

In the reception system that is configured as described above, in the acquiring unit 1101, a signal in which the compression encoding such as the MPEG encoding and the error correction encoding such as the LDPC encoding are performed with respect to data such as an image or a sound is acquired through the transmission path and is supplied to the transmission path decoding processing unit 1102.

In the transmission path decoding processing unit 1102, the same processing as the receiving device 12 executes as the transmission path decoding processing with respect to the signal supplied from the acquiring unit 1101 and a signal obtained as a result is supplied to the information source decoding processing unit 1103.

In the information source decoding processing unit 1103, the information source decoding processing such as the MPEG decoding is executed with respect to the signal supplied from the transmission path decoding processing unit 1102 and an image or a sound obtained as a result is output.

The reception system of FIG. 127 described above can be applied to a television tuner to receive television broadcasting corresponding to digital broadcasting.

Each of the acquiring unit 1101, the transmission path decoding processing unit 1102, and the information source decoding processing unit 1103 can be configured as one independent device (hardware (IC (Integrated Circuit) and the like) or software module).

With respect to the acquiring unit 1101, the transmission path decoding processing unit 1102, and the information source decoding processing unit 1103, each of a set of the acquiring unit 1101 and the transmission path decoding processing unit 1102, a set of the transmission path decoding processing unit 1102 and the information source decoding processing unit 1103, and a set of the acquiring unit 1101, the transmission path decoding processing unit 1102, and the information source decoding processing unit 1103 can be configured as one independent device.

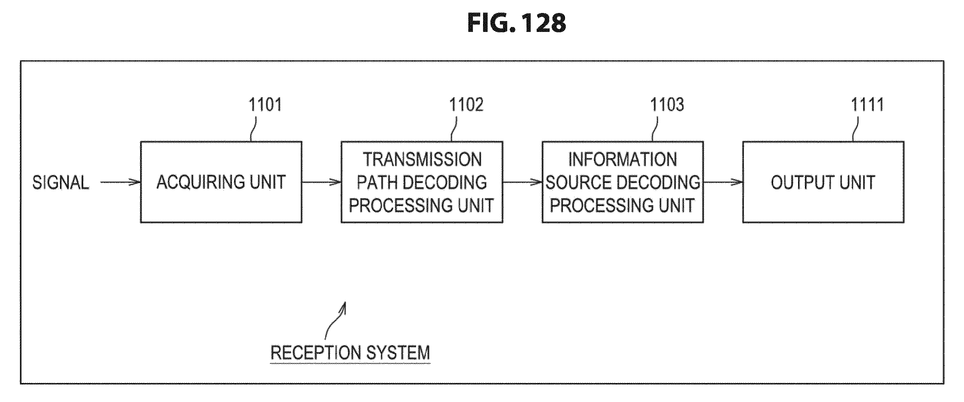

FIG. 128 is a block diagram illustrating a second configuration example of the reception system that can be applied to the receiving device 12.

In the drawings, portions that correspond to the case of FIG. 127 are denoted with the same reference numerals and explanation thereof is appropriately omitted hereinafter.

The reception system of FIG. 128 is common to the case of FIG. 127 in that the acquiring unit 1101, the transmission path decoding processing unit 1102, and the information source decoding processing unit 1103 are provided and is different from the case of FIG. 127 in that an output unit 1111 is newly provided.

The output unit 1111 is a display device to display an image or a speaker to output a sound and outputs an image or a sound corresponding to a signal output from the information source decoding processing unit 1103. That is, the output unit 1111 displays the image or outputs the sound.

The reception system of FIG. 128 described above can be applied to a TV (television receiver) receiving television broadcasting corresponding to digital broadcasting or a radio receiver receiving radio broadcasting.

When the compression encoding is not performed with respect to the signal acquired in the acquiring unit 1101, the signal that is output by the transmission path decoding processing unit 1102 is supplied to the output unit 1111.

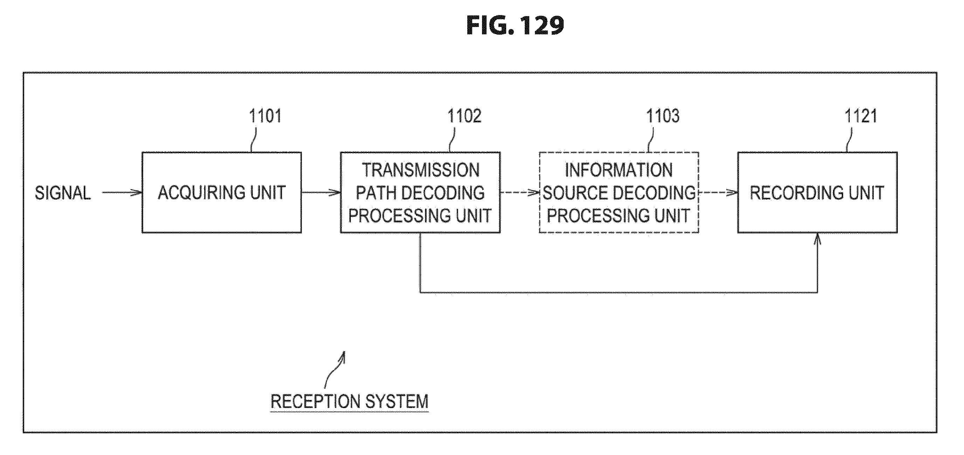

FIG. 129 is a block diagram illustrating a third configuration example of the reception system that can be applied to the receiving device 12.

In the drawings, portions that correspond to the case of FIG. 127 are denoted with the same reference numerals and explanation thereof is appropriately omitted hereinafter.

The reception system of FIG. 129 is common to the case of FIG. 127 in that the acquiring unit 1101 and the transmission path decoding processing unit 1102 are provided.

However, the reception system of FIG. 129 is different from the case of FIG. 127 in that the information source decoding processing unit 1103 is not provided and a recording unit 1121 is newly provided.

The recording unit 1121 records (stores) a signal (for example, TS packets of TS of MPEG) output by the transmission path decoding processing unit 1102 on recording (storage) media such as an optical disk, a hard disk (magnetic disk), and a flash memory.

The reception system of FIG. 129 described above can be applied to a recorder that records television broadcasting.

In FIG. 129, the reception system is configured by providing the information source decoding processing unit 1103 and can record the signal obtained by executing the information source decoding processing by the information source decoding processing unit 1103, that is, the image or the sound obtained by decoding, by the recording unit 1121.

[Embodiment of Computer]

Next, the series of processing described above can be executed by hardware or can be executed by software. In the case in which the series of processing is executed by the software, a program configuring the software is installed in a general-purpose computer.

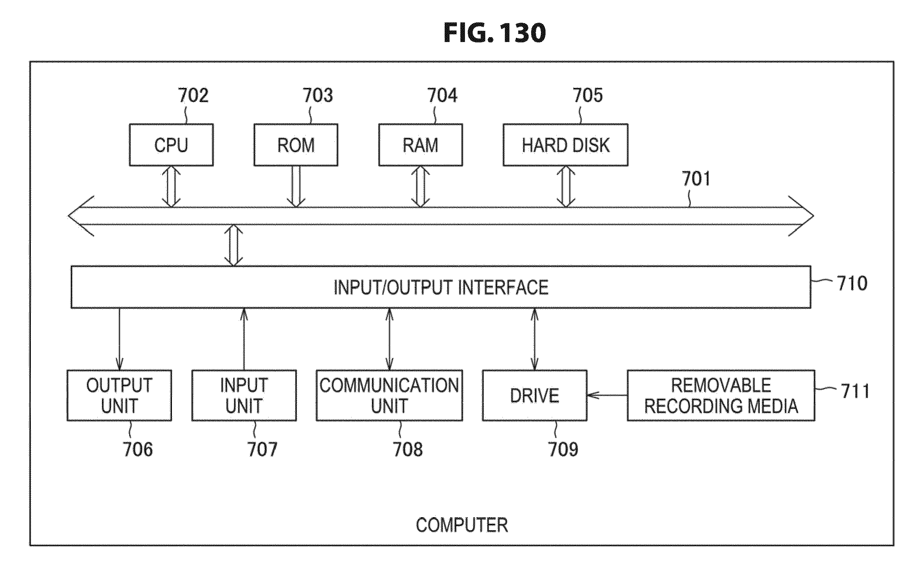

Therefore, FIG. 130 illustrates a configuration example of an embodiment of the computer in which a program executing the series of processing is installed.

The program can be previously recorded on a hard disk 705 and a ROM 703 corresponding to recording media embedded in the computer.

Alternatively, the program can be temporarily or permanently stored (recorded) on removable recording media 711 such as a flexible disk, a CD-ROM (Compact Disc Read Only Memory), an MO (Magneto Optical) disk, a DVD (Digital Versatile Disc), a magnetic disk, and a semiconductor memory. The removable recording media 711 can be provided as so-called package software.

The program is installed from the removable recording media 711 to the computer. In addition, the program can be transmitted from a download site to the computer by wireless through an artificial satellite for digital satellite broadcasting or can be transmitted to the computer by wire through a network such as a LAN (Local Area Network) or the Internet. The computer can receive the program transmitted as described above by a communication unit 708 and install the program in the embedded hard disk 705.

The computer includes a CPU (Central Processing Unit) 702 embedded therein. An input/output interface 710 is connected to the CPU 702 through a bus 701. If a user operates an input unit 707 configured using a keyboard, a mouse, and a microphone and a command is input through the input/output interface 710, the CPU 702 executes the program stored in the ROM (Read Only Memory) 703, according to the command. Alternatively, the CPU 702 loads the program stored in the hard disk 705, the program transmitted from a satellite or a network, received by the communication unit 708, and installed in the hard disk 705, or the program read from the removable recording media 711 mounted to a drive 709 and installed in the hard disk 705 to the RAM (Random Access Memory) 704 and executes the program. Thereby, the CPU 702 executes the processing according to the flowcharts described above or the processing executed by the configurations of the block diagrams described above. In addition, the CPU 702 outputs the processing result from the output unit 706 configured using an LCD (Liquid Crystal Display) or a speaker, transmits the processing result from the communication unit 708, and records the processing result on the hard disk 705, through the input/output interface 710, according to necessity.

In the present specification, it is not necessary to process the processing steps describing the program for causing the computer to execute the various processing in time series according to the order described as the flowcharts and processing executed in parallel or individually (for example, parallel processing or processing using an object) is also included.

The program may be processed by one computer or may be processed by a plurality of computers in a distributed manner. The program may be transmitted to a remote computer and may be executed.

An embodiment of the disclosure is not limited to the embodiments described above, and various changes and modifications may be made without departing from the scope of the disclosure.

That is, for example, (the parity check matrix initial value table of) the above-described new LDPC code can be used even if the communication path 13 (FIG. 7) is any of a satellite circuit, a ground wave, a cable (wire circuit) and others. In addition, the new LDPC code can also be used for data transmission other than digital broadcasting.

Reference Signs List

| 11 | transmitting device |
|----|----|
| 12 | receiving device |
| 23 | parity interleaver |
| 24 | column twist interleaver |
| 25 | demultiplexer |
| 31 | memory |
| 32 | interchanging unit |
| 54 | multiplexer |
| 55 | column twist interleaver |
| 111 | mode adaptation/multiplexer |
| 112 | padder |
| 113 | BB scrambler |
| 114 | BCH encoder |
| 115 | LDPC encoder |
| 116 | bit interleaver |
| 117 | QAM encoder |
| 118 | time interleaver |
| 119 | MISO/MIMO encoder |
| 120 | frequency interleaver |
| 121 | BCH encoder |
| 122 | LDPC encoder |
| 123 | QAM encoder |
| 124 | frequency interleaver |
| 131 | frame builder/resource allocation unit |
| 132 | OFDM generating unit |
| 151 | OFDM operating unit |
| 152 | frame managing unit |
| 153 | frequency deinterleaver |
| 154 | QAM decoder |
| 155 | LDPC decoder |
| 156 | BCH decoder |
| 161 | frequency deinterleaver |
| 162 | MISO/MIMO decoder |
| 163 | time deinterleaver |
| 164 | QAM decoder |

165     bit deinterleaver
166     LDPC decoder
167     BCH decoder
168     BB descrambler
169     null deletion unit
170     demultiplexer
300     branch data storing memory
301     selector
302     check node calculating unit
303     cyclic shift circuit
304     branch data storing memory
305     selector
306     reception data memory
307     variable node calculating unit
308     cyclic shift circuit
309     decoding word calculating unit
310     reception data rearranging unit
311     decoded data rearranging unit
601     encoding processing unit
602     storage unit
611     encoding rate setting unit
612     initial value table reading unit
613     parity check matrix generating unit
614     information bit reading unit
615     encoding parity operation unit
616     control unit
701     bus
702     CPU
703     ROM
704     RAM
705     hard disk
706     output unit
707     input unit
708     communication unit
709     drive
710     input/output interface
711     removable recording media
1001    reverse interchanging unit
1002    memory
1011    parity deinterleaver
1101    acquiring unit
1101    transmission path decoding processing unit
1103    information source decoding processing unit
1111    output unit
1121    recording unit

**Claims**

1.  A data processing device comprising:

an encoding unit configured to encode an information bit into an LDPC code with a code length of 64800 bits and an encoding rate of 2/30, based on a parity check matrix of an LDPC (Low Density Parity Check) code, wherein
the LDPC code includes an information bit and a parity bit,
the parity check matrix includes an information matrix part corresponding to the information bit and a parity matrix part corresponding to the parity bit,
the information matrix part is shown by a parity check matrix initial value table, and

the parity check matrix initial value table is a table showing positions of elements of 1 of the information matrix part every 360 columns and is expressed as follows

30 251 2458 3467 9897 12052 12191 15073 15949 16328 16972 17704 20672 22200 22276 25349 26106 28258 29737 30518 30951 32440 43031 46622 47113 52077 52609 52750 54295 55384 56954 57155 57853 59942 6985 7975 8681 10628 10866 13223 14882 18449 19570 24418 24538 24556 25926 26162 26947 28181 30049 33678 35497 37980 41276 43443 44124 48684 50382 51223 53635 57661 58040 59128 59300 59614 60200 60329 1896 5169 7347 10895 14434 14583 15125 15279 17169 18374 20805 25203 29509 30267 30925 33774 34653 34827 35707 36868 38136 38926 42690 43464 44624 46562 50291 50321 51544 56470 56532 58199 58398 60423 144 152 1236 8826 11983 12930 13349 19562 20564 30203 31766 35635 40367 40905 41792 41872 42428 43828 44359 47973 48041 49046 50158 50786 55527 55541 57260 57353 57821 58770 59098 59407 60358 60475 2085 28320 37838 50085 6903 21724 38880 59861 17156 20293 21231 44440 16799 38095 41049 44269 11939 30310 39689 47323 10563 17282 45331 60186 19860 23595 59085 60417 10403 19812 27225 48006.

**2.** The data processing device according to claim 1, wherein
when a row of the parity check matrix initial value table is expressed as i and a parity length of the LDPC code is expressed as M, a $2+360\times(i-1)$-th column of the parity check matrix is a column subjected to cyclic shift of a $1+360\times(i-1)$-th column of the parity check matrix showing the positions of the elements of 1 in the parity check matrix initial value table by $q=M/360$ in a downward direction.

**3.** The data processing device according to claim 2, wherein
as for the $1+360\times(i-1)$-th column of the parity check matrix, an i-th row of the parity check matrix initial value table shows a row number of an element of 1 of the $1+360\times(i-1)$-th column of the parity check matrix, and
as for each of columns from the $2+360\times(i-1)$-th column to a 360xi-th column which are columns other than the $1+360\times(i-1)$-th column of the parity check matrix, when a numerical value of an i-th row and j-th column of the parity check matrix initial value table is expressed as $h_{i,j}$ and a row number of a j-th element of 1 of a w-th column of the parity check matrix H is expressed as $H_{w-j}$, the row number $H_{w-j}$ of the element of 1 in the w-th column which is a column other than the $1+360\times(i-1)$-th column of the parity check matrix is expressed by an expression $H_{w-j}=mod\{h_{i,j}+mod((w-1),360)\times M/360,M)$.

**4.** The data processing device according to claim 2, wherein
the q is 168.

**5.** The data processing device according to claim 1, further comprising:

a parity interleave unit configured to interleave only a parity bit of a code bit of the LDPC code.

**6.** The data processing device according to claim 1, further comprising:

a column twist interleave unit configured to perform column twist interleave by shifting a code bit of the LDPC code in a column direction and storing the code bit.

**7.** The data processing device according to claim 1, further comprising:

an interchange unit configured to interchange a code bit of the LDPC code with a symbol bit of a symbol corresponding to any of a predetermined number of signal points defined by a predetermined digital modulation method.

**8.** The data processing device according to claim 7, wherein
the interchange unit interchanges the code bit stored in a column direction and read in a row direction.

**9.** The data processing device according to claim 1, wherein
the parity check matrix is a parity check matrix without cycle 4.

**10.** The data processing device according to claim 1, wherein
the parity check matrix is a parity check matrix of an LDPC code belonging to an ensemble of an LDPC code in which a performance threshold that is $E_b/N_0$ with decreasing BER is equal to or less than a predetermined value, which is detected by density evolution of a multi-edge type.

**11.** A data processing method comprising:

an encoding step of encoding an information bit into an LDPC code with a code length of 64800 bits and an encoding rate of 2/30, based on a parity check matrix of an LDPC (Low Density Parity Check) code, wherein the LDPC code includes an information bit and a parity bit,
the parity check matrix includes an information matrix part corresponding to the information bit and a parity matrix part corresponding to the parity bit,
the information matrix part is shown by a parity check matrix initial value table, and
the parity check matrix initial value table is a table showing positions of elements of 1 of the information matrix part every 360 columns and is expressed as follows
30 251 2458 3467 9897 12052 12191 15073 15949 16328 16972 17704 20672 22200 22276 25349 26106
28258 29737 30518 30951 32440 43031 46622 47113 52077 52609 52750 54295 55384 56954 57155 57853
59942 6985 7975 8681 10628 10866 13223 14882 18449 19570 24418 24538 24556 25926 26162 26947
28181 30049 33678 35497 37980 41276 43443 44124 48684 50382 51223 53635 57661 58040 59128 59300
59614 60200 60329 1896 5169 7347 10895 14434 14583 15125 15279 17169 18374 20805 25203 29509
30267 30925 33774 34653 34827 35707 36868 38136 38926 42690 43464 44624 46562 50291 50321 51544
56470 56532 58199 58398 60423 144 152 1236 8826 11983 12930 13349 19562 20564 30203 31766 35635
40367 40905 41792 41872 42428 43828 44359 47973 48041 49046 50158 50786 55527 55541 57260 57353
57821 58770 59098 59407 60358 60475 2085 28320 37838 50085 6903 21724 38880 59861 17156 20293
21231 44440 16799 38095 41049 44269 11939 30310 39689 47323 10563 17282 45331 60186 19860 23595
59085 60417 10403 19812 27225 48006.

**12.** The data processing method according to claim 11, wherein
when a row of the parity check matrix initial value table is expressed as i and a parity length of the LDPC code is expressed as M, a $2+360\times(i-1)$-th column of the parity check matrix is a column subjected to cyclic shift of a $1+360\times(i-1)$-th column of the parity check matrix showing the positions of the elements of 1 in the parity check matrix initial value table by q=M/360 in a downward direction.

**13.** The data processing method according to claim 12, wherein
as for the $1+360\times(i-1)$-th column of the parity check matrix, an i-th row of the parity check matrix initial value table shows a row number of an element of 1 of the $1+360\times(i-1)$-th column of the parity check matrix, and
as for each of columns from the $2+360\times(i-1)$-th column to a 360xi-th column which are columns other than the $1+360\times(i-1)$-th column of the parity check matrix, when a numerical value of an i-th row and j-th column of the parity check matrix initial value table is expressed as $h_{i,j}$ and a row number of a j-th element of 1 of a w-th column of the parity check matrix H is expressed as $H_{w-j}$, the row number $H_{w-j}$ of the element of 1 in the w-th column which is a column other than the $1+360\times(i-1)$-th column of the parity check matrix is expressed by an expression $H_{w-j}=mod\{h_{i,j}+mod((w-1),360)\times M/360,M\}$.

**14.** The data processing method according to claim 12, wherein
the q is 168.

**15.** The data processing method according to claim 11, comprising:

interleaving only a parity bit of a code bit of the LDPC code.

**16.** The data processing method according to claim 11, comprising:

performing column twist interleave by shifting a code bit of the LDPC code in a column direction and storing the code bit.

**17.** The data processing method according to claim 11, comprising:

interchanging a code bit of the LDPC code with a symbol bit of a symbol corresponding to any of a predetermined number of signal points defined by a predetermined digital modulation method.

**18.** The data processing method according to claim 17, wherein
in the interchange of the code bit, the code bit that is stored in a column direction and read in a row direction is interchanged.

**19.** The data processing method according to claim 11, wherein
the parity check matrix is a parity check matrix without cycle 4.

**20.** The data processing method according to claim 11, wherein
the parity check matrix is a parity check matrix of an LDPC code belonging to an ensemble of an LDPC code in which a performance threshold that is $E_b/N_0$ with decreasing BER is equal to or less than a predetermined value, which is detected by density evolution of a multi-edge type.

**21.** A data processing device comprising:

a decoding unit configured to decode an LDPC code with a code length of 64800 bits and an encoding rate of 2/30, based on a parity check matrix of an LDPC (Low Density Parity Check) code, wherein
the LDPC code includes an information bit and a parity bit,
the parity check matrix includes an information matrix part corresponding to the information bit and a parity matrix part corresponding to the parity bit,
the information matrix part is shown by a parity check matrix initial value table, and
the parity check matrix initial value table is a table showing positions of elements of 1 of the information matrix part every 360 columns and is expressed as follows
30 251 2458 3467 9897 12052 12191 15073 15949 16328 16972 17704 20672 22200 22276 25349 26106 28258 29737 30518 30951 32440 43031 46622 47113 52077 52609 52750 54295 55384 56954 57155 57853 59942 6985 7975 8681 10628 10866 13223 14882 18449 19570 24418 24538 24556 25926 26162 26947 28181 30049 33678 35497 37980 41276 43443 44124 48684 50382 51223 53635 57661 58040 59128 59300 59614 60200 60329 1896 5169 7347 10895 14434 14583 15125 15279 17169 18374 20805 25203 29509 30267 30925 33774 34653 34827 35707 36868 38136 38926 42690 43464 44624 46562 50291 50321 51544 56470 56532 58199 58398 60423 144 152 1236 8826 11983 12930 13349 19562 20564 30203 31766 35635 40367 40905 41792 41872 42428 43828 44359 47973 48041 49046 50158 50786 55527 55541 57260 57353 57821 58770 59098 59407 60358 60475 2085 28320 37838 50085 6903 21724 38880 59861 17156 20293 21231 44440 16799 38095 41049 44269 11939 30310 39689 47323 10563 17282 45331 60186 19860 23595 59085 60417 10403 19812 27225 48006.

**22.** The data processing device according to claim 21, wherein
when a row of the parity check matrix initial value table is expressed as i and a parity length of the LDPC code is expressed as M, a $2+360 \times (i-1)$-th column of the parity check matrix is a column subjected to cyclic shift of a $1+360 \times (i-1)$-th column of the parity check matrix showing the positions of the elements of 1 in the parity check matrix initial value table by q=M/360 in a downward direction.

**23.** The data processing device according to claim 22, wherein
as for the $1+360 \times (i-1)$-th column of the parity check matrix, an i-th row of the parity check matrix initial value table shows a row number of an element of 1 of the $1+360 \times (i-1)$-th column of the parity check matrix, and
as for each of columns from the $2+360 \times (i-1)$-th column to a 360xi-th column which are columns other than the $1+360 \times (i-1)$-th column of the parity check matrix, when a numerical value of an i-th row and j-th column of the parity check matrix initial value table is expressed as $h_{i,j}$ and a row number of a j-th element of 1 of a w-th column of the parity check matrix H is expressed as $H_{w-j}$, the row number $H_{w-j}$ of the element of 1 in the w-th column which is a column other than the $1+360 \times (i-1)$-th column of the parity check matrix is expressed by an expression $H_{w-j} = \mathrm{mod}\{h_{i,j} + \mathrm{mod}((w-1), 360) \times M/360, M\}$.

**24.** The data processing device according to claim 22, wherein
the q is 168.

**25.** The data processing device according to claim 21, further comprising:

a column twist deinterleave unit configured to perform column twist deinterleave that returns a code bit of the LDPC code to original arrangement when column twist interleave is performed by shifting the code bit of the LDPC code in a column direction and storing the code bit.

**26.** The data processing device according to claim 21, further comprising:

a reverse interchange unit configured to perform reverse interchange processing that returns a code bit whose position is interchanged as a symbol bit to an original position when interchange processing that interchanges the code bit of the LDPC code with the symbol bit of a symbol corresponding to any of a predetermined number of signal points defined by a predetermined digital modulation method is performed.

**27.** The data processing device according to claim 26, wherein
the reverse interchange unit performs the reverse interchange processing that returns the code bit stored in a row direction and read in a column direction to the original position.

**28.** The data processing device according to claim 21, wherein
the parity check matrix is a parity check matrix without cycle 4.

**29.** The data processing device according to claim 21, wherein
the parity check matrix is a parity check matrix of an LDPC code belonging to an ensemble of an LDPC code in which a performance threshold that is $E_b/N_0$ with decreasing BER is equal to or less than a predetermined value, which is detected by density evolution of a multi-edge type.

**30.** A data processing method comprising:

a decoding step of decoding an LDPC code with a code length of 64800 bits and an encoding rate of 2/30, based on a parity check matrix of an LDPC (Low Density Parity Check) code, wherein
the LDPC code includes an information bit and a parity bit,
the parity check matrix includes an information matrix part corresponding to the information bit and a parity matrix part corresponding to the parity bit,
the information matrix part is shown by a parity check matrix initial value table, and
the parity check matrix initial value table is a table showing positions of elements of 1 of the information matrix part every 360 columns and is expressed as follows
30 251 2458 3467 9897 12052 12191 15073 15949 16328 16972 17704 20672 22200 22276 25349 26106 28258 29737 30518 30951 32440 43031 46622 47113 52077 52609 52750 54295 55384 56954 57155 57853 59942 6985 7975 8681 10628 10866 13223 14882 18449 19570 24418 24538 24556 25926 26162 26947 28181 30049 33678 35497 37980 41276 43443 44124 48684 50382 51223 53635 57661 58040 59128 59300 59614 60200 60329 1896 5169 7347 10895 14434 14583 15125 15279 17169 18374 20805 25203 29509 30267 30925 33774 34653 34827 35707 36868 38136 38926 42690 43464 44624 46562 50291 50321 51544 56470 56532 58199 58398 60423 144 152 1236 8826 11983 12930 13349 19562 20564 30203 31766 35635 40367 40905 41792 41872 42428 43828 44359 47973 48041 49046 50158 50786 55527 55541 57260 57353 57821 58770 59098 59407 60358 60475 2085 28320 37838 50085 6903 21724 38880 59861 17156 20293 21231 44440 16799 38095 41049 44269 11939 30310 39689 47323 10563 17282 45331 60186 19860 23595 59085 60417 10403 19812 27225 48006.

**31.** The data processing method according to claim 30, wherein
when a row of the parity check matrix initial value table is expressed as i and a parity length of the LDPC code is expressed as M, a 2+360×(i-1)-th column of the parity check matrix is a column subjected to cyclic shift of a 1+360×(i-1)-th column of the parity check matrix showing the positions of the elements of 1 in the parity check matrix initial value table by q=M/360 in a downward direction.

**32.** The data processing method according to claim 31, wherein
as for the 1+360×(i-1)-th column of the parity check matrix, an i-th row of the parity check matrix initial value table shows a row number of an element of 1 of the 1+360×(i-1)-th column of the parity check matrix, and
as for each of columns from the 2+360×(i-1)-th column to a 360xi-th column which are columns other than the 1+360×(i-1)-th column of the parity check matrix, when a numerical value of an i-th row and j-th column of the parity check matrix initial value table is expressed as $h_{i,j}$ and a row number of a j-th element of 1 of a w-th column of the parity check matrix H is expressed as $H_{w-j}$, the row number $H_{w-j}$ of the element of 1 in the w-th column which is a column other than the 1+360×(i-1)-th column of the parity check matrix is expressed by an expression $H_{w-j}=\mathrm{mod}\{h_{i,j}+\mathrm{mod}((w-1),360)\times M/360,M\}$.

**33.** The data processing method according to claim 31, wherein
the q is 168.

**34.** The data processing method according to claim 30, wherein

column twist deinterleave that returns a code bit of the LDPC code to original arrangement is performed when column twist interleave is performed by shifting the code bit of the LDPC code in a column direction and storing the code bit.

**35.** The data processing method according to claim 30, wherein
reverse interchange processing that returns a code bit whose position is interchanged as a symbol bit to an original position is performed when interchange processing that interchanges the code bit of the LDPC code with the symbol bit of a symbol corresponding to any of a predetermined number of signal points defined by a predetermined digital modulation method is performed.

**36.** The data processing method according to claim 35,
wherein the code bit stored in a row direction and read in a column direction is returned to the original position in the reverse interchange processing.

**37.** The data processing method according to claim 30, wherein
the parity check matrix is a parity check matrix without cycle 4.

**38.** The data processing method according to claim 30, wherein
the parity check matrix is a parity check matrix of an LDPC code belonging to an ensemble of an LDPC code in which a performance threshold that is $E_b/N_0$ with decreasing BER is equal to or less than a predetermined value, which is detected by density evolution of a multi-edge type.

**39.** A data processing device comprising:

an encoding unit configured to encode an information bit into an LDPC code with a code length of 64800 bits and an encoding rate of 3/30, based on a parity check matrix of an LDPC (Low Density Parity Check) code, wherein
the LDPC code includes an information bit and a parity bit,
the parity check matrix includes an information matrix part corresponding to the information bit and a parity matrix part corresponding to the parity bit,
the information matrix part is shown by a parity check matrix initial value table, and
the parity check matrix initial value table is a table showing positions of elements of 1 of the information matrix part every 360 columns and is expressed as follows
153 2939 6037 11618 12401 17787 18472 22673 25220 26245 29839 35106 36915 37622 37655 45425 55595
56308 56726 58286 146 160 9060 12867 16536 20818 31754 35546 36480 36698 56314 56509 56837 57342
57373 57895 57947 58163 58202 58262 58 1555 10183 10446 12204 16197 16830 17382 19144 19565 21476
29121 41158 49953 51531 55642 57423 57587 57627 57974 120 9906 12466 21668 26856 27304 28451
29413 30168 31274 33309 33499 37486 38265 43457 50299 55218 56971 57059 58115 80 6649 9541 12490
14153 14346 19926 20677 23672 42397 45629 46288 55935 56115 56555 56865 56993 57921 58049 58190
46 152 3536 7134 9040 10474 10504 11549 17066 19102 27486 29364 39577 39995 48289 56236 57279
57560 57608 57930 19824 21165 34427 58143 22747 50215 50864 58176 2943 31340 39711 57281 1186
20802 27612 33409 1347 20868 29222 48776 19 8548 46255 56946 10762 20467 48519 39 7401 34355 142
10827 17009 1822 29424 39439 5944 11349 28870 4981 14731 15377.

**40.** A data processing method comprising:

an encoding step of encoding an information bit into an LDPC code with a code length of 64800 bits and an encoding rate of 3/30, based on a parity check matrix of an LDPC (Low Density Parity Check) code, wherein the LDPC code includes an information bit and a parity bit,
the parity check matrix includes an information matrix part corresponding to the information bit and a parity matrix part corresponding to the parity bit,
the information matrix part is shown by a parity check matrix initial value table, and
the parity check matrix initial value table is a table showing positions of elements of 1 of the information matrix part every 360 columns and is expressed as follows
153 2939 6037 11618 12401 17787 18472 22673 25220 26245 29839 35106 36915 37622 37655 45425 55595
56308 56726 58286 146 160 9060 12867 16536 20818 31754 35546 36480 36698 56314 56509 56837 57342
57373 57895 57947 58163 58202 58262 58 1555 10183 10446 12204 16197 16830 17382 19144 19565 21476
29121 41158 49953 51531 55642 57423 57587 57627 57974 120 9906 12466 21668 26856 27304 28451 29413 30168 31274 33309 33499 37486 38265 43457 50299 55218 56971 57059 58115 80 6649 9541 12490 14153 14346 19926 20677 23672 42397 45629 46288 55935 56115 56555 56865 56993 57921 58049 58190 46 152 3536 7134 9040 10474 10504 11549 17066 19102 27486 29364 39577 39995 48289 56236 57279 57560 57608 57930 19824 21165 34427 58143 22747 50215 50864 58176 2943 31340 39711 57281 1186 20802 27612 33409 1347 20868 29222 48776 19 8548 46255 56946 10762 20467 48519 39 7401 34355 142 10827 17009 1822 29424 39439 5944 11349 28870 4981 14731 15377.

**41.** A data processing device comprising:

a decoding unit configured to decode an LDPC code with a code length of 64800 bits and an encoding rate of 3/30, based on a parity check matrix of an LDPC (Low Density Parity Check) code, wherein
the LDPC code includes an information bit and a parity bit,
the parity check matrix includes an information matrix part corresponding to the information bit and a parity matrix part corresponding to the parity bit,
the information matrix part is shown by a parity check matrix initial value table, and
the parity check matrix initial value table is a table showing positions of elements of 1 of the information matrix part every 360 columns and is expressed as follows
153 2939 6037 11618 12401 17787 18472 22673 25220 26245 29839 35106 36915 37622 37655 45425 55595 56308 56726 58286 146 160 9060 12867 16536 20818 31754 35546 36480 36698 56314 56509 56837 57342 57373 57895 57947 58163 58202 58262 58 1555 10183 10446 12204 16197 16830 17382 19144 19565 21476 29121 41158 49953 51531 55642 57423 57587 57627 57974 120 9906 12466 21668 26856 27304 28451 29413 30168 31274 33309 33499 37486 38265 43457 50299 55218 56971 57059 58115 80 6649 9541 12490 14153 14346 19926 20677 23672 42397 45629 46288 55935 56115 56555 56865 56993 57921 58049 58190 46 152 3536 7134 9040 10474 10504 11549 17066 19102 27486 29364 39577 39995 48289 56236 57279 57560 57608 57930 19824 21165 34427 58143 22747 50215 50864 58176 2943 31340 39711 57281 1186 20802 27612 33409 1347 20868 29222 48776 19 8548 46255 56946 10762 20467 48519 39 7401 34355 142 10827 17009 1822 29424 39439 5944 11349 28870 4981 14731 15377.

**42.** A data processing method comprising:

a decoding step of decoding an LDPC code with a code length of 64800 bits and an encoding rate of 3/30, based on a parity check matrix of an LDPC (Low Density Parity Check) code, wherein
the LDPC code includes an information bit and a parity bit,
the parity check matrix includes an information matrix part corresponding to the information bit and a parity matrix part corresponding to the parity bit,
the information matrix part is shown by a parity check matrix initial value table, and
the parity check matrix initial value table is a table showing positions of elements of 1 of the information matrix part every 360 columns and is expressed as follows
153 2939 6037 11618 12401 17787 18472 22673 25220 26245 29839 35106 36915 37622 37655 45425 55595 56308 56726 58286 146 160 9060 12867 16536 20818 31754 35546 36480 36698 56314 56509 56837 57342 57373 57895 57947 58163 58202 58262 58 1555 10183 10446 12204 16197 16830 17382 19144 19565 21476 29121 41158 49953 51531 55642 57423 57587 57627 57974 120 9906 12466 21668 26856 27304 28451 29413 30168 31274 33309 33499 37486 38265 43457 50299 55218 56971 57059 58115 80 6649 9541 12490 14153 14346 19926 20677 23672 42397 45629 46288 55935 56115 56555 56865 56993 57921 58049 58190 46 152 3536 7134 9040 10474 10504 11549 17066 19102 27486 29364 39577 39995 48289 56236 57279 57560 57608 57930 19824 21165 34427 58143 22747 50215 50864 58176 2943 31340 39711 57281 1186 20802 27612 33409 1347 20868 29222 48776 19 8548 46255 56946 10762 20467 48519 39 7401 34355 142 10827 17009 1822 29424 39439 5944 11349 28870 4981 14731 15377.

**43.** A data processing device comprising:

an encoding unit configured to encode an information bit into an LDPC code with a code length of 64800 bits and an encoding rate of 4/30, based on a parity check matrix of an LDPC (Low Density Parity Check) code, wherein
the LDPC code includes an information bit and a parity bit,
the parity check matrix includes an information matrix part corresponding to the information bit and a parity matrix part corresponding to the parity bit,
the information matrix part is shown by a parity check matrix initial value table, and

the parity check matrix initial value table is a table showing positions of elements of 1 of the information matrix part every 360 columns and is expressed as follows

7248 8578 11266 16015 17433 18038 20159 20848 22164 23848 24516 25093 25888 28382 31701 33259 33540 34615 36428 38595 38683 38814 41592 44323 44522 44859 45857 48657 49686 53354 54260 54853 55069 55426 56127 715 1505 3314 5537 6377 6750 11039 11271 15840 16615 24045 24314 24435 26992 28524 28745 28935 32956 33359 34964 36217 37546 38189 42599 44326 49694 54236 54779 55501 55543 55721 55865 55961 55966 55988 70 116 613 2482 6204 6608 7392 13585 14175 14228 17842 20004 20142 21324 22575 24443 24497 25394 26585 30222 37825 38548 41709 44999 50925 52186 53793 54177 54705 55096 55489 55584 56019 56055 56151 9 2054 3493 3584 3989 5916 11915 14323 15091 16998 17631 18645 18882 20510 27499 28990 30054 32231 36556 37437 39651 41543 41963 42798 42937 44864 48056 48971 53104 54511 54610 55151 55216 55470 55736 30 81 110 294 1636 2152 4312 6098 9415 12105 14021 15226 15618 18614 21368 23154 28913 29260 36969 37792 39386 42362 42949 43758 43765 44572 45877 46424 46948 47683 47903 48245 51804 52166 53264 3 50 987 1771 4255 9714 9907 13728 17807 20438 24206 24326 24458 26039 26898 35691 36875 37877 38103 38398 38671 39288 40642 41533 41753 42069 45374 46377 48016 48165 48805 49392 50660 51907 51968 138 441 4163 6450 7419 10743 11330 14962 14984 15032 24819 28987 29221 33223 35464 37535 38213 39085 39223 39925 41220 41341 41643 44944 46330 46870 47142 48577 49387 50732 52578 53839 54085 55426 56132 3773 41938 55428 55720 8833 47844 49437 50265 7054 31403 48642 53739 2286 22401 42270 53546 14435 24811 29047 36135 21010 23783 55073 55612 20516 27533 51132 52391 884 22844 25100 56123 1150 12133 44416 53752 9761 38585 52021 55545 1476 5057 49721 50744 16334 39503 40494 43840 24 31960 33866 53369 22065 22989 32356 52287 111 155 3706 13753 17878 18240 27828 55776 13582 47019 54558 55557.

**44.** A data processing method comprising:

an encoding step of encoding an information bit into an LDPC code with a code length of 64800 bits and an encoding rate of 4/30, based on a parity check matrix of an LDPC (Low Density Parity Check) code, wherein the LDPC code includes an information bit and a parity bit,
the parity check matrix includes an information matrix part corresponding to the information bit and a parity matrix part corresponding to the parity bit,
the information matrix part is shown by a parity check matrix initial value table, and
the parity check matrix initial value table is a table showing positions of elements of 1 of the information matrix part every 360 columns and is expressed as follows

7248 8578 11266 16015 17433 18038 20159 20848 22164 23848 24516 25093 25888 28382 31701 33259 33540 34615 36428 38595 38683 38814 41592 44323 44522 44859 45857 48657 49686 53354 54260 54853 55069 55426 56127 715 1505 3314 5537 6377 6750 11039 11271 15840 16615 24045 24314 24435 26992 28524 28745 28935 32956 33359 34964 36217 37546 38189 42599 44326 49694 54236 54779 55501 55543 55721 55865 55961 55966 55988 70 116 613 2482 6204 6608 7392 13585 14175 14228 17842 20004 20142 21324 22575 24443 24497 25394 26585 30222 37825 38548 41709 44999 50925 52186 53793 54177 54705 55096 55489 55584 56019 56055 56151 9 2054 3493 3584 3989 5916 11915 14323 15091 16998 17631 18645 18882 20510 27499 28990 30054 32231 36556 37437 39651 41543 41963 42798 42937 44864 48056 48971 53104 54511 54610 55151 55216 55470 55736 30 81 110 294 1636 2152 4312 6098 9415 12105 14021 15226 15618 18614 21368 23154 28913 29260 36969 37792 39386 42362 42949 43758 43765 44572 45877 46424 46948 47683 47903 48245 51804 52166 53264 3 50 987 1771 4255 9714 9907 13728 17807 20438 24206 24326 24458 26039 26898 35691 36875 37877 38103 38398 38671 39288 40642 41533 41753 42069 45374 46377 48016 48165 48805 49392 50660 51907 51968 138 441 4163 6450 7419 10743 11330 14962 14984 15032 24819 28987 29221 33223 35464 37535 38213 39085 39223 39925 41220 41341 41643 44944 46330 46870 47142 48577 49387 50732 52578 53839 54085 55426 56132 3773 41938 55428 55720 8833 47844 49437 50265 7054 31403 48642 53739 2286 22401 42270 53546 14435 24811 29047 36135 21010 23783 55073 55612 20516 27533 51132 52391 884 22844 25100 56123 1150 12133 44416 53752 9761 38585 52021 55545 1476 5057 49721 50744 16334 39503 40494 43840 24 31960 33866 53369 22065 22989 32356 52287 111 155 3706 13753 17878 18240 27828 55776 13582 47019 54558 55557.

**45.** A data processing device comprising:

a decoding unit configured to decode an LDPC code with a code length of 64800 bits and an encoding rate of 4/30, based on a parity check matrix of an LDPC (Low Density Parity Check) code, wherein the LDPC code includes an information bit and a parity bit,
the parity check matrix includes an information matrix part corresponding to the information bit and a parity matrix part corresponding to the parity bit,
the information matrix part is shown by a parity check matrix initial value table, and
the parity check matrix initial value table is a table showing positions of elements of 1 of the information matrix part every 360 columns and is expressed as follows

7248 8578 11266 16015 17433 18038 20159 20848 22164 23848 24516 25093 25888 28382 31701 33259 33540 34615 36428 38595 38683 38814 41592 44323 44522 44859 45857 48657 49686 53354 54260 54853 55069 55426 56127 715 1505 3314 5537 6377 6750 11039 11271 15840 16615 24045 24314 24435 26992 28524 28745 28935 32956 33359 34964 36217 37546 38189 42599 44326 49694 54236 54779 55501 55543 55721 55865 55961 55966 55988 70 116 613 2482 6204 6608 7392 13585 14175 14228 17842 20004 20142 21324 22575 24443 24497 25394 26585 30222 37825 38548 41709 44999 50925 52186 53793 54177 54705 55096 55489 55584 56019 56055 56151 9 2054 3493 3584 3989 5916 11915 14323 15091 16998 17631 18645 18882 20510 27499 28990 30054 32231 36556 37437 39651 41543 41963 42798 42937 44864 48056 48971 53104 54511 54610 55151 55216 55470 55736 30 81 110 294 1636 2152 4312 6098 9415 12105 14021 15226 15618 18614 21368 23154 28913 29260 36969 37792 39386 42362 42949 43758 43765 44572 45877 46424 46948 47683 47903 48245 51804 52166 53264 3 50 987 1771 4255 9714 9907 13728 17807 20438 24206 24326 24458 26039 26898 35691 36875 37877 38103 38398 38671 39288 40642 41533 41753 42069 45374 46377 48016 48165 48805 49392 50660 51907 51968 138 441 4163 6450 7419 10743 11330 14962 14984 15032 24819 28987 29221 33223 35464 37535 38213 39085 39223 39925 41220 41341 41643 44944 46330 46870 47142 48577 49387 50732 52578 53839 54085 55426 56132 3773 41938 55428 55720 8833 47844 49437 50265 7054 31403 48642 53739 2286 22401 42270 53546 14435 24811 29047 36135 21010 23783 55073 55612 20516 27533 51132 52391 884 22844 25100 56123 1150 12133 44416 53752 9761 38585 52021 55545 1476 5057 49721 50744 16334 39503 40494 43840 24 31960 33866 53369 22065 22989 32356 52287 111 155 3706 13753 17878 18240 27828 55776 13582 47019 54558 55557.

**46.** A data processing method comprising:

a decoding step of decoding an LDPC code with a code length of 64800 bits and an encoding rate of 4/30, based on a parity check matrix of an LDPC (Low Density Parity Check) code, wherein
the LDPC code includes an information bit and a parity bit,
the parity check matrix includes an information matrix part corresponding to the information bit and a parity matrix part corresponding to the parity bit,
the information matrix part is shown by a parity check matrix initial value table, and
the parity check matrix initial value table is a table showing positions of elements of 1 of the information matrix part every 360 columns and is expressed as follows

7248 8578 11266 16015 17433 18038 20159 20848 22164 23848 24516 25093 25888 28382 31701 33259 33540 34615 36428 38595 38683 38814 41592 44323 44522 44859 45857 48657 49686 53354 54260 54853 55069 55426 56127 715 1505 3314 5537 6377 6750 11039 11271 15840 16615 24045 24314 24435 26992 28524 28745 28935 32956 33359 34964 36217 37546 38189 42599 44326 49694 54236 54779 55501 55543 55721 55865 55961 55966 55988 70 116 613 2482 6204 6608 7392 13585 14175 14228 17842 20004 20142 21324 22575 24443 24497 25394 26585 30222 37825 38548 41709 44999 50925 52186 53793 54177 54705 55096 55489 55584 56019 56055 56151 9 2054 3493 3584 3989 5916 11915 14323 15091 16998 17631 18645 18882 20510 27499 28990 30054 32231 36556 37437 39651 41543 41963 42798 42937 44864 48056 48971 53104 54511 54610 55151 55216 55470 55736 30 81 110 294 1636 2152 4312 6098 9415 12105 14021 15226 15618 18614 21368 23154 28913 29260 36969 37792 39386 42362 42949 43758 43765 44572 45877 46424 46948 47683 47903 48245 51804 52166 53264 3 50 987 1771 4255 9714 9907 13728 17807 20438 24206 24326 24458 26039 26898 35691 36875 37877 38103 38398 38671 39288 40642 41533 41753 42069 45374 46377 48016 48165 48805 49392 50660 51907 51968 138 441 4163 6450 7419 10743 11330 14962 14984 15032 24819 28987 29221 33223 35464 37535 38213 39085 39223 39925 41220 41341 41643 44944 46330 46870 47142 48577 49387 50732 52578 53839 54085 55426 56132 3773 41938 55428 55720 8833 47844 49437 50265 7054 31403 48642 53739 2286 22401 42270 53546 14435 24811 29047 36135 21010 23783 55073 55612 20516 27533 51132 52391 884 22844 25100 56123 1150 12133 44416 53752 9761 38585 52021 55545 1476 5057 49721 50744 16334 39503 40494 43840 24 31960 33866 53369 22065 22989 32356 52287 111 155 3706 13753 17878 18240 27828 55776 13582 47019 54558 55557.

**47.** A data processing device comprising:

an encoding unit configured to encode an information bit into an LDPC code with a code length of 64800 bits and an encoding rate of 5/30, based on a parity check matrix of an LDPC (Low Density Parity Check) code, wherein

the LDPC code includes an information bit and a parity bit,

the parity check matrix includes an information matrix part corresponding to the information bit and a parity matrix part corresponding to the parity bit,

the information matrix part is shown by a parity check matrix initial value table, and

the parity check matrix initial value table is a table showing positions of elements of 1 of the information matrix part every 360 columns and is expressed as follows

2035 5424 6737 8778 10775 15496 17467 21825 23901 27869 28939 29614 34298 34951 35578 37326 39797 44488 45293 45900 49239 53415 53900 2090 4170 12643 12925 13383 17659 23995 24520 25766 26042 26585 29531 31126 34856 43610 49028 49872 50309 50455 51586 52161 52207 53263 819 1629 5521 8339 8501 18663 22208 24768 25082 35272 35560 40387 40618 42891 44288 46834 47264 47458 47561 48563 49141 49583 51837 100 564 4861 9130 15954 22395 23542 26105 27127 31905 33977 35256 37679 40472 40912 42224 43230 44945 45473 52217 52707 52953 53468 73 86 6004 9799 13581 14067 14910 14944 15502 22412 26032 27498 27746 27993 28590 35442 38766 44649 47956 48653 48724 50247 52165 108 1173 5321 6132 7304 15477 18466 19091 20238 23398 26431 34944 36899 40209 42997 48433 48762 49752 49826 50984 51319 53634 53657 4541 7635 11720 12065 16896 28028 28457 30950 35156 38740 39045 43153 43802 44180 45186 45716 45794 46645 48679 49071 49181 53212 53489 6118 8633 11204 11448 15114 19954 24570 26810 28236 39277 43584 46042 47499 48573 48715 49697 50511 51228 51563 51635 53410 53760 53851 1223 4008 8948 9130 16129 17767 22039 23572 24550 28200 29157 32730 33821 38449 39758 48433 49362 52582 53129 53282 53407 53414 53972 176 10948 11719 12340 13870 15842 18928 20987 24540 24852 28366 30017 36547 37426 38667 40361 44725 48275 48825 51211 52901 53737 53868 21792 35759 44481 53371 147 33771 34263 35853 15696 41236 46244 46674 48208 52868 53324 53794 34077 36441 49909 53506 34932 51666 53755 53974 18455 38927 49349 51201 3836 31114 37755 53469 31831 42633 46626 52743 21053 28415 46538 53154 5752 19363 42484 719 48444 52185 25502 53443 53739 11596 53495 53635 43934 52112 53323 42015 52196 52288 72 129 52340 9 17870 43153 24743 41406 53180 23388 48087 52441.

**48.** A data processing method comprising:

an encoding step of encoding an information bit into an LDPC code with a code length of 64800 bits and an encoding rate of 5/30, based on a parity check matrix of an LDPC (Low Density Parity Check) code, wherein the LDPC code includes an information bit and a parity bit,

the parity check matrix includes an information matrix part corresponding to the information bit and a parity matrix part corresponding to the parity bit,

the information matrix part is shown by a parity check matrix initial value table, and

the parity check matrix initial value table is a table showing positions of elements of 1 of the information matrix part every 360 columns and is expressed as follows

2035 5424 6737 8778 10775 15496 17467 21825 23901 27869 28939 29614 34298 34951 35578 37326 39797 44488 45293 45900 49239 53415 53900 2090 4170 12643 12925 13383 17659 23995 24520 25766 26042 26585 29531 31126 34856 43610 49028 49872 50309 50455 51586 52161 52207 53263 819 1629 5521 8339 8501 18663 22208 24768 25082 35272 35560 40387 40618 42891 44288 46834 47264 47458 47561 48563 49141 49583 51837 100 564 4861 9130 15954 22395 23542 26105 27127 31905 33977 35256 37679 40472 40912 42224 43230 44945 45473 52217 52707 52953 53468 73 86 6004 9799 13581 14067 14910 14944 15502 22412 26032 27498 27746 27993 28590 35442 38766 44649 47956 48653 48724 50247 52165 108 1173 5321 6132 7304 15477 18466 19091 20238 23398 26431 34944 36899 40209 42997 48433 48762 49752 49826 50984 51319 53634 53657 4541 7635 11720 12065 16896 28028 28457 30950 35156 38740 39045 43153 43802 44180 45186 45716 45794 46645 48679 49071 49181 53212 53489 6118 8633 11204 11448 15114 19954 24570 26810 28236 39277 43584 46042 47499 48573 48715 49697 50511 51228 51563 51635 53410 53760 53851 1223 4008 8948 9130 16129 17767 22039 23572 24550 28200 29157 32730 33821 38449 39758 48433 49362 52582 53129 53282 53407 53414 53972 176 10948 11719 12340 13870 15842 18928 20987 24540 24852 28366 30017 36547 37426 38667 40361 44725 48275 48825 51211 52901 53737 53868 21792 35759 44481 53371 147 33771 34263 35853 15696 41236 46244 46674 48208 52868 53324 53794 34077 36441 49909 53506 34932 51666 53755 53974 18455 38927 49349 51201 3836 31114 37755 53469 31831 42633 46626 52743 21053 28415 46538 53154 5752 19363 42484 719 48444 52185 25502 53443 53739 11596 53495 53635 43934 52112 53323 42015 52196 52288 72 129 52340 9 17870 43153 24743 41406 53180 23388 48087 52441.

**49.** A data processing device comprising:

a decoding unit configured to decode an LDPC code with a code length of 64800 bits and an encoding rate of 5/30, based on a parity check matrix of an LDPC (Low Density Parity Check) code, wherein

the LDPC code includes an information bit and a parity bit,

the parity check matrix includes an information matrix part corresponding to the information bit and a parity matrix part corresponding to the parity bit,

the information matrix part is shown by a parity check matrix initial value table, and

the parity check matrix initial value table is a table showing positions of elements of 1 of the information matrix part every 360 columns and is expressed as follows

2035 5424 6737 8778 10775 15496 17467 21825 23901 27869 28939 29614 34298 34951 35578 37326 39797 44488 45293 45900 49239 53415 53900 2090 4170 12643 12925 13383 17659 23995 24520 25766 26042 26585 29531 31126 34856 43610 49028 49872 50309 50455 51586 52161 52207 53263 819 1629 5521 8339 8501 18663 22208 24768 25082 35272 35560 40387 40618 42891 44288 46834 47264 47458 47561 48563 49141 49583 51837 100 564 4861 9130 15954 22395 23542 26105 27127 31905 33977 35256 37679 40472 40912 42224 43230 44945 45473 52217 52707 52953 53468 73 86 6004 9799 13581 14067 14910 14944 15502 22412 26032 27498 27746 27993 28590 35442 38766 44649 47956 48653 48724 50247 52165 108 1173 5321 6132 7304 15477 18466 19091 20238 23398 26431 34944 36899 40209 42997 48433 48762 49752 49826 50984 51319 53634 53657 4541 7635 11720 12065 16896 28028 28457 30950 35156 38740 39045 43153 43802 44180 45186 45716 45794 46645 48679 49071 49181 53212 53489 6118 8633 11204 11448 15114 19954 24570 26810 28236 39277 43584 46042 47499 48573 48715 49697 50511 51228 51563 51635 53410 53760 53851 1223 4008 8948 9130 16129 17767 22039 23572 24550 28200 29157 32730 33821 38449 39758 48433 49362 52582 53129 53282 53407 53414 53972 176 10948 11719 12340 13870 15842 18928 20987 24540 24852 28366 30017 36547 37426 38667 40361 44725 48275 48825 51211 52901 53737 53868 21792 35759 44481 53371 147 33771 34263 35853 15696 41236 46244 46674 48208 52868 53324 53794 34077 36441 49909 53506 34932 51666 53755 53974 18455 38927 49349 51201 3836 31114 37755 53469 31831 42633 46626 52743 21053 28415 46538 53154 5752 19363 42484 719 48444 52185 25502 53443 53739 11596 53495 53635 43934 52112 53323 42015 52196 52288 72 129 52340 9 17870 43153 24743 41406 53180 23388 48087 52441.

**50.** A data processing method comprising:

a decoding step of decoding an LDPC code with a code length of 64800 bits and an encoding rate of 5/30, based on a parity check matrix of an LDPC (Low Density Parity Check) code, wherein

the LDPC code includes an information bit and a parity bit,

the parity check matrix includes an information matrix part corresponding to the information bit and a parity matrix part corresponding to the parity bit,

the information matrix part is shown by a parity check matrix initial value table, and

the parity check matrix initial value table is a table showing positions of elements of 1 of the information matrix part every 360 columns and is expressed as follows

2035 5424 6737 8778 10775 15496 17467 21825 23901 27869 28939 29614 34298 34951 35578 37326 39797 44488 45293 45900 49239 53415 53900 2090 4170 12643 12925 13383 17659 23995 24520 25766 26042 26585 29531 31126 34856 43610 49028 49872 50309 50455 51586 52161 52207 53263 819 1629 5521 8339 8501 18663 22208 24768 25082 35272 35560 40387 40618 42891 44288 46834 47264 47458 47561 48563 49141 49583 51837 100 564 4861 9130 15954 22395 23542 26105 27127 31905 33977 35256 37679 40472 40912 42224 43230 44945 45473 52217 52707 52953 53468 73 86 6004 9799 13581 14067 14910 14944 15502 22412 26032 27498 27746 27993 28590 35442 38766 44649 47956 48653 48724 50247 52165 108 1173 5321 6132 7304 15477 18466 19091 20238 23398 26431 34944 36899 40209 42997 48433 48762 49752 49826 50984 51319 53634 53657 4541 7635 11720 12065 16896 28028 28457 30950 35156 38740 39045 43153 43802 44180 45186 45716 45794 46645 48679 49071 49181 53212 53489 6118 8633 11204 11448 15114 19954 24570 26810 28236 39277 43584 46042 47499 48573 48715 49697 50511 51228 51563 51635 53410 53760 53851 1223 4008 8948 9130 16129 17767 22039 23572 24550 28200 29157 32730 33821 38449 39758 48433 49362 52582 53129 53282 53407 53414 53972 176 10948 11719 12340 13870 15842 18928 20987 24540 24852 28366 30017 36547 37426 38667 40361 44725 48275 48825 51211 52901 53737 53868 21792 35759 44481 53371 147 33771 34263 35853 15696 41236 46244 46674 48208 52868 53324 53794 34077 36441 49909 53506 34932 51666 53755 53974 18455 38927 49349 51201 3836 31114 37755 53469 31831 42633 46626 52743 21053 28415 46538 53154 5752 19363 42484 719 48444 52185 25502 53443 53739 11596 53495 53635 43934 52112 53323 42015 52196 52288 72 129 52340 9 17870 43153 24743 41406 53180 23388 48087 52441.

**51.** A data processing device comprising

an encoding unit configured to encode an information bit into an LDPC code with a code length of 64800 bits and an encoding rate of 6/30, based on a parity check matrix of an LDPC (Low Density Parity Check) code, wherein the LDPC code includes an information bit and a parity bit,

the parity check matrix includes an information matrix part corresponding to the information bit and a parity matrix part corresponding to the parity bit,

the information matrix part is shown by a parity check matrix initial value table, and

the parity check matrix initial value table is a table showing positions of elements of 1 of the information matrix part every 360 columns and is expressed as follows

13033 14477 15028 17763 19244 20156 22458 24073 32202 32591 33531 33552 35823 41495 46351 49442 51612 44 66 8422 8760 14694 18768 20943 27806 29012 33594 36262 36820 40434 47704 49355 51729 51758 4233 16270 18958 20915 21313 27009 28249 33438 33855 34475 34541 37093 38835 42139 42169 44757 50122 82 10760 14292 17911 18008 23008 33152 34162 35749 36166 37411 37523 40838 42786 43581 46177 48829 4661 5201 5824 6014 8283 12840 22044 22103 29657 29722 32246 32893 34131 36007 40779 44900 51089 5869 12204 14095 26632 27101 27300 32344 33761 35081 38057 40709 46805 47733 48220 49806 51318 51691 87 5764 16204 20947 23257 31579 38832 40942 43112 43239 44602 49032 49482 49727 49929 50186 50593 880 1883 8876 9204 12370 21536 32858 35875 36247 36319 37151 38601 48914 49533 51239 51399 51824 20 129 2841 5695 8176 15720 26066 26197 34149 35814 36477 37478 45338 48988 50675 51071 51774 7252 14498 19246 20257 20693 22336 26037 29523 29844 34015 35828 38232 40999 41437 43343 44109 49883 4859 8000 9342 16137 21600 24083 36364 37038 38988 44465 45445 46569 48994 50591 51065 51166 51268 7728 9766 11199 11244 13877 14245 23083 27064 28433 28810 34979 39031 42939 44517 45730 48365 51374 67 135 1601 6123 9100 22043 24498 25417 30186 34430 34535 37216 40359 42794 47908 50685 51501 1006 10492 18259 51816 27272 49144 51574 51631 23 5636 38161 39514 9490 41564 46463 51162 33623 41959 50610 11626 22027 50936 28345 39504 45097 46639 50046 50319 74 18582 27985 102 17060 43142 38765 49453 51242 6102 41272 51729 24686 33446 49011 19634 49837 50000 569 22448 25746 33986 50729 51301 9883 14876 29601 9142 29505 50604 22623 40979 51260 23109 33398 51819 163 50643 50984 47021 47381 50970 16215 20964 21588.

**52.** A data processing method comprising

an encoding step of encoding an information bit into an LDPC code with a code length of 64800 bits and an encoding rate of 6/30, based on a parity check matrix of an LDPC (Low Density Parity Check) code, wherein the LDPC code includes an information bit and a parity bit,

the parity check matrix includes an information matrix part corresponding to the information bit and a parity matrix part corresponding to the parity bit,

the information matrix part is shown by a parity check matrix initial value table, and

the parity check matrix initial value table is a table showing positions of elements of 1 of the information matrix part every 360 columns and is expressed as follows

13033 14477 15028 17763 19244 20156 22458 24073 32202 32591 33531 33552 35823 41495 46351 49442 51612 44 66 8422 8760 14694 18768 20943 27806 29012 33594 36262 36820 40434 47704 49355 51729 51758 4233 16270 18958 20915 21313 27009 28249 33438 33855 34475 34541 37093 38835 42139 42169 44757 50122 82 10760 14292 17911 18008 23008 33152 34162 35749 36166 37411 37523 40838 42786 43581 46177 48829 4661 5201 5824 6014 8283 12840 22044 22103 29657 29722 32246 32893 34131 36007 40779 44900 51089 5869 12204 14095 26632 27101 27300 32344 33761 35081 38057 40709 46805 47733 48220 49806 51318 51691 87 5764 16204 20947 23257 31579 38832 40942 43112 43239 44602 49032 49482 49727 49929 50186 50593 880 1883 8876 9204 12370 21536 32858 35875 36247 36319 37151 38601 48914 49533 51239 51399 51824 20 129 2841 5695 8176 15720 26066 26197 34149 35814 36477 37478 45338 48988 50675 51071 51774 7252 14498 19246 20257 20693 22336 26037 29523 29844 34015 35828 38232 40999 41437 43343 44109 49883 4859 8000 9342 16137 21600 24083 36364 37038 38988 44465 45445 46569 48994 50591 51065 51166 51268 7728 9766 11199 11244 13877 14245 23083 27064 28433 28810 34979 39031 42939 44517 45730 48365 51374 67 135 1601 6123 9100 22043 24498 25417 30186 34430 34535 37216 40359 42794 47908 50685 51501 1006 10492 18259 51816 27272 49144 51574 51631 23 5636 38161 39514 9490 41564 46463 51162 33623 41959 50610 11626 22027 50936 28345 39504 45097 46639 50046 50319 74 18582 27985 102 17060 43142 38765 49453 51242 6102 41272 51729 24686 33446 49011 19634 49837 50000 569 22448 25746 33986 50729 51301 9883 14876 29601 9142 29505 50604 22623 40979 51260 23109 33398 51819 163 50643 50984 47021 47381 50970 16215 20964 21588.

**53.** A data processing device comprising

a decoding unit configured to decode an LDPC code with a code length of 64800 bits and an encoding rate of 6/30, based on a parity check matrix of an LDPC (Low Density Parity Check) code, wherein
the LDPC code includes an information bit and a parity bit,
the parity check matrix includes an information matrix part corresponding to the information bit and a parity matrix part corresponding to the parity bit,
the information matrix part is shown by a parity check matrix initial value table, and
the parity check matrix initial value table is a table showing positions of elements of 1 of the information matrix part every 360 columns and is expressed as follows

13033 14477 15028 17763 19244 20156 22458 24073 32202 32591 33531 33552 35823 41495 46351 49442 51612 44 66 8422 8760 14694 18768 20943 27806 29012 33594 36262 36820 40434 47704 49355 51729 51758 4233 16270 18958 20915 21313 27009 28249 33438 33855 34475 34541 37093 38835 42139 42169 44757 50122 82 10760 14292 17911 18008 23008 33152 34162 35749 36166 37411 37523 40838 42786 43581 46177 48829 4661 5201 5824 6014 8283 12840 22044 22103 29657 29722 32246 32893 34131 36007 40779 44900 51089 5869 12204 14095 26632 27101 27300 32344 33761 35081 38057 40709 46805 47733 48220 49806 51318 51691 87 5764 16204 20947 23257 31579 38832 40942 43112 43239 44602 49032 49482 49727 49929 50186 50593 880 1883 8876 9204 12370 21536 32858 35875 36247 36319 37151 38601 48914 49533 51239 51399 51824 20 129 2841 5695 8176 15720 26066 26197 34149 35814 36477 37478 45338 48988 50675 51071 51774 7252 14498 19246 20257 20693 22336 26037 29523 29844 34015 35828 38232 40999 41437 43343 44109 49883 4859 8000 9342 16137 21600 24083 36364 37038 38988 44465 45445 46569 48994 50591 51065 51166 51268 7728 9766 11199 11244 13877 14245 23083 27064 28433 28810 34979 39031 42939 44517 45730 48365 51374 67 135 1601 6123 9100 22043 24498 25417 30186 34430 34535 37216 40359 42794 47908 50685 51501 1006 10492 18259 51816 27272 49144 51574 51631 23 5636 38161 39514 9490 41564 46463 51162 33623 41959 50610 11626 22027 50936 28345 39504 45097 46639 50046 50319 74 18582 27985 102 17060 43142 38765 49453 51242 6102 41272 51729 24686 33446 49011 19634 49837 50000 569 22448 25746 33986 50729 51301 9883 14876 29601 9142 29505 50604 22623 40979 51260 23109 33398 51819 163 50643 50984 47021 47381 50970 16215 20964 21588.

54. A data processing method comprising:

a decoding step of decoding an LDPC code with a code length of 64800 bits and an encoding rate of 6/30, based on a parity check matrix of an LDPC (Low Density Parity Check) code, wherein
the LDPC code includes an information bit and a parity bit,
the parity check matrix includes an information matrix part corresponding to the information bit and a parity matrix part corresponding to the parity bit,
the information matrix part is shown by a parity check matrix initial value table, and
the parity check matrix initial value table is a table showing positions of elements of 1 of the information matrix part every 360 columns and is expressed as follows

13033 14477 15028 17763 19244 20156 22458 24073 32202 32591 33531 33552 35823 41495 46351 49442 51612 44 66 8422 8760 14694 18768 20943 27806 29012 33594 36262 36820 40434 47704 49355 51729 51758 4233 16270 18958 20915 21313 27009 28249 33438 33855 34475 34541 37093 38835 42139 42169 44757 50122 82 10760 14292 17911 18008 23008 33152 34162 35749 36166 37411 37523 40838 42786 43581 46177 48829 4661 5201 5824 6014 8283 12840 22044 22103 29657 29722 32246 32893 34131 36007 40779 44900 51089 5869 12204 14095 26632 27101 27300 32344 33761 35081 38057 40709 46805 47733 48220 49806 51318 51691 87 5764 16204 20947 23257 31579 38832 40942 43112 43239 44602 49032 49482 49727 49929 50186 50593 880 1883 8876 9204 12370 21536 32858 35875 36247 36319 37151 38601 48914 49533 51239 51399 51824 20 129 2841 5695 8176 15720 26066 26197 34149 35814 36477 37478 45338 48988 50675 51071 51774 7252 14498 19246 20257 20693 22336 26037 29523 29844 34015 35828 38232 40999 41437 43343 44109 49883 4859 8000 9342 16137 21600 24083 36364 37038 38988 44465 45445 46569 48994 50591 51065 51166 51268 7728 9766 11199 11244 13877 14245 23083 27064 28433 28810 34979 39031 42939 44517 45730 48365 51374 67 135 1601 6123 9100 22043 24498 25417 30186 34430 34535 37216 40359 42794 47908 50685 51501 1006 10492 18259 51816 27272 49144 51574 51631 23 5636 38161 39514 9490 41564 46463 51162 33623 41959 50610 11626 22027 50936 28345 39504 45097 46639 50046 50319 74 18582 27985 102 17060 43142 38765 49453 51242 6102 41272 51729 24686 33446 49011 19634 49837 50000 569 22448 25746 33986 50729 51301 9883 14876 29601 9142 29505 50604 22623 40979 51260 23109 33398 51819 163 50643 50984 47021 47381 50970 16215 20964 21588.

**FIG. 1**

$$H = \begin{bmatrix} \cdots\cdots 1 \cdots\cdots 1 \cdots 1 \cdots\cdots\cdots 1 \cdots 1 \cdots 1 \end{bmatrix}$$

# FIG. 2

START

RECEIVE RECEPTION VALUE $u_{oi}$
$u_j = 0$, $k = 0$ | S11

CALCULATE MESSAGE $v_i$, CALCULATE MESSAGE $u_j$,
AND SET $k = k + 1$ | S12

$k > C$? | S13

No

Yes

CALCULATE MESSAGE $v_i$ AND OUTPUT MESSAGE | S14

END

**FIG. 3**

$$
H = \begin{bmatrix}
1 & 1 & 1 & 0 & 0 & 0 & 1 & 0 & 1 & 1 & 0 & 0 \\
1 & 1 & 0 & 1 & 1 & 0 & 0 & 0 & 0 & 0 & 1 & 1 \\
0 & 0 & 1 & 1 & 1 & 1 & 1 & 0 & 0 & 1 & 0 & 0 \\
0 & 0 & 0 & 1 & 1 & 1 & 0 & 1 & 1 & 0 & 0 & 1 \\
1 & 1 & 0 & 0 & 0 & 1 & 0 & 1 & 0 & 1 & 1 & 0 \\
0 & 0 & 1 & 0 & 0 & 0 & 1 & 1 & 1 & 0 & 1 & 1
\end{bmatrix}
$$

# FIG. 4

CHECK NODE

VARIABLE NODE

# FIG. 5

VARIABLE NODE

$u_1$

$u_{0i}$

$u_2$

$v_i$

# FIG. 6

CHECK NODE

$v_1$
$v_2$
$v_3$
$v_4$
$v_5$
$u_j$

# FIG.7

TRANSMITTING DEVICE

11

COMMUNICATION PATH

13

RECEIVING DEVICE

12

TRANSMISSION SYSTEM

**FIG. 8**

EP 2 955 852 A1

FIG. 9

EP 2 955 852 A1

**FIG. 10**

PARITY LENGTH M

PARITY MATRIX $H_T$

PARITY LENGTH M

INFORMATION LENGTH K

INFORMATION MATRIX $H_A$

CODE LENGTH N

PARITY CHECK MATRIX

$H =$

# FIG. 11

PARITY MATRIX $H_T$

# FIG.12

# FIG. 13

| NUMBER OF COLUMNS OF EACH COLUMN WEIGHT | | N=64800 | | | | N=16200 | | | |
|---|---|---|---|---|---|---|---|---|---|
| | NOMINAL ENCODING RATES | X | KX | K3 | M | X | KX | K3 | M |
| | 1/4 | 12 | 5400 | 10800 | 48600 | 12 | 1440 | 1800 | 12960 |
| | 1/3 | 12 | 7200 | 14400 | 43200 | 12 | 1800 | 3600 | 10800 |
| | 2/5 | 12 | 8640 | 17280 | 38880 | 12 | 2160 | 4320 | 9720 |
| | 1/2 | 8 | 12960 | 19440 | 32400 | 8 | 1800 | 5400 | 9000 |
| | 3/5 | 12 | 12960 | 25920 | 25920 | 12 | 3240 | 6480 | 6480 |
| | 2/3 | 13 | 4320 | 38880 | 21600 | 13 | 1080 | 9720 | 5400 |
| | 3/4 | 12 | 5400 | 43200 | 16200 | 12 | 360 | 11520 | 4320 |
| | 4/5 | 11 | 6480 | 45360 | 12960 | – | 0 | 12600 | 3600 |
| | 5/6 | 13 | 5400 | 48600 | 10800 | 13 | 360 | 12960 | 2880 |
| | 8/9 | 4 | 7200 | 50400 | 7200 | 4 | 1800 | 12600 | 1800 |
| | 9/10 | 4 | 6480 | 51840 | 6480 | ──── | ──── | ──── | ──── |

# FIG. 14

STRONG BITS = ERROR IS UNLIKELY TO BE GENERATED       WEAK BITS = ERROR IS EASILY GENERATED

# FIG. 15

$y_0$

1                                0

BIT BOUNDARY

$y_1$

0

1

BIT BOUNDARY

EP 2 955 852 A1

# FIG. 16

# FIG. 17

BIT BOUNDARY

BIT BOUNDARY

# FIG. 18

## FIG. 19

# FIG. 20

A

$\gamma = R_2/R_1$

B

| Code rate | Modulation/coding spectral efficiency | $\gamma$ |
|-----------|---------------------------------------|----------|
| 2/3 | 2, 66 | 3, 15 |
| 3/4 | 2, 99 | 2, 85 |
| 4/5 | 3, 19 | 2, 75 |
| 5/6 | 3, 32 | 2, 70 |
| 8/9 | 3, 55 | 2, 60 |
| 9/10 | 3, 59 | 2, 57 |

# FIG. 21

$\gamma_1 = R_2/R_1$
$\gamma_2 = R_3/R_1$

| Code rate | Modulation/coding spectral efficiency | $\gamma_1$ | $\gamma_2$ |
|-----------|----------------------------------------|------------|------------|
| 3/4 | 3, 74 | 2, 84 | 5, 27 |
| 4/5 | 3, 99 | 2, 72 | 4, 87 |
| 5/6 | 4, 15 | 2, 64 | 4, 64 |
| 8/9 | 4, 43 | 2, 54 | 4, 33 |
| 9/10 | 4, 49 | 2, 53 | 4, 30 |

# FIG. 22

A

WRITING

6 BITS

READING

COLUMN DIRECTION

N/6 BITS

COLUMN

STRONG BITS    WEAK BITS

ROW DIRECTION

EXAMPLE OF 64QAM

25

$b_0$ $b_1$ $b_2$ $b_3$ $b_4$ $b_5$

INTERCHANGING UNIT ~32

$y_0$ $y_1$ $y_2$ $y_3$ $y_4$ $y_5$

$b_0$ $b_1$ $b_2$ $b_3$ $b_4$ $b_5$    $b_0$ $b_1$ $b_2$ $b_3$ $b_4$ $b_5$    $b_0$ $b_1$ $b_2$ $b_3$ $b_4$ $b_5$

$y_0$ $y_1$ $y_2$ $y_3$ $y_4$ $y_5$    $y_0$ $y_1$ $y_2$ $y_3$ $y_4$ $y_5$    $y_0$ $y_1$ $y_2$ $y_3$ $y_4$ $y_5$

B  FIRST INTERCHANGE METHOD

$b_0$ $b_1$ $b_2$ $b_3$ $b_4$ $b_5$    $b_0$ $b_1$ $b_2$ $b_3$ $b_4$ $b_5$

$y_0$ $y_1$ $y_2$ $y_3$ $y_4$ $y_5$    $y_0$ $y_1$ $y_2$ $y_3$ $y_4$ $y_5$

C  SECOND INTERCHANGE METHOD

$b_0$ $b_1$ $b_2$ $b_3$ $b_4$ $b_5$    $b_0$ $b_1$ $b_2$ $b_3$ $b_4$ $b_5$    $b_0$ $b_1$ $b_2$ $b_3$ $b_4$ $b_5$

$y_0$ $y_1$ $y_2$ $y_3$ $y_4$ $y_5$    $y_0$ $y_1$ $y_2$ $y_3$ $y_4$ $y_5$    $y_0$ $y_1$ $y_2$ $y_3$ $y_4$ $y_5$

$b_0$ $b_1$ $b_2$ $b_3$ $b_4$ $b_5$    $b_0$ $b_1$ $b_2$ $b_3$ $b_4$ $b_5$    $b_0$ $b_1$ $b_2$ $b_3$ $b_4$ $b_5$

$y_0$ $y_1$ $y_2$ $y_3$ $y_4$ $y_5$    $y_0$ $y_1$ $y_2$ $y_3$ $y_4$ $y_5$    $y_0$ $y_1$ $y_2$ $y_3$ $y_4$ $y_5$

D  THIRD INTERCHANGE METHOD

# FIG. 23

EP 2 955 852 A1

# FIG.24

# FIG. 25

STAIRCASE STRUCTURE OF PARITY MATRIX

A

STAIRCASE STRUCTURE PORTION OF TANNER GRAPH

B

**FIG. 26**

ONE THING IS APART
FROM ADJACENT THING
BY 360 COLUMNS

360 / 360 / 360 / 360 (column groupings)

360 / 360 / 360 / 360 (row groupings)

$M = q \times 360$ ROWS

※IN THIS EXAMPLE, ROW
REPLACEMENT IS ALSO
PERFORMED. HOWEVER,
AS INTERLEAVE, ONLY COLUMN
REPLACEMENT HAS MEANING.

PARITY MATRIX

PARITY BIT IS MADE STRONG FOR BURST ERROR BY THIS ALONE

EP 2 955 852 A1

FIG. 27

16QAM, r = 3/4 (AFTER PARITY INTERLEAVE)

A PARITY CHECK MATRIX

B $\frac{64800}{4} = 16200$ BITS

ALL QAM SYMBOLS INCLUDE FOUR CODE BITS BELONGING TO SAME CHECK NODE.

COLUMN

IF QAM SYMBOL BECOMES ERASURE, 4 BITS COLLECTIVELY BECOME ERASURE.

IN CHANNEL IN WHICH ERASURE IS GENERATED, THERE IS FAULT IN INTERLEAVE.

EP 2 955 852 A1

**FIG. 28**

16QAM ← 4 BITS →

WRITE — LOWERING BY TWO — LOWERING BY FOUR — LOWERING BY SEVEN

$\frac{N}{4}$ BIT

31

COLUMN

IN ALL OF 11 CODES OF 64k, CODE BITS BELONGING TO SAME CHECK NODE ARE NOT INCLUDED IN SAME QAM SYMBOL.

**FIG. 29**

| NUMBER OF NECESSARY MEMORY COLUMNS | b = 1 (FIRST TO THIRD INTERCHANGE METHODS) | b = 2 (FOURTH INTERCHANGE METHOD) | WRITE START POSITION OF EACH OF mb COLUMNS | | | | | | | | | | | | | | | | | | | | | | |
|---|---|---|---|---|---|---|---|---|---|---|---|---|---|---|---|---|---|---|---|---|---|---|---|---|---|---|
| | | | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 |
| 2 | QPSK | | 0 | 2 | | | | | | | | | | | | | | | | | | | | | | | |
| 4 | 16QAM | QPSK | 0 | 2 | 4 | 7 | | | | | | | | | | | | | | | | | | | | | |
| 6 | 64QAM | | 0 | 2 | 5 | 9 | 10 | 13 | | | | | | | | | | | | | | | | | | | |
| 8 | 256QAM | 16QAM | 0 | 0 | 2 | 4 | 4 | 5 | 7 | 7 | | | | | | | | | | | | | | | | | |
| 10 | 1024QAM | | 0 | 3 | 6 | 8 | 11 | 13 | 15 | 17 | 18 | 20 | | | | | | | | | | | | | | | |
| 12 | 4096QAM | 64QAM | 0 | 0 | 2 | 2 | 3 | 4 | 4 | 5 | 5 | 7 | 8 | 9 | | | | | | | | | | | | | |
| 16 | | 256QAM | 0 | 2 | 2 | 2 | 2 | 3 | 7 | 15 | 16 | 20 | 22 | 22 | 27 | 27 | 28 | 32 | | | | | | | | | |
| 20 | | 1024QAM | 0 | 1 | 3 | 4 | 5 | 6 | 6 | 9 | 13 | 14 | 14 | 16 | 21 | 21 | 23 | 25 | 25 | 26 | 28 | 30 | | | | | |
| 24 | | 4096QAM | 0 | 5 | 8 | 8 | 8 | 8 | 10 | 10 | 10 | 12 | 13 | 16 | 17 | 19 | 21 | 22 | 23 | 26 | 37 | 39 | 40 | 41 | 41 | 41 |

## FIG. 30

| NUMBER OF NECESSARY MEMORY COLUMNS | b = 1 (FIRST TO THIRD INTERCHANGE METHODS) | b = 2 FOURTH INTERCHANGE METHOD | WRITE START POSITION OF EACH OF mb COLUMNS | | | | | | | | | | | | | | | | | | | | | | |
|---|---|---|---|---|---|---|---|---|---|---|---|---|---|---|---|---|---|---|---|---|---|---|---|---|---|---|
| | | | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 |
| 2 | QPSK | | 0 | 0 | | | | | | | | | | | | | | | | | | | | | | |
| 4 | 16QAM | QPSK | 0 | 2 | 3 | 3 | | | | | | | | | | | | | | | | | | | | |
| 6 | 64QAM | | 0 | 0 | 2 | 3 | 7 | 7 | | | | | | | | | | | | | | | | | | |
| 8 | 256QAM | 16QAM | 0 | 0 | 0 | 1 | 7 | 20 | 20 | 21 | | | | | | | | | | | | | | | | |
| 10 | 1024QAM | | 0 | 1 | 2 | 2 | 3 | 3 | 4 | 4 | 5 | 7 | | | | | | | | | | | | | | |
| 12 | 4096QAM | 64QAM | 0 | 0 | 0 | 2 | 2 | 2 | 3 | 3 | 3 | 6 | 7 | 7 | | | | | | | | | | | | |
| 20 | | 1024QAM | 0 | 0 | 0 | 2 | 2 | 2 | 2 | 2 | 5 | 5 | 5 | 5 | 5 | 7 | 7 | 7 | 7 | 8 | 8 | 10 | | | | |
| 24 | | 4096QAM | 0 | 0 | 0 | 0 | 0 | 0 | 0 | 1 | 1 | 1 | 2 | 2 | 2 | 3 | 7 | 9 | 9 | 9 | 10 | 10 | 10 | 10 | 10 | 11 |

EP 2 955 852 A1

# FIG. 31

```
        ┌─────────┐
        │  START  │
        └─────────┘
             │
             ▼
┌──────────────────────────────────┐ S101
│     PERFORM LDPC ENCODING         │
└──────────────────────────────────┘
             │
             ▼
┌──────────────────────────────────┐ S102
│   PERFORM BIT INTERLEAVE (PARITY  │
│ INTERLEAVE, COLUM TWIST INTERLEAVE,│
│    AND INTERCHANGE PROCESSING)    │
└──────────────────────────────────┘
             │
             ▼
┌──────────────────────────────────┐ S103
│  PERFORM MAPPING AND MODULATION   │
└──────────────────────────────────┘
             │
             ▼
        ┌─────────┐
        │   END   │
        └─────────┘
```

## FIG. 32

EQUIVALENT REDUCTION MODEL OF FLUTTER

A

$\alpha \cdot e^{j(2\pi \cdot f_d \cdot t)}$

$1/\alpha^2 = D/U$
$f_d$:doppler freq.
$t$:time

OFDM SYMBOL IS TRANSMITTED BY CHANNEL
AND SIMULATION IS PERFORMED BY MODEL EXTRACTED
BY ONE CARRIER AFTER FFT AT RECEPTION SIDE.

B

$$Y = \left[ 1 + \alpha \cdot \exp\left( j2\pi \cdot m \cdot f_d \cdot Ts + j2\pi \cdot \frac{(Nu-1) \cdot f_d \cdot Tu}{Nu} \right) \cdot \frac{\mathrm{sinc}(\pi \cdot f_d \cdot Tu)}{\mathrm{sinc}(\pi \cdot f_d \cdot Tu/Nu)} \right] \cdot X + N$$

$$\underbrace{\qquad\qquad\qquad\qquad\qquad\qquad\qquad\qquad\qquad\qquad\qquad}_{H}$$

$$E\left[N^2\right] = \alpha^2 \cdot \left( 1 - \left| \frac{\mathrm{sinc}(\pi \cdot f_d \cdot Tu)}{\mathrm{sinc}(\pi \cdot f_d \cdot Tu/Nu)} \right|^2 \right)$$

POWER OF |C|: APPROXIMATED BY AWGN

$m$:symbol number
$Ts$:symbol length(sec)
$Tu$:effective symbol length(sec)
$Nu$:number of OFDM carriers

# FIG.33

EP 2 955 852 A1

# FIG.34

EP 2 955 852 A1

# FIG. 35

EP 2 955 852 A1

# FIG. 36

START

S201 SET ENCODING RATE OF PARITY CHECK MATRIX

S202 READ PARITY CHECK MATRIX INITIAL VALUE TABLE
CORRESPONDING TO ENCODING RATE

S203 DETERMINE PARITY CHECK MATRIX H FOR LDPC CODE

S204 READ INFORMATION BIT STRING

S205 PERFORM LDPC ENCODING OF INFORMATION BIT STRING BY
PARITY CHECK MATRIX H AND PERFORM PARITY CALCULATION

S206 DOES ENCODING END?   No

Yes

END

# FIG.37

```
r1/4 16K
6295 9626 304 7695 4839 4936 1660 144 11203 5567 6347 12557
10691 4988 3859 3734 3071 3494 7687 10313 5964 8069 8296 11090
10774 3613 5208 11177 7676 3549 8746 6583 7239 12265 2674 4292
11869 3708 5981 8718 4908 10650 6805 3334 2627 10461 9285 11120
7844 3079 10773
3385 10854 5747
1360 12010 12202
6189 4241 2343
9840 12726 4977
```

# FIG.38

DISPLAY ROW NUMBERS OF PARITY CHECK MATRIX (INFORMATION MATRIX HA) EVERY 360 COLUMNS FROM FIRST COLUMN

ROW NUMBER OF PARITY CHECK MATRIX →

FIRST ROW OF $H_A$ →
F361-ST ROW OF $H_A$ →
721-ST ROW OF $H_A$ →
1081-ST ROW OF $H_A$ →

```
0  2084  1613  1548  1286  1460  3196  4297  2481  3369  3451  4620  2622
1  122   1516  3448  2880  1407  1847  3799  3529  373   971   4358  3108
2  259   3399  929   2650  864   3996  3833  107   5287  164   3125  2350
3  342   3529
4  4198  2147
5  1880  4836
6  3864  4910
7  243   1542
8  3011  1436
9  2167  2512
10 4606  1003
11 2835  705
12 3426  2365
13 3848  2474
14 1360  1743
0  163   2536
1  2583  1180
2  1542  509
3  4418  1005
4  5212  5117
5  2155  2922
6  347   2696
7  226   4296
8  1560  487
9  3926  1640
10 149   2928
11 2364  563
12 635   688
13 231   1684
14 1129  3894
```

$h_{3,5}$

PARITY CHECK MATRIX INITIAL VALUE TABLE

98

FIG.39

# FIG. 40

```
┌─N=64800, rate=2/30 ──────────────────────────────────────────────────────────┐
│   30  251  2458  3467  9897  12052  12191  15073  15949  16328  16972  17704  20672  22200  22276  25349
│ 26106  28258  29737  30518  30951  32440  43031  46622  47113  52077  52609  52750  54295  55384  56954
│ 57155  57853  59942
│   6985  7975  8681  10628  10866  13223  14882  18449  19570  24418  24538  24556  25926  26162  26947
│ 28181  30049  33678  35497  37980  41276  43443  44124  48684  50382  51223  53635  57661  58040  59128
│ 59300  59614  60200  60329
│   1896  5169  7347  10895  14434  14583  15125  15279  17169  18374  20805  25203  29509  30267  30925
│ 33774  34653  34827  35707  36868  38136  38926  42690  43464  44624  46562  50291  50321  51544  56470
│ 56532  58199  58398  60423
│   144  152  1236  8826  11983  12930  13349  19562  20564  30203  31766  35635  40367  40905  41792  41872
│ 42428  43828  44359  47973  48041  49046  50158  50786  55527  55541  57260  57353  57821  58770  59098
│ 59407  60358  60475
│   2085  28320  37838  50085
│   6903  21724  38880  59861
│  17156  20293  21231  44440
│  16799  38095  41049  44269
│  11939  30310  39689  47323
│  10563  17282  45331  60186
│  19860  23595  59085  60417
│  10403  19812  27225  48006
└────────────────────────────────────────────────────────────────────────────┘
```

100

EP 2 955 852 A1

# FIG. 41

```
 N=64800, rate=3/30
   153 2939 6037 11618 12401 17787 18472 22673 25220 26245 29839 35106 36915 37622 37655
45425 55595 56308 56726 58286
   146 160 9060 12867 16536 20818 31754 35546 36480 36698 56314 56509 56837 57342 57373
57895 57947 58163 58202 58262
   58 1555 10183 10446 12204 16197 16830 17382 19144 19565 21476 29121 41158 49953 51531
55642 57423 57587 57627 57974
   120 9906 12466 21668 26856 27304 28451 29413 30168 31274 33309 33499 37486 38265 43457
50299 55218 56971 57059 58115
   80 6649 9541 12490 14153 14346 19926 20677 23672 42397 45629 46288 55935 56115 56555
56865 56993 57921 58049 58190
   46 152 3536 7134 9040 10474 10504 11549 17066 19102 27486 29364 39577 39995 48289 56236
57279 57560 57608 57930
   19824 21165 34427 58143
   22747 50215 50864 58176
   2943 31340 39711 57281
   1186 20802 27612 33409
   1347 20868 29222 48776
   19 8548 46255 56946
   10762 20467 48519
   39 7401 34355
   142 10827 17009
   1822 29424 39439
   5944 11349 28870
   4981 14731 15377
```

# FIG. 42

```
N=64800, rate=4/30
    7248 8578 11266 16015 17433 18038 20159 20848 22164 23848 24516 25093 25888 28382 31701
33259 33540 34615 36428 38595 38683 38814 41592 44323 44522 44859 45857 48657 49686 53354
54260 54853 55069 55426 56127
    715 1505 3314 5537 6377 6750 11039 11271 15840 16615 24045 24314 24435 26992 28524 28745
28935 32956 33359 34964 36217 37546 38189 42599 44326 49694 54236 54779 55501 55543 55721
55865 55961 55966 55988
    70 116 613 2482 6204 6608 7392 13585 14175 14228 17842 20004 20142 21324 22575 24443
24497 25394 26585 30222 37825 38548 41709 44999 50925 52186 53793 54177 54705 55096 55489
55584 56019 56055 56151
    9 2054 3493 3584 3989 5916 11915 14323 15091 16998 17631 18645 18882 20510 27499 28990
30054 32231 36556 37437 39651 41543 41963 42798 42937 44864 48056 48971 53104 54511 54610
55151 55216 55470 55736
    30 81 110 294 1636 2152 4312 6098 9415 12105 14021 15226 15618 18614 21368 23154 28913
29260 36969 37792 39386 42362 42949 43758 43765 44572 45877 46424 46948 47683 47903 48245
51804 52166 53264
    3 50 987 1771 4255 9714 9907 13728 17807 20438 24206 24326 24458 26039 26898 35691 36875
37877 38103 38398 38671 39288 40642 41533 41753 42069 45374 46377 48016 48165 48805 49392
50660 51907 51968
    138 441 4163 6450 7419 10743 11330 14962 14984 15032 24819 28987 29221 33223 35464 37535
38213 39085 39223 39925 41220 41341 41643 44944 46330 46870 47142 48577 49387 50732 52578
53839 54085 55426 56132
    3773 41938 55428 55720
    8833 47844 49437 50265
    7054 31403 48642 53739
    2286 22401 42270 53546
    14435 24811 29047 36135
    21010 23783 55073 55612
    20516 27533 51132 52391
    884 22844 25100 56123
    1150 12133 44416 53752
    9761 38585 52021 55545
    1476 5057 49721 50744
    16334 39503 40494 43840
    24 31960 33866 53369
    22065 22989 32356 52287
    111 155 3706 13753
    17878 18240 27828 55776
    13582 47019 54558 55557
```

# FIG.43

```
┌─ N=64800, rate=5/30 ──────────────────────────────────────────────────────────────
│     2035 5424 6737 8778 10775 15496 17467 21825 23901 27869 28939 29614 34298 34951 35578
│  37326 39797 44488 45293 45900 49239 53415 53900
│     2090 4170 12643 12925 13383 17659 23995 24520 25766 26042 26585 29531 31126 34856 43610
│  49028 49872 50309 50455 51586 52161 52207 53263
│     819 1629 5521 8339 8501 18663 22208 24768 25082 35272 35560 40387 40618 42891 44288
│  46834 47264 47458 47561 48563 49141 49583 51837
│     100 564 4861 9130 15954 22395 23542 26105 27127 31905 33977 35256 37679 40472 40912
│  42224 43230 44945 45473 52217 52707 52953 53468
│     73 86 6004 9799 13581 14067 14910 14944 15502 22412 26032 27498 27746 27993 28590 35442
│  38766 44649 47956 48653 48724 50247 52165
│     108 1173 5321 6132 7304 15477 18466 19091 20238 23398 26431 34944 36899 40209 42997 48433
│  48762 49752 49826 50984 51319 53634 53657
│     4541 7635 11720 12065 16896 28028 28457 30950 35156 38740 39045 43153 43802 44180 45186
│  45716 45794 46645 48679 49071 49181 53212 53489
│     6118 8633 11204 11448 15114 19954 24570 26810 28236 39277 43584 46042 47499 48573 48715
│  49697 50511 51228 51563 51635 53410 53760 53851
│     1223 4008 8948 9130 16129 17767 22039 23572 24550 28200 29157 32730 33821 38449 39758
│  48433 49362 52582 53129 53282 53407 53414 53972
│     176 10948 11719 12340 13870 15842 18928 20987 24540 24852 28366 30017 36547 37426 38667
│  40361 44725 48275 48825 51211 52901 53737 53868
│     21792 35759 44481 53371
│     147 33771 34263 35853
│     15696 41236 46244 46674
│     48208 52868 53324 53794
│     34077 36441 49909 53506
│     34932 51666 53755 53974
│     18455 38927 49349 51201
│     3836 31114 37755 53469
│     31831 42633 46626 52743
│     21053 28415 46538 53154
│     5752 19363 42484
│     719 48444 52185
│     25502 53443 53739
│     11596 53495 53635
│     43934 52112 53323
│     42015 52196 52288
│     72 129 52340
│     9 17870 43153
│     24743 41406 53180
│     23388 48087 52441
└─────────────────────────────────────────────────────────────────────────────────────
```

# FIG. 44

```
─ N=64800, rate=6/30 ─
   13033 14477 15028 17763 19244 20156 22458 24073 32202 32591 33531 33552 35823 41495
46351 49442 51612
   44 66 8422 8760 14694 18768 20943 27806 29012 33594 36262 36820 40434 47704 49355 51729
51758
   4233 16270 18958 20915 21313 27009 28249 33438 33855 34475 34541 37093 38835 42139 42169
44757 50122
   82 10760 14292 17911 18008 23008 33152 34162 35749 36166 37411 37523 40838 42786 43581
46177 48829
   4661 5201 5824 6014 8283 12840 22044 22103 29657 29722 32246 32893 34131 36007 40779
44900 51089
   5869 12204 14095 26632 27101 27300 32344 33761 35081 38057 40709 46805 47733 48220 49806
51318 51691
   87 5764 16204 20947 23257 31579 38832 40942 43112 43239 44602 49032 49482 49727 49929
50186 50593
   880 1883 8876 9204 12370 21536 32858 35875 36247 36319 37151 38601 48914 49533 51239
51399 51824
   20 129 2841 5695 8176 15720 26066 26197 34149 35814 36477 37478 45338 48988 50675 51071
51774
   7252 14498 19246 20257 20693 22336 26037 29523 29844 34015 35828 38232 40999 41437 43343
44109 49883
   4859 8000 9342 16137 21600 24083 36364 37038 38988 44465 45445 46569 48994 50591 51065
51166 51268
   7728 9766 11199 11244 13877 14245 23083 27064 28433 28810 34979 39031 42939 44517 45730
48365 51374
   67 135 1601 6123 9100 22043 24498 25417 30186 34430 34535 37216 40359 42794 47908 50685
51501
   1006 10492 18259 51816
   27272 49144 51574 51631
   23 5636 38161 39514
   9490 41564 46463 51162
   33623 41959 50610
   11626 22027 50936
   28345 39504 45097
   46639 50046 50319
   74 18582 27985
   102 17060 43142
   38765 49453 51242
   6102 41272 51729
   24686 33446 49011
   19634 49837 50000
   569 22448 25746
   33986 50729 51301
   9883 14876 29601
   9142 29505 50604
   22623 40979 51260
   23109 33398 51819
   163 50643 50984
   47021 47381 50970
   16215 20964 21588
```

# FIG. 45

```
N=64800, rate=7/30
  548 9528 12205 12770 22023 22082 25884 27421 33215 36046 43580 43953 47539
  919 2623 5098 5514 5645 6348 9666 13795 14555 43224 44048 44948 47964
  995 7270 17753 21272 29228 29916 31634 34055 35205 37499 37777 47490 49301
  645 3803 8836 9470 11054 20253 29417 31243 31990 36468 38715 39932 43045
  14572 18646 21100 26617 32033 32410 37195 38586 43833 44577 45584 46453 49515
  6004 16982 17829 24616 28056 29646 32944 39051 42517 47086 48585 48772 49247
  1306 1447 4898 7781 18587 25724 26672 35062 35202 37080 39781 46111 47595
  92 3231 13043 22258 24198 28923 33303 37846 43610 44857 47322 48914 49291
  298 12557 13469 14451 21917 23539 26310 29839 37050 38507 41377 46971 48155
  12582 13044 21039 30600 34202 34947 37120 39108 39203 43449 46941 48542 49354
  871 12218 12680 14152 17171 25797 29021 37783 43728 47519 48794 48898 48980
  35 4623 13422 15881 16692 17463 23675 28063 31248 41997 44246 47992 48339
  7150 13015 17950 18214 20659 23579 25714 28328 32658 39717 39995 43322 45884
  82 11054 11845 19085 24174 26694 41530 45954 46508 46892 48832 49097 49420
  5789 13839 18512 25596 26478 26736 29431 32349 33384 41765 46661 49206 49543
  13805 17786 17798 29653 30310 34870 40176 40391 43227 45292 46423 46855 49454
  12433 27119 34645
  32065 34998 44021
  5158 16546 34359
  44 33285 39929
  39032 39296 40317
  9885 45251 47640
  14383 43446 44478
  31280 39945 48472
  27961 38221 48391
  2927 37404 38716
  19461 42462 46162
  24909 25915 40636
  11029 35538 45381
  26880 34179 48775
  192 6032 26853
  4563 14952 24256
  10003 30853 43811
  749 36334 41363
  100 17006 24982
  9507 20228 31214
  41691 44310 47083
  24070 30411 46982
  2727 28251 49289
  16689 21167 32590
  40813 41198 46175
  8336 32714 43075
```

## FIG. 46

N=64800, rate=8/30

100 3433 4111 9089 13360 24012 26305 30252 31430 31769 34689 34917 36091 40873 41983 42689 43835 44318 47109

3 48 124 2240 7029 21694 24565 29302 39777 42706 43631 43784 46033 47064 47079 47141 47239 47439 47479

2 5675 7056 12715 24128 26596 30571 38210 38586 41138 42272 43336 43444 43917 45812 46840 47245 47286 47510

2103 4285 10068 10702 12693 17619 18711 21309 22191 22999 37432 45646 46275 46338 46777 46860 46963 47432 47472

6827 8209 8606 10412 15670 19469 22205 22215 25425 29565 34843 34985 37686 39277 44625 45016 45623 47069 47250

58 114 1751 7913 24642 26995 40734 41486 43133 44804 45490 45725 46122 46412 47019 47080 47103 47495 47506

96 5952 9078 9786 17738 17888 17986 31657 34430 34763 35450 37276 42395 43223 43283 44261 45648 47014 47276

106 5405 9614 20500 21633 23242 28875 37238 38854 41778 42292 43883 45909 46558 46826 47292 47353 47436 47504

32 11217 12153 26818 27616 38783 39976 40842 43581 43703 44287 44435 44576 44774 46080 46098 46801 46813 47168

65 102 111 3879 11224 11772 23623 27306 28726 34663 34873 36288 39196 42003 45279 45629 46836 47021 47419

77 131 11275 18964 20418 22364 22635 27727 28689 29720 29781 32110 41597 42046 43952 44786 46416 46808 47200

87 8637 10829 23737 24117 26486 29603 34389 35509 35872 38948 40643 42698 45949 46159 46660 47041 47165 47220

2 58 3110 7539 8886 10422 11597 13385 27870 35895 38120 43546 44948 46272 46369 46596 47199 47317 47351

78 16119 27780 32231 38973 39088 40118 40231 43170 44131 44203 44878 45905 46250 47011 47113 47195 47303 47427

2960 6685 8830 11107 11843 12811 30030 36574 36850 36920 37706 38025 41007 43554 44109 44643 45874 46469 46565

125 366 10175 29860

45 17503 44634 45789

6272 19614 34408 37248

14785 41017 44274 46858

19935 22960 44726 44919

15247 17925 33947 37392

34631 39148 43287 45443

8544 26457 30996 38672

11725 31442 42167 45461

22357 41743 46702 47285

13786 26288 41358 43082

7306 21352 43298 47359

77 5188 20988 45572

10334 23790 40878

9304 29379 47450

22048 44762 47300

8529 8825 47443

40831 41328 46415

26715 43038 46498

26925 30797 43181

32434 45624 47460

**FIG. 47**

```
17989 31811 47215
5624 25501 33016
5024 9037 33642
93 7329 46908
20303 42578 46780
16137 26869 42360
112 3049 46527
23615 29931 47360
23050 24267 44687
60 40754 47114
30217 36283 37445
127 27308 38345
```

# FIG. 48

```
N=64800, rate=9/30
  339 4777 5366 7623 13034 13260 15107 17772 20338 21178 25914 27663 29948 37489 41021
  3871 5812 9795 23437 24079 27699 33471 39878 40302 41038 41217 42316 42765 43675 45118
  3699 4072 16553 21492 26210 29839 30322 34139 38227 39696 40762 41156 41269 45168 45350
  995 12194 12494 16542 20423 21950 23519 26215 26708 30587 38352 38840 39729 41645 43210
  3963 4315 6832 11354 21042 21084 21108 25595 33109 34029 34448 35129 38018 39012 44791
  164 887 2902 9021 9193 16705 17850 19241 25893 33427 37416 41024 41355 44381 45303
  1367 1495 5495 14440 18026 18130 18178 21946 24057 25663 29216 31965 38107 43907 44278
  10763 13722 13975 18294 20813 23028 23353 24211 37366 38805 40985 41792 42495 43259
43528
  1580 12448 21464 31246 33058 34794 35760 36021 36426 37138 37478 38199 42138 42335 45207
  83 112 12225 15224 18205 21345 28488 34362 37195 39660 42371 42814 44509 45201 45244
  6836 7635 11644 16591 17121 19307 21456 23544 30596 37887 38141 38581 43607 44246 45097
  9174 14934 17131 29762 30243 31656 33251 35498 37106 37655 41462 44002 44649 45032 45230
  33 5376 13536 17068 18581 23478 32021 32074 33716 38434 39452 42166 44305 44979 45306
  6013 7553 10023 19354 23126 25427 27665 30239 32699 34123 36171 38898 38972 41974 45213
  41 98 3088 8522 26252 29602 30009 30138 30948 32190 32428 32498 34273 34955 45311
  2000 15664 20677 20792 22980 25111 31491 37611 37981 39872 41668 42336 43602 43828 45329
  23 67 97 5339 8121 8583 20647 25425 32305 37158 40968 41578 43492 44929 45273
  1643 3496 5121 6546 15643 16423 20602 39950 43178 43252 43683 43992 44001 44611 45125
  11093 19172 20548 24518 28289 29246 30148 34884 40403 40745 42723 43064 44448 44723
44812
  12748 12799 28567 41605
  1965 4087 31879
  27178 33638 38344
  9580 13096 45337
  2672 22800 43869
  28287 31407 31975
  2823 5108 9945
  5891 30848 42082
  23 41944 44909
  909 2311 45162
  24998 37829 44704
  35339 40087 45019
  16928 26505 35256
  26462 27297 37766
  19656 35067 38586
  6958 17172 41412
  72 26012 37231
  15259 16044 30243
  2879 12148 34601
  36173 39731 42668
  20670 35816 43266
  22570 27213 30404
  40284 44171 45313
  17765 22514 39347
  24711 39892 45132
  13741 34633 44535
  15209 31692 45280
  11189 43771 45303
  28294 31110 32287
  29085 39876 45246
```

FIG. 49

```
24285  36009  45347
6882   28921  34504
9256   19267  44194
2132   21404  28687
23809  34383  44540
```

EP 2 955 852 A1

# FIG. 50

```
N=64800, rate=10/30
   867 2733 2978 8947 10214 11810 13566 15922 18838 20543 25845 29179 30055 31284 33447
34330 35081 35605 36268 39563 42331 43174
   2765 6017 6394 6769 12351 13567 15195 19900 23094 27077 28626 28914 32219 33106 33662
33905 34878 37861 39749 39862 40976 42690
   2343 4231 7603 7789 8396 8783 15636 16221 20591 21538 24008 25117 25663 26817 29692 30937
31472 32070 33793 39506 41763 43172
   8536 10705 10960 11206 12513 15399 17108 17224 17512 20180 25288 27824 28958 30600 36792
36828 38891 39575 39581 42342 42914 42961
   9 107 681 1195 9957 14055 21420 23279 26129 32044 35750 37065 37092 37165 37179 40127
40835 41476 41564 41571 42576 42910
   86 1760 6842 8119 8904 12644 17603 18189 20018 22259 22654 25620 27606 27833 28002 31053
31814 31848 35573 36133 40698 41370
   28 115 4354 9276 11229 11252 13848 21112 22851 29912 32453 34693 37344 37420 40926 40992
41063 41762 41856 42012 42642 43045
   1589 7190 7221 7668 11805 14071 14367 14629 17087 19579 19861 25505 35471 35514 37495
38375 40286 40330 40402 41662 42638 43126
   76 99 3237 5137 7982 9598 13470 14045 26680 27058 32025 32235 34601 35658 36841 38408
40517 40987 41400 41861 42691 42772
   54 2470 2728 3177 3484 8267 9351 17523 18513 21119 22947 23771 26569 27308 31217 35887
36449 38529 40424 41873 42146 42706
   39 80 385 1386 3397 5234 14733 16955 17656 23262 23463 25340 31638 31676 32683 37130
37641 39064 41839 42193 42495 43063
   62 573 11847 14616 16033 16064 16302 18776 19434 23845 23873 25937 27741 32244 32612
33554 38445 38480 38610 40933 42386 42520
   33 183 968 5477 6173 7363 10358 12597 14468 18025 23369 23387 24723 25254 28299 28989
31675 32776 35077 40241 41572 42035
   36 2529 2543 3891 7108 9002 9481 16496 19796 26687 27343 33300 35495 37070 39247 40126
41758 41892 42124 42622 42738 43100
   91 6897 8794 9581 12922 15711 18539 19227 21592 22906 26449 29804 30895 31538 31930 33392
38006 38294 38705 38952 39005 42120
   64 76 709 1155 3162 7099 8740 9670 12678 21126 29239 29844 31248 32001 35243 36814 38008
42050 42149 42631 42705 43119
   17670 40897 42359
   17471 20895 32101
   5458 5508 30504
   17291 19627 27186
   14600 41106 43103
   18059 28398 40623
   23776 30190 32880
   4676 13593 21791
   19 2832 27959
   6193 21762 42854
   64 16088 42982
   29425 35004 42209
   14338 31982 41789
   21572 42838 42923
   5 87 6639
   5529 42541 43173
   15512 31740 35801
   44 86 43183
   26027 26995 36455
```

# FIG. 51

```
16485 30090 34537
22276 40174 42367
10781 18230 18766
9984 42877 43027
11108 20618 41626
8496 42994 43171
10581 25803 42606
4989 14002 29020
35032 39378 41455
109 11667 42914
12471 14022 35477
31761 34625 36228
1228 6013 43110
22355 37905 40784
12740 21805 31648
4202 28639 32213
10697 31674 42998
4092 23877 34360
54 9459 16450
1 56 33675
18163 31951 42528
50 5655 35891
47 35033 40356
29097 32786 35931
9532 27004 43009
```

## FIG.52

N=64800, rate=11/30

```
   3208 6587 9493 9539 12368 12501 14811 15784 17625 18654 18721 19471 19503 20079 20411
20876 21493 22083 22430 27275 29322 32758 33227 33347 33715 34472 34711 38450 39151 39709
39862 40093 40497 40912
   42 1118 3086 5466 6379 8483 9051 9330 13250 13898 14055 15033 18094 21429 22652 25251
28709 29909 30233 30472 30635 31367 32603 33614 33708 36404 36530 37039 37782 38115 38307
40225 40597 40822
   5939 11990 15027 15162 16503 17171 17806 17902 18031 18077 21216 22134 22660 24170 28558
29364 30003 31128 32674 33103 33361 34196 34435 34626 34991 35974 36022 37459 38170 38709
39774 39960 40571 40858
   63 3871 9148 10328 12830 12912 18361 18839 20122 23126 23795 28612 30350 32251 32750
33762 33866 36188 36979 37562 37836 38536 38705 38829 39609 40219 40324 40336 40367 40638
40699 40809 40987 41019
   36 70 104 3737 5028 19023 19575 19746 23840 24611 24661 26741 27749 30359 31027 31509
32621 32859 33830 34619 35281 35479 36796 37344 37555 38993 39088 39445 40276 40299 40762
40771 40835 40967
   113 2313 4411 5858 9909 10426 18955 21663 21884 24105 24472 26944 27826 28574 28689 29579
30903 32352 33334 36408 36795 36805 37112 37121 38731 39080 39739 40007 40326 40356 40472
40476 40622 40778
   54 84 3529 5202 9825 9900 10846 12104 13332 14493 14584 23772 24084 25786 25963 26145
28306 29514 30050 30060 33171 33416 33657 33951 34908 37715 37854 38088 38966 39148 40166
40633 40746 40939
   105 8722 10244 12148 13029 16368 18186 19660 19830 21616 22256 22534 23100 23219 25473
26585 29858 32350 33305 34290 34356 34675 35297 37052 37144 37934 38201 39867 40270 40539
40781 40804 40944 40966
   53 61 82 96 2665 6552 9517 15693 17214 17588 18347 19039 20679 21962 24255 25861 27117
27919 30691 36195 36379 37031 37309 37535 37793 38198 38212 38595 38808 38911 39474 39677
40135 40935
   15 67 723 2962 4991 5285 11583 13398 16301 16338 20996 21510 25697 28214 29143 30539
30573 31108 32500 32506 32727 32755 36134 37226 37655 37799 39219 39626 39980 40093 40105
40628 40634 40816
   18854 37884 40104 40772
   35209 40379 40447 40508
   3049 36078 39403 40402
   19118 27981 35730 36649
   20465 28570 39076 40910
   24047 31275 39790 40126
   31041 33526 34162 39092
   1152 8976 24071 35698
   3 27991 31485 40934
   5245 20676 30579 38823
   47 11196 38674 38894
   14920 15270 16047 40928
   23974 30146 39805 40911
   8791 16641 25060 31681
   1147 4233 34386 37802
   58 5354 22265 41018
   869 3078 39882 40730
   1071 6322 9163 10642
   7235 32596 35540 37487
   26910 35537 40830 41035
   81 11905 16179 19558
```

# FIG. 53

```
29 41 5161 12173
3043 5574 9993 26058
875 36935 39423 40956
3362 19166 20017 39729
12893 16403 33880 37115
9980 27100 28525 36786
3218 12776 40651 40703
7669 25783 32781 34504
25951 34595 39049 40597
11271 35112 35290 40600
5330 38324 40325 40986
58 24777 40560 40835
23895 25427 33552 37472
2811 4731 11601 39912
109 39021 40611 40754
79 15387 30999 40978
31162 34975 38844 39784
34891 37007 39433 40102
42 9072 21526 22610
20243 20499 24418 29056
7951 26469 29729 40956
6 10833 13188 15714
7910 20652 40574 40874
14586 24839 37804 40722
1103 11381 21050 30084
10 9032 20123 28528
19477 29966 37702 37766
131 31352 39069 40971
34 7368 17799 27467
16767 27584 32869 34769
31515 34543 36230 40752
15098 25451 26402 27629
149 10388 24558 40709
6997 7288 23995 29893
346 12245 13843 40402
```

# FIG. 54

```
N=64800, rate=12/30
   2455 2650 6184 7016 7280 7409 7507 8261 8591 8829 11277 13729 14302 15883 17754 18506
19816 19940 22442 23981 26881 26981 28760 29688 31138 31497 32673 35889 37690 38665
   50 327 3574 4465 5954 9702 10606 11684 11715 12627 14132 14951 20099 24111 24283 27026
27473 28162 30076 31032 31476 35031 36675 36914 37008 37425 37530 37689 38830 38856
   59 102 5278 5548 5850 11840 13813 16641 19597 20543 24088 24298 25171 25224 26925 28312
28867 31551 31898 32849 33616 34486 34562 35252 35931 36107 37950 38494 38537 38547
   79 2084 2361 2922 3048 3525 5712 9376 10012 10463 11842 15200 18443 19223 20476 21361
22584 24343 24594 28001 28304 28475 28969 31149 31528 32574 33007 35120 38245 38253
   821 2803 8187 8501 10063 10497 14472 14570 15613 18469 19620 23034 24029 24578 26538
31025 32621 34134 34508 34988 35201 35907 36693 36793 37608 37998 38090 38506 38611 38682
   9 50 88 1222 2430 2824 7233 9972 10225 15762 18283 18961 20711 28455 29946 32016 35611
35763 37263 37325 38287 38360 38416 38471 38518 38551 38643 38759 38763 38818
   33 38 151 2523 3787 5069 6710 7667 8501 11083 17631 19589 24263 24684 24940 28493 30646
31916 33741 35060 35810 36284 36394 36400 38209 38312 38340 38782 38825 38858
   8 49 84 381 4009 6978 9983 14028 14051 16325 17393 24325 25130 25838 30998 35159 36135
37516 37636 37837 37927 38433 38620 38647 38650 38699 38733 38784 38804 38862
   44 76 4362 4480 8679 8833 13730 16493 16507 22419 24544 25614 25671 33032 33120 35219
35986 36415 36505 38169 38173 38327 38371 38468 38508 38546 38551 38747 38761 38853
   16 683 1013 8364 8665 12213 12279 12643 13134 15450 16703 17846 20656 21664 22896 23487
25022 32049 32482 33647 35029 35197 36636 37162 38376 38408 38430 38520 38721 38734
   3 760 1052 6377 8526 9014 11769 12589 16661 18156 20521 21303 23361 27434 32315 34602
34892 35078 35262 35639 36655 37893 38063 38578 38602 38719 38737 38748 38837 38861
   15 30 79 99 16844 19586 24117 24702 25088 26129 27790 28383 30976 33472 34613 35266 35337
36278 36841 36980 37214 37651 37817 38085 38218 38338 38396 38432 38760 38812
   12483 24049 35782 38706
   12146 19270 23193 38389
   26418 34831 37883 38501
   25045 36512 37567 38487
   15238 33547 38210 38696
   14 6773 17384 38679
   14367 16694 16867 38453
   15371 37498 37910 38610
   2509 18705 27907 28422
   21246 37360 38125 38868
   11357 23312 24884 36318
   14467 19559 22338 37893
   26899 35264 36300 37973
   17311 28273 32934 38607
   0 14452 16264 38585
   6736 19801 31034 38279
   35256 36593 38204 38655
   10037 29019 32956 38670
   98 17138 28233 37750
   576 4888 14014 23030
   2003 2470 18968 38841
   1042 4623 8098 9963
   61 3037 9719 27052
   15129 26628 31307 37604
   9791 11904 12369 34528
   7996 15467 21456 38165
   7644 12741 34083 38851
```

# FIG. 55

```
4766 26027 31133 38830
17783 36021 37697 38571
4925 9033 28100 32671
9452 23191 32529 36265
6124 19224 27145 30628
24 26468 35718 38718
14403 14741 20334 38444
322 15324 22539 33347
22663 29889 38488
7 13998 38748
8835 20728 20777
9742 24551 26087
23173 24287 38644
16606 30002 32432
30691 37266 38776
20366 21134 35082
21617 28615 29424
15974 26095 34262
92 35091 36358
9348 28177 38737
16104 37933 38151
14133 30118 38803
1314 37661 38852
19118 28886 37980
20212 22241 32326
3885 17856 38675
12577 21905 30465
28672 35317 35384
12880 16994 34495
16353 34789 38134
465 37194 38658
23 6202 38823
24020 25383 37955
```

## FIG.56

```
N=64800, rate=13/30
   1153 2676 2759 5782 7192 10887 11573 11888 12383 18472 20695 21466 21753 23630 24580
25006 25182 25636 25887 29615 29677 31968 32188 32277 33135
   935 5609 7730 9427 9519 10465 11182 12164 15765 17266 18156 20309 20542 21193 21697 22913
22989 23780 27048 30762 31731 35754 36161 36379 36710
   644 2718 6995 7088 7898 11242 13921 14068 14328 15840 19581 19919 21938 22749 23311 23767
25945 26731 27405 27830 31023 32589 33239 33957 34456
   17 131 2331 6624 10568 12965 16184 17665 19575 20690 22609 23378 24385 28281 30808 33083
34435 34509 36016 36355 36525 36580 36586 36636 36644
   5 42 59 80 100 3327 4882 5238 6588 15417 17416 17476 18307 19336 20336 22770 33204 33302
34207 35133 35594 35650 36090 36619 36659
   46 141 308 995 2267 2645 5224 5839 7945 8336 10865 14607 21285 22062 23225 23772 24190
25324 26738 29253 29674 33264 35593 36564 36608
   55 2316 8545 13623 14353 14516 15773 18442 20172 21970 22319 26595 27849 29185 30141
31195 33614 34586 35699 35994 36309 36445 36516 36662 36665
   17 59 82 955 5050 7239 17495 19753 23481 25131 30124 32434 33042 34583 35231 35786 36232
36336 36518 36530 36541 36584 36592 36629 36648
   1 16 78 717 5622 7351 7729 9200 10674 12647 22946 24316 25268 28139 31794 32278 33243
34217 34485 34505 34929 35450 35865 36340 36565
   15 36 73 2381 4118 6829 9453 11705 12402 14884 17442 19226 21328 25523 26538 29300 34635
35066 35547 35617 36285 36343 36599 36607 36708
   27 58 3657 8026 9245 11874 14579 15588 16280 16426 22692 25061 27788 29797 31776 34992
35324 35529 36295 36298 36469 36608 36626 36661 36679
   13 36 78 3785 5888 10015 13647 14824 18283 20262 26268 26890 27517 33128 33659 34191
35729 35965 36196 36381 36385 36501 36593 36659 36667
   0 6 63 1713 8050 11113 18981 20118 22082 23210 24401 27239 31104 32963 33846 34334 35232
35626 36159 36424 36441 36457 36523 36609 36640
   39 60 64 92 438 4764 6022 9256 14471 20458 23327 26872 30944 34061 34882 35249 35586 35642
35680 36092 36126 36548 36626 36633 36649
   40 67 6336 8195 9735 19400 20396 21095 22015 28597 31367 33511 33932 34732 34847 35247
35543 36020 36258 36619 36651 36688 36693 36709 36717
   13990 15734 24992 35907
   448 14650 29725 36141
   27195 27825 34118 35317
   2514 7964 31027 31885
   12966 22180 24997 33406
   13568 17438 18377 36038
   76 15846 25385 35720
   1 758 23751 36083
   2238 8449 29406 31840
   80 14882 15923 33878
   86 18320 24636 36111
   5392 24119 31102 34507
   6485 8182 14790 21264
   13702 29065 35939 36554
   9160 11429 36663 36691
   9153 12051 20063 25493
   37 3918 13758 18923
   18643 24675 31646 33893
   3941 9238 30160 36584
   26037 31006 35886
   115 8925 13728
```

# FIG.57

```
8079  12229  21571
18315  34532  35200
14760  36073  36540
27155  28360  36381
24111  32816  36411
17214  32333  35208
10181  13269  24419
55  13696  29382
35958  36528  36673
21481  27758  31170
2161  27055  36569
14381  22920  36680
9113  19651  32334
2500  20917  29374
1966  30518  30855
14419  25676  36077
31502  33331  34982
23192  27819  36698
23130  34074  35969
39  82  9069
1665  23618  28887
13344  16378  16410
3753  6863  27107
5309  26232  29584
83  10780  35045
23884  31975  36715
8591  27909  35282
16924  29871  36684
11923  21783  30567
20309  26955  36030
33545  36648  36706
6851  9052  35671
2188  11594  34478
32  5093  24903
7863  21519  23494
2227  25547  36218
27745  35240  36580
8094  13505  31136
14191  28503  33160
14107  25438  30594
30235  33886  35034
14118  35846  36621
```

## FIG.58

```
N=64800, rate=14/30
   2422 2919 3173 3795 4428 12681 13428 14654 17367 17687 19587 20017 23588 24353 25280
27167 29853 32040 32473 33170 33375
   34 79 817 12478 12769 14798 15383 16688 16739 17538 21654 22792 25145 25588 26995 27388
31655 32133 32601 33452 34471
   88 986 1907 2868 3657 6826 8595 11922 14704 17681 19503 20604 24251 28125 28612 29976
30687 31208 31464 33686 33909
   526 3853 4486 6507 10616 11300 11453 13385 20007 21420 21441 22554 23794 24581 24959
27083 28710 30235 32852 34179 34327
   43 1775 4405 5644 6553 8885 10337 11178 14114 15108 16189 16192 18490 18801 21475 22748
28269 28970 30758 31968 33554
   27 624 1191 1470 4277 5054 5695 9632 10911 11365 13339 21097 23810 26677 27822 28433
29878 31026 32525 33335 33873
   14 45 760 1098 1567 2003 6710 10195 12052 13024 13337 19088 22647 25050 25899 27035 28844
29927 33916 34033 34490
   30 94 4493 11928 14051 17759 18541 20842 21277 24587 24948 25790 27442 31120 31205 31526
32107 32263 33696 34393 34529
   3 4245 5284 7791 10196 10922 13992 14397 14947 16908 21032 24585 27219 30300 30981 32732
33362 33558 33725 34424 34537
   78 6958 8297 15781 23302 23386 23863 25570 25734 31844 31919 32100 32815 33345 33531
33561 33889 34348 34504 34512 34530
   52 90 775 3760 4099 6945 8954 11931 16578 20804 23252 26583 29420 32461 33695 33874 33964
34018 34177 34483 34506
   81 1162 3084 3986 4494 8523 10309 10934 12819 16784 23113 23803 25952 29134 29930 30530
32021 33343 33400 33664 33685
   0 35 57 1564 9062 19694 24489 24737 26422 27021 30630 31513 33317 33425 33545 33624 33743
33869 33875 34046 34519
   58 639 2340 3613 19319 21917 24284 29214 29430 29736 32496 32785 32830 32835 33176 33323
33711 33967 34197 34438 34468
   71 77 88 953 4233 7365 8395 15176 16662 18280 21989 24348 26847 27645 31050 31890 34119
34223 34235 34548 34551
   163 4304 4697 7470 11857 12787 12837 18000 18472 18489 19730 27014 29653 29740 30070
30252 32769 33637 34382 34394 34555
   7 29 79 7321 9770 11315 15354 16240 18888 19559 27783 28220 28924 30659 31474 33084 33310
33644 34282 34452 34557
   8 24 41 4491 11252 14225 18230 25845 30258 30801 31349 32655 32932 32951 33058 33794
33889 34150 34338 34463 34494
   13 13092 15747 23904 29675 29732 30199 31273 31928 32211 32704 32959 33056 33374 33646
33931 34043 34203 34426 34429 34509
   6 11188 19937
   11738 14763 34508
   11 4674 25431
   6346 9658 31716
   13231 32283 33193
   19187 31166 33846
   297 27886 32712
   74 8683 24435
   2200 20501 21571
   25 10097 29631
   4515 32145 33245
   13010 26434 29967
   0 30598 33940
```

# FIG. 59

1342 27835 33782
2253 7519 33030
9079 13091 29109
20124 20880 27383
14317 16550 26394
84 2860 33197
21726 28620 31525
12888 23822 32157
1221 10300 34113
15613 22759 28517
4889 28647 31367
22184 25784 30338
21714 26800 28577
1408 15983 16148
6569 18901 23827
42 7606 25499
11193 13616 31040
8996 28561 30145
6335 23176 26286
6236 23314 24004
25452 30736 31684
3826 12150 21414
10711 17869 29177
13382 34510 34532
14491 16483 31945
77 16047 34221
17991 32178 32575
5508 6547 13800
4265 19226 25358
10154 23746 29274
3421 20929 34055
2976 9237 30748
17492 23256 34334
14069 21117 34122
2 30 34279
4782 18300 33733
153 4829 34472
6935 20289 25347
94 23931 34474
4955 13105 18305
3455 6361 16383
5195 13496 34289
1637 5512 18417
14082 20496 28064
12268 18659 23956
9430 22419 34549
6153 21548 24847
1995 12662 13605
13498 29840 31922
14059 14662 33208
20727 33280 34067
564 20975 23516

## FIG. 60

```
N=64800, rate=15/30
   760 874 3785 6601 10266 14790 16713 18014 18215 20992 21237 21250 24161 24295 25360
25380 26306 28764 30139 30708 31719 31730 32179
   191 7294 12316 12887 15172 15688 16749 18425 21102 25133 25875 25892 26013 26763 27058
29510 29746 30265 30326 30386 31467 31665 32391
   76 2184 4641 6139 8656 9053 10603 15456 15797 15853 19689 21857 23984 24703 24732 26828
26912 27714 27978 28627 30815 31332 31701
   13 5917 11178 13332 13401 16567 18144 18332 21502 22585 26654 27287 27474 27580 28266
28949 30045 30669 30950 31388 31786 31820 32319
   723 9266 11501 12279 14691 14757 16829 18863 19022 19311 21466 22322 23441 23479 26959
29450 29621 30075 30305 32044 32050 32110 32387
   42 3584 3807 6900 8188 12414 14341 20161 20466 23466 23722 26503 28207 29006 30745 30942
31023 31647 31668 31908 32130 32332 32338
   2108 6363 8375 8971 10744 12734 15004 16460 16558 21479 22043 23858 24423 27887 28871
30000 30089 30596 30926 31378 31525 32333 32355
   28 948 5841 6154 6643 10141 11528 12498 12525 13792 15031 18762 20383 20443 23824 25767
27445 27558 27979 31402 32064 32133 32394
   14 19 2616 3474 4620 5333 6095 8507 8656 9411 13922 17800 18897 23695 25311 29891 30342
31067 31124 31139 31467 32019 32240
   0 1082 2189 4147 8496 8986 10062 11294 16960 20197 23516 23989 24429 25718 29296 30293
31195 31351 31665 31820 32073 32355 32376
   1661 4207 5859 14432 17329 18592 20431 20758 23186 23573 29558 29974 30107 30295 30396
30635 30935 31185 31534 31650 31685 31960 32007
   89 4834 5934 6765 7256 7928 9025 12135 14585 23859 25231 25332 26519 26921 30891 31001
31496 31625 31700 31730 31852 32022 32224
   5460 6506 6639 10691 16488 20520 21627 22863 25303 26209 26647 27502 27898 28112 28982
29023 29188 31060 31193 31673 31911 32200 32343
   4652 9366 12753 13047 16124 19840 19846 19928 22041 26095 27473 28784 29506 29827 29958
30347 31018 31027 31904 32274 32300 32383 32387
   2265 3996 4208 6150 7258 9151 9983 12269 12788 12986 15469 17063 26727 26859 28941 30162
30172 30616 30714 31315 31357 31818 32284
   6518 11111 24325 32103
   72 12699 23236 30992
   8360 19792 19940 32358
   14197 21794 25358 27036
   4398 6859 18988 32137
   841 22129 27876 31949
   6974 7937 17758 27732
   7040 9749 9755 32242
   2949 17069 29881 30587
   1373 9669 30875 32281
   11884 12078 27981 32205
   7736 24771 25380 32163
   74 3602 19540 25410
   16273 30193 32344 32355
   1315 13197 20672 25600
   13 9947 14814 27294
   21919 29940 31822 32276
   11 3234 17261 27366
   18543 21226 24436 32375
   18492 19557 22383 30490
   24 17620 23927 32049
   14847 22301 22903 29032
```

# FIG.61

```
2676 11480 11692 18567
12192 31056 31967 32098
44 27120 32324 32378
5721 9533 32015 32311
30379 31576 31774 32209
5335 10732 31892 32363
11000 22458 32187 32398
1872 10630 32347 32391
16571 17488 23289 23346
27732 29271 29371 30145
3353 29492 31289 31868
2198 6637 10704 26015
15354 19712 25567
21163 24225 25981
4200 22366 31698
9311 18196 25010
28406 31360 31879
5159 6285 31195
28054 29700 31997
4049 10513 29649
78 29253 32396
1024 7865 16946
4124 20295 22713
14007 19361 32315
4044 12702 14541
25377 29764 31569
2057 25664 32000
8836 10649 14172
6497 27125 29138
11983 21816 29095
8545 16142 25004
13112 27787 32221
28 7470 32149
21978 31113 32332
24788 31901 32359
19016 31956 32312
8082 16436 22264
27 23947 28943
20 19713 25231
24 5409 25558
17325 22825 29039
58 30869 32333
52 7935 13780
76 27127 32224
16783 30121 30450
9138 17711 31443
16066 25671 32301
13418 14979 22933
11496 16370 20860
4727 10245 15174
1523 17435 32170
60 10068 32392
8324 27536 32209
```

# FIG. 62

```
┌─ N=64800, rate=16/30 ─────────────────────────────────────────────────────────────┐
   3111 4871 6505 6799 7635 11197 14052 14348 14826 15557 15659 18613 21220 22340 22401
27614 28374 29255 29841
   3361 4302 5676 9039 12309 14206 14677 15432 18320 20678 22348 23548 24612 27694 28211
28562 29155 29406 29548
   5 53 3037 4529 5584 5648 17104 18025 18489 20393 24434 24500 24814 25552 25565 26415
27851 29090 29780
   5161 5493 5523 10121 12283 13234 14979 17374 18240 20035 24222 25047 26289 26734 28216
28403 28465 28810 29385
   43 186 1836 4590 11586 12799 13507 13724 14711 15317 21647 23476 24193 24699 25994 28699
29940 30122 30203
   2003 3800 5130 6577 9365 10145 11356 15819 15932 16104 18223 19103 20631 22002 23366
26895 28896 28976 30165
   23 9657 11412 13196 15347 15358 16644 17463 18784 19185 26582 28301 28342 28525 28922
29224 29957 30116 30120
   2206 3177 4177 6441 7458 11162 15727 16894 19718 20753 20946 22516 22660 26757 26827
26850 28909 29822 30046
   739 3969 4582 14549 15188 15831 21294 22417 22460 23015 25237 25515 26568 26656 27187
27924 28526 29071 29734
   4208 4241 4427 6512 14103 18082 22518 23522 24048 24879 27014 28704 28753 29196 29438
29571 29695 29829 30174
   13 32 3455 8111 10978 13661 13856 18718 19398 20224 22663 23517 26241 27440 28748 28817
28979 29377 30187
   1463 3641 4046 6345 6676 10287 12165 13506 15052 15192 20449 23322 23426 24120 25788
26284 27049 28460 30124
   1569 3052 3370 5187 6418 12733 15343 15725 16555 19231 25563 26273 27866 28411 28938
29006 29339 29387 29566
   77 4306 7810 12815 18400 19686 19803 20446 20940 21189 22144 23248 24200 25226 28695
28801 29268 30118 30206
   45 649 1691 4421 8406 9642 10567 11550 12441 15117 17109 18327 19727 24980 26328 27075
27235 28892 30221
   12483 13895 20152 20245 20655 21468 22162 22961 24057 24365 24605 25411 26180 26761
27446 29507 30100 30181 30216
   44 1264 3026 7950 8626 14270 17615 17922 18819 23010 23725 25137 25284 25409 27704 28128
28675 29774 30092
   55 2812 7572 7825 8647 19309 20122 20243 20787 22530 22612 24719 24955 25546 26352 26396
26477 29301 29918
   6419 11660 28980 30169
   62 7613 22157 25645
   3958 5559 27517 28608
   2395 6628 21235 27555
   750 14167 14443 29001
   14265 15570 28940 29039
   77 600 7982 16623
   19331 26506 29810 30208
   1269 1541 23861 27282
   19 12841 24031 27927
   1666 14901 16818 28517
   3189 11786 18478 23399
   6495 10934 16584 25011
   8 28009 28559 30049
   58 1288 17394 18565
```

# FIG.63

```
13723 28172 29034
8440 9110 16677
12909 17320 30012
24814 27014 29165
17859 24172 24616
13076 28350 28463
22 10992 13100
13027 14490 29661
8454 13705 30238
11 21997 22751
12860 16875 26073
14510 26256 29962
3886 4042 27359
11582 29084 29204
17120 28447 29009
21893 24307 30195
79 20747 27546
34 8136 23729
19787 29064 29759
18463 22634 26188
6266 6668 8406
12813 19765 27450
37 29680 29989
4708 9183 26121
46 3504 4132
69 18724 30090
24867 27125 30171
2214 4898 23823
20902 27008 30091
7073 17524 29356
120 2952 29234
3325 23880 29001
65 9413 21897
26943 27109 29732
602 29267 29947
8477 14722 24091
7886 28109 29997
12730 27726 29820
27 12228 30239
17638 28758 30236
24 13634 30168
8892 16810 25858
5263 9232 29835
527 18583 30143
28 1820 21525
2574 24420 29901
3 6599 20094
3484 24193 24838
43 12248 22044
1052 1669 27379
20703 28365 30141
892 23049 29633
9076 16913 27030
```

FIG.64

10878 11979 29525
38 62 5737
61 3446 17492
12701 21553 29475
10928 30088 30163
16919 26239 28009
59 25348 27313
21414 28574 29768
4515 19286 28017
19661 20675 26662

# FIG.65

```
─N=64800, rate=17/30─────────────────────────────────────────────────────────
    3638 3722 7015 10458 11119 12197 14103 14536 17412 18774 22287 22612 22713 25635 27548
27686 27778 27826
    5324 7803 10924 11606 12282 12502 12860 16739 22141 23364 23709 23875 25369 26285 26862
26922 26948 27844
    118 2886 6188 8567 8753 10752 11895 11939 12361 12739 14031 15749 16127 16638 18517 22030
23682 27925
    158 489 824 1854 2935 4257 6997 11791 15452 15664 16719 19672 24085 25188 25240 25283
25636 27011
    2918 5981 6349 7833 12983 14033 14242 14344 17083 17405 19655 21959 22550 23777 27153
27827 27848 27921
    3265 5089 6050 6323 10714 18435 20910 21582 24038 24361 24712 25131 25484 26901 27073
27174 27309 27693
    17 26 32 3083 10749 11918 11982 12657 13842 14454 18559 20569 23993 27282 27712 27732
27772 27820
    3991 4273 5550 8223 9048 10163 12392 15961 19676 20564 20586 21360 24139 26555 27189
27334 27708 27844
    1611 3553 6046 9278 10150 13220 13670 14436 17764 19828 20986 21353 21723 25542 25691
26339 27591 27823
    6173 6835 7028 7803 8388 8626 11307 15884 17784 18339 19512 24249 26438 27137 27255 27594
27770 28072
    67 486 3205 5487 10201 11054 14546 20328 23045 23272 23673 25248 25527 25802 26578 27235
27872 27971
    23 3605 3873 13976 16258 18335 18529 20465 22508 24880 24946 25672 26326 26479 26514
27758 28026 28047
    2183 7317 10716 11014 11637 20111 21269 22729 23581 25870 25891 27176 27185 27709 27747
27912 28003 28024
    12 31 53 68 1492 9988 15395 19124 20807 23692 25299 25979 26394 27022 27026 27092 27576
28041
    18 52 4442 12761 15481 17938 20266 24312 24821 25137 25916 26131 26642 26851 27065 27311
27697 27987
    49 4516 5076 12930 15048 20703 21360 22615 25025 25577 25997 26353 26659 26701 27206
27655 28030 28037
    36 1654 2703 8738 13150 15338 18464 20505 21404 25826 25911 27400 27433 27513 27891 28011
28015 28043
    40 54 6027 11231 14164 15995 17839 19890 22537 25509 26043 26700 27141 27166 27182 27660
27893 27990
    2840 11826 14170 15701 15758 17947 19094 23029 26232 26528 26556 26849 27015 27456 27761
27881 27987 28036
    30 680 1541 5734 8251 19767 20127 21120 22480 25861 25867 26517 26755 26821 27220 27547
27793 27875
    1630 5956 7702 9606 10458 10541 17763 19609 21908 23593 24189 24356 24896 25180 26091
27038 27081 27422
    2459 2748 22536 23254
    597 7455 22226 26562
    12250 13286 13325 25013
    8523 13590 27754
    39 19867 24723
    19403 21896 22752
    8491 20514 23236
    4300 25422 27311
    11586 19002 28004
```

## FIG. 66

```
10358 19197 20224
11549 24404 24743
25288 26238 27603
7064 7516 12667
10495 22956 25193
2138 16441 19980
57 3925 20396
26 3672 6014
8425 24543 26134
8188 8317 24909
40 2219 17740
4187 10940 11324
2447 7425 20795
46 13240 16149
37 12701 25168
4044 5791 27998
33 24019 25005
18081 22487 23003
13 20833 25074
15660 22973 27116
2816 17854 27914
18148 23098 27712
3886 19711 20993
54 17332 26188
10188 16959 27174
74 14117 23707
8805 19540 27887
25062 27736 28002
1698 16599 28039
19195 24524 25323
6814 27968 27986
942 972 24673
4760 24441 27142
680 11557 27969
4544 14190 19878
15369 18267 27683
9155 20072 26804
65 5166 12757
49 14369 26870
1 35 26298
5975 12813 19445
20809 27226 27431
59 75 5907
9940 17252 27654
11221 14695 17335
10851 18647 27885
8004 26096 26754
7 23111 27220
22256 26278 27521
1087 24826 28022
3753 11220 15209
11595 12395 27701
21 67 1577
```

## FIG. 67

```
11832 25290 26155
13569 19238 19712
5240 18333 22195
3466 20906 25558
18549 24520 27963
17078 18683 28070
7525 21035 27052
25555 26737 27020
10046 10066 15471
7526 19774 27813
10476 11424 27594
18349 24493 27123
5476 26410 28071
7964 14835 18804
33 4787 25619
757 6564 13708
23472 27330 28015
7067 19247 22116
7363 27544 27851
```

## FIG.68

```
N=64800, rate=18/30
   113 1557 3316 5680 6241 10407 13404 13947 14040 14353 15522 15698 16079 17363 19374 19543
20530 22833 24339
   271 1361 6236 7006 7307 7333 12768 15441 15568 17923 18341 20321 21502 22023 23938 25351
25590 25876 25910
   73 605 872 4008 6279 7653 10346 10799 12482 12935 13604 15909 16526 19782 20506 22804
23629 24859 25600
   1445 1690 4304 4851 8919 9176 9252 13783 16076 16675 17274 18806 18882 20819 21958 22451
23869 23999 24177
   1290 2337 5661 6371 8996 10102 10941 11360 12242 14918 16808 20571 23374 24046 25045
25060 25662 25783 25913
   28 42 1926 3421 3503 8558 9453 10168 15820 17473 19571 19685 22790 23336 23367 23890
24061 25657 25680
   0 1709 4041 4932 5968 7123 8430 9564 10596 11026 14761 19484 20762 20858 23803 24016
24795 25853 25863
   29 1625 6500 6609 16831 18517 18568 18738 19387 20159 20544 21603 21941 24137 24269
24416 24803 25154 25395
   55 66 871 3700 11426 13221 15001 16367 17601 18380 22796 23488 23938 25476 25635 25678
25807 25857 25872
   1 19 5958 8548 8860 11489 16845 18450 18469 19496 20190 23173 25262 25566 25668 25679
25858 25888 25915
   7520 7690 8855 9183 14654 16695 17121 17854 18083 18428 19633 20470 20736 21720 22335
23273 25083 25293 25403
   48 58 410 1299 3786 10668 18523 18963 20864 22106 22308 23033 23107 23128 23990 24286
24409 24595 25802
   12 51 3894 6539 8276 10885 11644 12777 13427 14039 15954 17078 19053 20537 22863 24521
25087 25463 25838
   3509 8748 9581 11509 15884 16230 17583 19264 20900 21001 21310 22547 22756 22959 24768
24814 25594 25626 25880
   21 29 69 1448 2386 4601 6626 6667 10242 13141 13852 14137 18640 19951 22449 23454 24431
25512 25814
   18 53 7890 9934 10063 16728 19040 19809 20825 21522 21800 23582 24556 25031 25547 25562
25733 25789 25906
   4096 4582 5766 5894 6517 10027 12182 13247 15207 17041 18958 20133 20503 22228 24332
24613 25689 25855 25883
   0 25 819 5539 7076 7536 7695 9532 13668 15051 17683 19665 20253 21996 24136 24890 25758
25784 25807
   34 40 44 4215 6076 7427 7965 8777 11017 15593 19542 22202 22973 23397 23423 24418 24873
25107 25644
   1595 6216 22850 25439
   1562 15172 19517 22362
   7508 12879 24324 24496
   6298 15819 16757 18721
   11173 15175 19966 21195
   59 13505 16941 23793
   2267 4830 12023 20587
   8827 9278 13072 16664
   14419 17463 23398 25348
   6112 16534 20423 22698
   493 8914 21103 24799
   6896 12761 13206 25873
   2 1380 12322 21701
   11600 21306 25753 25790
```

## FIG. 69

```
8421  13076  14271  15401
9630  14112  19017  20955
212  13932  21781  25824
5961  9110  16654  19636
58  5434  9936  12770
6575  11433  19798
2731  7338  20926
14253  18463  25404
21791  24805  25869
2  11646  15850
6075  8586  23819
18435  22093  24852
2103  2368  11704
10925  17402  18232
9062  25061  25674
18497  20853  23404
18606  19364  19551
7  1022  25543
6744  15481  25868
9081  17305  25164
8  23701  25883
9680  19955  22848
56  4564  19121
5595  15086  25892
3174  17127  23183
19397  19817  20275
12561  24571  25825
7111  9889  25865
19104  20189  21851
549  9686  25548
6586  20325  25906
3224  20710  21637
641  15215  25754
13484  23729  25818
2043  7493  24246
16860  25230  25768
22047  24200  24902
9391  18040  19499
7855  24336  25069
23834  25570  25852
1977  8800  25756
6671  21772  25859
3279  6710  24444
24099  25117  25820
5553  12306  25915
48  11107  23907
10832  11974  25773
2223  17905  25484
16782  17135  20446
475  2861  3457
16218  22449  24362
11716  22200  25897
8315  15009  22633
```

## FIG. 70

```
13 20480 25852
12352 18658 25687
3681 14794 23703
30 24531 25846
4103 22077 24107
23837 25622 25812
3627 13387 25839
908 5367 19388
0 6894 25795
20322 23546 25181
8178 25260 25437
2449 13244 22565
31 18928 22741
1312 5134 14838
6085 13937 24220
66 14633 25670
47 22512 25472
8867 24704 25279
6742 21623 22745
147 9948 24178
8522 24261 24307
19202 22406 24609
```

## FIG.71

```
─ N=64800, rate=19/30 ─────────────────────────────────────────────────────
   354 794 1214 1640 8278 9195 11069 11580 11911 13276 13438 14495 14734 15741 19195 19537
21951
   4657 5351 5887 6634 7718 8327 10300 10815 11822 13506 16746 19429 19920 21548 22087 23650
23712
   4603 5160 6345 7259 8428 8937 9665 11623 11864 13590 13613 17117 18678 19118 21126 21884
23054
   27 2157 3039 3219 4191 5651 7098 12555 12634 13791 14885 15505 16163 16664 19792 20437
23588
   30 49 2768 3314 4345 6972 8994 15294 16653 18282 18808 19324 20597 21510 21643 23741
23748
   1 553 2228 4277 4499 5818 10580 10823 12135 14102 14923 15980 15995 16319 18577 22838
23058
   4 2307 2764 3075 4755 8064 9673 12150 21139 21224 21572 21682 23415 23598 23703 23710
23739
   4 9 13 5867 6028 7730 10859 14755 14879 15746 21166 21643 22777 23409 23502 23511 23734
   13 28 481 7146 8144 13768 15081 19349 20187 20858 21913 22025 23134 23472 23506 23711
23744
   12 24 36 1004 3080 3496 7356 7834 16011 16492 19536 20918 22833 22937 23717 23745 23749
   31 378 812 1578 1957 5163 14759 16701 16829 18111 22931 23253 23314 23351 23584 23660
23699
   25 38 1183 6573 9556 12523 14303 14412 18209 18530 21334 21770 21809 22630 22734 23154
23186
   57 3497 6667 9653 10168 12771 15082 19365 19415 19514 19611 19785 21242 22974 23107 23690
23715
   2456 2562 6223 7150 12652 14580 14807 20072 20513 21091 21201 21922 23010 23046 23215
23514 23663
   5 635 3760 4981 6824 8425 13532 14618 19654 20026 21439 21684 22023 23027 23499 23691
23707
   8 3018 4509 9002 11537 17156 17490 17779 20182 22018 22416 23348 23497 23575 23685 23708
23753
   3 19 60 9502 12512 12907 17118 20225 20508 21429 21695 22010 22187 22347 23574 23608
23617
   2 5 22 61 6583 15302 17930 18081 18562 19427 21204 21744 22713 23422 23503 23597 23730
   15 4333 9774 11921 15075 20998 21581 21622 22468 22638 23104 23530 23593 23613 23645
23648 23719
   16 48 65 2563 3079 12594 17391 17524 20302 21062 21809 22772 23189 23501 23625 23628
23756
   59 4288 6124 13237 13580 13607 19899 20348 21481 22380 22510 22883 23114 23233 23709
23715 23735
   46 2949 3278 6100 9887 10255 19509 19883 20022 21147 21422 21915 22489 22777 23422 23750
23754
   761 8196 8895 23472
   10842 15470 23658 23748
   13 16585 19888 21445
   13341 17522 18603 20826
   2932 8194 19093 21220
   6202 9623 23715
   2288 21290 22116
   5143 10529 19731
   15559 16069 23704
   137 11927 20849
```

## FIG. 72

```
11 5997 11214
1212 9635 22820
8785 10770 15217
14930 15004 19622
15 9351 22137
6984 10545 18086
17 5394 22378
5666 17493 23525
2788 2962 18427
15308 18638 23694
6477 21407 23683
5907 22795 23101
3398 17256 18334
3010 12780 18130
2912 12048 19907
10071 21798 22747
9806 23050 23683
13541 23317 23733
11998 12007 17363
9401 16372 23473
16221 19981 21929
32 7499 20187
17718 22377 23147
17276 21344 22014
21779 22541 23607
16248 18722 23096
4225 19889 20582
21394 23463 23652
10428 11323 12984
60 23098 23752
8941 12692 20396
3909 12976 23323
4172 13704 21088
4252 20334 23229
5669 9953 23616
747 22117 23391
1201 17300 19083
6226 22684 23382
8854 14713 23706
18391 19269 20334
15856 16811 23747
39 3964 14259
11159 17884 18130
11388 23637 23738
12481 16865 23422
17762 22000 23602
13515 19709 21596
45 16207 16302
2011 13753 23611
20451 23564 23756
13 10379 16323
20 14421 16684
11082 19565 22082
```

FIG.73

```
9158 9437 20186
9270 21333 22631
24 22736 23382
28 19129 21403
34 1541 19415
18638 22335 23418
42 8892 23629
13154 13353 22663
51 2780 21921
45 6677 20895
61 15836 22536
15246 23565 23578
48 22661 23012
17 21419 23698
22650 23448 23497
20671 22579 23692
27 7302 23401
9478 19287 20789
9312 23176 23598
3566 21768 23652
19 6707 11777
430 19822 22687
1705 6631 23312
5 19562 23680
644 2620 13917
3998 22493 23529
20916 22930 23741
12467 22100 23737
8546 15903 22828
```

# FIG.74

```
N=64800, rate=20/30
   692 1779 1973 2726 5151 6088 7921 9618 11804 13043 15975 16214 16889 16980 18585 18648
   13 4090 4319 5288 8102 10110 10481 10527 10953 11185 12069 13177 14217 15963 17661 20959
   2330 2516 2902 4087 6338 8015 8638 9436 10294 10843 11802 12304 12371 14095 18486 18996
   125 586 5137 5701 6432 6500 8131 8327 10488 11032 11334 11449 12504 16000 20753 21317
   30 480 2681 3635 3898 4058 12803 14734 20252 20306 20680 21329 21333 21466 21562 21568
   20 44 738 4965 5516 7659 8464 8759 12216 14630 18241 18711 19093 20217 21316 21490
   31 43 3554 5289 5667 8687 14885 16579 17883 18384 18486 19142 20785 20932 21131 21308
   7054 9276 10435 12324 12354 13849 14285 16482 19212 19217 19221 20499 20831 20925 21195
21247
   9 13 4099 10353 10747 14884 15492 17650 19291 19394 20356 20658 21068 21117 21183 21586
   28 2250 2980 8988 10282 12503 13301 18351 20546 20622 21006 21293 21344 21472 21530
21542
   17 32 2521 4374 5098 7525 13035 14437 15283 18635 19136 20240 21147 21179 21300 21349
   57 4735 5657 7649 8807 12375 16092 16178 16379 17545 19461 19489 20321 20530 21453 21457
   35 55 5333 14423 14670 15438 19468 19667 20823 21084 21241 21344 21447 21520 21554 21586
   13 20 2025 11854 12516 14938 15929 18081 19730 19929 20408 21338 21391 21425 21468 21546
   54 7451 8176 10136 15240 16442 16482 19431 19483 19762 20647 20839 20966 21512 21579
21592
   26 465 3604 4233 9831 11741 13692 18953 18974 21021 21039 21133 21282 21488 21532 21558
   1 7 16 59 6979 7675 7717 9791 12370 13050 18534 18729 19846 19864 20127 20165
   15 31 11089 12360 13640 14237 17937 18043 18410 19443 21107 21444 21449 21528 21576 21584
   32 51 9768 17848 18095 19326 19594 19618 19765 20440 20482 20582 21236 21338 21563 21587
   44 55 4864 10253 11306 12117 13076 13901 15610 17057 18205 19794 20939 21132 21267 21573
   3436 11304 15361 16511 16860 18238 18639 19341 20106 20123 20407 21200 21280 21452 21526
21569
   679 8822 11045 14403 16588 17838 19117 19453 20265 20558 21374 21396 21428 21442 21529
21590
   391 13002 13140 14314 17169 17175 17846 18122 19447 20075 20212 20436 20583 21330 21359
21403
   7601 10257 20060 21285
   4419 9150 18097 20315
   4675 13376 21435
   610 1238 16704
   5732 7096 21104
   5690 13531 14545
   4334 14839 17357
   8 2814 17674
   2392 8128 18369
   502 7403 15133
   343 13624 20673
   13188 15687 21593
   321 16866 21347
   1242 4261 17449
   4691 8086 8691
   8500 11538 20278
   6269 12905 18192
   5984 15452 17111
   11541 18717 21534
   16 10780 16107
   12310 12959 20390
   1365 18306 19634
```

## FIG. 75

```
6125  19132  20242
3012  17233  21533
5816  13021  21440
13207  17811  18798
2762  7586  12139
3949  5545  13584
11374  18279  19241
2736  10989  21209
4095  20677  21395
8251  10084  20498
7628  8875  21406
2743  8943  9090
1817  7788  15767
9333  9838  21268
6203  9480  12042
5747  21187  21468
2553  18281  21500
3179  9155  15222
12498  18109  20326
14106  21209  21592
7454  17484  20791
20804  21120  21574
5754  18178  20935
30  4322  21381
11905  20416  21397
12452  19899  21497
1917  6028  16868
9891  18710  18953
912  21083  21446
370  14355  18069
16519  19003  20902
11163  17558  18424
8427  14396  21405
8885  11796  21361
4960  15431  20653
11944  16839  21236
9967  14529  17208
14144  19354  19745
7986  12680  21396
6097  11501  13028
33  13803  21038
3177  20124  20803
2692  6841  18655
971  5892  14354
3887  19455  21271
17214  17315  21148
6539  13910  21526
3809  5153  15793
3865  21438  21510
7129  17787  19636
5972  13150  14182
7078  14906  16911
15705  21160  21482
```

## FIG.76

```
5479  13860  19763
16817  19722  20001
14649  16147  18886
15138  18578  21502
2096  2534  17760
11920  13460  19783
19876  20071  20583
6241  14230  20775
16138  16386  21371
8616  15624  18453
6013  8015  21599
9184  10688  20792
18122  21141  21469
10706  13177  20957
15148  15584  20959
9114  9432  16467
5483  14687  14705
8325  21161  21410
2328  17670  19834
7015  20802  21385
52  5451  20379
9689  15537  19733
```

# FIG. 77

```
N=64800, rate=21/30
 549 611 1357 3717 5079 5412 5964 10310 13716 16028 16067 16726 16856 18095 18515
 25 163 1310 4468 5938 8348 9208 11118 13355 13539 14004 14869 16512 17878 19194
 9 3271 4816 5091 5642 6704 8049 8431 8513 9264 10118 10905 17317 19047 19204
 1775 2009 2741 3978 5427 6376 8143 9682 12173 13086 13232 14386 15220 17433 19332
 18 519 4261 4265 6356 6409 11253 12973 14592 16637 17039 18474 19112 19202 19214
 874 2918 3977 8791 9100 10391 10623 11738 16545 16968 17928 19049 19251 19295 19384
 15 2832 4906 5010 7208 7315 8266 12524 14718 14789 16532 16637 17333 19314 19361
 1 44 169 967 3980 7358 8489 9672 11731 12519 19027 19030 19156 19348 19434
 32 112 2611 5885 6907 9231 9890 10047 10456 17955 17959 19236 19361 19395 19419
 5 13 38 51 1307 6348 7275 10351 11869 13074 17179 17889 18802 18957 18963
 45 1114 1822 13768 13968 16002 17945 18577 18944 19097 19142 19191 19211 19280 19410
 16 25 31 6527 7318 10336 11522 11826 12038 17843 19218 19270 19346 19365 19428
 44 3166 11719 13946 14592 16659 17881 18127 18335 18401 18672 19025 19093 19218 19233
 3890 4804 10421 11575 15260 15641 15738 15835 16462 17085 17902 18650 19131 19328 19336
 40 4635 6324 12215 13030 14029 15387 16287 18128 18893 18939 19138 19409 19416 19422
 26 10421 10487 11386 12158 13231 16951 17521 18100 18309 18468 18689 18745 18862 19350
 33 1635 8499 10728 12209 15641 16482 17298 18157 18247 18498 18885 19018 19304 19340
 155 7584 9130 9253 10095 14414 15396 16572 16660 18942 19031 19287 19319 19334 19418
 0 452 4180 6281 7401 13527 13855 14524 16190 18133 18346 18428 18983 19370 19377
 43 5974 9711 10621 11296 13782 16955 17413 17514 17949 18441 18465 18800 19368 19380
 20 2462 6141 6157 7855 13754 17444 17900 18517 19099 19217 19392 19416 19419 19436
 44 3197 6827 8627 12967 13503 14327 15070 16306 17079 18212 18283 19000 19021 19318
 0 9 24 784 875 2519 3900 5797 13090 13395 18070 18095 18767 19024 19212
 27 1943 4688 5617 7512 7773 10220 13453 15976 15984 17284 17785 18950 19187 19422
 2095 17203 18559
 29 10616 15594
 14366 14924 15179
 5487 7882 14228
 1228 19301 19420
 2144 9744 10245
 47 12037 16969
 4990 8811 19259
 13271 13624 18766
 11793 15199 18405
 13618 15135 16272
 9174 15906 19070
 10882 15172 19435
 2925 5216 18611
 8983 16271 19303
 5729 11533 19203
 3507 5159 11003
 11001 13292 17253
 101 1300 14833
 8847 16410 19344
 38 3941 11470
 10236 12322 19338
 1260 12919 18542
 14 1600 18816
 7291 10840 19376
 13341 17748 18862
 2024 16189 16472
```

## FIG. 78

```
15455 19239 19324
7128 12794 13415
2451 13218 15127
11 9927 15112
12 10965 18860
6608 9066 12275
41 18066 19438
9728 14238 15735
2681 18067 18373
5703 12695 17303
6313 10968 16782
11614 17966 19415
8655 11059 19328
5073 10392 17906
14548 18253 18669
19 14499 15650
2143 4832 19385
34 14211 19234
2 12953 17512
25 10861 17406
5130 5806 14134
39 7187 9438
10151 13443 14947
3133 17418 19306
10438 17365 18111
663 1871 9263
2263 10489 18872
1394 11495 14248
13142 14532 17626
4112 8384 17008
343 10678 16973
36 15014 18796
7493 9878 17251
4377 18986 19224
308 4759 14859
351 4223 15427
8202 9473 16372
34 11406 17412
288 17583 19377
11399 19314 19423
12751 16286 18472
8491 18395 19437
4963 17013 17320
8 8055 18734
16273 18187 18587
2518 11798 16676
53 10193 12952
12684 17095 19344
12177 17294 19409
2392 2779 11655
22 2710 13906
13632 18515 18736
7382 14797 19428
```

# FIG. 79

```
179 2268 14006
3906 17265 18591
7319 19149 19416
4758 6806 13737
5870 16687 18049
951 17955 18610
18594 19185 19230
12 10368 14750
9075 15399 16142
52 18271 19415
11188 16933 18251
5 3895 18928
42 4376 16217
392 10065 12992
24 6280 7491
5120 6017 14213
13487 18094 18488
6894 8901 18670
4309 7212 11581
4843 7906 17221
2422 10835 18516
26 16787 19383
```

# FIG. 80

N=64800, rate=22/30

```
696  989  1238  3091  3116  3738  4269  6406  7033  8048  9157  10254  12033  16456  16912
444  1488  6541  8626  10735  12447  13111  13706  14135  15195  15947  16453  16916  17137  17268
401  460  992  1145  1576  1678  2238  2320  4280  6770  10027  12486  15363  16714  17157
1161  3108  3727  4508  5092  5348  5582  7727  11793  12515  12917  13362  14247  16717  17205
542  1190  6883  7911  8349  8835  10489  11631  14195  15009  15454  15482  16632  17040  17063
17  487  776  880  5077  6172  9771  11446  12798  16016  16109  16171  17087  17132  17226
1337  3275  3462  4229  9246  10180  10845  10866  12250  13633  14482  16024  16812  17186  17241
15  980  2305  3674  5971  8224  11499  11752  11770  12897  14082  14836  15311  16391  17209
0  3926  5869  8696  9351  9391  11371  14052  14172  14636  14974  16619  16961  17033  17237
3033  5317  6501  8579  10698  12168  12966  14019  15392  15806  15991  16493  16690  17062  17090
981  1205  4400  6410  11003  13319  13405  14695  15846  16297  16492  16563  16616  16862  16953
1725  4276  8869  9588  14062  14486  15474  15548  16300  16432  17042  17050  17060  17175  17273
1807  5921  9960  10011  14305  14490  14872  15852  16054  16061  16306  16799  16833  17136  17262
2826  4752  6017  6540  7016  8201  14245  14419  14716  15983  16569  16652  17171  17179  17247
1662  2516  3345  5229  8086  9686  11456  12210  14595  15808  16011  16421  16825  17112  17195
2890  4821  5987  7226  8823  9869  12468  14694  15352  15805  16075  16462  17102  17251  17263
3751  3890  4382  5720  10281  10411  11350  12721  13121  14127  14980  15202  15335  16735  17123
26  30  2805  5457  6630  7188  7477  7556  11065  16608  16859  16909  16943  17030  17103
40  4524  5043  5566  9645  10204  10282  11696  13080  14837  15607  16274  17034  17225  17266
904  3157  6284  7151  7984  11712  12887  13767  15547  16099  16753  16829  17044  17250  17259
7  311  4876  8334  9249  11267  14072  14559  15003  15235  15686  16331  17177  17238  17253
4410  8066  8596  9631  10369  11249  12610  15769  16791  16960  17018  17037  17062  17165  17204
24  8261  9691  10138  11607  12782  12786  13424  13933  15262  15795  16476  17084  17193  17220
88  11622  14705  15890
304  2026  2638  6018
1163  4268  11620  17232
9701  11785  14463  17260
4118  10952  12224  17006
3647  10823  11521  12060
1717  3753  9199  11642
2187  14280  17220
14787  16903  17061
381  3534  4294
3149  6947  8323
12562  16724  16881
7289  9997  15306
5615  13152  17260
5666  16926  17027
4190  7798  16831
4778  10629  17180
10001  13884  15453
6  2237  8203
7831  15144  15160
9186  17204  17243
9435  17168  17237
42  5701  17159
7812  14259  15715
39  4513  6658
38  9368  11273
1119  4785  17182
5620  16521  16729
```

# FIG.81

```
16  6685  17242
210  3452  12383
466  14462  16250
10548  12633  13962
1452  6005  16453
22  4120  13684
5195  11563  16522
5518  16705  17201
12233  14552  15471
6067  13440  17248
8660  8967  17061
8673  12176  15051
5959  15767  16541
3244  12109  12414
31  15913  16323
3270  15686  16653
24  7346  14675
12  1531  8740
6228  7565  16667
16936  17122  17162
4868  8451  13183
3714  4451  16919
11313  13801  17132
17070  17191  17242
1911  11201  17186
14  17190  17254
11760  16008  16832
14543  17033  17278
16129  16765  17155
6891  15561  17007
12741  14744  17116
8992  16661  17277
1861  11130  16742
4822  13331  16192
13281  14027  14989
38  14887  17141
10698  13452  15674
4  2539  16877
857  17170  17249
11449  11906  12867
285  14118  16831
15191  17214  17242
39  728  16915
2469  12969  15579
16644  17151  17164
2592  8280  10448
9236  12431  17173
9064  16892  17233
4526  16146  17038
31  2116  16083
15837  16951  17031
5362  8382  16618
6137  13199  17221
```

# FIG. 82

```
2841  15068  17068
24  3620  17003
9880  15718  16764
1784  10240  17209
2731  10293  10846
3121  8723  16598
8563  15662  17088
13  1167  14676
29  13850  15963
3654  7553  8114
23  4362  14865
4434  14741  16688
8362  13901  17244
13687  16736  17232
46  4229  13394
13169  16383  16972
16031  16681  16952
3384  9894  12580
9841  14414  16165
5013  17099  17115
2130  8941  17266
6907  15428  17241
16  1860  17235
2151  16014  16643
14954  15958  17222
3969  8419  15116
31  15593  16984
11514  16605  17255
```

## FIG. 83

```
┌─N=64800, rate=23/30 ─────────────────────────────────────────────────────┐
│  310 1729 3466 4343 5079 5360 6486 7268 8660 8684 9687 10496 12682 13283 14142
│  10 35 3137 4489 4906 5614 6655 9072 10341 10512 11699 12547 12992 15098 15103
│  20 28 1671 4321 8051 8676 9003 10395 11047 11259 12221 13005 14041 14459 15078
│  82 329 2415 3798 8856 11071 11483 12210 12283 13592 14111 14118 14890 15043 15080
│  38 3425 4256 5892 6586 9088 10029 10168 10845 13170 13742 14143 14505 14648 14949
│  24 1462 5755 9371 9921 10303 11838 13574 13755 13982 14821 14848 14916 15082 15088
│  27 4818 7432 7508 8148 9725 10575 13009 13205 13469 14264 14707 14967 15029 15092
│  4118 6906 8252 10421 11578 12851 13114 13662 13815 14535 14795 14971 15007 15019 15094
│  34 5330 7799 9336 10563 11473 11624 13103 13490 13664 14286 14782 15013 15075 15089
│  30 1833 4359 7535 10347 10691 12403 13357 14063 14358 14554 14563 14611 14886 14894
│  2 11 2662 3363 5469 5674 8489 9870 11571 12625 14094 14602 14962 14972 15016
│  2666 3305 4681 8359 9701 9970 10838 11432 12869 13053 13873 14664 14703 14928 14998
│  3164 5920 5949 9228 10188 11757 12119 12878 13410 13951 14398 14652 14910 14967 15103
│  7840 9295 9875 11112 12316 12463 12771 13094 13197 13712 14085 14444 14707 14947 14987
│  1110 1223 3530 6281 10867 13008 14412 14528 14628 14753 14901 14938 15063 15087 15112
│  21 791 3863 5611 8101 10837 12988 13585 13731 14228 14435 14843 14910 15052 15082
│  40 1358 6434 9368 9892 10005 11561 11996 12506 13093 13167 14607 14674 14844 15030
│  803 1072 4593 6553 8291 8954 10035 11469 13719 14077 14173 14771 14812 14888 14992
│  6 5334 7322 7499 9560 10116 11560 11795 11874 11994 13936 14284 14376 14671 14863
│  41 5509 7768 9585 9698 10441 11621 12907 13092 13535 13832 14759 14887 14903 14972
│  4836 6794 8298 8883 10019 11625 12322 12563 13084 14192 14431 14526 14611 14883 15044
│  39 2210 7759 8572 8654 13258 13651 14070 14115 14279 14418 14566 14718 14811 15004
│  19 3975 4451 5642 6685 7975 8633 9640 9811 10753 10890 11243 11269 12598 14952
│  6363 6545 9439 9791 9818 13695 14229 14556 14711 14730 14744 14758 14844 14962 15032
│  6068 6472 6852 7431
│  3260 8709 11880 14644
│  8072 10635 12785 14902
│  936 12069 14934 14957
│  31 3503 7561 14443
│  4377 13028 14483 14513
│  397 6963 12232
│  8743 10726 14721
│  2800 3819 12560
│  11057 13202 15084
│  2256 4829 13796
│  2759 3104 14683
│  139 10014 12174
│  3531 9304 14860
│  3890 5170 13556
│  10401 13606 14910
│  4070 4564 7583
│  13749 14399 15019
│  2025 13882 15031
│  10616 11730 14148
│  2890 6342 12520
│  2071 6431 14496
│  8209 9125 13522
│  6008 7161 12442
│  14655 14792 15037
│  9054 14297 15119
│  5028 6219 12074
```

# FIG. 84

```
4932 6117 12187
12826 13557 14731
29 3332 10904
3244 5024 14841
1049 2209 13864
5834 7363 9300
8811 13949 15067
2676 14611 14917
4002 8661 14258
2371 3303 13028
3752 8981 15017
4942 10910 14170
3468 7594 8043
36 10685 12755
9662 11320 15033
9492 9545 15037
2896 12060 14451
702 9889 14014
645 2309 8254
4 10526 14294
24 6849 9207
4757 8294 14632
4831 14801 15043
10 6249 12881
4410 14983 15118
2286 7820 11208
7426 14880 14989
1509 10463 12060
1178 5443 8507
8631 9398 13789
6338 14601 15113
7697 10138 15054
3320 4956 8415
3367 13345 14874
13 2297 12215
610 10921 13983
7774 9106 13675
14 6002 6695
10257 13816 15090
12630 13922 14694
11114 14476 15105
32 9315 14962
5 3297 5106
3295 5972 10033
2417 14325 14447
2402 13380 13428
18 3172 14813
25 2268 9077
8145 8832 9014
2603 12606 12669
28 6315 14074
2569 3887 13526
2849 4358 15087
```

# FIG. 85

```
4385  7371  15088
6751  9658  13980
2701  4780  14869
625  3867  4178
11687  13958  14425
5036  12280  14985
3  9966  15042
16  14222  14721
1847  14627  14856
3933  4622  7832
29  4886  14278
1436  4839  7869
1504  11063  14943
8386  11749  15046
9371  10290  13903
9762  10901  15068
4162  8497  9405
7  22  8605
1547  9194  15102
6997  12409  14946
2680  7168  15066
3835  11767  13355
68  11375  13564
2404  11541  14983
5828  11258  14013
50  611  14485
8228  13664  14202
2397  7302  14977
9954  13847  14514
1733  13749  15058
173  13024  14763
12  7767  15052
4429  12945  14972
9425  15079  15096
```

# FIG. 86

```
┌─N=64800, rate=24/30────────────────────────────────────────────────────────────
   1504 2103 2621 2840 3869 4594 5246 6314 7327 7364 10425 11934 12898 12954
   27 1903 3923 4513 7812 8098 8428 9789 10519 11345 12032 12157 12573 12930
   17 191 660 2451 2475 2976 3398 3616 5769 6724 8641 10046 11552 12842
   13 1366 4993 6468 7689 8563 9131 10012 10914 11574 11837 12203 12715 12946
   432 872 2603 3286 3306 3385 4137 5563 7540 9339 9948 12315 12656 12929
   1113 1394 4104 4186 7240 8827 11522 11833 12359 12363 12629 12821 12904 12946
   14 441 1432 1677 2432 8981 11478 11507 12599 12783 12793 12912 12922 12943
   1579 1806 7971 8586 9845 10357 11600 12007 12020 12339 12576 12817 12830 12904
   20 546 3672 5538 6944 8052 8781 9743 12269 12393 12418 12549 12555 12718
   1 3540 4397 5011 6626 8617 9587 10360 10602 11402 11983 12068 12495 12838
   30 1572 4908 7421 8041 8910 8963 11005 11930 12240 12340 12467 12892 12933
   33 2060 3907 4215 5545 8306 8655 8743 8806 9315 9364 10685 11954 12959
   1338 2596 4876 5207 9555 10421 10929 11648 11739 12375 12416 12643 12742 12754
   9469 10544 10932 11250 11426 11582 11846 12139 12202 12210 12356 12378 12873 12929
   2681 3337 3616 6113 7078 8167 8624 9697 10908 11781 11855 12095 12475 12659
   28 4086 5432 6555 6848 7368 8794 11483 11572 12414 12816 12894 12936 12957
   5 5044 5572 9023 9192 9589 9979 10009 10855 10991 11715 12314 12610 12945
   17 272 602 5681 6530 9572 9886 11061 11495 12238 12265 12483 12885 12955
   22 2245 4282 4469 5007 6650 6733 10151 10401 11571 12004 12261 12805 12844
   23 3270 4468 8621 9662 11240 11934 12091 12444 12691 12717 12858 12888 12917
   740 1519 4923 6191 7878 8350 9293 10779 11020 11287 11630 12792 12862 12920
   12 28 3584 6072 7079 8075 10477 11130 11383 11780 12341 12667 12818 12927
   14 118 5283 5382 8301 9097 9413 9664 10437 10701 11124 12685 12730 12734
   32 1426 3078 4325 5353 7780 9042 9928 10077 10377 10679 11191 11750 12611
   1 669 3831 3980 5381 5412 6552 8453 9435 10243 11546 11821 11987 12807
   232 483 919 1232 2156 2396 2990 3774 8539 8704 8819 10810 11868 12634
   2381 7309 9334
   348 6494 12623
   4872 6257 11090
   7 11970 11985
   6615 12788 12855
   1173 5269 12647
   1944 7738 8116
   17 4828 9175
   2329 6034 12642
   1254 2366 5013
   2984 5078 5664
   7423 10265 11528
   1656 8526 8716
   22 287 2837
   18 100 3079
   299 3171 12169
   33 5920 11144
   1286 3650 9309
   2283 8809 12588
   3199 8242 9081
   2507 6846 8113
   5211 8722 12689
   1064 2592 8659
   6136 6925 12958
   1256 12789 12932
```

# FIG. 87

```
4274 8045 8788
1824 3209 6926
11 8899 12669
6249 6338 8730
641 9679 12831
3459 9876 11185
3226 6148 8173
9078 12126 12771
10907 11278 12731
3392 4020 12838
2814 11588 12909
6063 9214 11519
6064 6827 12683
1610 2452 6582
903 6289 8074
4592 8138 12952
2587 6271 9945
2733 11844 11893
581 4601 10020
14 5597 6049
343 3582 5931
5263 6521 12846
1394 2457 5251
11 4627 12747
2650 10366 12390
6285 11893 12062
10143 12892 12956
8448 11917 12330
4209 11693 12356
1529 2360 9086
5389 8148 10224
64 4876 12862
9483 12659 12887
3587 6767 12478
3122 5245 9044
3267 10118 11466
1347 3857 6705
9384 9576 11971
1366 8708 10758
412 4249 12863
1676 10488 11850
17 1605 2455
14 111 6045
11368 12919 12953
10588 11530 12937
4549 5143 12218
3088 4185 11674
23 2554 7823
6615 9291 9863
2229 3629 10855
3818 5509 12764
2740 11525 12914
8297 8611 12948
```

# FIG. 88

```
3606 11104 12920
5097 10412 12759
6502 7266 12072
5425 5490 10728
22 73 8462
32 12439 12657
8483 9540 10430
7275 7377 7420
5748 9726 12356
5672 6150 9156
28 3527 5857
520 7099 11335
405 6173 12865
5847 12843 12934
4289 7679 10386
2950 8021 12938
8844 11214 12955
2130 10760 12665
734 4790 12940
8 6991 12772
19 8205 11289
12 1440 9077
8670 8837 12951
3531 9166 12937
15 8901 8929
838 10114 11740
2648 9959 10934
323 7499 12877
5505 5659 11395
6627 12709 12933
364 1976 12888
8213 9124 12793
9588 10088 11108
299 890 11634
7368 7598 11602
28 4669 12585
15 27 12474
1426 3614 4205
30 2087 11147
6226 6259 12941
```

## FIG. 89

N=64800, rate=25/30

```
1860 2354 3967 4292 4488 5243 5373 5766 8378 9111 10468 10505 10774
24 2266 2380 3282 4255 4779 8729 9140 9566 10102 10661 10711 10797
605 650 1108 1669 2251 3133 5847 6197 6902 7545 10521 10600 10773
1016 1428 1612 2335 3102 3810 4926 5953 9964 10246 10569 10734 10784
3195 6308 8029 9030 9397 9461 9833 10239 10499 10675 10736 10757 10773
2 27 3641 4566 7332 9318 9323 9916 10365 10438 10561 10581 10750
2405 2458 4820 6232 6254 6347 7139 7474 8623 8779 8798 10747 10794
3164 4736 6474 7162 7420 7517 7835 8238 8412 8489 9006 10113 10440
20 2372 5561 5649 6907 8393 8505 9181 9567 9595 10388 10483 10714
1071 2899 5135 5780 6616 7111 7773 8582 9015 9912 10139 10387 10768
292 2833 5490 6011 6136 6713 7517 9096 10128 10328 10407 10525 10736
1044 3711 4421 5140 5207 8118 8749 8884 9205 10359 10372 10746 10784
3241 5696 6440 7240 7419 8613 8878 9593 9959 9997 10401 10404 10754
3133 4647 5912 6065 6694 7208 7346 8227 9465 9739 10452 10516 10770
2254 6444 7449 8095 8120 8710 9030 9162 9643 9968 10101 10571 10678
918 1445 2217 4262 4623 5401 5749 7446 7907 9539 10125 10514 10726
6 1341 1788 3105 4359 5263 5470 7552 8249 8644 10609 10674 10733
1994 3000 3151 3173 7742 8335 8438 8741 9232 9296 9817 10023 10257
467 1674 3016 3950 4055 5399 6688 7113 7273 8658 8702 9642 10545
2007 2541 3125 7380 7550 8122 8501 8665 9882 10403 10519 10594 10696
334 587 709 1540 2023 2876 6216 8768 9328 9481 10424 10507 10779
2165 4185 4306 5019 6961 7386 8447 9082 9837 10091 10461 10559 10570
7 903 2948 6312 6654 7738 7980 8312 9104 9743 10070 10278 10406
3047 3154 4160 4378 5461 8711 8809 9040 9173 9252 9537 9995 10735
2018 2355 3828 3854 6201 6696 8313 8459 8550 8833 9586 10202 10224
1402 1908 4286 4660 6029 6115 6737 7538 9495 9517 10055 10509 10644
3442 3589 3868 5051 5322 5580 8725 9046 9170 10041 10613 10681 10689
2733 7826 10622
3597 4753 7086
1394 7297 10264
2848 7502 10304
1649 2405 10783
647 2911 9069
2572 4006 7508
1361 8887 10103
3681 4023 9090
1496 4962 6325
2016 5120 9747
3954 5260 8568
3364 8719 10035
4208 4806 9973
29 3361 3490
1835 2317 10436
7312 8177 9041
7728 8097 10761
2109 7902 9685
5424 8943 9436
4369 7643 9152
2240 10140 10528
3435 6124 10604
8962 9357 10040
```

# FIG. 90

```
26 1931 8629
8275 10455 10643
8 24 4952
3995 6456 10633
28 10300 10337
4894 9286 9429
5587 6721 9120
1859 9198 9762
6374 6453 7011
1319 4530 5442
1507 10711 10798
2115 3445 3641
6668 9139 10163
4038 8117 10295
1479 3403 8247
2522 2934 3562
1526 5073 9650
2136 9820 10636
4214 8464 9891
8018 10330 10610
8984 10209 10647
3414 7272 8599
4883 9077 9525
22 8173 8425
2941 6536 10126
29 6540 7361
5 3787 10468
4264 4818 6906
3903 7041 10412
6078 7661 10619
6922 9723 9890
5112 5416 6253
5925 9961 10447
9 10311 10598
8790 8814 10793
4768 5466 10664
10 10675 10766
6814 8705 10737
17 769 6692
1503 10696 10742
1285 4632 8976
4279 4973 7907
4650 4775 10785
28 729 10331
1914 5240 10723
3569 4921 9561
4 9442 10796
494 2328 9507
1717 8768 10750
9540 10599 10774
11 10075 10644
10246 10607 10753
5510 7088 9053
```

# FIG. 91

```
1347 3584 5523
7872 10596 10736
628 10592 10695
5632 5688 10627
2375 10009 10561
4169 4630 8871
2896 10038 10521
89 9695 9799
20 7563 9069
4534 10321 10697
8212 9868 10716
7485 9312 10327
234 536 6293
5515 7350 9251
283 3182 7167
2444 5378 6130
6183 8315 10726
43 4871 8347
2427 10219 10728
10 21 9448
1067 8312 8420
4793 9522 10105
4688 10536 10724
3825 7496 10709
682 8544 10449
2794 7110 10741
9279 10741 10767
2897 5442 8771
33 7957 10460
5 10393 10792
6225 10224 10798
23 9014 10786
7836 8339 8642
3476 5455 9788
1939 10251 10384
4008 7890 10450
926 2090 3804
1038 2497 10701
22 6220 8405
5153 5944 10367
7260 7726 9529
3039 8397 10665
7262 9644 10083
5531 6248 10795
7926 8248 8413
4649 8971 10182
```

# FIG. 92

```
┌─ N=64800, rate=26/30 ─────────────────────────────────────────────┐
│  142 2307 2598 2650 4028 4434 5781 5881 6016 6323 6681 6698 8125   │
│  2932 4928 5248 5256 5983 6773 6828 7789 8426 8494 8534 8539 8583  │
│  899 3295 3833 5399 6820 7400 7753 7890 8109 8451 8529 8564 8602   │
│  21 3060 4720 5429 5636 5927 6966 8110 8170 8247 8355 8365 8616    │
│  20 1745 2838 3799 4380 4418 4646 5059 7343 8161 8302 8456 8631    │
│  9 6274 6725 6792 7195 7333 8027 8186 8209 8273 8442 8548 8632     │
│  494 1365 2405 3799 5188 5291 7644 7926 8139 8458 8504 8594 8625   │
│  192 574 1179 4387 4695 5089 5831 7673 7789 8298 8301 8612 8632    │
│  11 20 1406 6111 6176 6256 6708 6834 7828 8232 8457 8495 8602      │
│  6 2654 3554 4483 4966 5866 6795 8069 8249 8301 8497 8509 8623     │
│  21 1144 2355 3124 6773 6805 6887 7742 7994 8358 8374 8580 8611    │
│  335 4473 4883 5528 6096 7543 7586 7921 8197 8319 8394 8489 8636   │
│  2919 4331 4419 4735 6366 6393 6844 7193 8165 8205 8544 8586 8617  │
│  12 19 742 930 3009 4330 6213 6224 7292 7430 7792 7922 8137        │
│  710 1439 1588 2434 3516 5239 6248 6827 8230 8448 8515 8581 8619   │
│  200 1075 1868 5581 7349 7642 7698 8037 8201 8210 8320 8391 8526   │
│  3 2501 4252 5256 5292 5567 6136 6321 6430 6486 7571 8521 8636     │
│  3062 4599 5885 6529 6616 7314 7319 7567 8024 8153 8302 8372 8598  │
│  105 381 1574 4351 5452 5603 5943 7467 7788 7933 8362 8513 8587    │
│  787 1857 3386 3659 6550 7131 7965 8015 8040 8312 8484 8525 8537   │
│  15 1118 4226 5197 5575 5761 6762 7038 8260 8338 8444 8512 8568    │
│  36 5216 5368 5616 6029 6591 8038 8067 8299 8351 8565 8578 8585    │
│  1 23 4300 4530 5426 5532 5817 6967 7124 7979 8022 8270 8437       │
│  629 2133 4828 5475 5875 5890 7194 8042 8345 8385 8518 8598 8612   │
│  11 1065 3782 4237 4993 7104 7863 7904 8104 8228 8321 8383 8565    │
│  2131 2274 3168 3215 3220 5597 6347 7812 8238 8354 8527 8557 8614  │
│  5600 6591 7491 7696                                               │
│  1766 8281 8626                                                    │
│  1725 2280 5120                                                    │
│  1650 3445 7652                                                    │
│  4312 6911 8626                                                    │
│  15 1013 5892                                                      │
│  2263 2546 2979                                                    │
│  1545 5873 7406                                                    │
│  67 726 3697                                                       │
│  2860 6443 8542                                                    │
│  17 911 2820                                                       │
│  1561 4580 6052                                                    │
│  79 5269 7134                                                      │
│  22 2410 2424                                                      │
│  3501 5642 8627                                                    │
│  808 6950 8571                                                     │
│  4099 6389 7482                                                    │
│  4023 5000 7833                                                    │
│  5476 5765 7917                                                    │
│  1008 3194 7207                                                    │
│  20 495 5411                                                       │
│  1703 8388 8635                                                    │
│  6 4395 4921                                                       │
│  200 2053 8206                                                     │
│  1089 5126 5562                                                    │
```

## FIG. 93

```
10 4193 7720
1967 2151 4608
22 738 3513
3385 5066 8152
440 1118 8537
3429 6058 7716
5213 7519 8382
5564 8365 8620
43 3219 8603
4 5409 5815
5 6376 7654
4091 5724 5953
5348 6754 8613
1634 6398 6632
72 2058 8605
3497 5811 7579
3846 6743 8559
15 5933 8629
2133 5859 7068
4151 4617 8566
2960 8270 8410
2059 3617 8210
544 1441 6895
4043 7482 8592
294 2180 8524
3058 8227 8373
364 5756 8617
5383 8555 8619
1704 2480 4181
7338 7929 7990
2615 3905 7981
4298 4548 8296
8262 8319 8630
892 1893 8028
5694 7237 8595
1487 5012 5810
4335 8593 8624
3509 4531 5273
10 22 830
4161 5208 6280
275 7063 8634
4 2725 3113
2279 7403 8174
1637 3328 3930
2810 4939 5624
3 1234 7687
2799 7740 8616
22 7701 8636
4302 7857 7993
7477 7794 8592
9 6111 8591
5 8606 8628
347 3497 4033
```

## FIG. 94

```
1747 2613 8636
1827 5600 7042
580 1822 6842
232 7134 7783
4629 5000 7231
951 2806 4947
571 3474 8577
2437 2496 7945
23 5873 8162
12 1168 7686
8315 8540 8596
1766 2506 4733
929 1516 3338
21 1216 6555
782 1452 8617
8 6083 6087
667 3240 4583
4030 4661 5790
559 7122 8553
3202 4388 4909
2533 3673 8594
1991 3954 6206
6835 7900 7980
189 5722 8573
2680 4928 4998
243 2579 7735
4281 8132 8566
7656 7671 8609
1116 2291 4166
21 388 8021
6 1123 8369
311 4918 8511
0 3248 6290
13 6762 7172
4209 5632 7563
49 127 8074
581 1735 4075
0 2235 5470
2178 5820 6179
16 3575 6054
1095 4564 6458
9 1581 5953
2537 6469 8552
14 3874 4844
0 3269 3551
2114 7372 7926
1875 2388 4057
3232 4042 6663
9 401 583
13 4100 6584
2299 4190 4410
21 3670 4979
```

# FIG. 95

```
N=64800, rate=27/30
   658  706  898 1149 2577 2622 2772 3266 3329 5243 6079 6271
   289  784 1682 3584 3995 4821 4856 5063 5974 6168 6437 6453
   658 1426 2043 2065 2986 4118 4284 5394 5444 5477 5727 6018
   641  928 1225 2841 4052 4840 4992 5268 5533 6249 6461 6475
  2312 2917 3713 3849 4059 4241 4610 5440 5727 6101 6397 6444
  1165 1592 1891 2154 3981 4817 5181 5748 5788 6012 6266 6350
    13 2758 3069 4233 4697 5100 5279 5677 5919 5969 6280 6422
   818 1500 2125 2340 3774 4707 4901 5170 5744 6008 6316 6353
   857 3054 3409 3496 3704 4868 5326 6211 6292 6356 6367 6381
     0    7   12 1709 2166 3418 3723 4887 5770 6043 6069 6431
  2481 3379 4650 4900 4919 5060 5410 5425 6056 6173 6283 6386
    15  814  854 1871 2934 3387 3915 5180 5303 5442 5581 5665
   146 1882 3076 4458 4848 5252 5602 5778 5821 6213 6251 6401
     2  947 1419 1566 3437 3646 4615 4634 4735 5819 5943 6280
  1231 2309 2920 4158 4185 4298 4711 5082 5757 5762 6204 6209
   257  297  337 2783 3230 4134 4480 4749 5295 5689 5921 6202
  1436 2151 2629 3217 3930 4078 5386 5799 5906 6146 6226 6366
   133  530 2448 4745 5000 5020 5224 5273 6211 6266 6431 6453
    13 2644 3895 3898 4485 4722 5142 5462 5951 6031 6084 6351
     6 3000 3873 3995 4680 5158 5504 5692 5755 6255 6338 6359
   166  465 1658 2549 2941 4244 5071 5149 5452 5874 5939 6038
  2309 2937 4282 4628 5113 5454 5731 5825 6021 6171 6402 6472
     3 1077 2116 2426 2830 4853 5066 5571 5850 5916 6389 6421
   817 1608 2229 2925 3281 4393 5042 5058 5377 5464 5588 6448
  1848 3871 4381 4776 5366 5578 5648 6143 6389 6434 6465 6473
  1263 1616 3150 3497 3759 4078 5530 5665 5694 5913 6397 6420
    11  813 2185 2795 3349 4652 4678 5078 5504 6011 6286 6387
  3060 3161 4584 4996 5143 5542 5697 5937 6141 6155 6342 6445
  1638 2333 2632 3450 3505 3911 4399 4454 5499 5860 6044 6360
   650 1744 4517
  5772 6071 6471
  3582 3622 5776
  6153 6380 6446
  3977 5932 6447
  2071 4597 4891
    11 1428 3776
  1111 3874 5048
  1410 2144 4445
  4681 5481 6462
  4044 5037 5497
  2716 2891 6411
  3299 4384 6224
  1843 6087 6400
  4664 5009 5856
  1548 4383 5055
  3172 4190 6373
  5899 6443 6470
  2572 3647 6240
  1295 2158 6466
  5604 6269 6368
     3 5551 6454
```

## FIG. 96

```
3325  5797  6261
666  1397  5538
3069  4274  6410
4042  5992  6437
743  3075  3447
1344  2725  6386
283  2808  6303
2  4627  4632
26  1565  4000
4012  4946  6472
1629  6158  6467
6300  6351  6376
2969  4344  4440
2317  3115  4832
2099  5263  6285
2409  5868  5997
3752  4200  6350
3125  5841  6142
1  2249  6328
16  2525  6379
3198  5269  5960
4  1705  2069
990  4948  5520
1664  3836  4521
1765  4110  6454
9  1373  6387
1969  2405  6368
623  1428  3946
3111  6380  6436
1861  5611  5934
9  2444  3081
5  5508  6317
3184  4988  5995
1060  4803  6400
5021  5826  6289
1608  4754  5648
4702  6391  6421
3899  4811  6128
927  2286  5313
4123  6181  6453
2893  4150  5261
605  4332  5094
17  3518  6358
2858  6126  6478
15  1316  6465
2  2032  2983
5249  6340  6427
5  6003  6200
4478  6315  6420
5158  6390  6447
2598  3229  5399
3747  6424  6446
1412  2453  6332
```

## FIG. 97

```
5256 5715 6455
2137 3421 4368
15 3880 5245
17 3156 5638
3227 3798 6230
2094 3129 6458
1412 5573 5932
175 1182 6304
3555 6407 6463
583 1654 6339
14 6261 6449
3553 5383 5679
2092 2744 4153
0 4466 6472
11 3840 4354
17 5457 6222
1467 6083 6220
3449 3858 6337
3782 5318 6426
417 5038 5790
3571 5638 5873
6117 6241 6476
1898 5680 6219
3235 3817 6429
2095 4194 6224
2 4092 6448
5 6330 6383
285 5075 6334
10 505 2867
1183 5956 6466
839 4716 6471
984 3254 6432
1501 4790 6465
8 1457 1707
1660 1969 6438
4349 6182 6305
1423 3848 5490
1651 2969 6345
344 4164 6298
2397 6027 6274
2233 2778 6161
13 1778 2977
9 1916 3377
0 3 6190
395 4893 6394
3512 4098 6400
3490 6281 6473
12 1359 6465
4202 5179 6412
3007 3542 4271
2400 3350 6351
7 5490 5716
4695 5231 6266
```

FIG. 98

777 6292 6402
919 4851 6367
6 644 3893
5386 6190 6434
17 169 4896

# FIG. 99

```
N=64800, rate=28/30
  85  314 1602 1728 1929 2295 2729 2924 3779 4054 4276
 918 1378 1838 1903 2399 2524 2937 3615 3740 4140 4213
1361 1430 2639 2648 2910 3418 3511 3543 4177 4209 4248
 472 1143 1318 1545 1830 2228 2249 2256 3626 3839 3991
 226 1401 2154 2318 2851 3317 3468 3944 3983 4047 4093
 490 1145 1247 1851 2671 2776 3152 3229 3345 3758 3786
 522 1393 1473 2196 2707 3052 3398 3814 3827 4148 4301
 417 1982 2176 2336 2459 2806 3005 3771 3870 4080 4243
 112 1040 1596 1621 1685 2118 2571 3359 3945 4034 4171
 646 1705 2181 2439 2808 2851 2987 3044 3494 4049 4312
   6   11  115  245  663 1773 2624 3444 3601 3952 4246
  11  541 1020 1326 2259 2347 2750 2861 3328 3428 4126
 515  941 1233 1804 2295 2528 3265 3826 4002 4022 4224
  46  484  679 1949 2342 2929 3555 3860 3918 4068 4113
1832 2023 2279 2376 2965 3278 3318 3549 3640 3843 3910
 241  943 1222 1583 1637 2745 3338 4080 4086 4203 4300
  11 1419 1841 2398 2920 3409 3703 3768 3878 4052 4254
 878 2049 2123 2431 2657 2704 3135 3342 3728 4141 4162
  16  837 1267 1410 2100 3026 3099 3107 4042 4129 4157
 133  646 1367 1394 2118 2311 2676 2956 3195 3536 3657
 698 1444 2129 2432 2494 2793 2947 3852 3985 4254 4319
  11 1076 1618 1995 2332 2743 2934 3009 3565 4169 4188
  14   20  808 2629 2681 3090 3491 3835 4017 4068 4083
 433 1386 2416 2570 2950 3611 3869 3969 4248 4251 4316
 384 1292 1534 2610 2617 3559 3638 3964 4131 4293 4313
 271  564 1719 2288 2597 2674 3429 3455 3793 4074 4286
 133  190  815  955 1485 2000 2860 3000 3734 4013 4287
 559  771 1762 2537 2764 2816 3186 3806 3933 4224 4271
  11  733 1198 1735 1856 2668 2754 3216 4070 4113 4311
   4  306 1832 2047 2058 2724 3387 3793 3833 4005 4319
 506 1456 2339 3069 3343 3442 3889 3939 4013 4212 4278
2038 3980 4313
  64 2373 4080
 800 1535 4166
1030 3759 4002
1687 3269 4225
1219 2632 3878
 719 2916 4277
1261 1930 3459
 777 1568 1914
   4  397 3290
  10 3451 4115
3629 3885 4155
2652 3668 4026
 135 3172 4319
1426 1970 3657
 199 1268 2064
 570  845 2761
  41 1067 3498
1588 2482 2750
1615 2013 2715
```

## FIG. 100

```
121 1812 2588
10 992 1082
1929 4225 4279
6 1967 3760
593 1812 4107
891 2146 4158
924 2282 3585
592 2971 4235
260 3493 4313
2423 3180 3449
2042 3118 3625
2877 3064 3882
7 2139 4316
4 7 2954
1398 3947 4272
3675 4253 4318
1561 1977 2432
2531 4192 4209
1032 1102 4268
75 1718 3438
925 1073 4171
2124 2762 4148
4 3455 4069
3 1279 3382
1277 1746 3969
2727 3127 4230
584 1108 3454
9 2057 3061
1608 4103 4310
2673 3164 3713
1379 4072 4318
950 3447 4146
2509 4255 4296
819 1352 3371
3562 3865 4041
940 1217 3607
114 2544 4310
4 2178 4213
2035 4246 4251
272 1236 2733
953 2762 4115
1853 3496 4309
1119 3740 4318
2051 4058 4317
0 3162 4207
2389 4034 4111
4 3395 4301
3716 4089 4198
6 4272 4311
1 4 1854
4238 4299 4305
7 10 3737
11 3764 4296
```

## FIG. 101

```
297 1912 4117
1087 1796 4056
2153 3882 4030
962 4043 4203
243 3841 4308
2183 3886 4216
943 1974 2897
278 3224 3933
3 4196 4245
3409 4301 4315
2 2176 3214
462 3203 4008
478 2178 4202
3593 3825 4216
115 2796 4225
3827 4196 4251
1375 4301 4306
296 407 2055
688 3913 4281
3446 3840 4314
1073 3444 4146
1556 2761 3391
2 3543 4264
1378 3347 4305
847 1952 2745
1 1743 4042
2087 3048 4254
1010 4073 4132
2610 4129 4152
4106 4120 4313
7 4282 4304
3885 4227 4319
1235 4105 4195
1700 2332 4224
9 3750 4282
1539 4013 4310
3734 3834 4011
1397 2758 3645
7 1000 2984
11 3433 4068
1139 1800 3352
8 546 2561
1 4209 4239
2366 4063 4282
279 2524 2533
657 1913 4006
2322 2623 2960
758 803 2304
9 13 4241
3887 4299 4318
2612 3830 4230
1300 1596 2155
3622 3671 4230
```

**FIG. 102**

```
2491  3722  3977
 735  3812  4201
3204  3796  4317
2727  4292  4305
1062  2676  4255
2777  3131  4286
2518  3352  3937
4225  4255  4317
3644  3822  4311
1853  3754  4094
 599  2608  3276
```

# FIG. 103

```
N=64800, rate=29/30
212 499 911 940 1392
316 563 1527 2006 2077
2 1906 2043 2112 2123
537 901 1582 1812 1955
5 978 1280 1933 2145
5 2035 2044 2108 2121
5 939 1874 1974
4 1069 1758
694 2096 2106
1129 1511 1659
1564 2089 2159
2 1605 2004
474 1341 2003
103 2128 2150
1656 1993 2153
1881 2122 2138
1088 1968 2141
1 298 2073
1042 1724 2137
1253 1758 2145
1209 1566 2123
1466 2116 2155
43 2006 2049
592 1806 1865
3 143 2149
1158 1448 2002
1422 2152 2157
485 2119 2150
371 1831 2086
204 2042 2151
174 544 974
1469 1795 1995
13 708 1683
5 1144 2030
486 1309 1576
165 2030 2147
504 2073 2126
263 565 1798
239 861 1861
862 1610 1716
1346 1971 2128
5 804 1399
2139 2144 2155
4 2136 2159
1485 2059 2158
50 1091 1332
373 1730 2092
59 1086 1401
1166 1781 2065
```

# FIG. 104

```
213 2080 2154
492 1905 2110
1 1517 2126
722 1427 2146
885 991 1842
3 278 1806
967 1354 1907
1697 2047 2156
684 1924 2151
2077 2122 2157
978 2054 2135
435 2034 2150
136 1997 2125
1504 1850 2153
1404 1989 2119
109 1001 2152
780 1473 2150
198 1723 2062
927 2087 2138
1 666 2018
1293 1960 2141
1648 2033 2144
681 1578 1999
1342 2022 2157
949 1907 1994
138 1261 2135
3 608 982
1211 1501 2150
201 228 1186
1295 2089 2132
267 556 2142
801 2052 2122
1382 2135 2155
572 1503 1704
346 1183 2129
1926 2090 2149
1337 2133 2140
5 1806 2125
1383 1628 2068
1193 1626 2138
1999 2115 2146
217 274 2021
3 816 2024
1380 2138 2157
607 1385 2110
184 1195 2063
0 1767 2108
0 2081 2097
1135 2036 2128
1748 2001 2125
```

# FIG.105

```
797 1552 1926
1046 1890 2128
291 1859 2131
1075 1214 1762
60 549 1943
581 1197 1232
1009 2026 2136
884 2002 2117
1 576 1449
519 1968 2114
5 1489 1630
1926 2037 2158
2 1249 2159
0 811 2114
2055 2152 2159
802 1911 2120
204 1033 2033
1840 2012 2037
1746 2111 2155
1098 1835 2157
2 1492 1831
353 1537 1830
375 1264 2036
2 1638 2035
1096 1971 2021
950 1809 1884
253 467 1600
5 379 1833
4 1698 1970
37 1637 2136
1174 1460 2157
612 1827 2134
1783 1802 1949
2029 2118 2151
1984 2030 2141
2 347 462
862 1693 2121
2 895 1401
4 1901 2100
1183 1674 2069
1575 1940 2158
5 1904 2097
1044 2029 2092
1441 1943 2150
0 3 1300
2 516 1735
503 1342 2019
1421 1914 2131
28 986 1467
1270 1851 1988
```

# FIG. 106

```
481  1265  2016
530  546  909
653  1909  2158
1805  2002  2149
2  1359  1518
1640  2104  2129
1656  2109  2155
1307  1762  2114
565  1647  2118
1690  2081  2156
1  300  1995
5  1681  2151
1602  2050  2156
1  1960  2153
2061  2070  2138
1581  1673  2142
1048  1142  2101
1867  1991  2055
856  1640  1878
251  561  966
343  1816  2114
3  966  2045
1885  1922  2158
57  556  2059
732  1724  2147
```

## FIG. 107

EP 2 955 852 A1

# FIG. 108

v1 PIECES      v2 PIECES      v3 PIECES

VARIABLE NODE

BRANCH

FIRST INTERLEAVER      SECOND INTERLEAVER

BRANCH

CHECK NODE

c1 PIECES      c2 PIECES      c3 PIECES

EP 2 955 852 A1

# FIG. 109

| Rate | PERFORMANCE THRESHOLD (Es/N0) | MINIMUM CYCLE LENGTH |
|------|---------------------------------|----------------------|
| 2/30 | -9.523519 | 14 |
| 3/30 | -7.758979 | 14 |
| 4/30 | -6.428797 | 6 |
| 5/30 | -5.490092 | 10 |
| 6/30 | -4.589849 | 10 |
| 7/30 | -3.760281 | 12 |
| 8/30 | -3.191565 | 8 |
| 9/30 | -2.550214 | 10 |
| 10/30 | -1.878597 | 8 |
| 11/30 | -1.378961 | 8 |
| 12/30 | -0.947792 | 6 |
| 13/30 | -0.494134 | 6 |
| 14/30 | -0.045119 | 8 |
| 15/30 | 0.428446 | 8 |
| 16/30 | 0.829080 | 8 |
| 17/30 | 1.248503 | 8 |
| 18/30 | 1.658523 | 8 |
| 19/30 | 2.078240 | 8 |
| 20/30 | 2.489205 | 6 |
| 21/30 | 2.918982 | 6 |
| 22/30 | 3.351930 | 6 |
| 23/30 | 3.788323 | 6 |
| 24/30 | 4.252169 | 6 |
| 25/30 | 4.761537 | 6 |
| 26/30 | 5.301749 | 6 |
| 27/30 | 5.921125 | 6 |
| 28/30 | 6.675945 | 6 |
| 29/30 | 7.881048 | 6 |

## FIG. 110

## FIG. 111

| Rate | X | KX | Y1 | KY1 | Y2 | KY2 | M |
|---|---|---|---|---|---|---|---|
| 2/30 | 34 | 1440 | 4 | 2880 | 3 | 0 | 60480 |
| 3/30 | 20 | 2160 | 4 | 2160 | 3 | 2160 | 58320 |
| 4/30 | 35 | 2520 | 4 | 6120 | 3 | 0 | 56160 |
| 5/30 | 23 | 3600 | 4 | 3600 | 3 | 3600 | 54000 |
| 6/30 | 17 | 4680 | 4 | 1440 | 3 | 6840 | 51840 |
| 7/30 | 13 | 5760 | 4 | 0 | 3 | 9360 | 49680 |
| 8/30 | 19 | 5400 | 4 | 4680 | 3 | 7200 | 47520 |
| 9/30 | 15 | 6840 | 4 | 360 | 3 | 12240 | 45360 |
| 10/30 | 22 | 5760 | 4 | 0 | 3 | 15840 | 43200 |
| 11/30 | 34 | 3600 | 4 | 20160 | 3 | 0 | 41040 |
| 12/30 | 30 | 4320 | 4 | 12600 | 3 | 9000 | 38880 |
| 13/30 | 25 | 5400 | 4 | 6840 | 3 | 15840 | 36720 |
| 14/30 | 21 | 6840 | 4 | 0 | 3 | 23400 | 34560 |
| 15/30 | 23 | 5400 | 4 | 12240 | 3 | 14760 | 32400 |
| 16/30 | 19 | 6480 | 4 | 5400 | 3 | 22680 | 30240 |
| 17/30 | 18 | 7560 | 4 | 1080 | 3 | 28080 | 28080 |
| 18/30 | 19 | 6840 | 4 | 6840 | 3 | 25200 | 25920 |
| 19/30 | 17 | 7920 | 4 | 1800 | 3 | 31320 | 23760 |
| 20/30 | 16 | 8280 | 4 | 720 | 3 | 34200 | 21600 |
| 21/30 | 15 | 8640 | 4 | 0 | 3 | 36720 | 19440 |
| 22/30 | 15 | 8280 | 4 | 2520 | 3 | 36720 | 17280 |
| 23/30 | 15 | 8640 | 4 | 2160 | 3 | 38880 | 15120 |
| 24/30 | 14 | 9360 | 4 | 0 | 3 | 42480 | 12960 |
| 25/30 | 13 | 9720 | 4 | 0 | 3 | 44280 | 10800 |
| 26/30 | 13 | 9360 | 4 | 360 | 3 | 46440 | 8640 |
| 27/30 | 12 | 10440 | 4 | 0 | 3 | 47880 | 6480 |
| 28/30 | 11 | 11160 | 4 | 0 | 3 | 49320 | 4320 |
| 29/30 | 5 | 2160 | 4 | 360 | 3 | 60120 | 2160 |

FIG.112

LDPC+BCH, BPSKAWGN it=50

EP 2 955 852 A1

# FIG. 113

LDPC+BCH, BPSKAWGN it=50

Legend:
- r=11/30
- r=12/30
- r=13/30
- r=14/30
- r=15/30
- r=16/30
- r=17/30
- r=18/30
- r=19/30
- r=20/30

Y-axis: BER/FER

X-axis: $E_s/N_0$ [dB]

173

## FIG. 114

LDPC+BCH, BPSKAWGN it=50

Legend:
- $r=21/30$
- $r=22/30$
- $r=23/30$
- $r=24/30$
- $r=25/30$
- $r=26/30$
- $r=27/30$
- $r=28/30$
- $r=29/30$

Y-axis: BER/FER

X-axis: $E_s/N_0$ [dB]

EP 2 955 852 A1

## FIG. 115

**A**

| LDPC code | BCH Uncoded Block $K_{bch}$ | BCH coded block $K_{bch}$ LDPC Uncoded Block $K_{ldpc}$ | BCH t-error correction | LDPC Coded Block $n_{ldpc}$ |
|---|---|---|---|---|
| 1/4 | 16 008 | 16 200 | 12 | 64 800 |
| 1/3 | 21 408 | 21 600 | 12 | 64 800 |
| 2/5 | 25 728 | 25 920 | 12 | 64 800 |
| 1/2 | 32 208 | 32 400 | 12 | 64 800 |
| 3/5 | 38 688 | 38 880 | 12 | 64 800 |
| 2/3 | 43 040 | 43 200 | 10 | 64 800 |
| 3/4 | 48 408 | 48 600 | 12 | 64 800 |
| 4/5 | 51 648 | 51 840 | 12 | 64 800 |
| 5/6 | 53 840 | 54 000 | 10 | 64 800 |
| 8/9 | 57 472 | 57 600 | 8 | 64 800 |
| 9/10 | 58 192 | 58 320 | 8 | 64 800 |

**B**

| LDPC code rate | BCH CODE INFORMATION BIT NUMBER | BCH CODE BIT NUMBER (LDPC CODE INFORMATION BIT NUMBER) | BCH CORRECTION BIT NUMBER | LDPC CODE BIT NUMBER |
|---|---|---|---|---|
| 2/30 | 4128 | 4320 | 12 | 64800 |
| 3/30 | 6288 | 6480 | 12 | 64800 |
| 4/30 | 8448 | 8640 | 12 | 64800 |
| 5/30 | 10608 | 10800 | 12 | 64800 |
| 6/30 | 12768 | 12960 | 12 | 64800 |
| 7/30 | 14928 | 15120 | 12 | 64800 |
| 8/30 | 17088 | 17280 | 12 | 64800 |
| 9/30 | 19248 | 19440 | 12 | 64800 |
| 10/30 | 21408 | 21600 | 12 | 64800 |
| 11/30 | 23568 | 23760 | 12 | 64800 |
| 12/30 | 25728 | 25920 | 12 | 64800 |
| 13/30 | 27888 | 28080 | 12 | 64800 |
| 14/30 | 30048 | 30240 | 12 | 64800 |
| 15/30 | 32208 | 32400 | 12 | 64800 |
| 16/30 | 34368 | 34560 | 12 | 64800 |
| 17/30 | 36528 | 36720 | 12 | 64800 |
| 18/30 | 38688 | 38880 | 12 | 64800 |
| 19/30 | 40848 | 41040 | 12 | 64800 |
| 20/30 | 43040 | 43200 | 10 | 64800 |
| 21/30 | 45168 | 45360 | 12 | 64800 |
| 22/30 | 47328 | 47520 | 12 | 64800 |
| 23/30 | 49488 | 49680 | 12 | 64800 |
| 24/30 | 51648 | 51840 | 12 | 64800 |
| 25/30 | 53840 | 54000 | 10 | 64800 |
| 26/30 | 56032 | 56160 | 8 | 64800 |
| 27/30 | 58192 | 58320 | 8 | 64800 |
| 28/30 | 60352 | 60480 | 8 | 64800 |
| 29/30 | 62512 | 62640 | 8 | 64800 |

EP 2 955 852 A1

**FIG.116**

**FIG. 117**

| QAM DECODER | MULTIPLEXER (MUX) | COLUMN TWIST DEINTERLEAVER | LDPC DECODER | → TARGET DATA |

54, 55, 164, 165, 166

# FIG. 118

```
              ┌──────────┐
              │  START   │
              └──────────┘
                   │
                   ▼
         ┌─────────────────────┐
         │     DEMAPPING       │ S111
         └─────────────────────┘
                   │
                   ▼
┌─────────────────────────────────────────────────────────┐
│                  BIT INTERLEAVE                          │ S112
│ (REVERSE INTERCHANGE PROCESSING, COLUMN TWIST           │
│                  DEINTERLEAVE)                           │
└─────────────────────────────────────────────────────────┘
                   │
                   ▼
         ┌─────────────────────┐
         │   LDPC DECODING     │ S113
         └─────────────────────┘
                   │
                   ▼
              ┌──────────┐
              │   END    │
              └──────────┘
```

**FIG.119**

**FIG. 120**

## FIG.121

# FIG. 122

**FIG. 123**

# FIG.124

A

B

# FIG. 125

EP 2 955 852 A1

## FIG. 126

# FIG. 127

# FIG. 128

SIGNAL → ACQUIRING UNIT (1101) → TRANSMISSION PATH DECODING PROCESSING UNIT (1102) → INFORMATION SOURCE DECODING PROCESSING UNIT (1103) → OUTPUT UNIT (1111)

RECEPTION SYSTEM

EP 2 955 852 A1

## FIG. 129

SIGNAL → ACQUIRING UNIT (1101) → TRANSMISSION PATH DECODING PROCESSING UNIT (1102) ⇢ INFORMATION SOURCE DECODING PROCESSING UNIT (1103) ⇢ RECORDING UNIT (1121)

RECEPTION SYSTEM

EP 2 955 852 A1

# FIG. 130

## INTERNATIONAL SEARCH REPORT

| International application No. |
| --- |
| PCT/JP2014/051620 |

A. CLASSIFICATION OF SUBJECT MATTER
*H03M13/19(2006.01)i*

According to International Patent Classification (IPC) or to both national classification and IPC

B. FIELDS SEARCHED

Minimum documentation searched (classification system followed by classification symbols)
H03M13/19

Documentation searched other than minimum documentation to the extent that such documents are included in the fields searched
Jitsuyo Shinan Koho        1922–1996    Jitsuyo Shinan Toroku Koho   1996–2014
Kokai Jitsuyo Shinan Koho  1971–2014    Toroku Jitsuyo Shinan Koho   1994–2014

Electronic data base consulted during the international search (name of data base and, where practicable, search terms used)
IEEE Xplore, CiNii

C. DOCUMENTS CONSIDERED TO BE RELEVANT

| Category* | Citation of document, with indication, where appropriate, of the relevant passages | Relevant to claim No. |
| --- | --- | --- |
| A | JP 2005-136990 A (The Directv Group, Inc.), 26 May 2005 (26.05.2005), paragraphs [0024] to [0040] & US 2005/0091565 A1   & US 2007/0226578 A1 & EP 1528687 A1       & CA 2486044 A & KR 10-2005-0040770 A  & CN 1642063 A & HK 1078697 A | 1-54 |
| A | WO 2011/105287 A1 (Sony Corp.), 01 September 2011 (01.09.2011), paragraphs [0359] to [0399]; fig. 35 to 43 & JP 2011-176782 A | 1-54 |

[X] Further documents are listed in the continuation of Box C.      [ ] See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| 04 April, 2014 (04.04.14) | 15 April, 2014 (15.04.14) |

| Name and mailing address of the ISA/ Japanese Patent Office | Authorized officer |
| --- | --- |
| Facsimile No. | Telephone No. |

Form PCT/ISA/210 (second sheet) (July 2009)

| International application No. |
| --- |
| PCT/JP2014/051620 |

C (Continuation). DOCUMENTS CONSIDERED TO BE RELEVANT

| Category* | Citation of document, with indication, where appropriate, of the relevant passages | Relevant to claim No. |
| --- | --- | --- |
| A | WO 2009/069628 A1 (Sony Corp.), 04 June 2009 (04.06.2009), paragraphs [0498] to [0545]; fig. 41 to 86 & JP 2009-153109 A    & US 2009/0125780 A1 & EP 2056464 A2    & KR 10-2009-0045096 A & AU 2008330661 A    & CN 101874350 A & EA 201070630 A    & CO 6300822 A & TW 200937870 A    & DK 2056549 T & ES 2398851 T    & NZ 585421 A | 1-54 |
| A | JP 2012-147197 A (Panasonic Corp.), 02 August 2012 (02.08.2012), paragraphs [0014] to [0020], [0087] to [0093]; fig. 3, 4 & US 2012/0179947 A1    & WO 2012/096396 A1 | 1-54 |
| A | JP 2012-517138 A (Telefonaktiebolaget LM Ericsson (publ)), 26 July 2012 (26.07.2012), paragraphs [0057] to [0062], [0103] to [0106] & US 2010/0287453 A1    & EP 2392074 A & WO 2010/087776 A1 | 1-54 |
| A | Digital Video Broadcasting (DVB);Frame structure channel coding and modulation for a second generation digital terrestrial television broadcasting system (DVB-T2), ETSI EN 302 755, V1.3.1, 2012.04, pp.1,40-45,130-138 | 1-54 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4224777 B

**Non-patent literature cited in the description**

- **H. JIN ; A. KHANDEKAR ; R. J. MCELIECE.** Irregular Repeat-Accumulate Codes. *Proceedings of 2nd International Symposium on Turbo codes and Related Topics,* September 2008, 1-8

- **S.Y.CHUNG ; G.D.FORNEY ; T.J.RICHARDSON ; R.URBANKE.** On the Design of Low-Density Parity-Check Codes within 0.0045 dB of the Shannon Limit. *IEEE Communications Leggers,* February 2001, vol. 5 (2